# EUROPEAN PATENT SPECIFICATION

(11) **EP 3 244 466 B1**
(45) Date of publication and mention of the grant of the patent: **04.08.2021**
(21) Application number: 17150355.0
(22) Date of filing: 05.01.2017
(51) Int. Cl.: H01L 51/54

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 10.05.2016 KR 20160057130
(43) Date of publication of application: 15.11.2017
(73) Proprietor: Samsung Display Co., Ltd., Gyeonggi-Do (KR)
(72) Inventor: Cho, Hwan-Hee, Gyeonggi-do, (KR); Kim, Myeong-Suk, Gyeonggi-do, (KR); Kim, Sung-Wook, Gyeonggi-do, (KR); Kim, Se-Hun, Gyeonggi-do, (KR); Hwang, Jin-Soo, Gyeonggi-do, (KR)
(74) Representative: Russell, Tim

(56) References cited:
- WO-A1-2012/013271
- WO-A1-2015/135625
- US-A1- 2009 309 487
- US-A1- 2012 305 898

## Description

### FIELD OF THE INVENTION

The present invention relates to an organic light-emitting device.

### BACKGROUND OF THE INVENTION

Organic light-emitting devices are self-emission devices and have wide viewing angles, high contrast ratios, short response times, and excellent luminance, driving voltage, and response speed characteristics, and can produce full-color images.

An organic light-emitting device may comprise a first electrode disposed (e.g., positioned) on a substrate, and a hole transport region, an emission layer, an electron transport region, and a second electrode, which are sequentially disposed on the first electrode in this stated order. Holes provided from the first electrode may move toward the emission layer through the hole transport region, and electrons provided from the second electrode may move toward the emission layer through the electron transport region. Carriers, such as holes and electrons, may then recombine in the emission layer to produce excitons. These excitons may transition from an excited state to a ground state, thereby generating light. US 2012305898 and WO 2012013271 disclose OLEDs.

### SUMMARY OF THE INVENTION

The present invention provides an organic light-emitting device comprising:
a first electrode;
a second electrode facing the first electrode; and
an organic layer between the first electrode and the second electrode, the organic layer comprising an emission layer, and a hole transport region between the first electrode and the emission layer,
wherein the emission layer comprises a first compound as a host, a second compound as a host, and a fourth compound as a dopant, and the hole transport region comprises a third compound
the first compound to the fourth compound satisfy Equations 1 to 8: ${E}_{1 , LUMO} \geq {E}_{2 , LUMO} + 0.15 electron volts \left(eV\right)$ ${E}_{1 , HOMO} \geq {E}_{2 , HOMO} + 0.15 eV$ ${E}_{1 , T 1} \geq {E}_{4 , T 1}$ ${E}_{2 , T 1} \geq {E}_{4 , T 1}$ ${E}_{3 , T 1} \geq {E}_{4 , T 1}$ ${E}_{3 , LUMO} \geq {E}_{2 , LUMO} + 0.1 eV$ $- 5.6 eV \geq {E}_{3 , HOMO}$ ${E}_{gap 1} \geq {E}_{gap 3} ,$ wherein, in Equations 1 to 8,
   E_{1,LUMO} indicates a lowest unoccupied molecular orbital (LUMO) energy level of the first compound,
   E_{2,LUMO} indicates a LUMO energy level of the second compound,
   E_{3,LUMO} indicates a LUMO energy level of the third compound,
   E_{1,HOMO} indicates a highest occupied molecular orbital (HOMO) energy level of the first compound,
   E_{2,HOMO} indicates a HOMO energy level of the second compound,
   E_{3,HOMO} indicates a HOMO energy level of the third compound,
   E_{1,T1} indicates a lowest excited triplet energy level of the first compound,
   E_{2,T1} indicates a lowest excited triplet energy level of the second compound, E_{3,T1} indicates a lowest excited triplet energy level of the third compound,
   E_{4,T1} indicates a lowest excited triplet energy level of the fourth compound,
   E_{gap1} indicates a gap between the LUMO energy level of the first compound and the HOMO energy level of the first compound, and
   E_{gap3} indicates a gap between the LUMO energy level of the third compound and the HOMO energy level of the third compound, wherein the HOMO, LUMO and lowest excited triplet energy level (Ti) of a compound used in Equations 1 to 8 may be determined according to the processes recited in claim 1.

### BRIEF DESCRIPTION OF THE DRAWINGS

FIG. 1 is a schematic diagram illustrating the relative relationship between highest occupied molecular orbital (HOMO) energy levels and lowest unoccupied molecular orbital (LUMO) energy levels of a first compound, a second compound, and a third compound that are comprised in an organic light-emitting device according to one or more embodiments.
FIG. 2 is a schematic cross-sectional diagram of an organic light-emitting device according to one or more embodiments.
FIG. 3 is a schematic cross-sectional diagram of an organic light-emitting device according to one or more embodiments.
FIG. 4 is a schematic cross-sectional diagram of an organic light-emitting device according to one or more embodiments.
FIG. 5 is a schematic cross-sectional diagram of an organic light-emitting device according to one or more embodiments.

### DETAILED DESCRIPTION OF THE INVENTION

As used herein, the term "and/or" includes any and all combinations of one or more of the associated listed. Expressions such as "at least one of," "one of," and "selected from," when preceding a list of elements, modify the entire list of elements and do not modify the individual elements of the list. Further, the use of "may" when describing embodiments of the present invention refers to "one or more embodiments of the present invention."

The organic light-emitting device of the present invention comprises a first electrode; a second electrode facing the first electrode; and an organic layer disposed (e.g., positioned) between the first electrode and the second electrode, the organic layer comprising an emission layer, and a hole transport region between the first electrode and the emission layer, wherein the emission layer may comprise a first compound as a host, a second compound as a host, and a fourth compound as a dopant, and the hole transport region comprises a third compound, the first compound to the fourth compound satisfy Equations 1 to 8: ${E}_{1 , LUMO} \geq {E}_{2 , LUMO} + 0.15 electron volts \left(eV\right)$ ${E}_{1 , HOMO} \geq {E}_{2 , HOMO} + 0.15 eV$ ${E}_{1 , T 1} \geq {E}_{4 , T 1}$ ${E}_{2 , T 1} \geq {E}_{4 , T 1}$ ${E}_{3 , T 1} \geq {E}_{4 , T 1}$ ${E}_{3 , LUMO} \geq {E}_{2 , LUMO} + 0.1 eV$ $- 5.6 eV \geq {E}_{3 , HOMO}$ ${E}_{gap 1} \geq {E}_{gap 3} ,$ wherein, in Equations 1 to 8,
E_{1,LUMO} indicates a lowest unoccupied molecular orbital (LUMO) energy level of the first compound,
E_{2,LUMO} indicates a LUMO energy level of the second compound,
E_{3,LUMO} indicates a LUMO energy level of the third compound,
E_{1,HOMO} indicates a highest occupied molecular orbital (HOMO) energy level of the first compound,
E_{2,HOMO} indicates a HOMO energy level of the second compound,
E_{3,HOMO} indicates a HOMO energy level of the third compound,
E_{1,T1} indicates a lowest excited triplet energy level of the first compound,
E_{2,T1} indicates a lowest excited triplet energy level of the second compound,
E_{3,T1} indicates a lowest excited triplet energy level of the third compound,
E_{4,T1} indicates a lowest excited triplet energy level of the fourth compound,
E_{gap1} indicates a gap (e.g., energy gap) between the LUMO energy level of the first compound and the HOMO energy level of the first compound, and
E_{gap3} indicates a gap between the LUMO energy level of the third compound and the HOMO energy level of the third compound where the HOMO, LUMO, and T1 are determined according to the processes set out in claim 1.

In an embodiment, E_{1,HOMO} may satisfy Equation a, but embodiments are not limited thereto: $- 5.9 eV \leq {E}_{1 , HOMO} \leq - 5.3 eV .$

In an embodiment, E_{1,LUMO} may satisfy Equation b, but embodiments are not limited thereto: $- 2.6 eV \leq {E}_{1 , LUMO} \leq - 2.0 eV .$

In an embodiment, E_{2,HOMO} may satisfy Equation c, but embodiments are not limited thereto: $- 6.4 eV \leq {E}_{2 , HOMO} \leq - 5.6 eV .$

In an embodiment, E_{2,LUMO} may satisfy Equation d, but embodiments are not limited thereto: $- 3.2 eV \leq {E}_{2 , LUMO} \leq - 2.4 eV .$

In an embodiment, E_{3,HOMO} may satisfy Equation e, but embodiments are not limited thereto: $- 5.9 eV \leq {E}_{3 , HOMO} \leq - 5.3 eV .$

In an embodiment, E_{3,LUMO} may satisfy Equation f, but embodiments are not limited thereto: $- 2.7 eV \leq {E}_{3 , LUMO} \leq - 2.1 eV .$

In an embodiment, E_{4,HOMO} may satisfy Equation g, but embodiments are not limited thereto: $- 5.5 eV \leq {E}_{4 , HOMO} \leq - 4.5 eV ,$ wherein, in Equation g, E_{4,HOMO} indicates a HOMO energy level of the fourth compound.

In an embodiment, E_{1,T1} may satisfy Equation h, but embodiments are not limited thereto: $2.2 eV \leq {E}_{1 , T 1} \leq 3.0 eV .$

In an embodiment, E_{2,T1} may satisfy Equation i, but embodiments are not limited thereto: $2.2 eV \leq {E}_{2 , T 1} \leq 3.0 eV .$

In an embodiment, E_{3,T1} may satisfy Equation j, but embodiments are not limited thereto: $2.2 eV \leq {E}_{3 , T 1} \leq 3.0 eV .$

In an embodiment, E_{4,T1} may satisfy Equation k, but embodiments are not limited thereto: $1.6 eV \leq {E}_{4 , T 1} \leq 2.9 eV .$

In an embodiment, E_{gap1} may satisfy Equation 1, but embodiments are not limited thereto: $3.0 eV \leq {E}_{gap 1} \leq 3.8 eV .$

In an embodiment, E_{gap3} may satisfy Equation m, but embodiments are not limited thereto: $3.0 eV \leq {E}_{gap 3} \leq 3.8 eV .$

In another embodiment, the first compound to the fourth compound may each satisfy Equations 1a to 6a, but embodiments are not limited thereto: ${E}_{1 , LUMO} \geq {E}_{2 , LUMO} + 0.2 eV$ ${E}_{1 , HOMO} \geq {E}_{2 , HOMO} + 0.2 eV$ ${E}_{1 , T 1} \geq {E}_{4 , T 1} + 0.1 eV$ ${E}_{2 , T 1} \geq {E}_{4 , T 1} + 0.1 eV$ ${E}_{3 , T 1} \geq {E}_{4 , T 1} + 0.1 eV$ ${E}_{3 , LUMO} \geq {E}_{2 , LUMO} + 0.2 eV .$

The emission layer comprises the first compound as a host, the second compound as a host, and the fourth compound as a dopant, and the hole transport region comprises the third compound.

In some embodiments, the hole transport region may comprise a first layer, the first layer may comprise the third compound, and the first layer may directly contact the emission layer.

According to an embodiment, the first compound may be represented by one of Formulae 1-1, 2-1, 2-2, and 3-1, the second compound may be represented by one of Formulae 1-2, 2-3, 2-4, and 3-2, and the third compound may be represented by Formula 4: 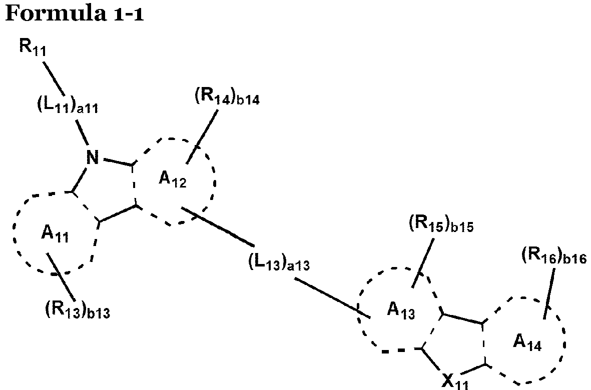 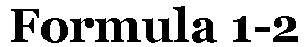 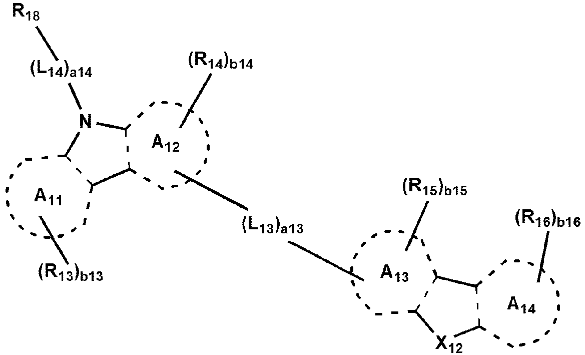 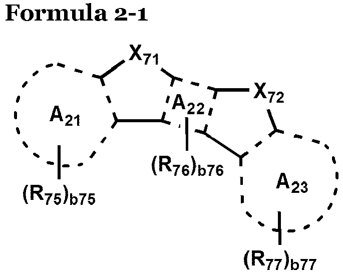 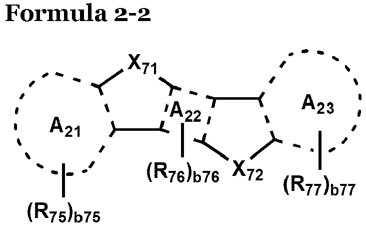 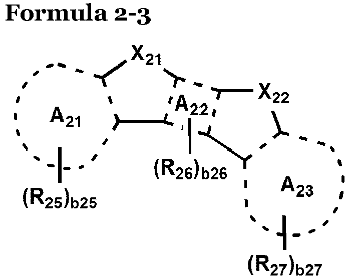 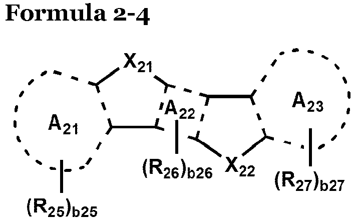 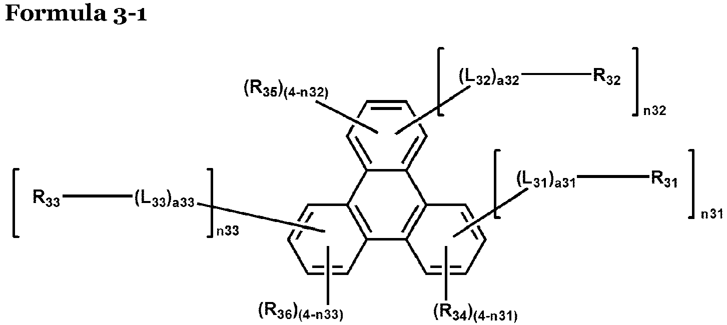 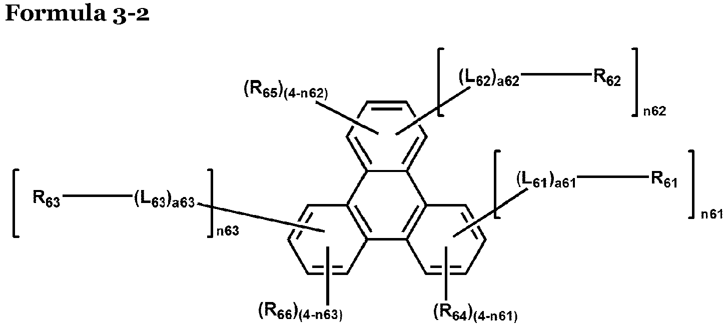 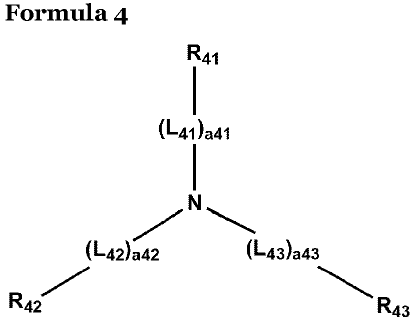 wherein, in Formulae 1-1, 1-2, 2-1 to 2-4, 3-1, 3-2, and 4,
L₁₁ L₁₃, L₁₄, L₃₁ to L₃₃, L₄₁ to L₄₃, and L₆₁ to L₆₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group, provided one or more L₄₁, one or more L₄₂, and/or one or more L₄₃ is a group represented by Formula 5, 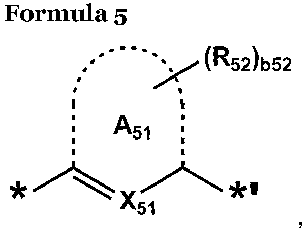
A₁₁ to A₁₄, A₂₁ to A₂₃, and A₅₁ may each independently be selected from a C₅-C₂₀ carbocyclic group and a C₁-C₂₀ heterocyclic group,
X₁₁ may be selected from O, S, N[(L₁₂)ₐ₁₂-R₁₂], C[(L₁₂)ₐ₁₂-R₁₂](R₁₇), Si[(L₁₂)ₐ₁₂-R₁₂](R₁₇), P[(L₁₂)ₐ₁₂-R_{12]}, B[(L₁₂)ₐ₁₂-R_{12]}, and P(=O)[(L₁₂)ₐ₁₂-R₁₂],
X₁₂ may be selected from O, S, N[(L₁₅)ₐ₁₅-R₁₉], C[(L₁₅)ₐ₁₅-R₁₉](R₂₀), Si[(L₁₅)ₐ₁₅-R₁₉](R₂₀), P[(L₁₅)ₐ₁₅-R₁₉], B[(L₁₅)ₐ₁₅-R₁₉], and P(=O)[(L₁₅)ₐ₁₅-R₁₉],
X₂₁ may be selected from N[(L₂₁)ₐ₂₁-R₂₁], C[(L₂₁)ₐ₂₁-R₂₁](R₂₃), O, and S,
X22 may be selected from N[(L₂₂)ₐ₂₂-R₂₂], C[(L₂₂)ₐ₂₂-R₂₂](R₂₄), O, and S,
X₅₁ may be selected from N and CR₅₁,
X₇₁ may be selected from N[(L₇₁)ₐ₇₁-R₇₁], C[(L₇₁)ₐ₇₁-R₇₁](R₇₃), O, and S,
X₇₂ may be selected from N[(L₇₂)ₐ₇₂-R₇₂], C[(L₇₂)ₐ₇₂-R₇₂](R₇₄), O, and S,
L₁₂, L₁₅, L₂₁, L₂₂, L₇₁, and L₇₂ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
a11 to a15, a21, a22, a31 to a33, a41 to a43, a61 to a63, a71, and a72 may each independently be selected from 0, 1, 2, 3, 4, and 5,
when one or more L₄₁ is a group represented by Formula 5, a41 may be selected from 1, 2, 3, 4, and 5; when one or more L₄₂ is a group represented by Formula 5, a42 may be selected from 1, 2, 3, 4, and 5; when one or more L₄₃ is a group represented by Formula 5, a43 may be selected from 1, 2, 3, 4, and 5,
R₁₁, R₁₃ to R₁₆, R₁₈, R₂₁ to R₂₇, R₃₁ to R₃₆, R₄₁ to R₄₃, R₅₁, R₅₂, R₆₁ to R₆₆, and R₇₁ to R₇₇ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁(Q₂), -C(=O)(Q₁), -S(=O)₂(Q₁), and -P(=O)(Q₁)(Q₂), wherein
at least one selected from R₄₁ to R₄₃ may be selected from a substituted or unsubstituted monovalent non-aromatic condensed C8-C60 polycyclic group and a substituted or unsubstituted monovalent non-aromatic condensed 8- to 60-membered heteropolycyclic group,
R₁₂ and R₁₇ may each independently be as defined for R₁₁ or are optionally bound to each other to form a C₅-C₂₀ carbocyclic group or a C₁-C₂₀ heterocyclic group,
R₁₉ and R₂₀ may each independently be as defined for R₁₁ or are optionally bound to each other to form a C₅-C₂₀ carbocyclic group and a C₁-C₂₀ heterocyclic group,
b13 to b16, b25 to b27, b52, and b75 to b77 may each independently be selected from 1, 2, 3, and 4,
n31 to n33 and n61 to n63 may each independently be selected from 0, 1, 2, 3, and 4,
* and *' indicate a binding site to an adjacent atom, and
the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed C8-C60 polycyclic group, substituted divalent non-aromatic condensed 8- to 60-membered heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed C8-C60 polycyclic group, and substituted monovalent non-aromatic condensed 8- to 60-membered heteropolycyclic group may be substituted with one or more substituents each independently selected from the group consisting of:
   deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
   wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

In some embodiments, in Formulae 1-1, 1-2, 2-1 to 2-4, and 5, A₁₁ to A₁₄, A₂₁ to A₂₃, and A₅₁ may each independently be selected from a benzene group, a naphthalene group, a fluorene group, a phenanthrene group, an anthracene group, a triphenylene group, a pyrene group, a chrysene group, a furan group, a thiophene group, a pyrrole group, a pyridine group, a pyrazine group, a pyrimidine group, a pyridazine group, a triazine group, a quinoline group, an isoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a benzofuran group, a benzothiophene group, a dibenzofuran group, a dibenzothiophene group, and a carbazole group.

In some embodiments, in Formulae 2-1 to 2-4, X₂₁ may be N[(L₂₁)ₐ₂₁-R₂₁], X₂₂ may be selected from N[(L₂₂)ₐ₂₂-R₂₂], C[(L₂₂)ₐ₂₂-R₂₂](R₂₄), O, and S, X₇₁ may be N[(L₇₁)ₐ₇₁-R₇₁], and X₇₂ may be selected from N[(L₇₂)ₐ₇₂-R₇₂], C[(L₇₂)ₐ₇₂-R₇₂](R₇₄), O, and S.

In one or more embodiments, at least one selected from R₄₁ to R₄₃ may be a group represented by Formula 4a or 4b: 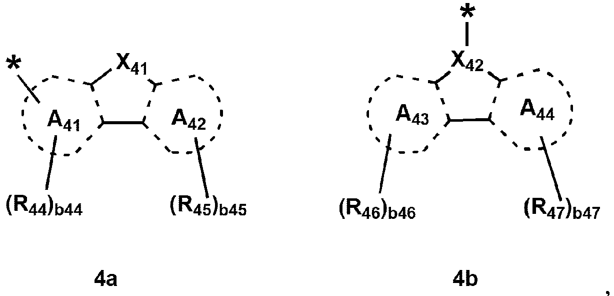 wherein, in Formulae 4a and 4b,
X₄₁ may be selected from N(R₄₀₁), B(R₄₀₁), C(R₄₀₁)(R₄₀₂), Si(R₄₀₁)(R₄₀₂), O, and S,
X₄₂ may be selected from N, B, C(R₄₀₃), and Si(R₄₀₃),
A₄₁ to A₄₄ may each independently be selected from a benzene group, a naphthalene group, a fluorene group, a phenanthrene group, an anthracene group, a triphenylene group, a pyrene group, a chrysene group, a furan group, a thiophene group, a pyrrole group, a pyridine group, a pyrazine group, a pyrimidine group, a pyridazine group, a triazine group, a quinoline group, an isoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a benzofuran group, a benzothiophene group, a dibenzofuran group, a dibenzothiophene group, and a carbazole group,
descriptions of R₄₄ to R₄₇ and R₄₀₁ to R₄₀₃ may each independently be the same as the description provided above in connection with R₄₁ to R₄₃ in Formula 4,
b₄₄ to b₄₇ may each independently be selected from 1, 2, 3, and 4, and
R₄₀₁ and R₄₀₂ may optionally be bound to form a saturated or unsaturated ring.

In some embodiments, L₁₁ to L₁₃, L₃₁ to L₃₃, L₇₁, and L₇₂ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group, each substituted with at least one selected from deuterium, a methyl group, an ethyl group, an n-propyl group, an iso-propyl group, an n-butyl group, a sec-butyl group, an iso-butyl group, a tert-butyl group, a methoxy group, an ethoxy group, an n-propoxy group, an iso-propoxy group, an n-butoxy group, a sec-butoxy group, an iso-butoxy group, a tert-butoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a thiophenyl group, a furanyl group, a carbazolyl group, a benzofuranyl group, a benzothiophenyl group, a dibenzofuranyl group, a dibenzothiophenyl group, a dibenzosilolyl group, a benzocarbazolyl group, a dibenzocarbazolyl group, -N(Q₃₁)(Q₃₂), -Si(Q₃₁)(Q₃₂)(Q₃₃), and -B(Q₃₁)(Q₃₂), and
L₁₄, L₁₅, L₂₁, L₂₂, and L₆₁ to L₆₃ may each independently be selected from the group consisting of:
   a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a pyridinylene group, a pyrazinylene group, a pyrimidinylene group, a pyridazinylene group, a triazinylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group; and
   a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a pyridinylene group, a pyrazinylene group, a pyrimidinylene group, a pyridazinylene group, a triazinylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group, each substituted with at least one selected from deuterium, -F, a cyano group, a methyl group, an ethyl group, an n-propyl group, an iso-propyl group, an n-butyl group, a sec-butyl group, an iso-butyl group, a tert-butyl group, a methoxy group, an ethoxy group, an n-propoxy group, an iso-propoxy group, an n-butoxy group, a sec-butoxy group, an iso-butoxy group, a tert-butoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a thiophenyl group, a furanyl group, a pyridinyl group, a pyrazinyl group, a pyrimidinyl group, a pyridazinyl group, a triazinyl group, a carbazolyl group, a benzofuranyl group, a benzothiophenyl group, a dibenzofuranyl group, a dibenzothiophenyl group, a dibenzosilolyl group, a benzocarbazolyl group, a dibenzocarbazolyl group, -N(Q₃₁)(Q₃₂), -Si(Q₃₁)(Q₃₂)(Q₃₃), and -B(Q₃₁)(Q₃₂),
   wherein Q₃₁ to Q₃₃ may each independently be selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group.
In some embodiments, L₄₁ to L₄₃ may each independently be selected from selected from the group consisting of:
   a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a benzocarbazolylene group, and a dibenzocarbazolylene group; and
   a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, dibenzosilolylene group, a benzocarbazolylene group, and a dibenzocarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
   wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group, but embodiments are not limited thereto;
   provided that at least one selected from L₄₁ to L₄₃ is a group represented by Formula 5 as described above.

According to an embodiment, L₄₁ to L₄₃ in Formula 4 may each independently be selected from groups represented by Formulae 4-1 to 4-31, but embodiments are not limited thereto: 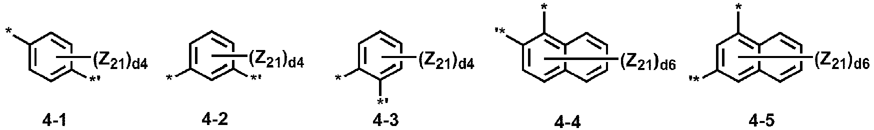 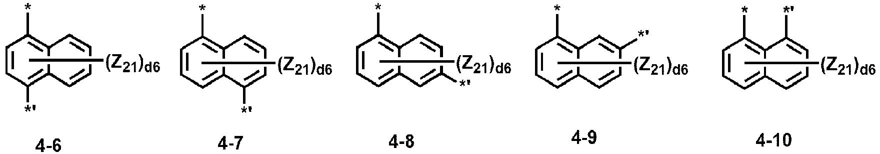 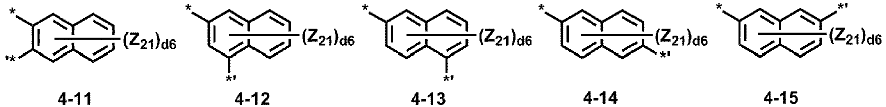 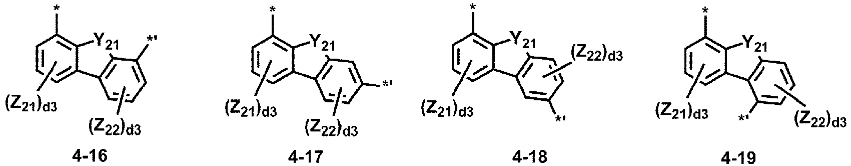 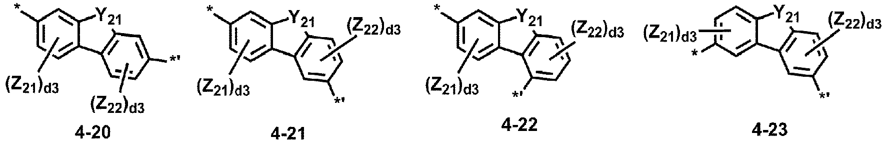 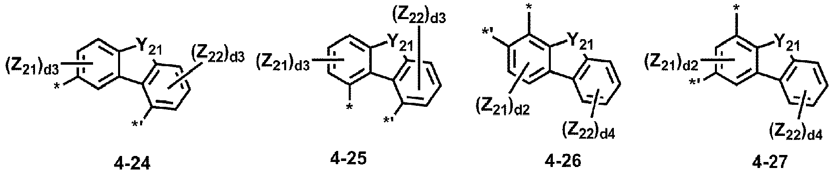 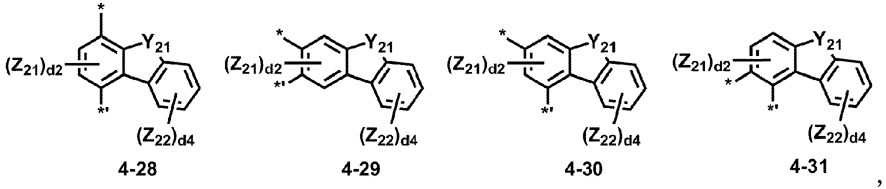 wherein, in Formulae 4-1 to 4-31,
Y₂₁ may be selected from O, S, N(R₄₃), C(R₄₃)(R₄₄), and Si(R₄₃)(R₄₄), wherein R₄₃ and R₄₄ are as defined herein,
Z₂₁ and Z₂₂ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group,
d2 may be an integer selected from 1 and 2, d3 may be an integer selected from 1 to 3, d4 may be an integer selected from 1 to 4, d6 may be an integer selected from 1 to 6, and
* and *' each independently indicate a binding site to an adjacent atom;
provided that at least one selected from L₄₁ to L₄₃ is a group represented by Formula 4-2, 4-5, 4-12, 4-27 and 4-30.

In one or more embodiments, compound represented by Formula 5 may be represented by one selected from Formulae 4-2, 4-5, 4-27, and 4-30, but embodiments are not limited thereto.

In some embodiments, a11 to a15, a21, a22, a31 to a33, a41 to a43, a61 to a63, a71, and a72 may each independently be selected from 0, 1, 2, and 3.

In an embodiment, R₁₁ to R₁₇, R₃₁ to R₃₆, R₅₁, R₅₂, and R₇₁ to R₇₇ may each independently be a hole transporting group, and
R₁₈ to R₂₇, R₄₁ to R₄₇, and R₆₁ to R₆₆ may each independently be selected from a hole transporting group and an electron transporting group, but embodiments are not limited thereto.

In some embodiments, the hole transporting group may be selected from a C₁-C₂₀ alkyl group, -Si(Q₁)(Q₂)(Q₃), -N(Q₁)(Q₂), and a group represented by any of Formulae 5-1 to 5-19: 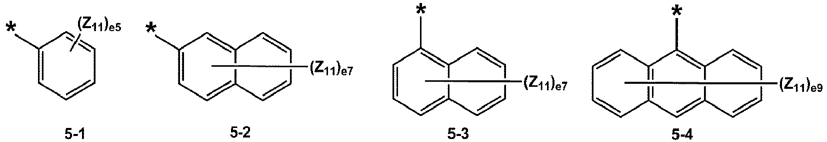 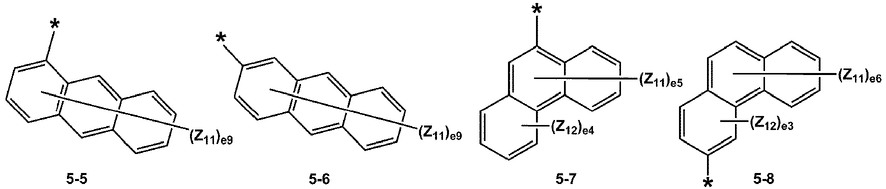 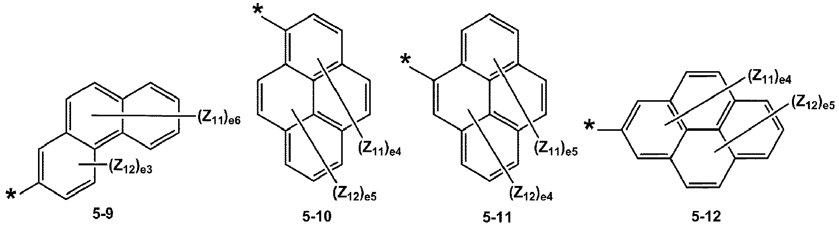 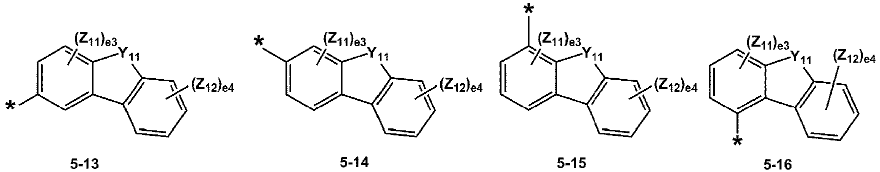 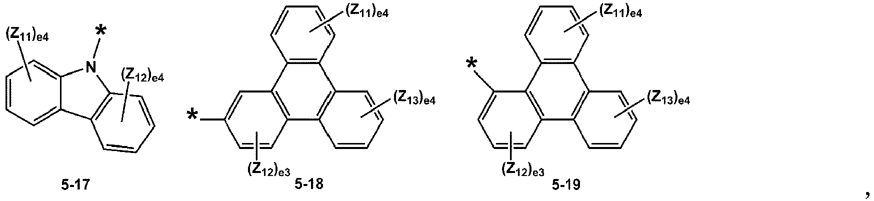 wherein, in Formulae 5-1 to 5-19,
Y₁₁ may be selected from O, S, C(Z₁₃)(Z₁₄), N(Z₁₃), and Si(Z₁₃)(Z₁₄),
Z₁₁ to Z₁₄ may each independently be selected from the group consisting of:
   hydrogen, deuterium, a hydroxyl group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a benzofuranyl group, a benzothiophenyl group, a benzosilolyl group, an isobenzothiazolyl group, a dibenzofuranyl group, a dibenzothiophenyl group, a dibenzosilolyl group, a carbazolyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂); and
   a phenyl group, a biphenyl group, a terphenyl group, a naphthyl group, a dibenzofuranyl group, a dibenzothiophenyl group, a dibenzosilolyl group, a carbazolyl group, a benzocarbazolyl group, and a dibenzocarbazolyl group, each substituted with at least one selected from a C₁-C₂₀ alkyl group, a C₁-C₂₀ alkoxy group, a phenyl group, a biphenyl group, a terphenyl group, a naphthyl group, a carbazolyl group, a fluorenyl group, -Si(Q₂₁)(Q₂₂)(Q₂₃), and -N(Q₂₁)(Q₂₂),
   wherein Q₁ to Q₃, Q₂₁ to Q₂₃, and Q₃₁ to Q₃₃ may each independently be selected from a C₁-C₁₀ alkyl group, a C₁-C₁₀ alkoxy group, a phenyl group, a biphenyl group, a terphenyl group, and a naphthyl group,
   e3 may be an integer selected from 1 to 3, e4 may be an integer selected from 1 to 4, e5 may be an integer selected from 1 to 5, e6 may be an integer selected from 1 to 6, e7 may be an integer selected from 1 to 7, e9 may be an integer selected from 1 to 9, and
   * indicates a binding site to an adjacent atom.

In some embodiments, the electron transporting group may be selected from the group consisting of:
a cyano group, -F, and -CF₃;
a C₆-C₆₀ aryl group substituted with at least one selected from a cyano group, -F, and -CF₃; and
a substituted or unsustituted C₁-C₆₀ heterocyclic group having at least one *=N-*' moiety as a ring-forming moiety, but embodiments are not limited thereto.

In some embodiments, the electron transporting group may be selected from - CN, -CF₃, and a group represented by any of Formulae 6-1 to 6-128, but embodiments are not limited thereto: 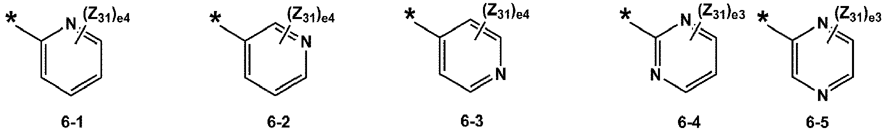 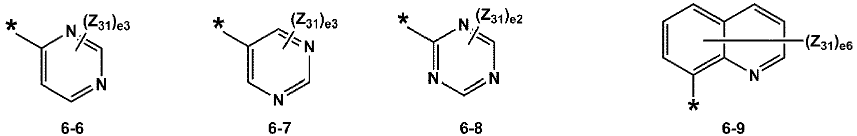 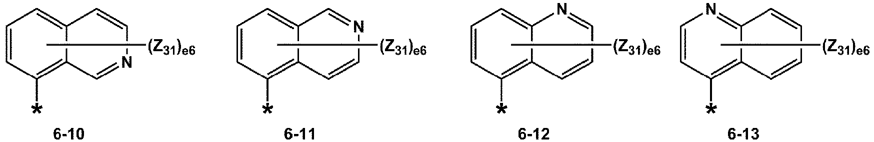 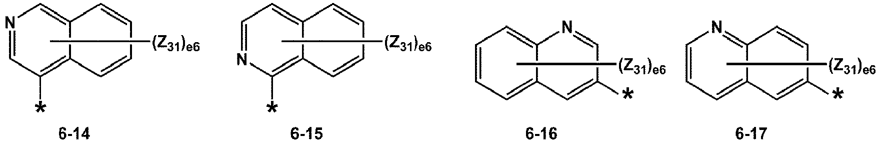 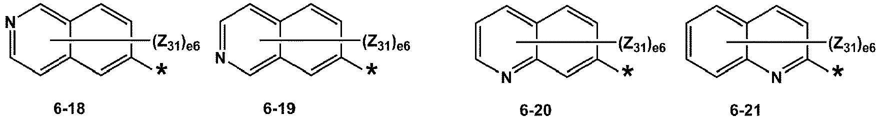 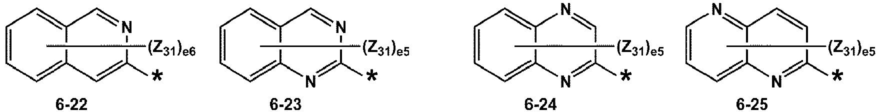 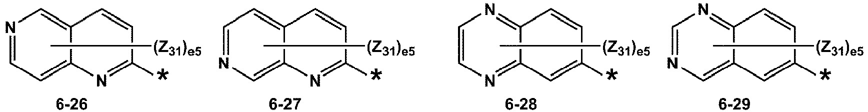 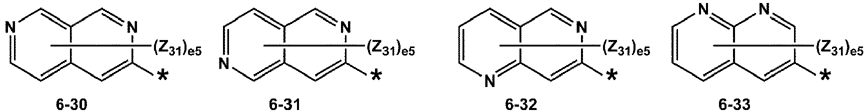 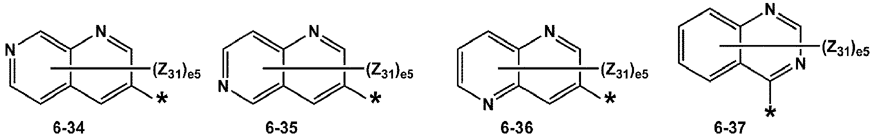 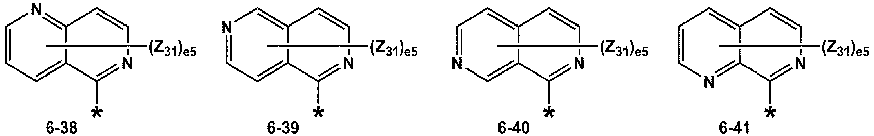 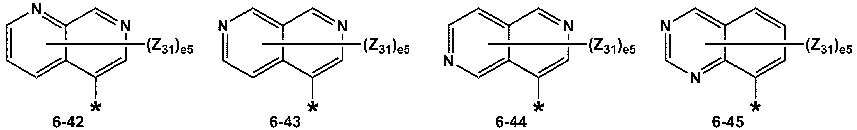 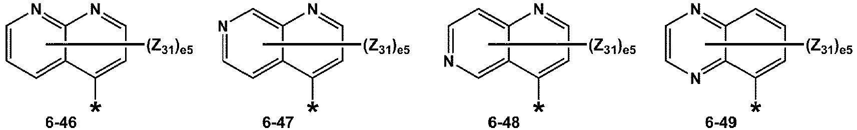 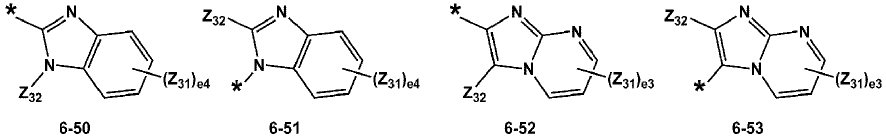 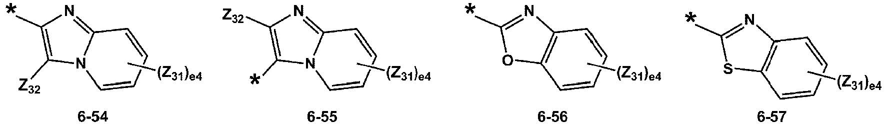 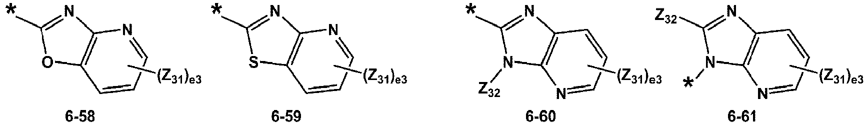 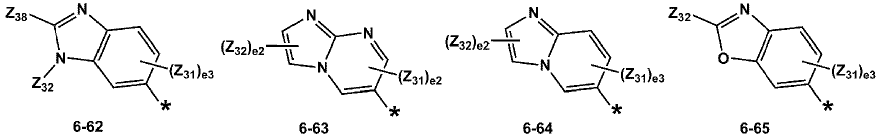 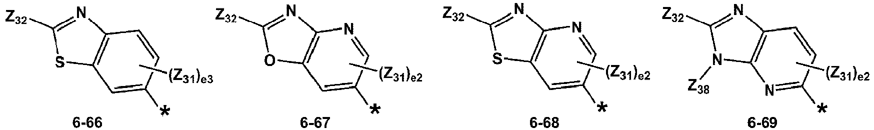 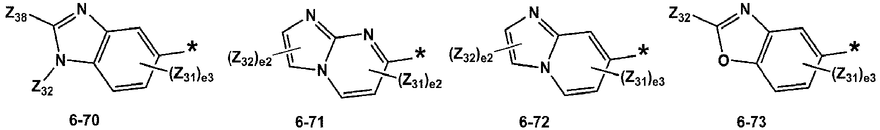 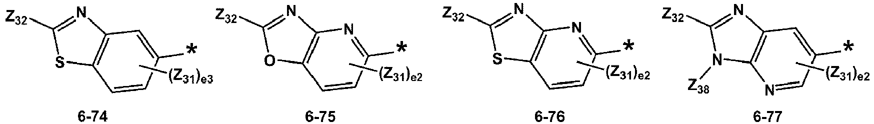 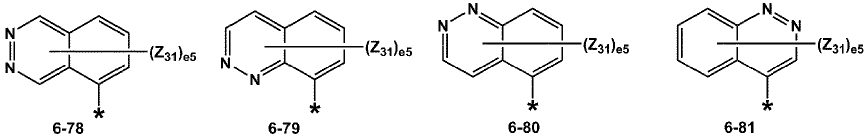 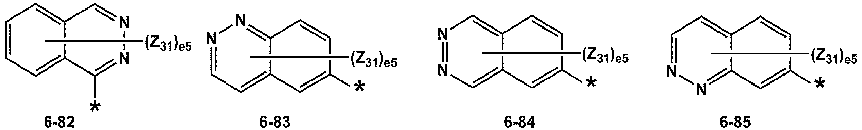 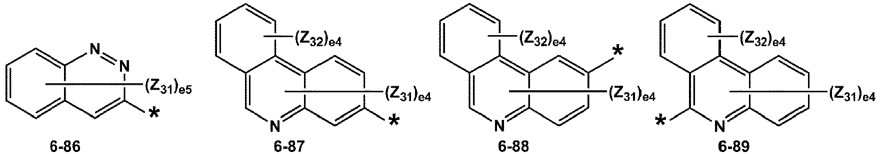 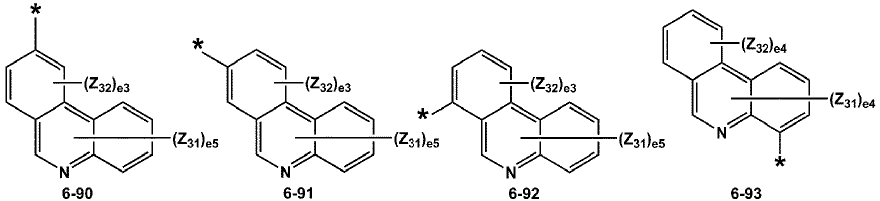 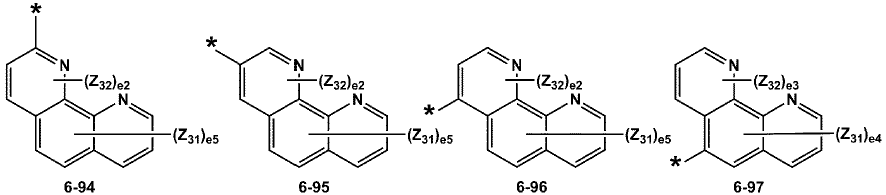 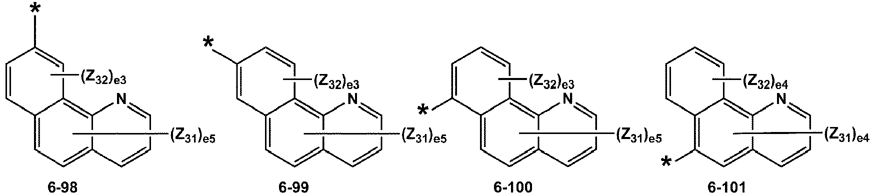 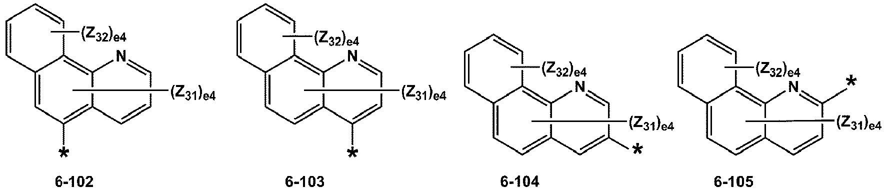 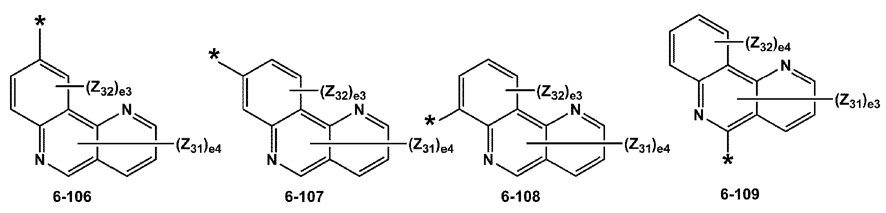 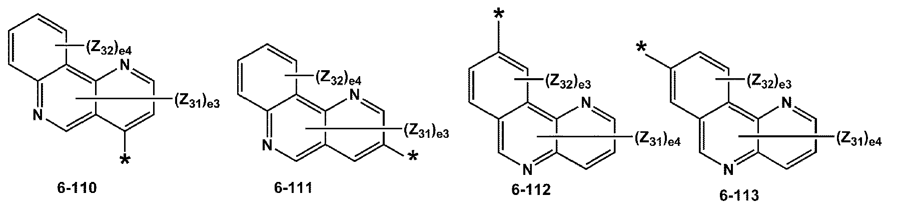 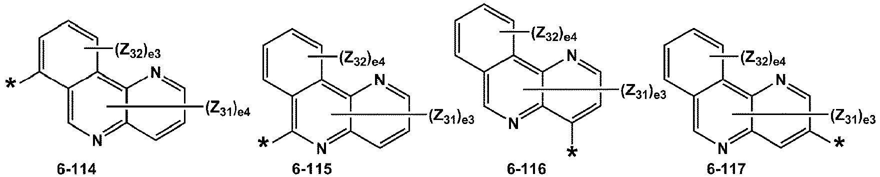 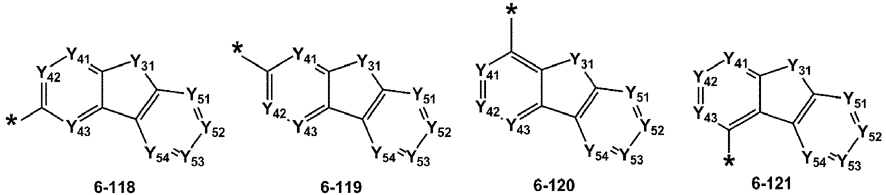 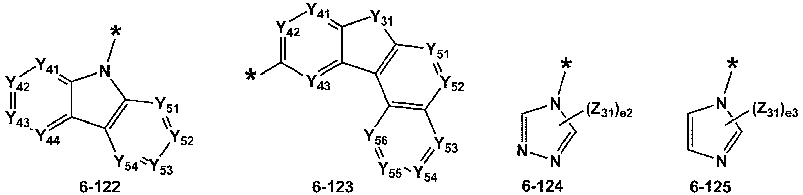 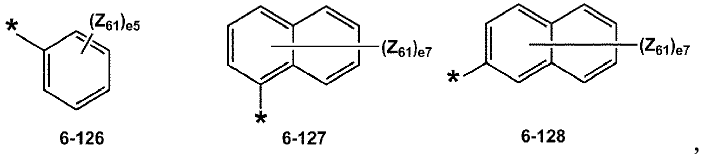 wherein, in Formulae 6-1 to 6-128,
Y₃₁ may be selected from O, S, C(Z₃₃)(Z₃₄), N(Z₃₃), and Si(Z₃₃)(Z₃₄),
Y₄₁ may be N or C(Z₄₁), Y₄₂ may be N or C(Z₄₂), Y₄₃ may be N or C(Z₄₃), Y₄₄ may be N or C(Z₄₄), Y₅₁ may be N or C(Z₅₁), Y₅₂ may be N or C(Z₅₂), Y₅₃ may be N or C(Z₅₃), Y₅₄ may be N or C(Z₅₄), Y₅₅ may be N or C(Z₅₅), Y₅₆ may be N or C(Z₅₆),
at least one selected from Y₄₁ to Y₄₃ and Y₅₁ to Y₅₄ in Formulae 6-118 to 6-121 may be N, at least one selected from Y₄₁ to Y₄₄ and Y₅₁ to Y₅₄ in Formula 6-122 may be N, at least one selected from Y₄₁ to Y₄₃ and Y₅₁ to Y₅₆ in Formula 6-123 may be N,
Z₃₁ to Z₃₄, Z₃₈, Z₄₁ to Z₄₄, and Z₅₁ to Z₅₆ may each independently be selected from the group consisting of:
   hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂); and
   a phenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₂₀ alkyl group, a C₁-C₂₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, a quinazolinyl group, a carbazolyl group, a fluorenyl group, -Si(Q₂₁)(Q₂₂)(Q₂₃), and -N(Q₂₁)(Q₂₂),
   Z₆₁ may be selected from hydrogen, a cyano group, -F, and -CF₃, provided that at least one Z₆₁ may be selected from a cyano group, -F, and -CF₃,
   wherein Q₂₁ to Q₂₃ and Q₃₁ to Q₃₃ may each independently be selected from a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group,
   e2 may be an integer selected from 1 and 2, e3 may be an integer selected from 1 to 3, e4 may be an integer selected from 1 to 4, e5 may be an integer selected from 1 to 5, e6 may be an integer selected from 1 to 6, e7 may be an integer selected from 1 to 7, and
   * indicates a binding site to an adjacent atom.

In some embodiments, the first compound may be represented by Formula 1-1 and the second compound may be represented by Formula 1-2. In some embodiments, the first compound represented by Formula 1-1 may be represented by Formula 1-11, and the second compound represented by Formula 1-2 may be represented by Formula 1-21: 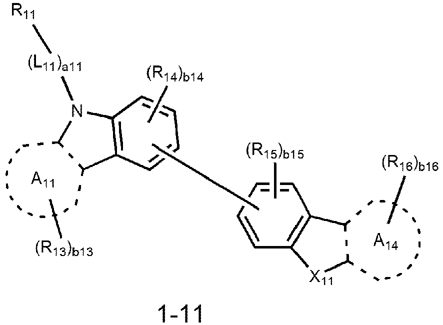 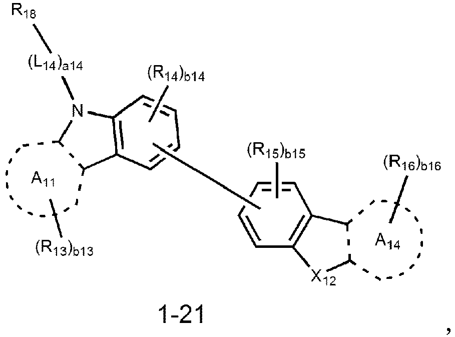 wherein, in Formulae 1-11 and 1-21,
definitions of A₁₁, A₁₄, X₁₁, X₁₂, L₁₁, L₁₃, L₁₄, a11, ai3, a14, R₁₁, R₁₃ to R₁₆, R₁₈, and b₁₃ to b16 may be respectively the same as those provided above in connection with Formulae 1-1 and 1-2.

In some embodiments, the first compound may be represented by Formula 2-1 or 2-2, and the second compound may be represented by Formula 2-3 or 2-4.

In some embodiments, the first compound represented by Formula 2-1 or 2-2 may be represented by one of Formulae 2-11 to 2-15 and 2-21 to 2-23, and
the second compound represented by Formula 2-3 or 2-4 may be represented by one of Formulae 2-31 to 2-35 and 2-41 to 2-43, but embodiments are not limited thereto: 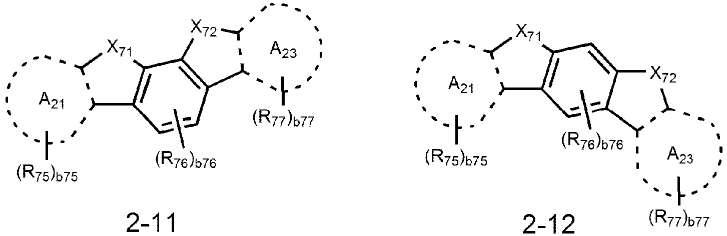 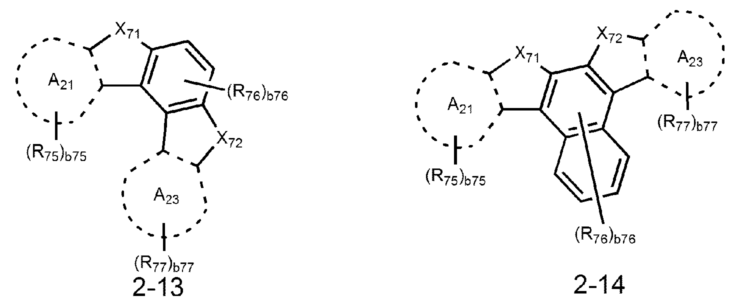 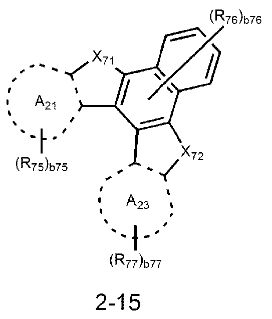 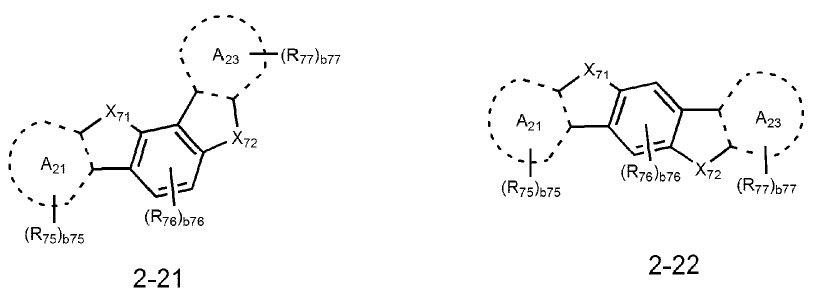 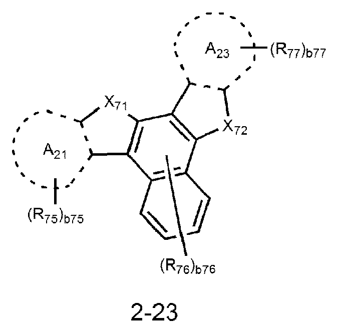 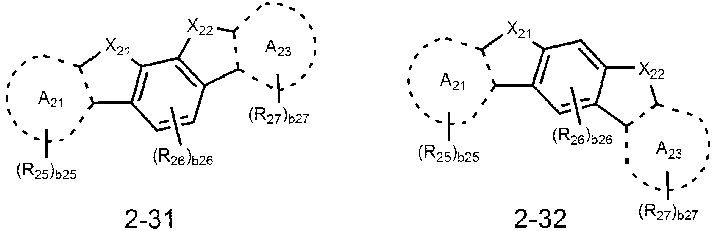 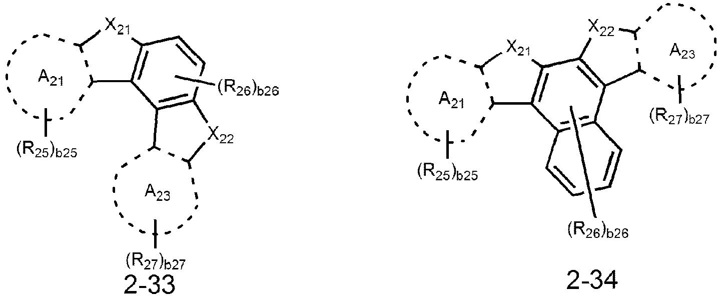 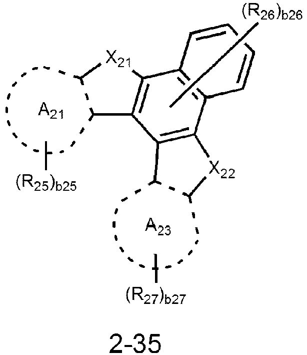 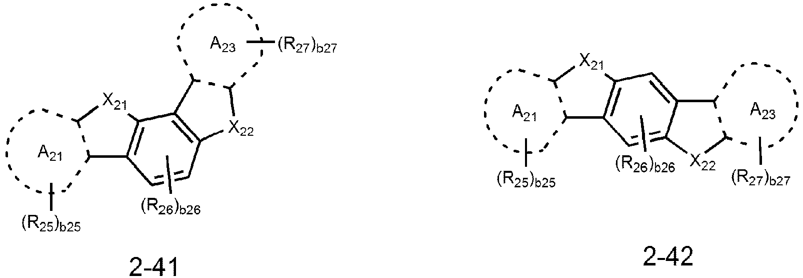 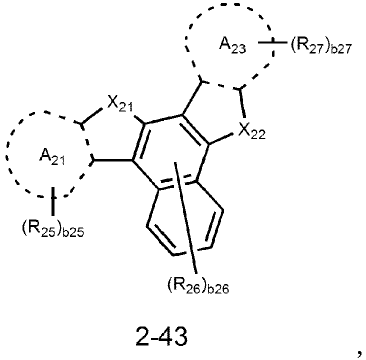 wherein, in Formulae 2-11 to 2-15, 2-21 to 2-23, 2-31 to 2-35, and 2-41 to 2-43, descriptions of A₂₁, A₂₃, X₂₁, X22, X₇₁, X₇₂, R₂₅ to R₂₇, R₇₅ to R₇₇, b25 to b27, and b75 to b₇₇ are respectively the same as those provided above in connection with Formulae 2-1 to 2-4.

In some embodiments, the first compound represented by Formula 1-1 may be selected from Compounds B-101 to B-230,
the second compound represented by Formula 1-2 may be selected from Compounds A-101 to A-206,
the first compound represented by Formula 2-1 or 2-2 may be selected from Compounds G-101 to G-173,
the second compound represented by Formula 2-3 or 2-4 may be selected from Compounds C-101 to C-270,
the first compound represented by Formula 3-1 may be selected from Compounds E-101 to E-182,
the second compound represented by Formula 3-2 may be selected from Compounds D-101 to D-159, and
the third compound represented by Formula 4 may be selected from Compounds F-101 to F-313:

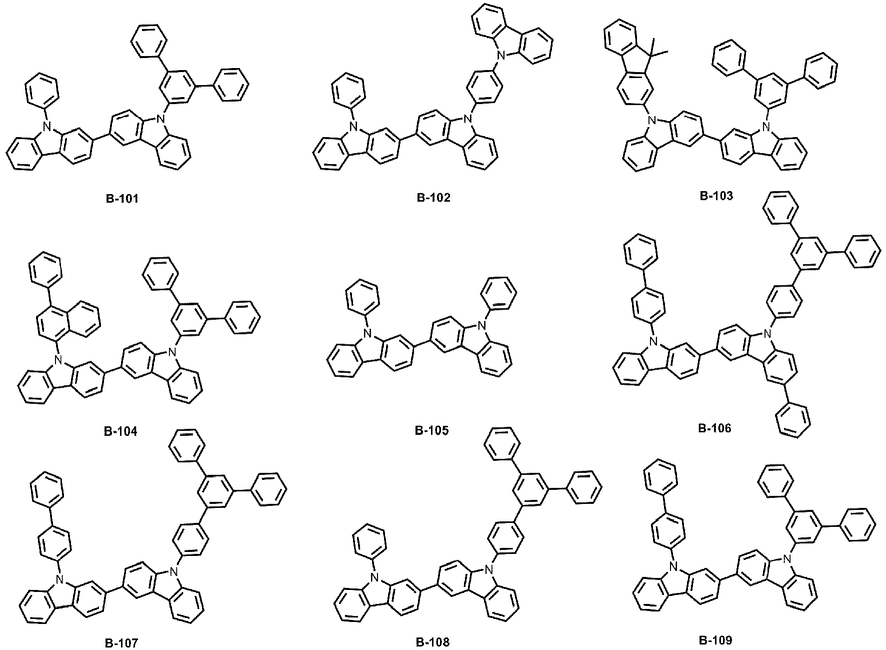

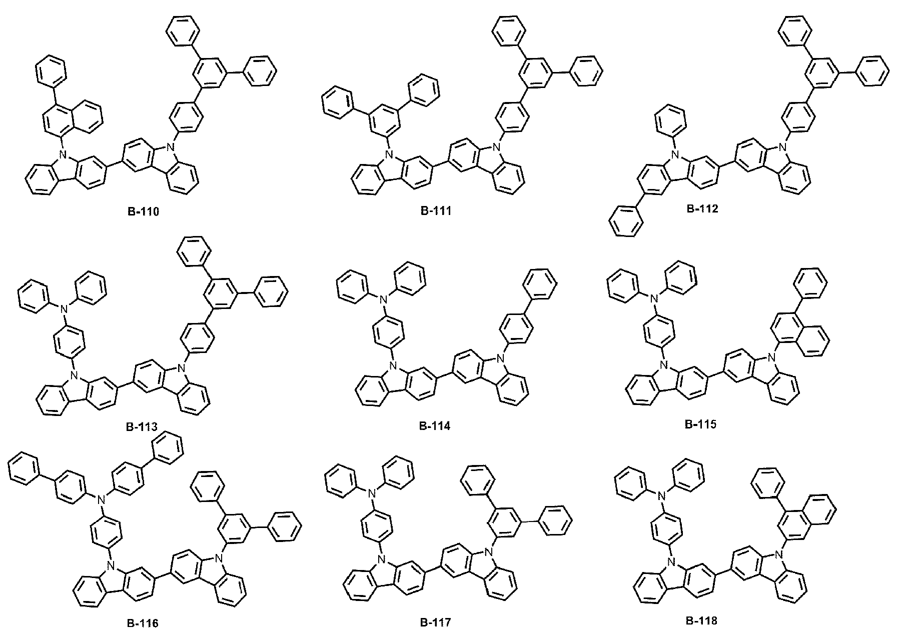

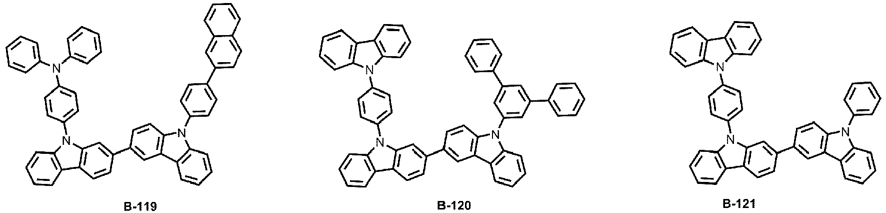

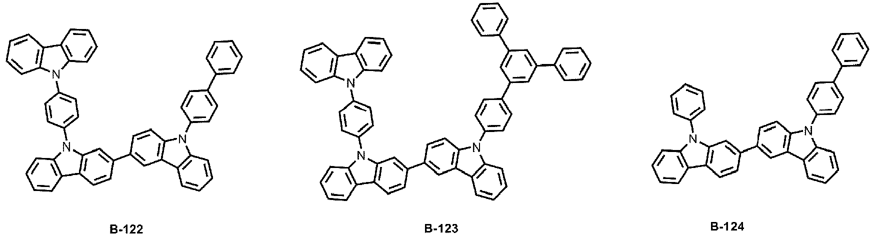

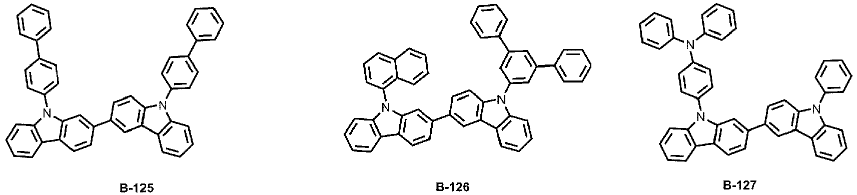

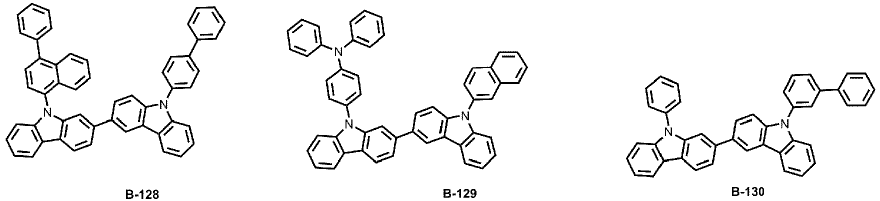

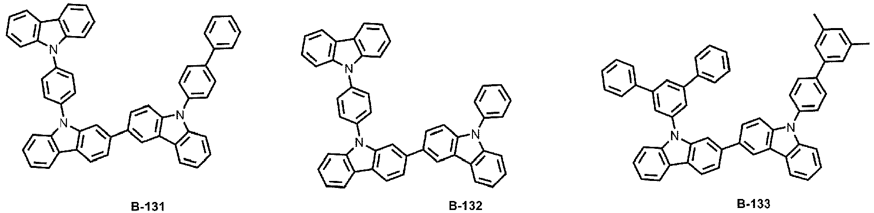

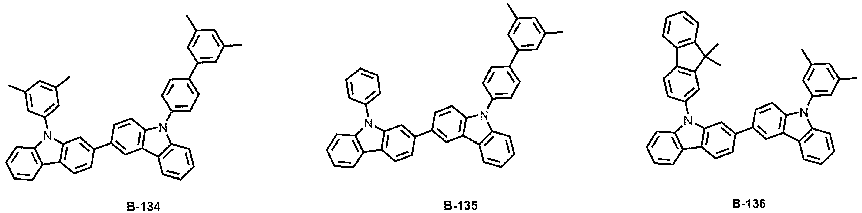

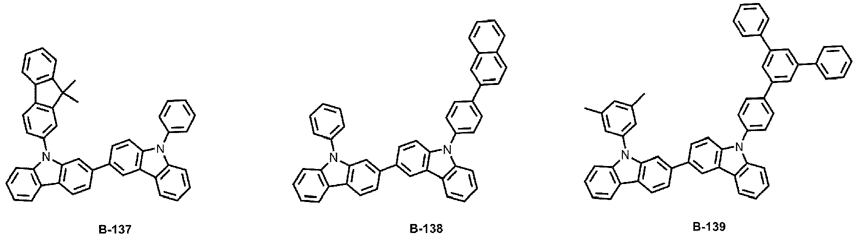

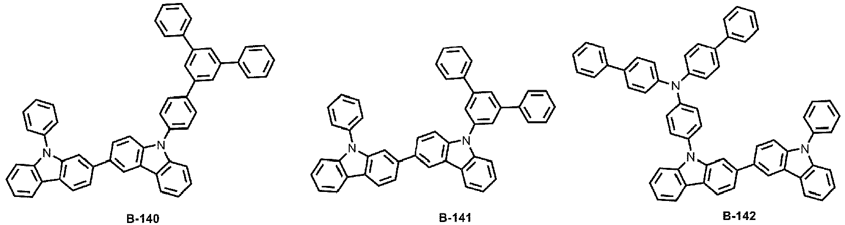

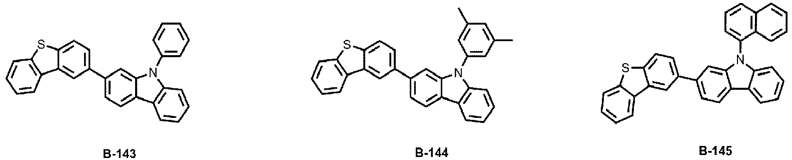

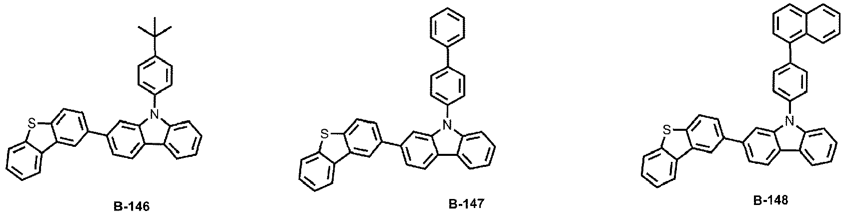

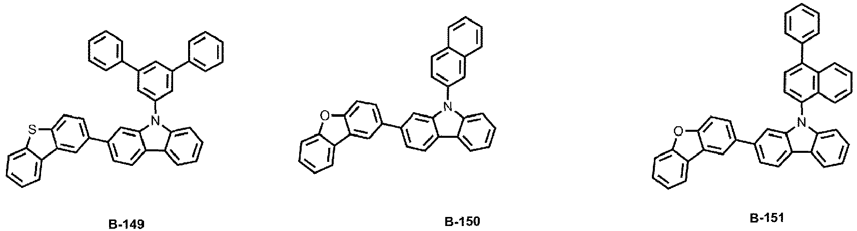

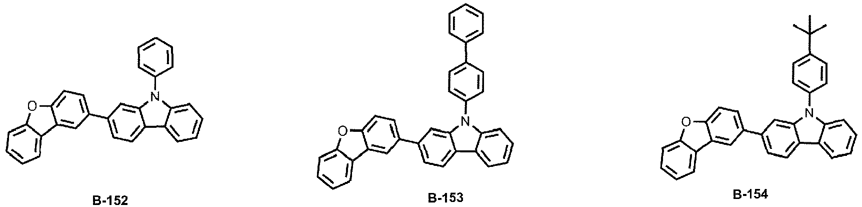

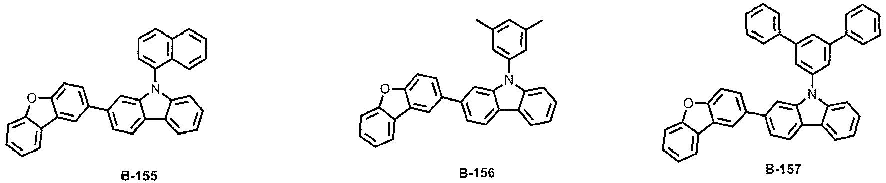

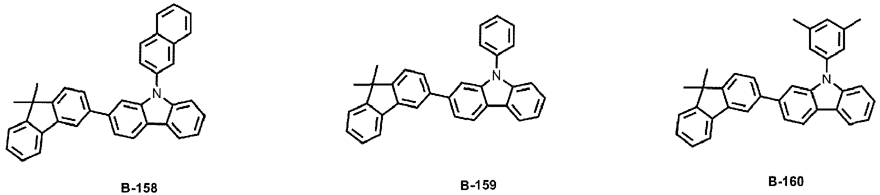

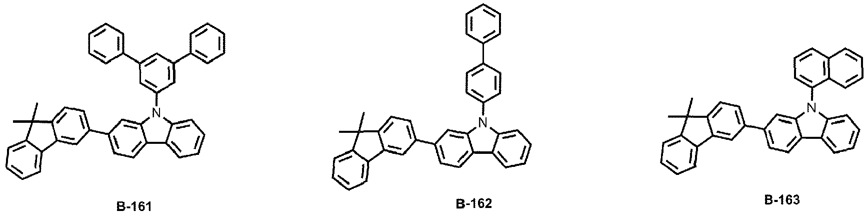

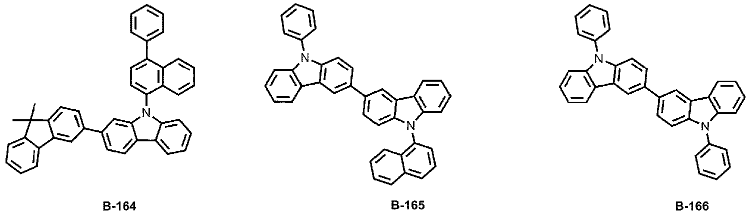

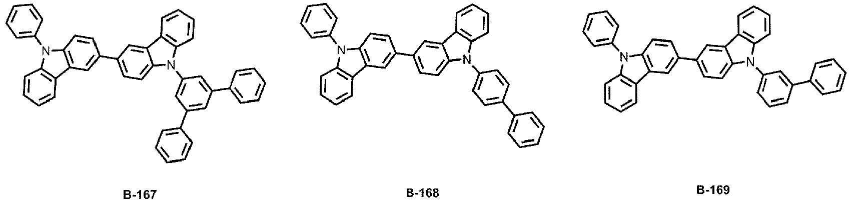

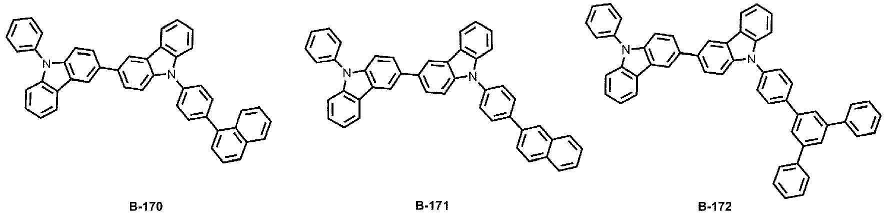

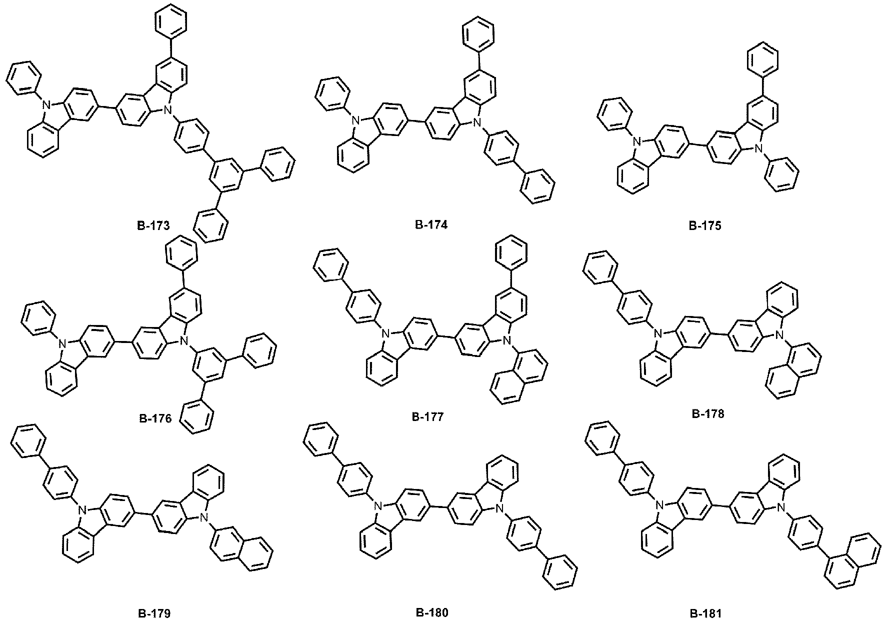

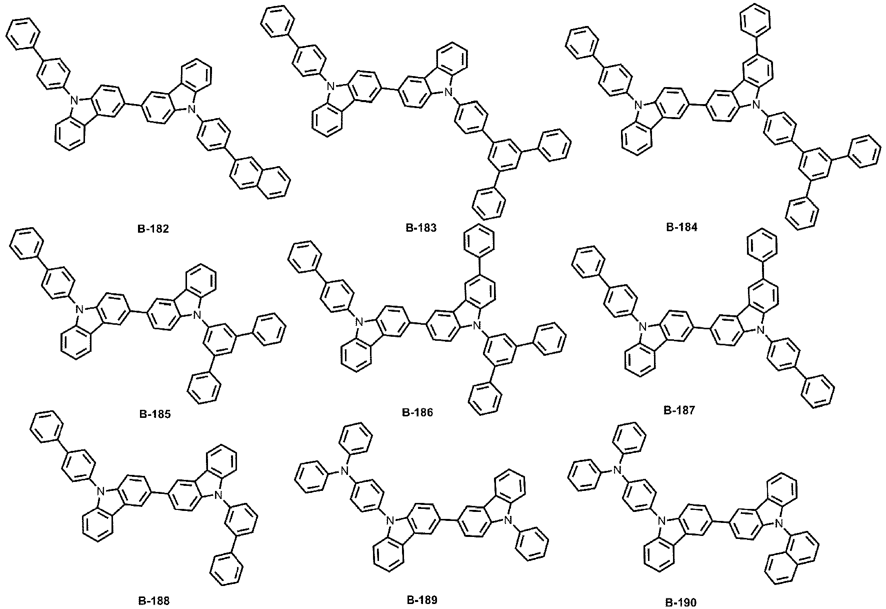

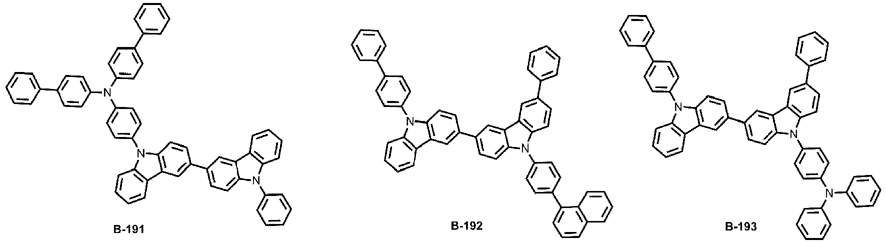

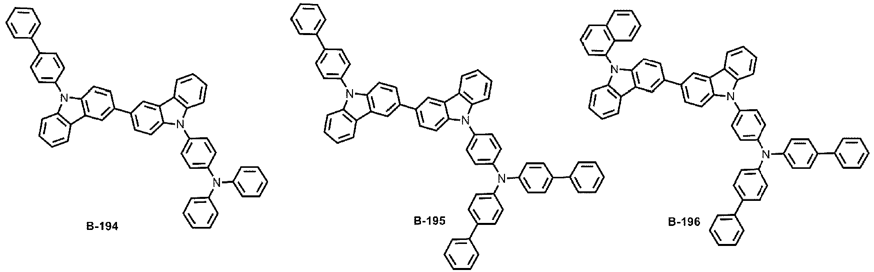

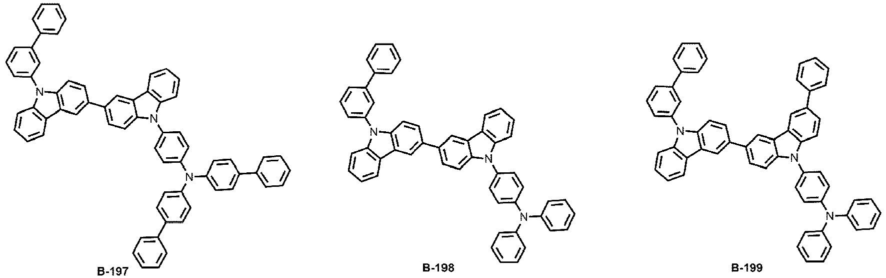

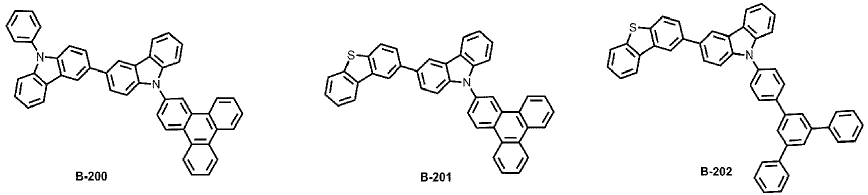

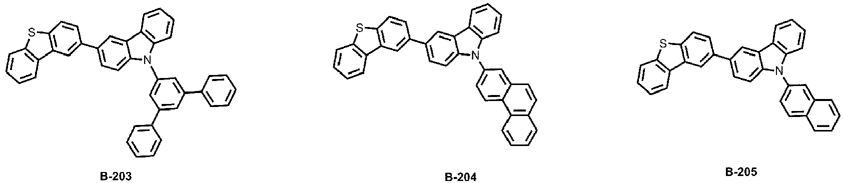

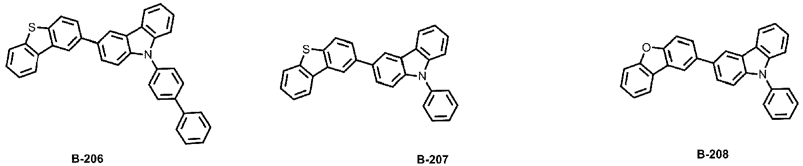

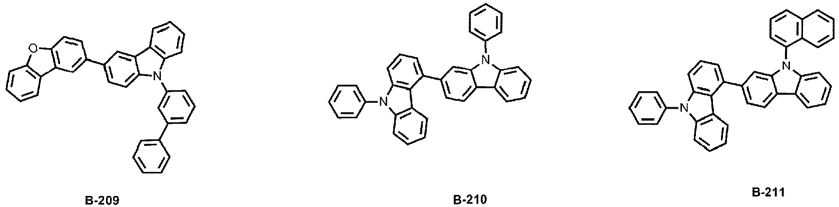

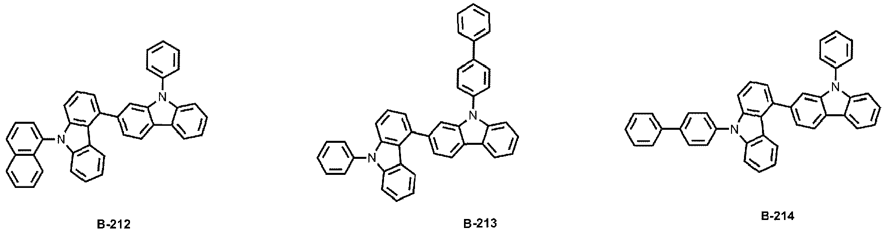

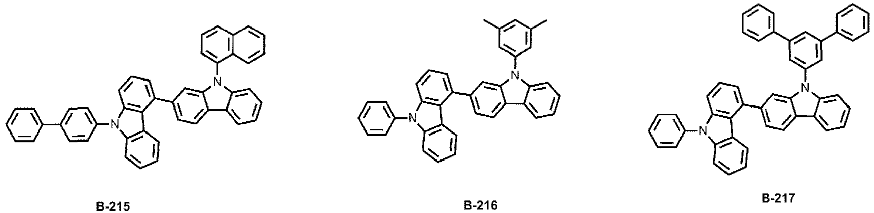

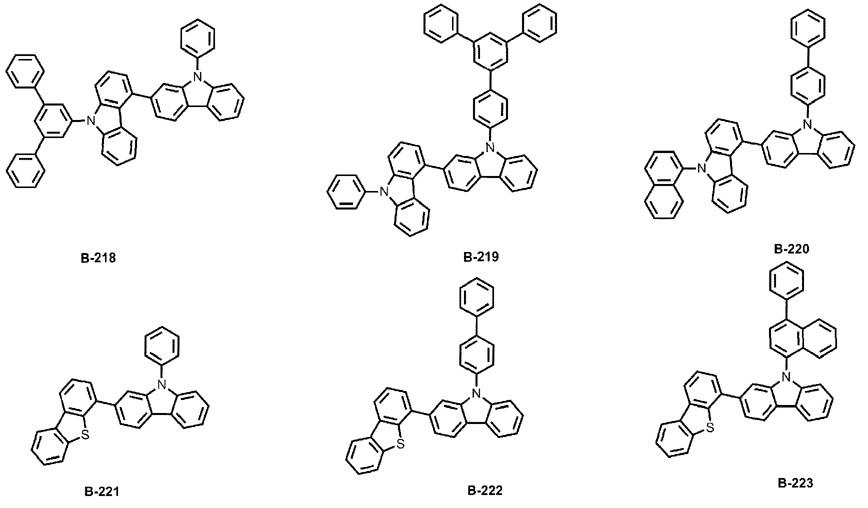

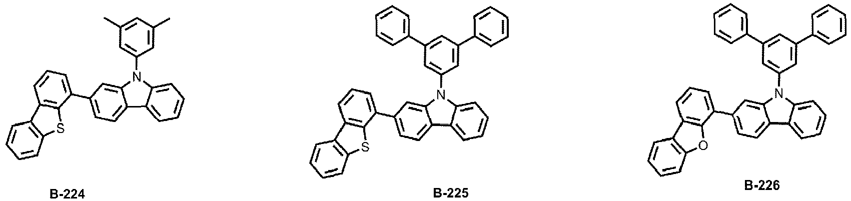

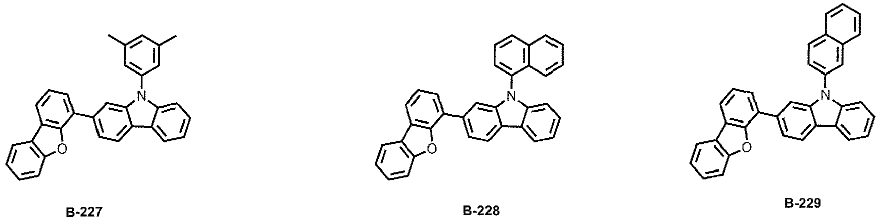

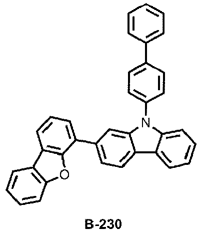

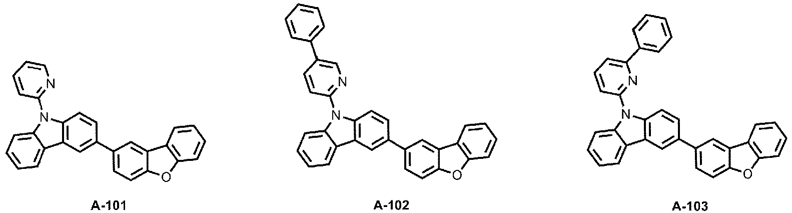

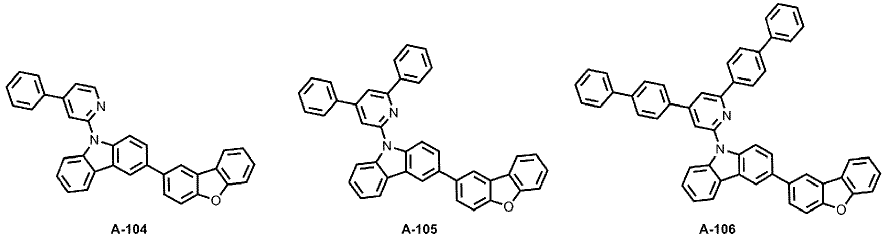

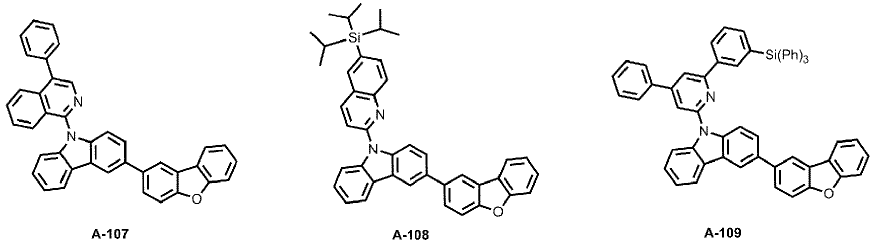

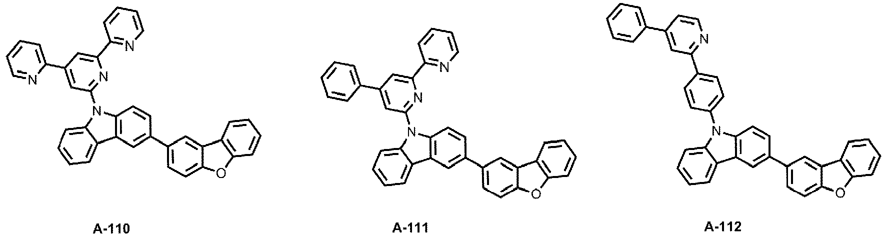

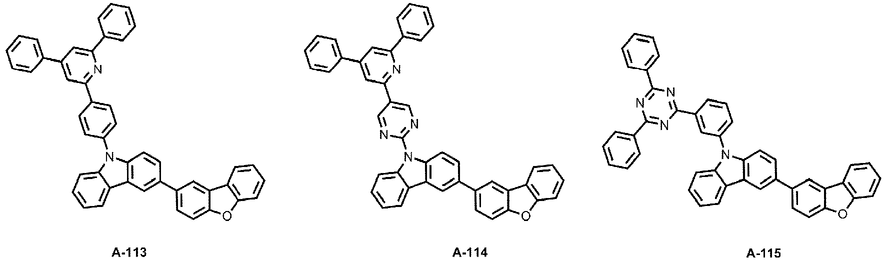

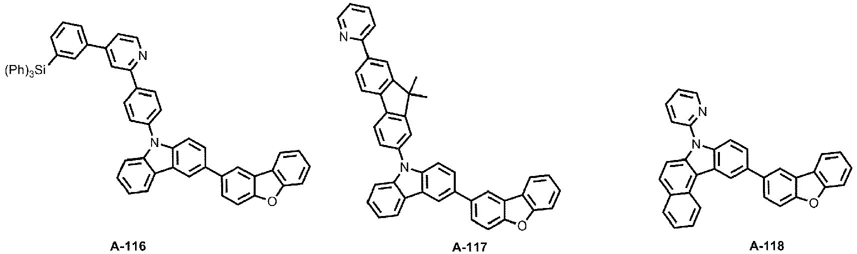

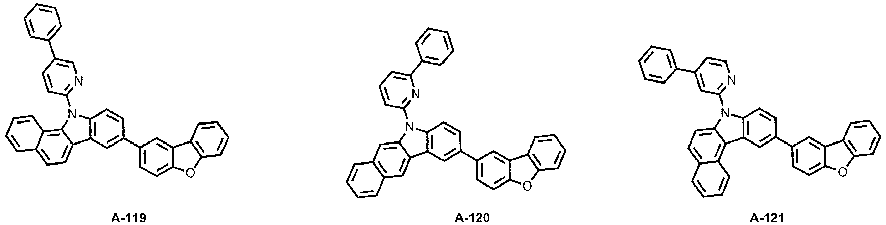

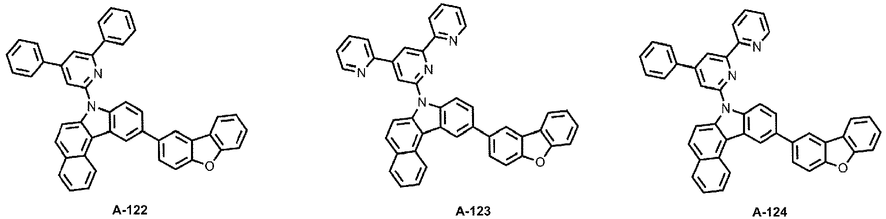

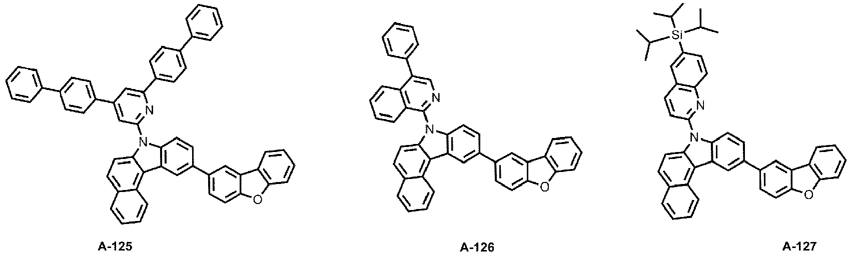

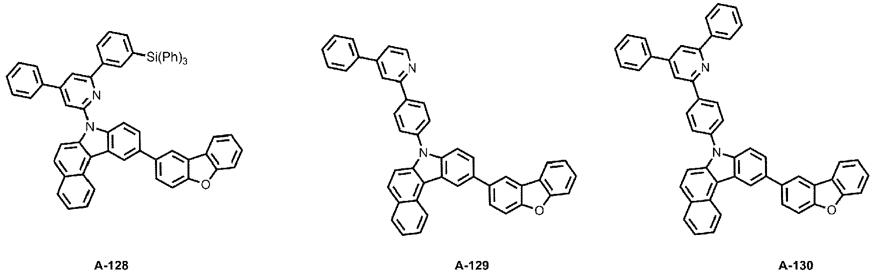

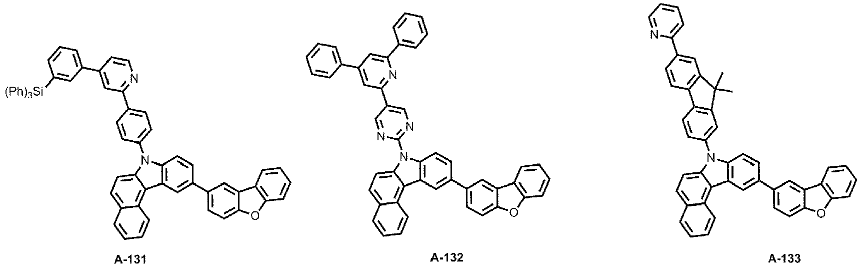

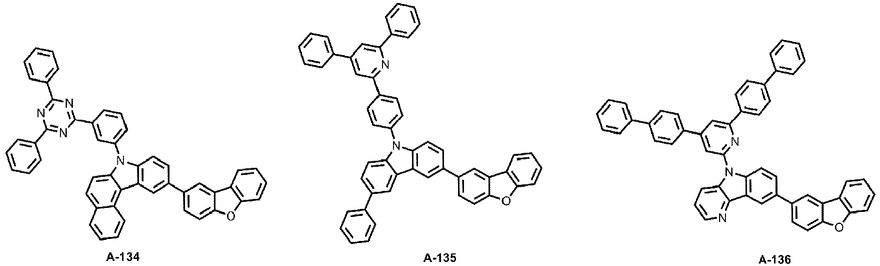

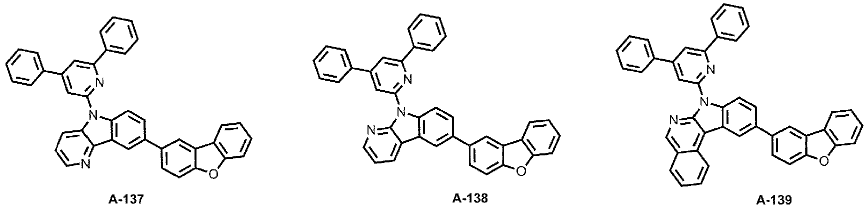

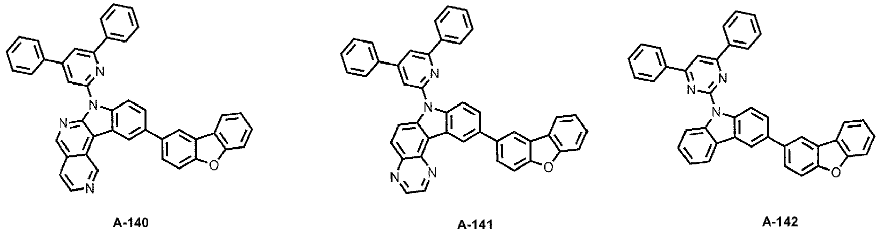

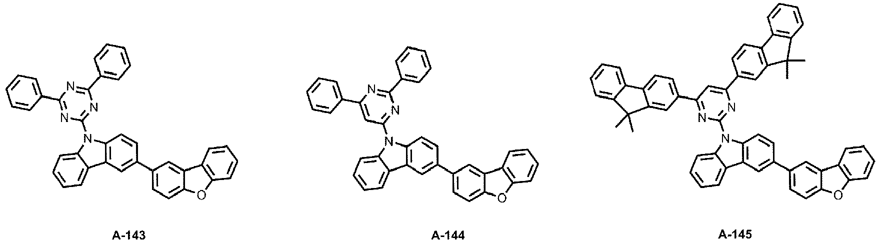

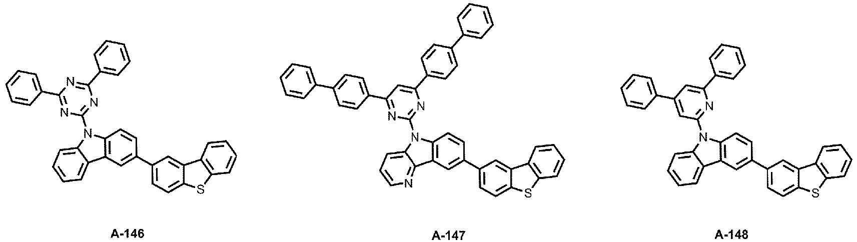

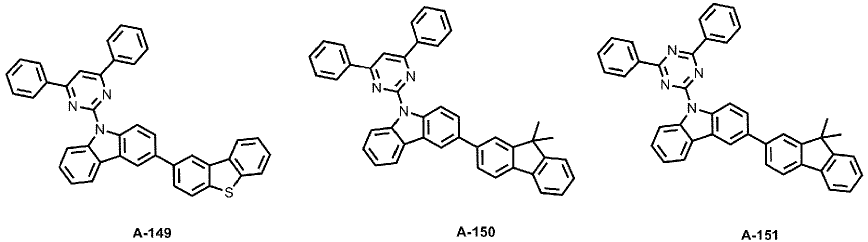

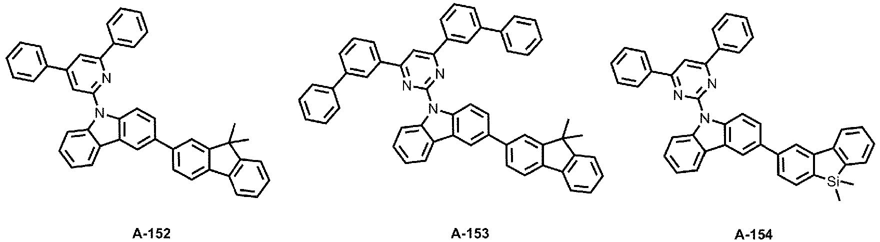

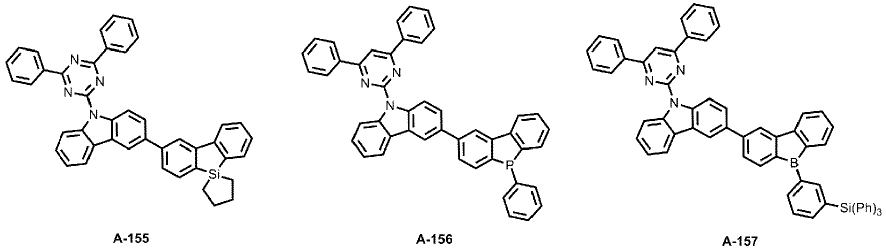

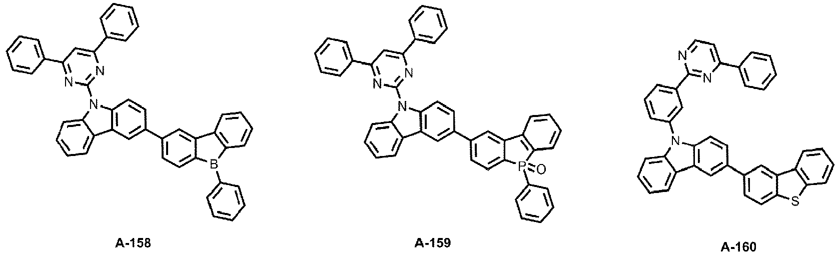

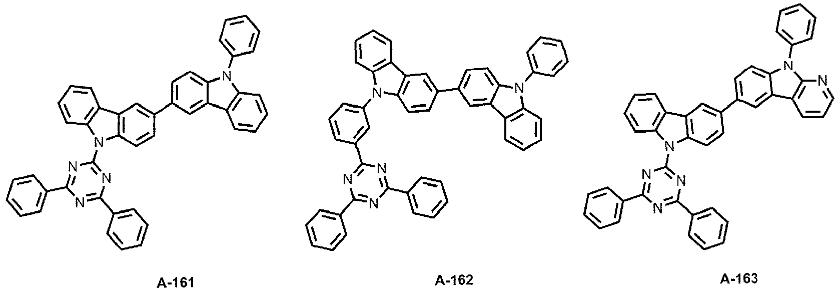

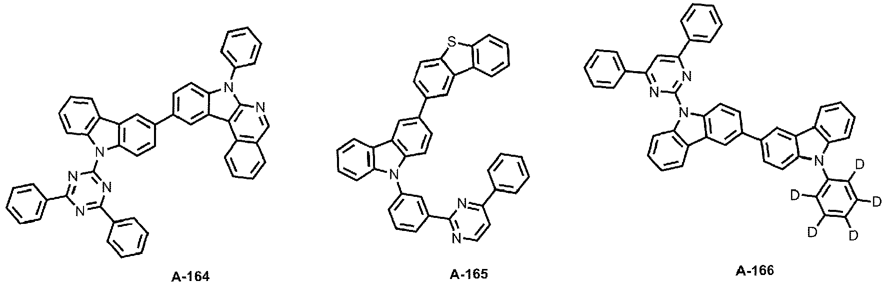

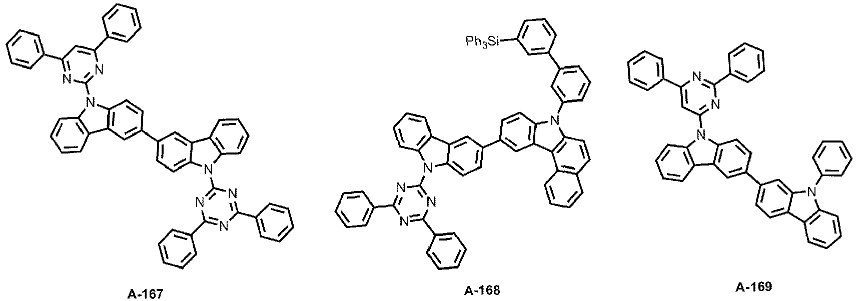

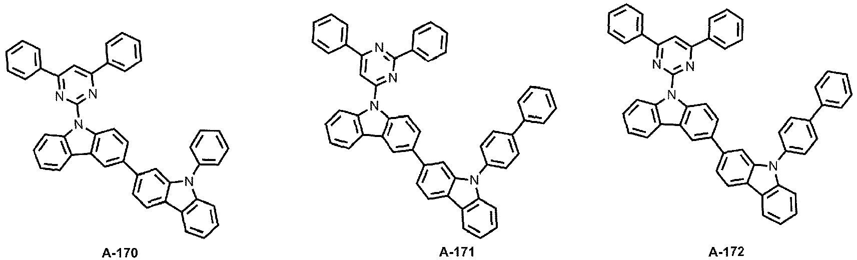

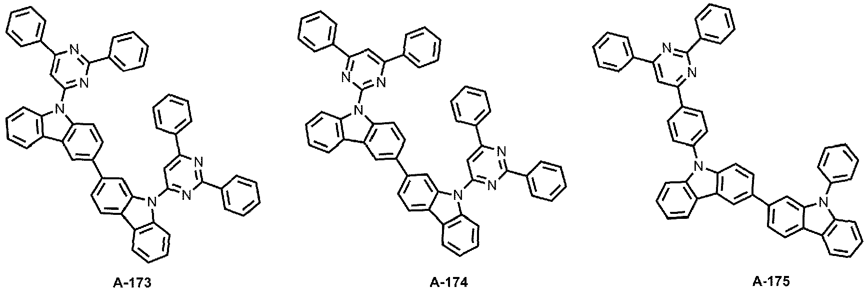

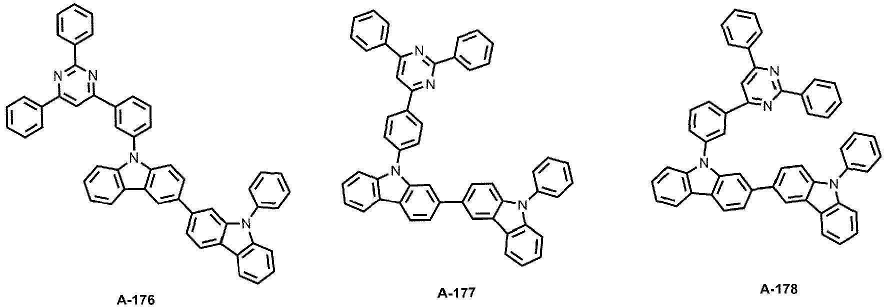

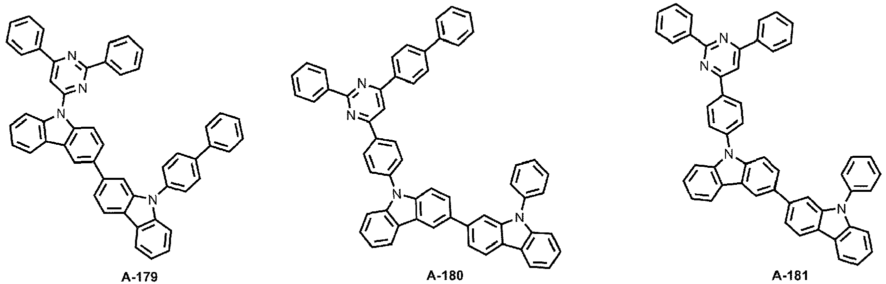

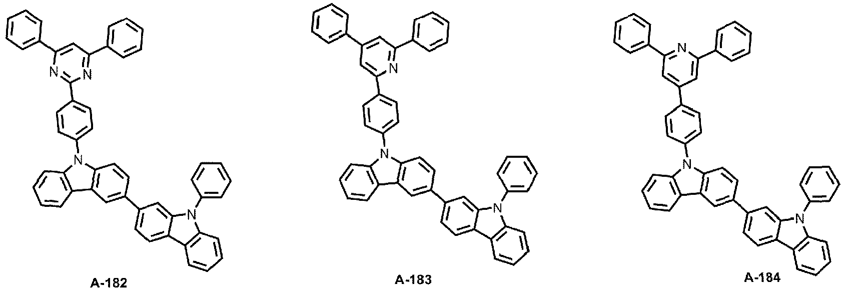

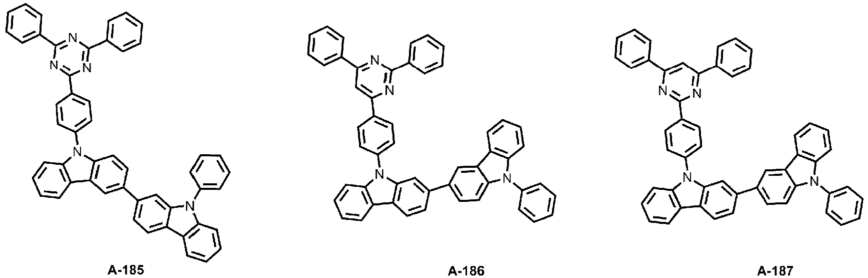

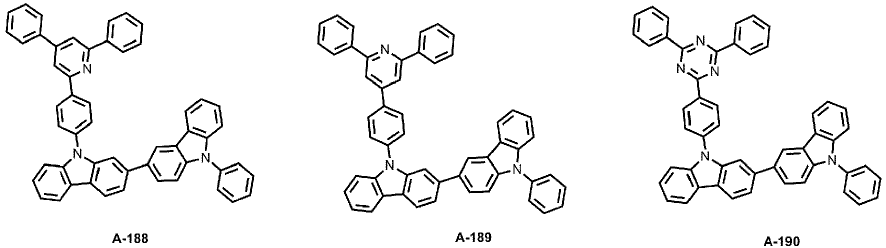

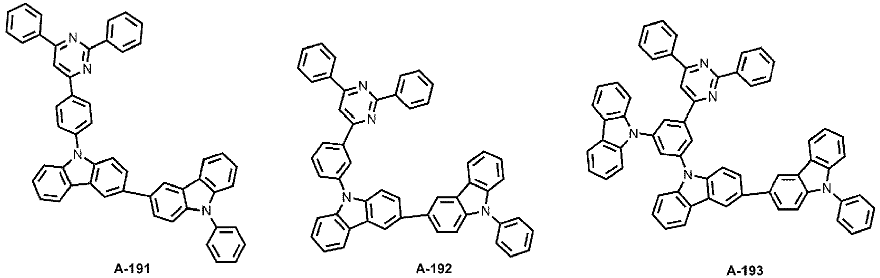

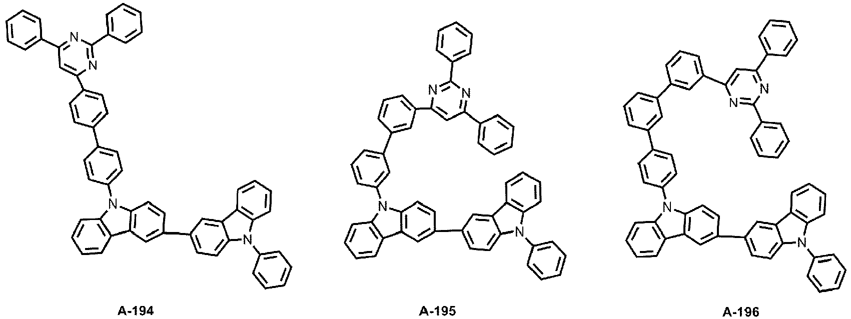

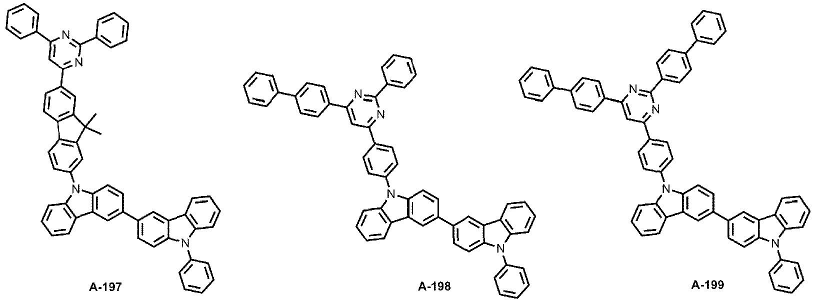

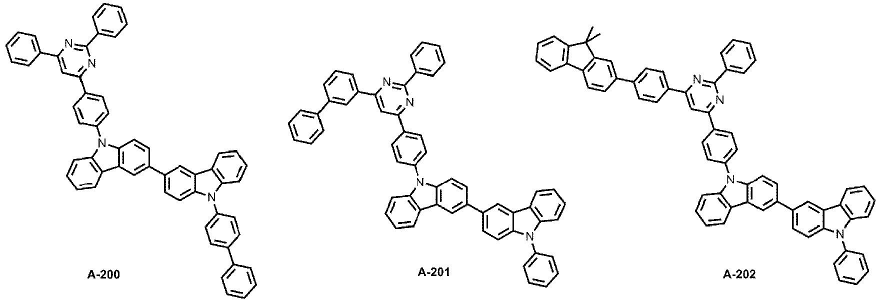

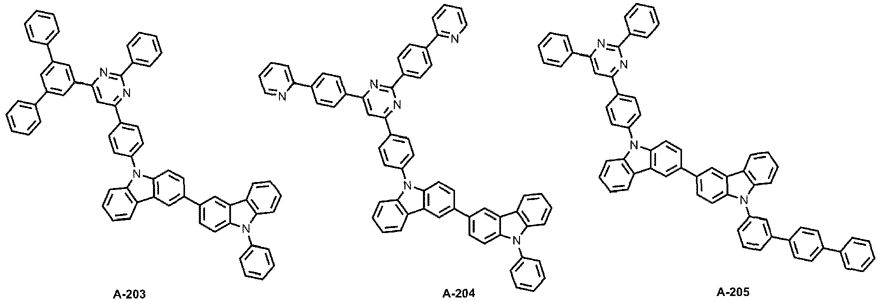

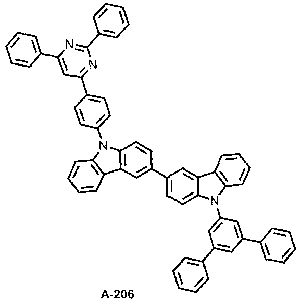

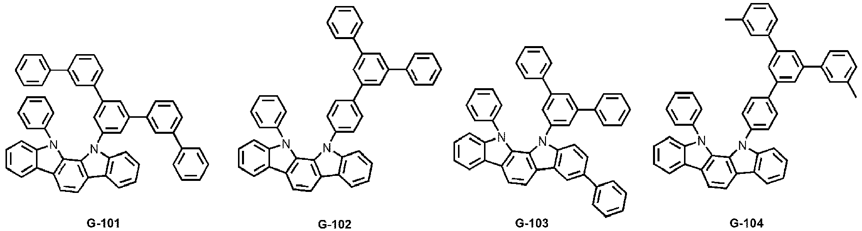

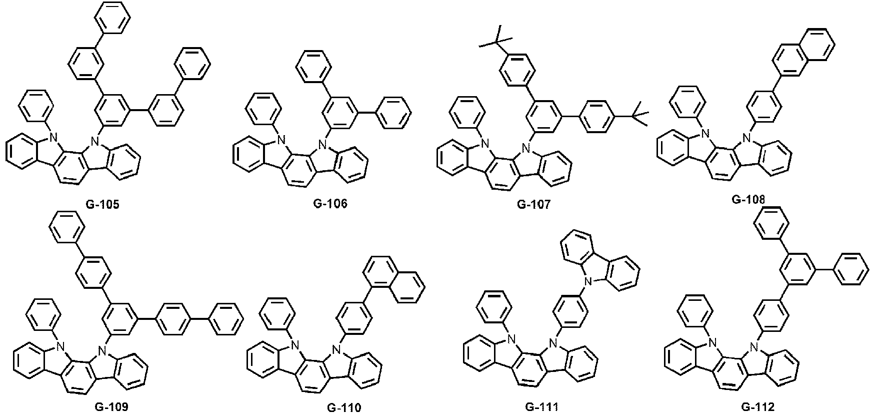

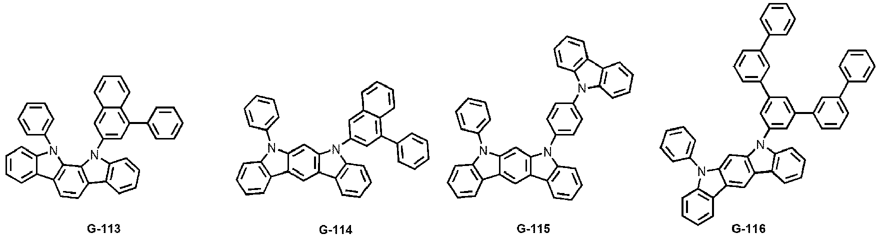

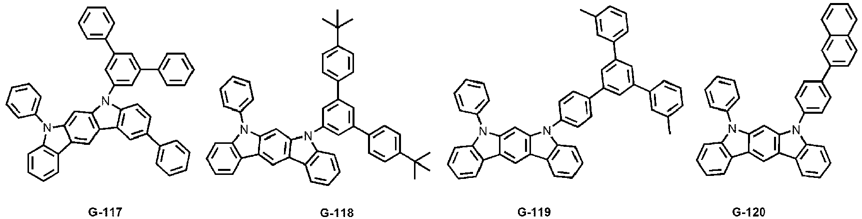

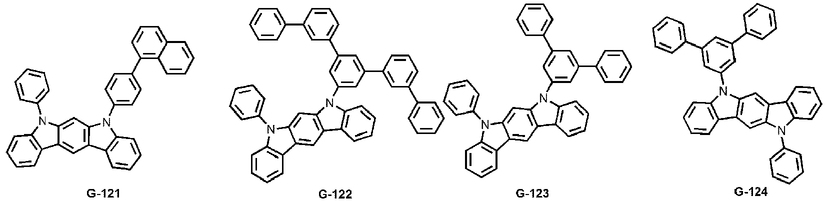

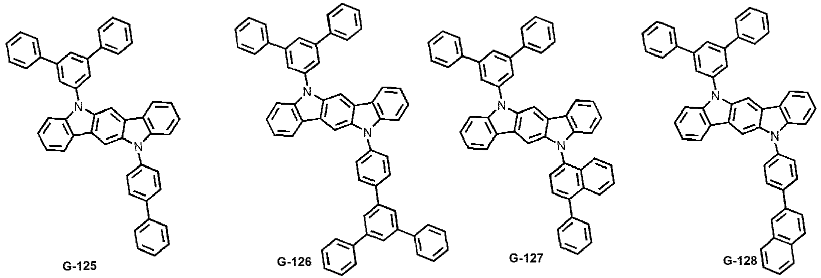

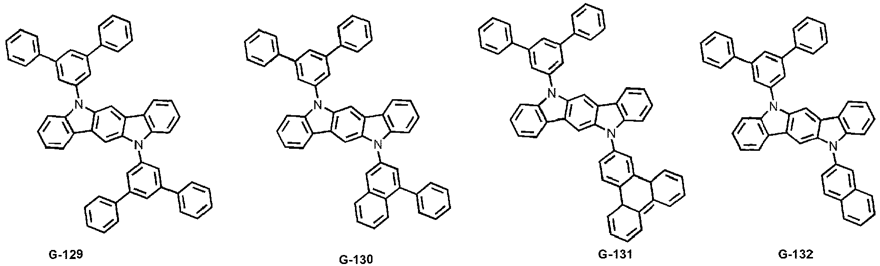

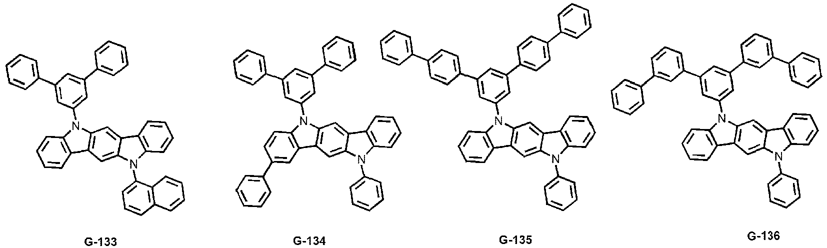

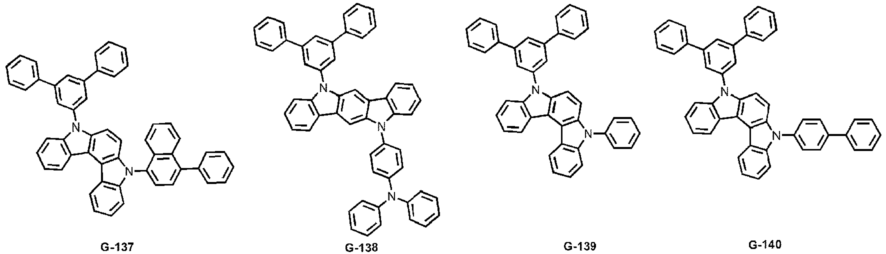

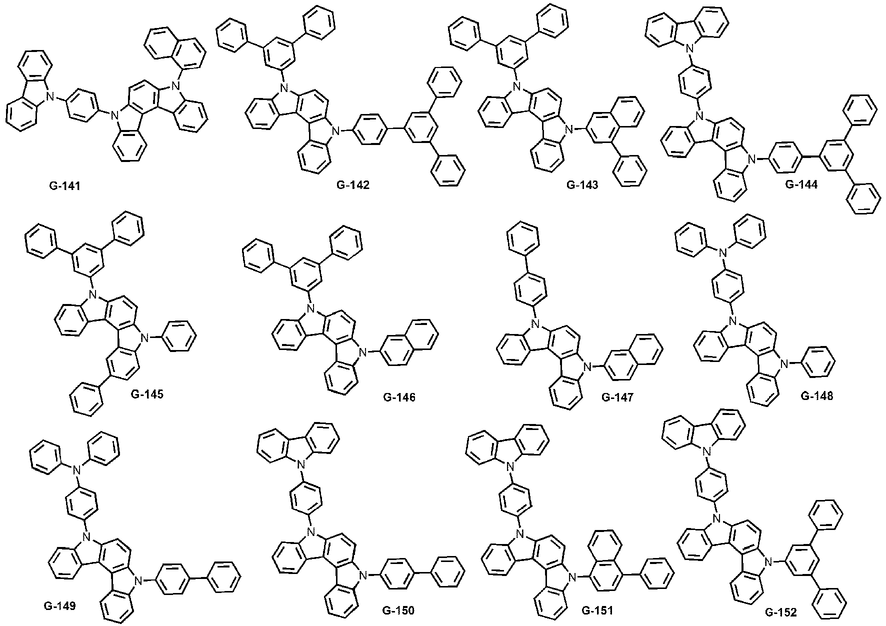

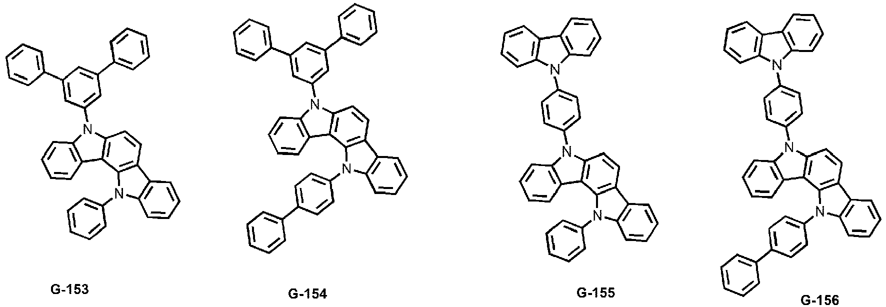

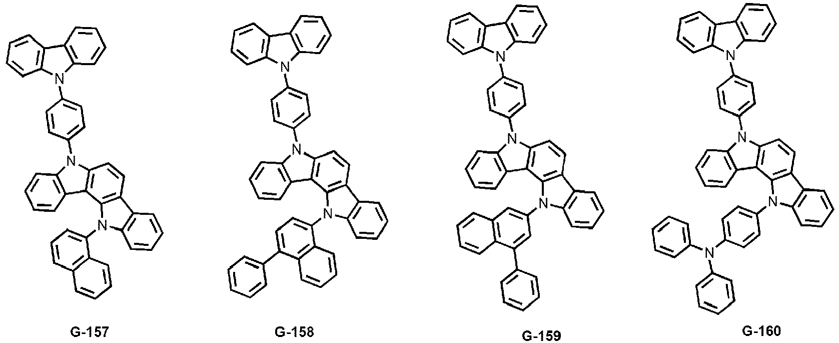

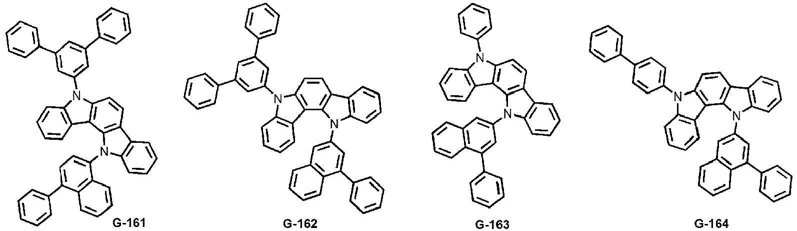

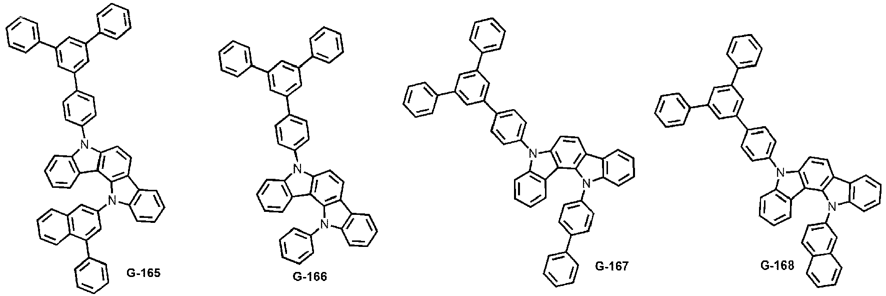

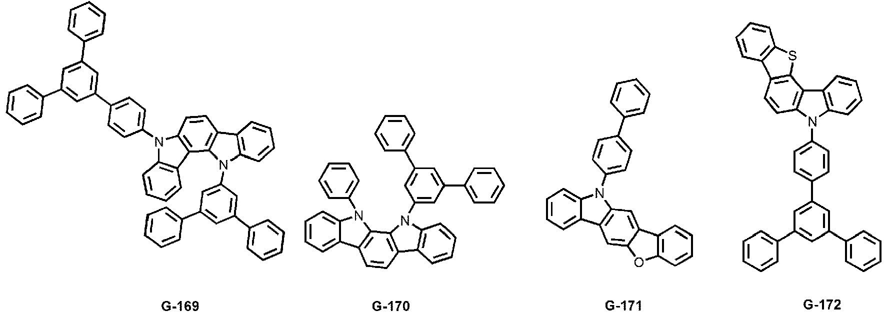

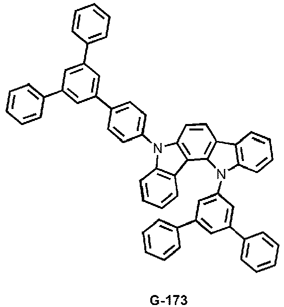

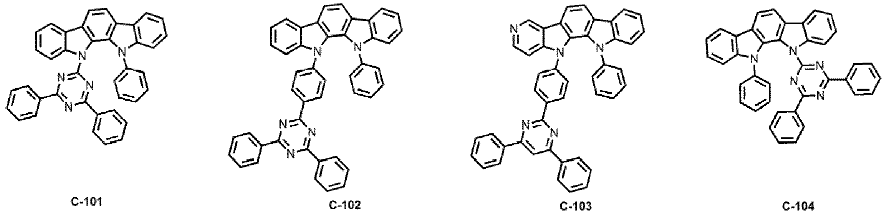

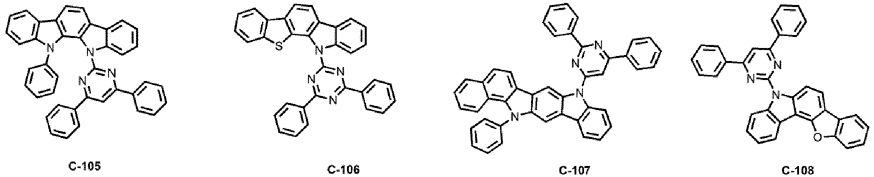

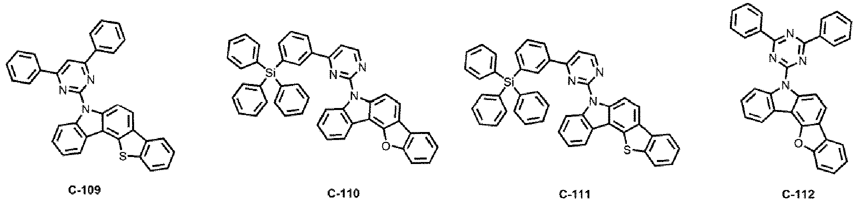

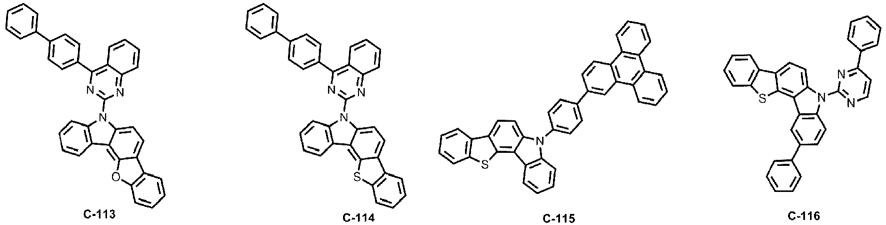

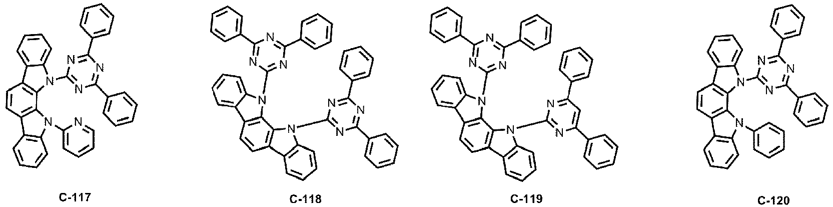

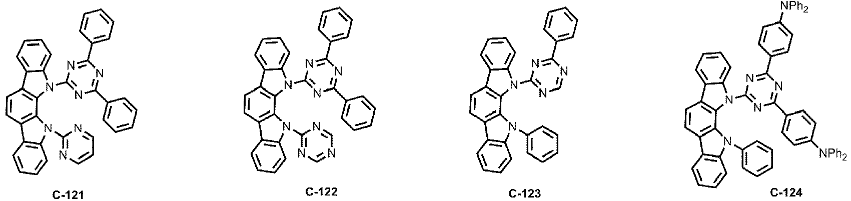

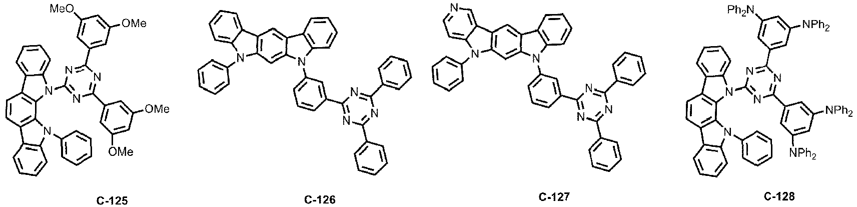

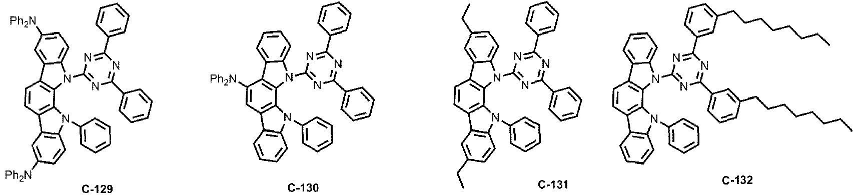

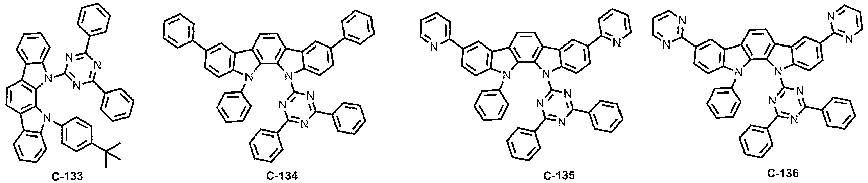

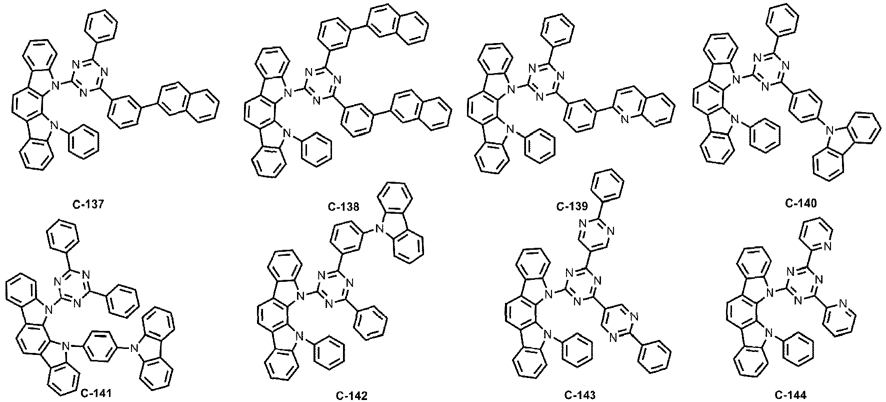

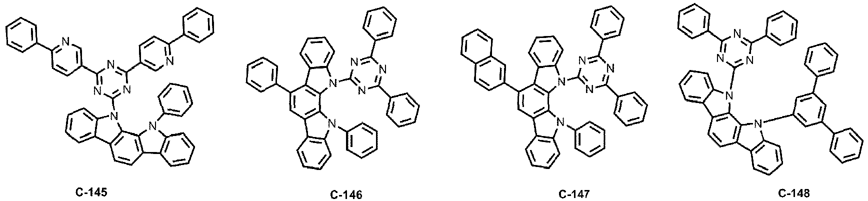

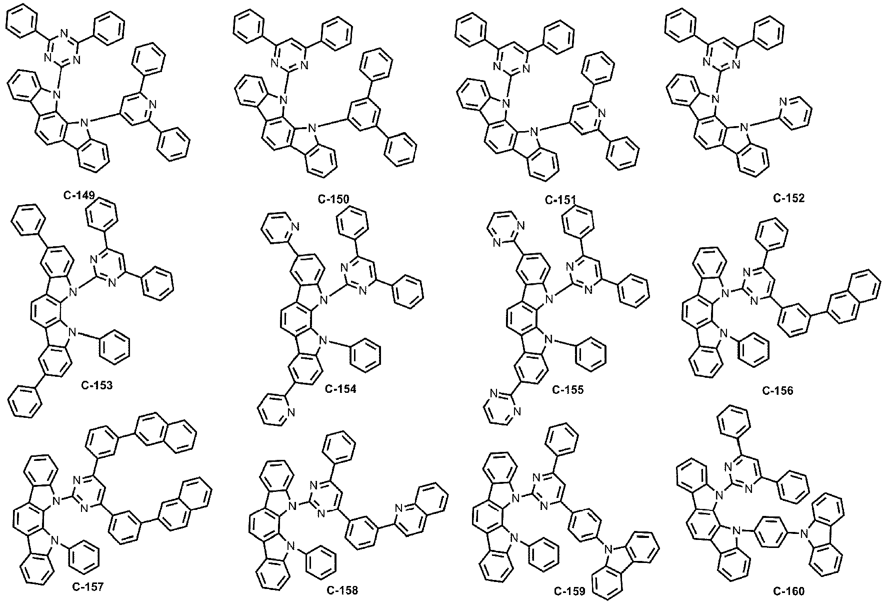

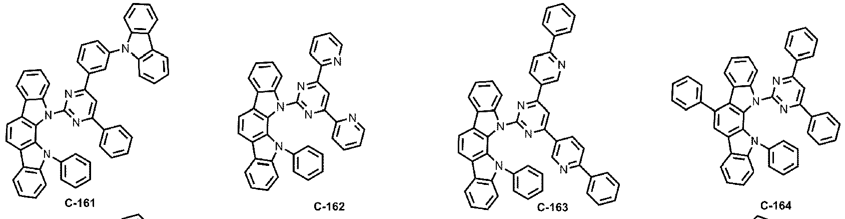

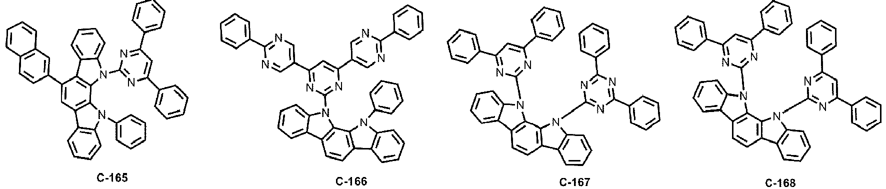

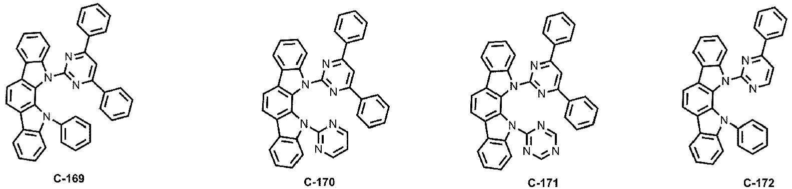

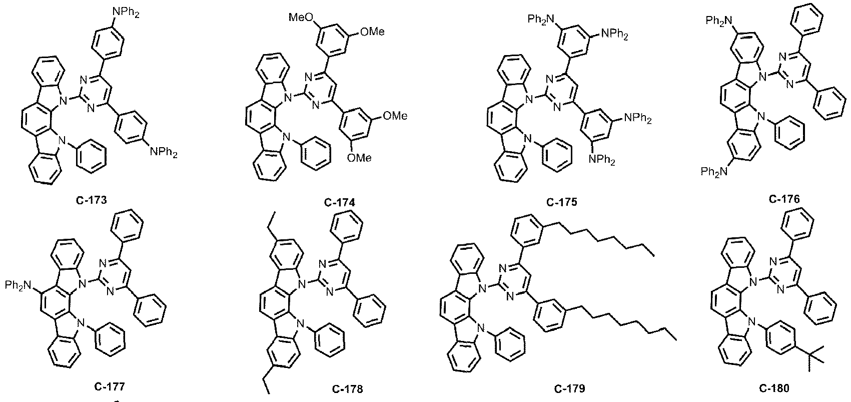

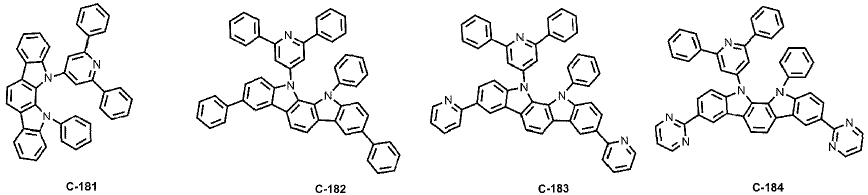

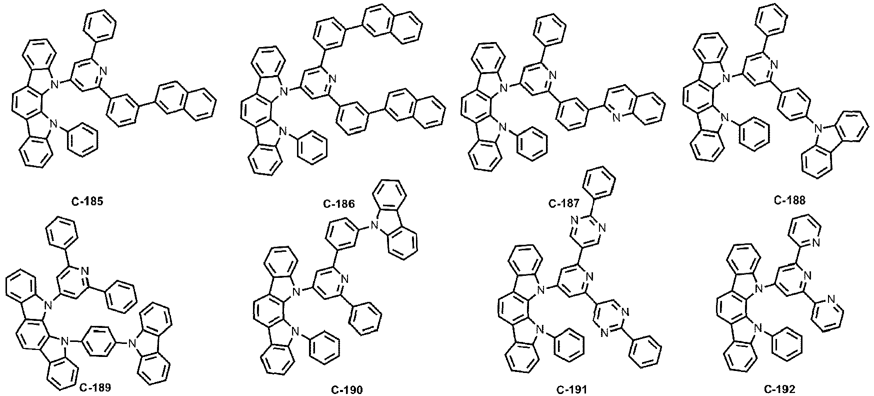

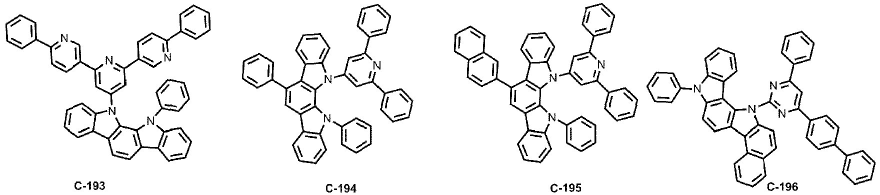

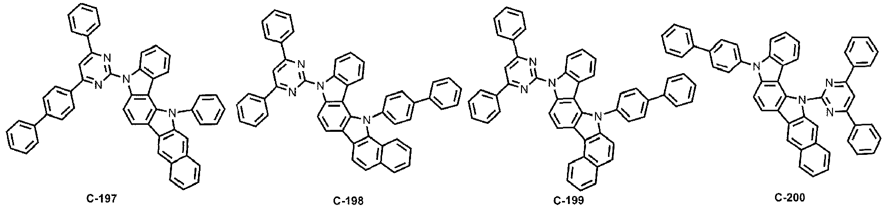

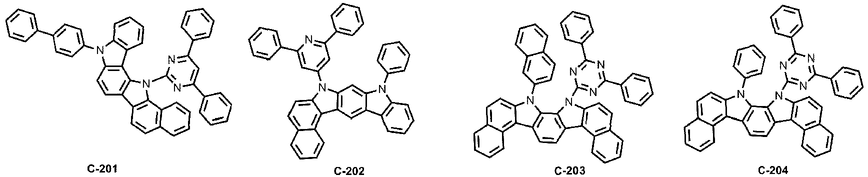

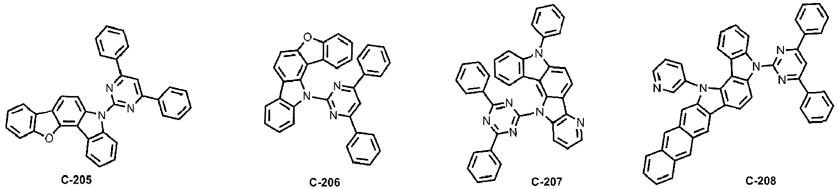

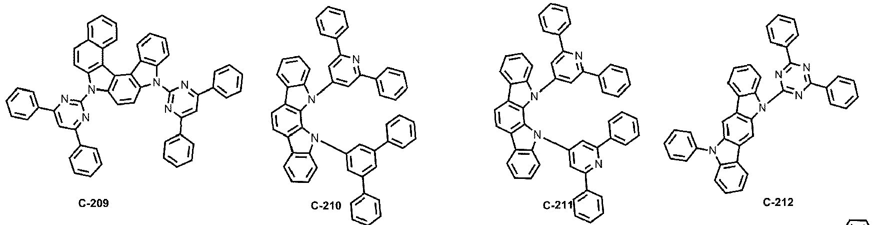

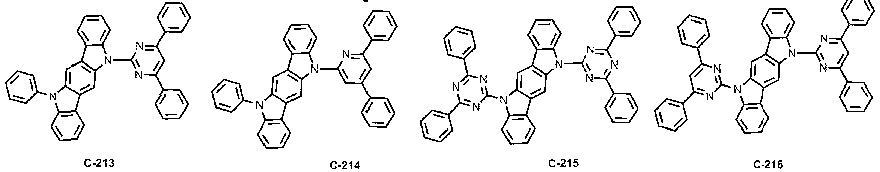

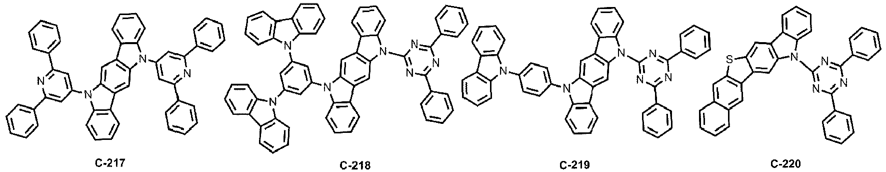

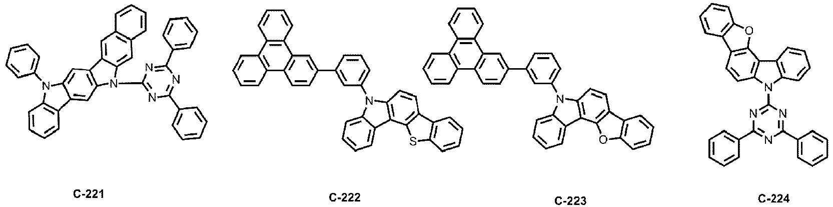

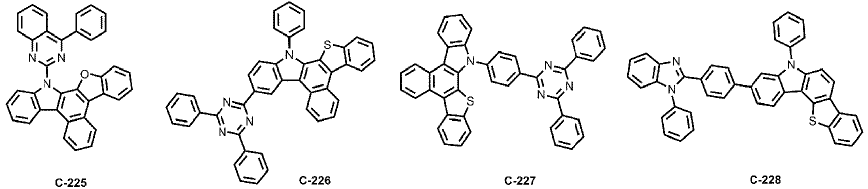

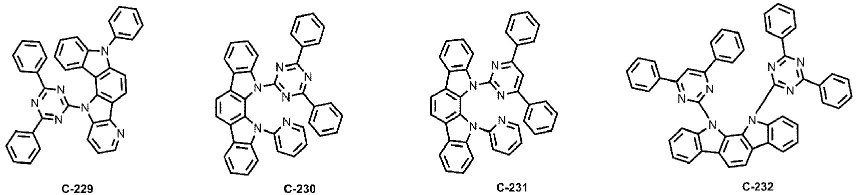

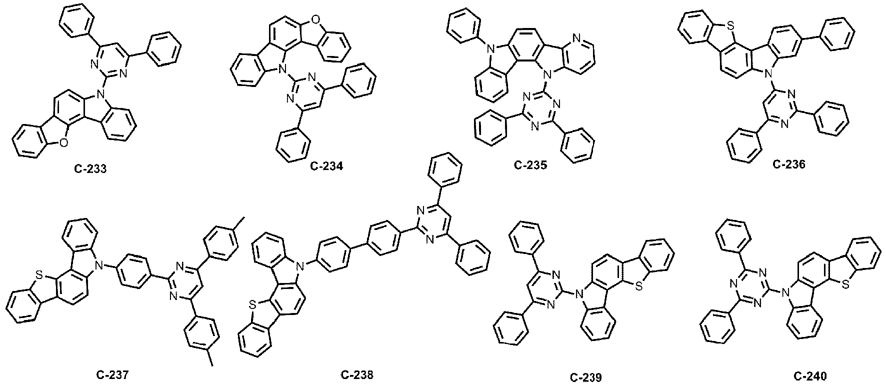

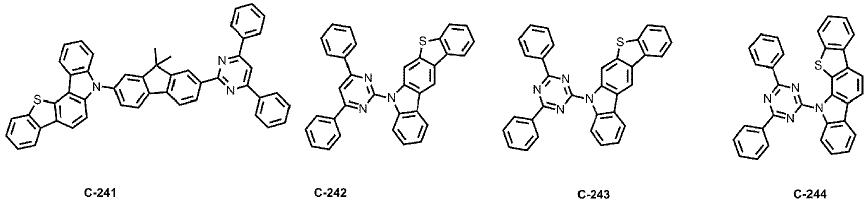

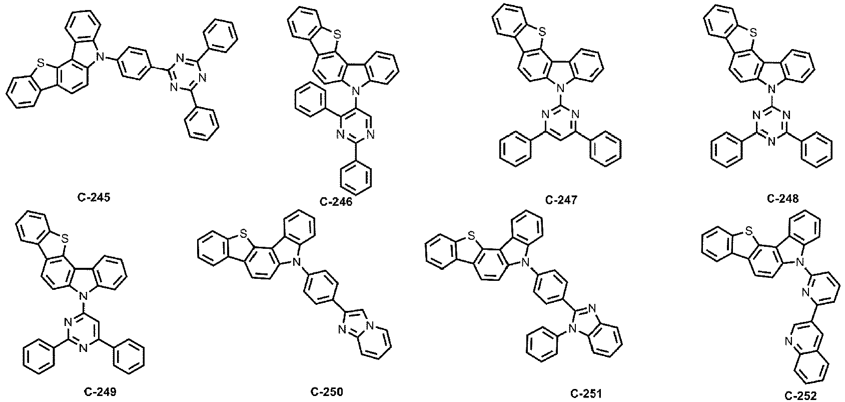

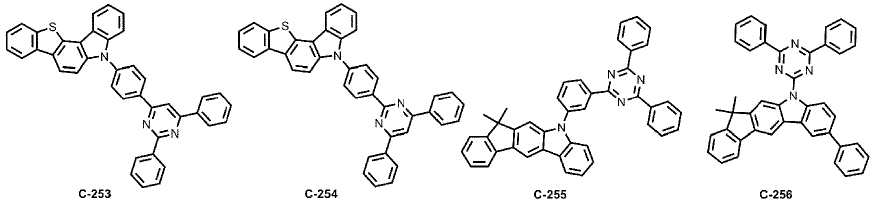

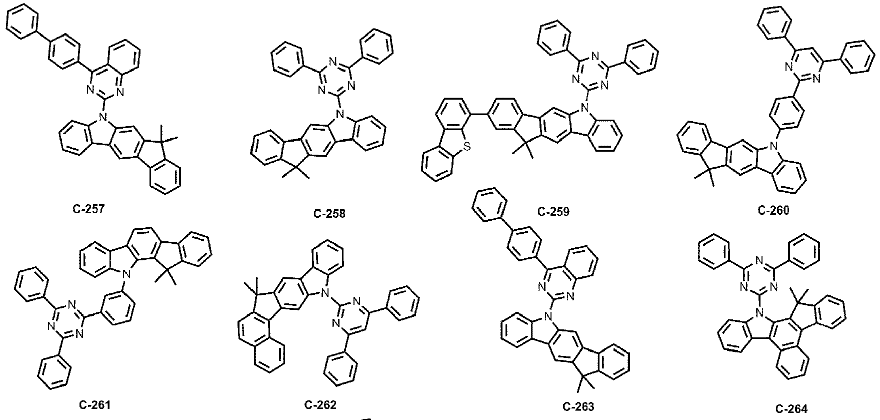

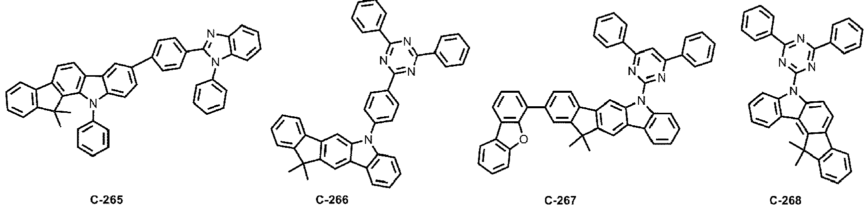

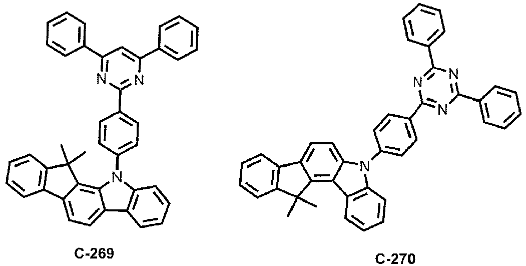

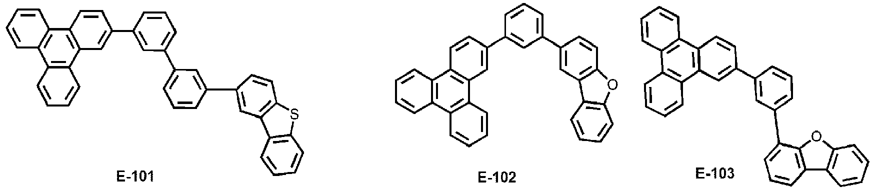

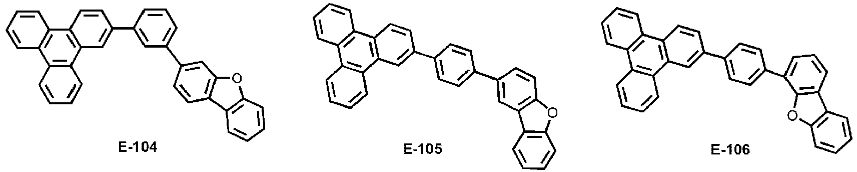

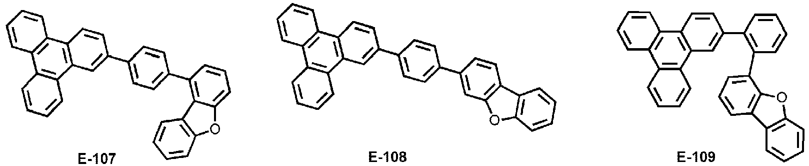

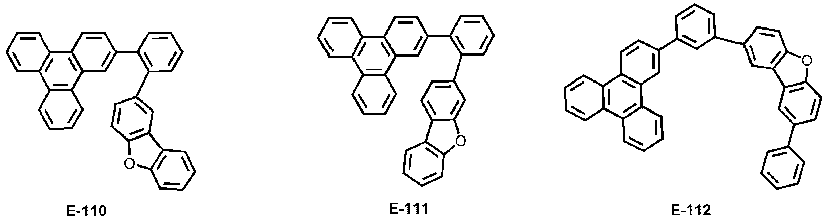

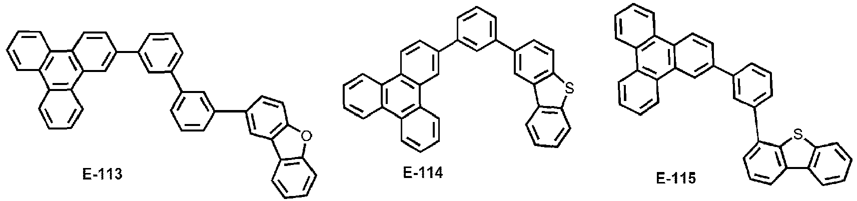

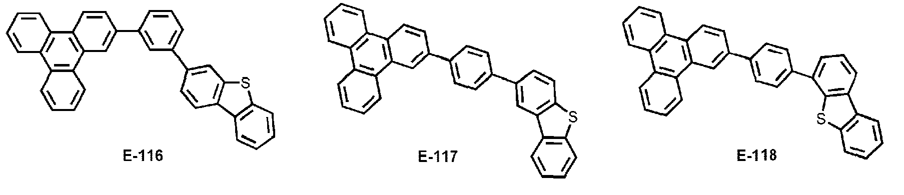

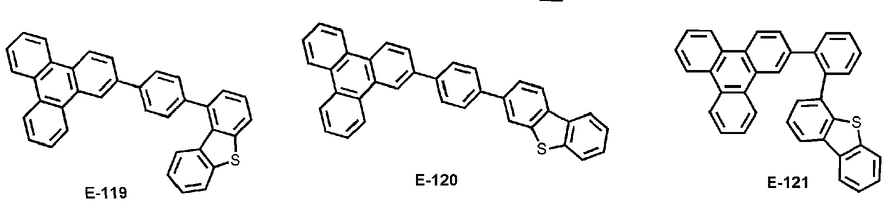

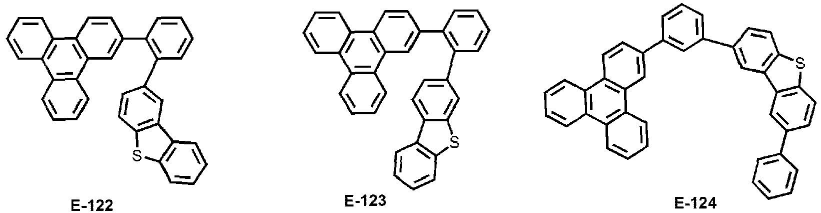

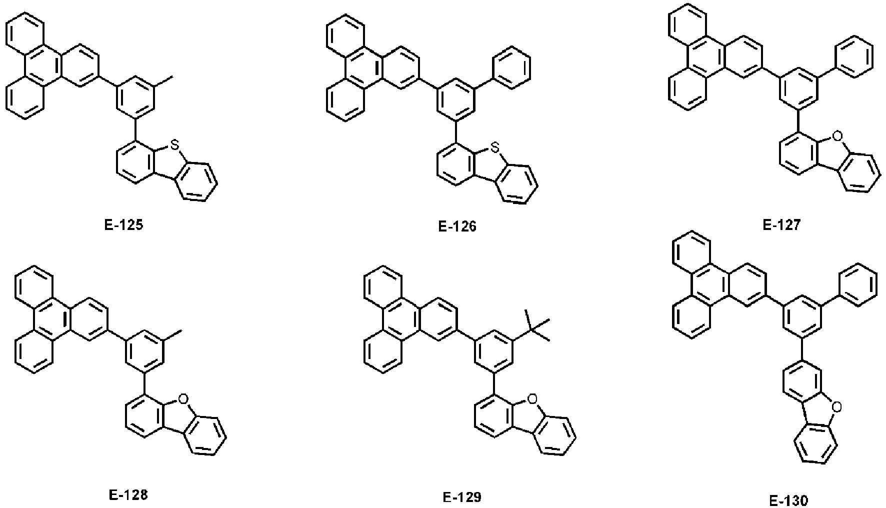

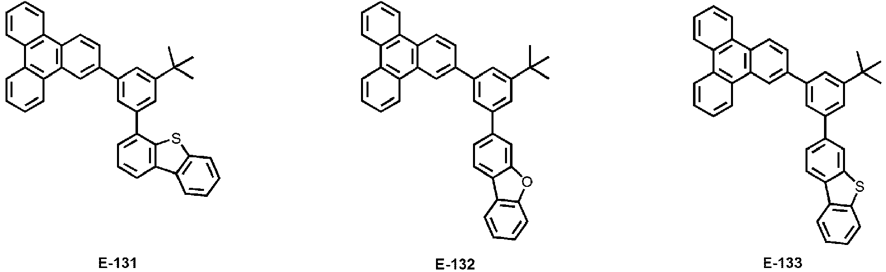

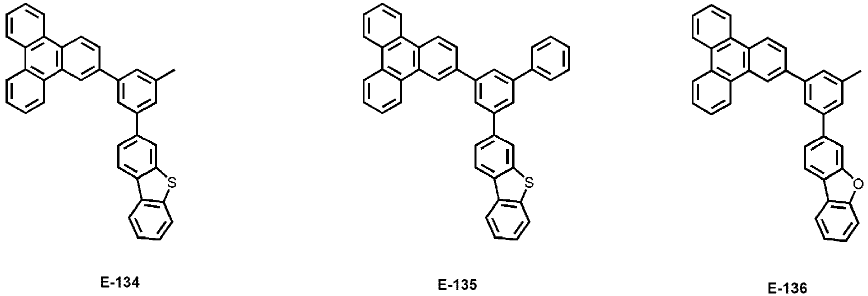

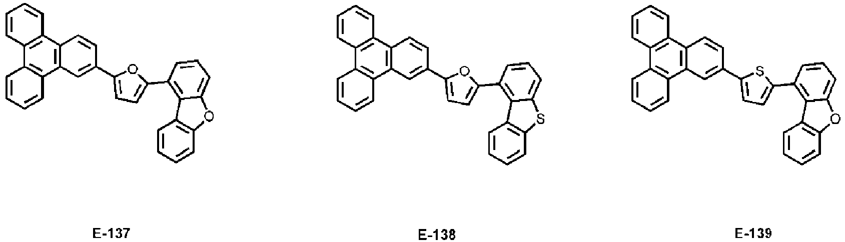

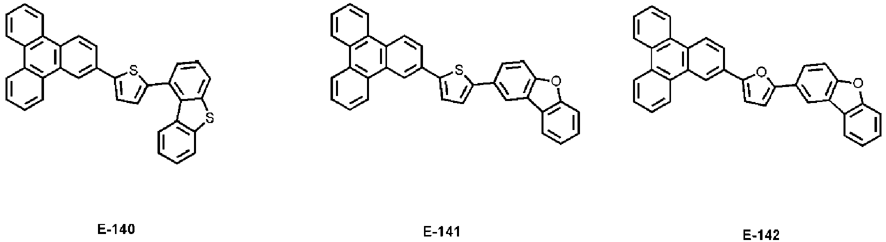

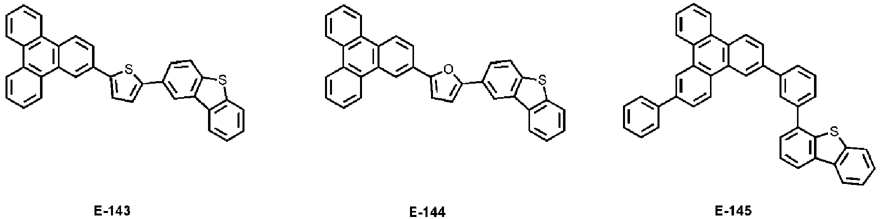

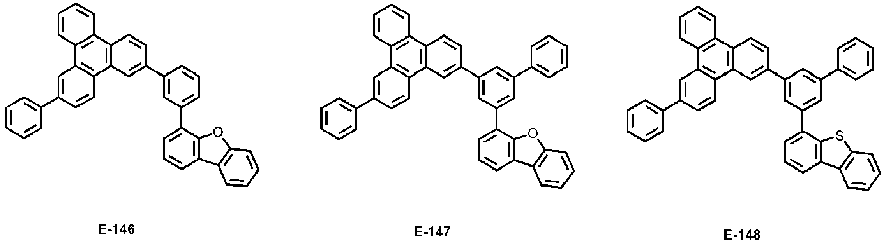

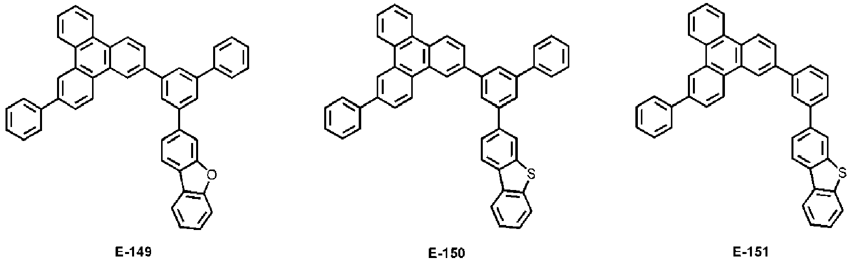

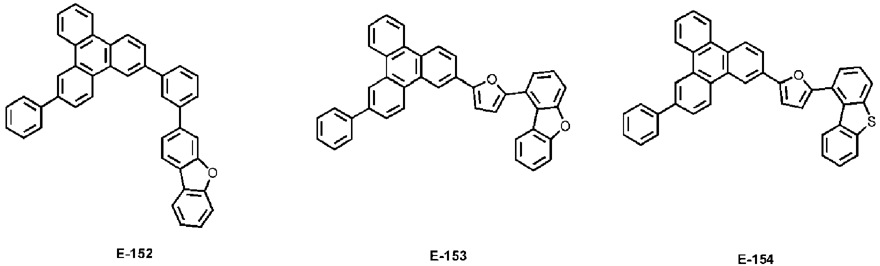

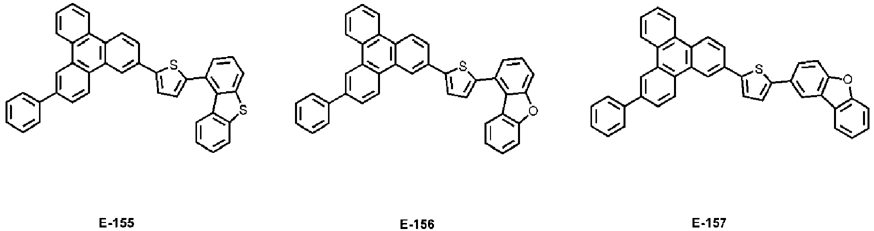

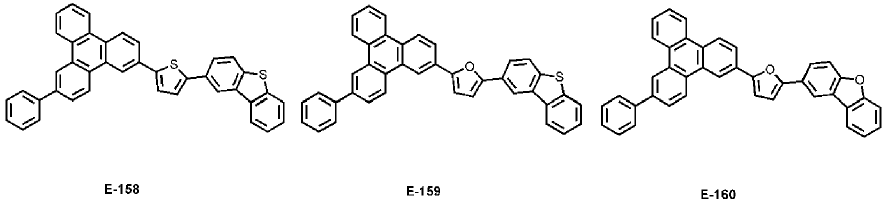

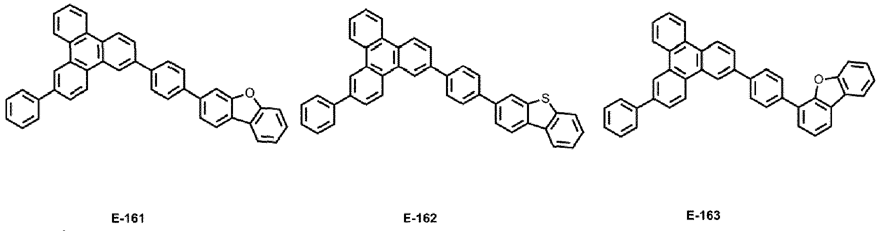

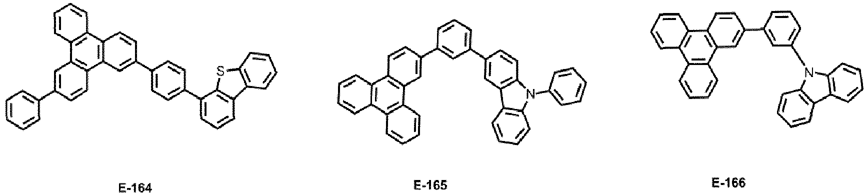

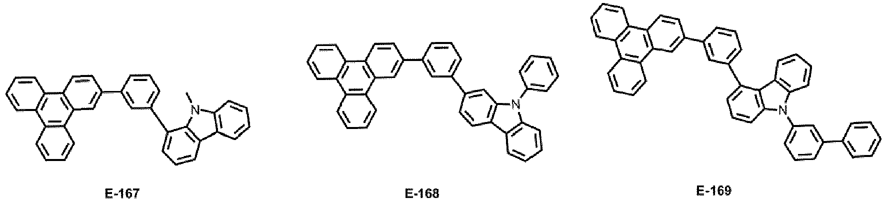

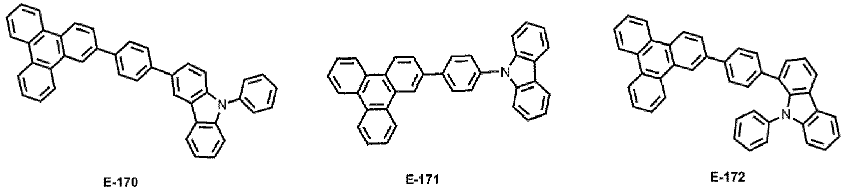

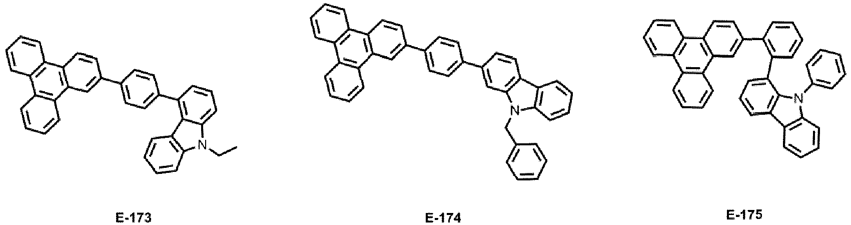

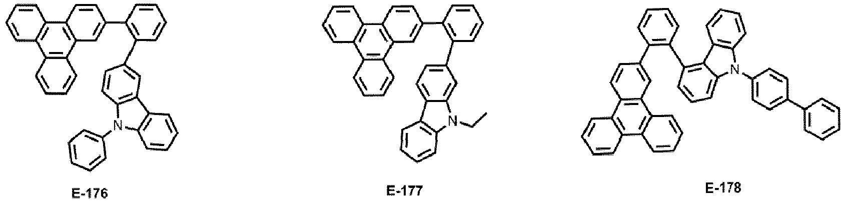

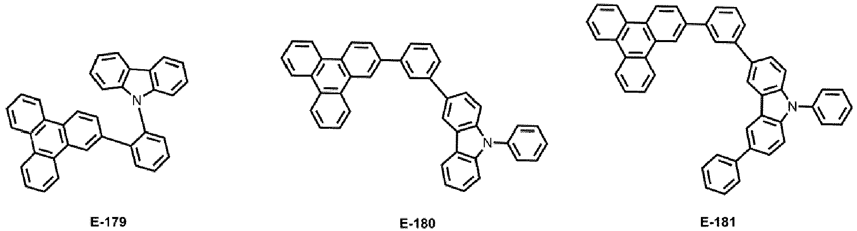

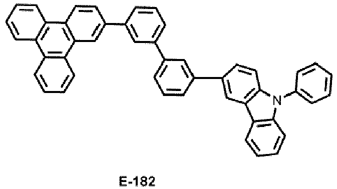

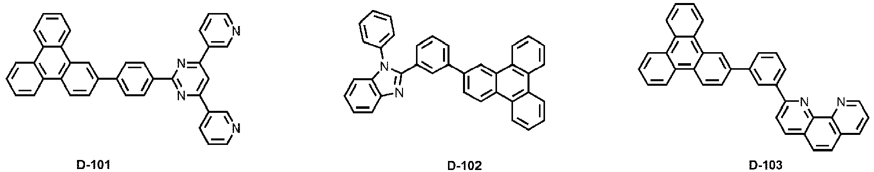

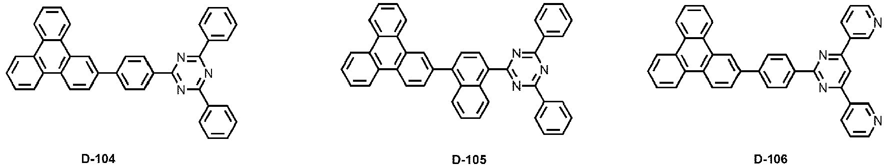

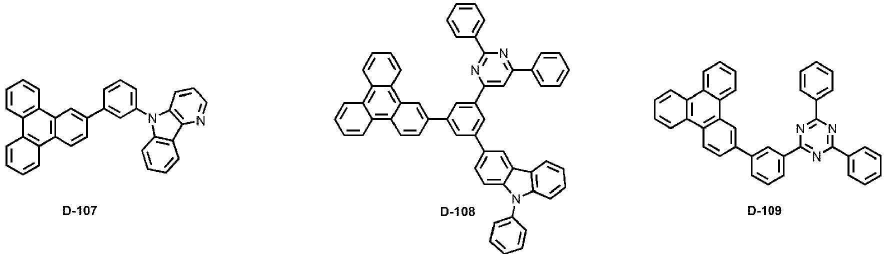

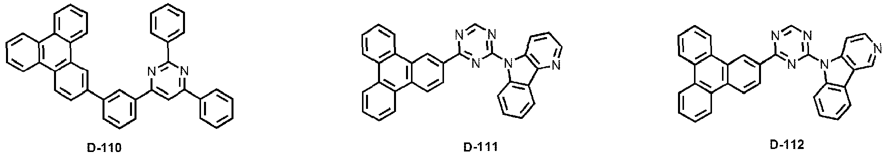

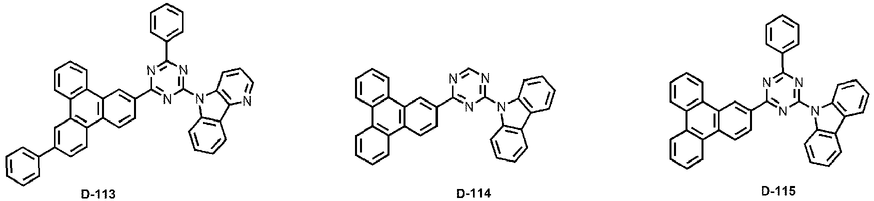

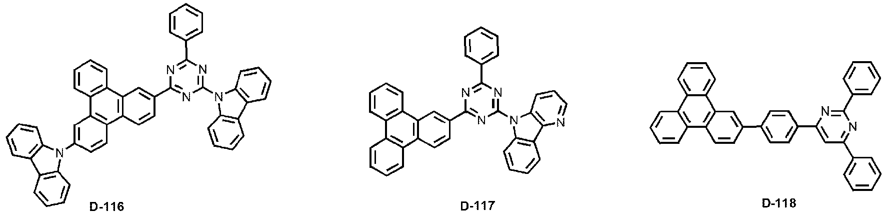

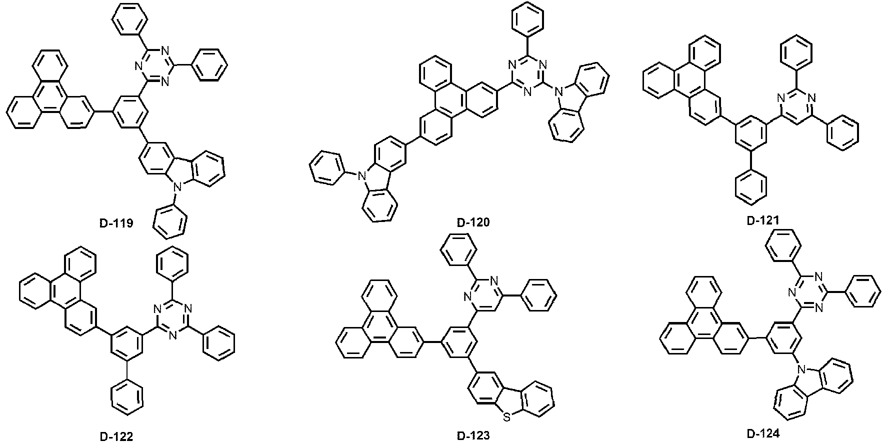

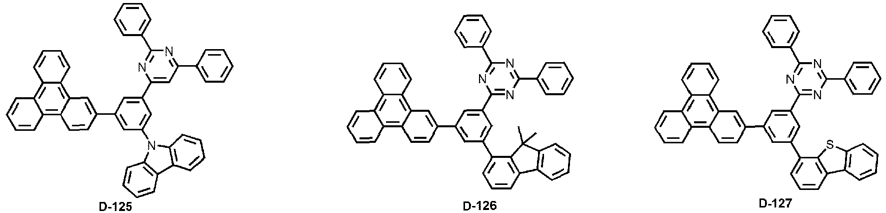

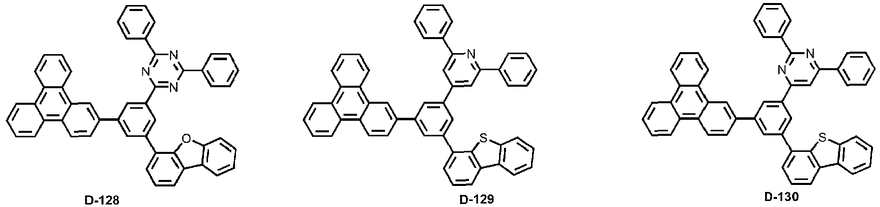

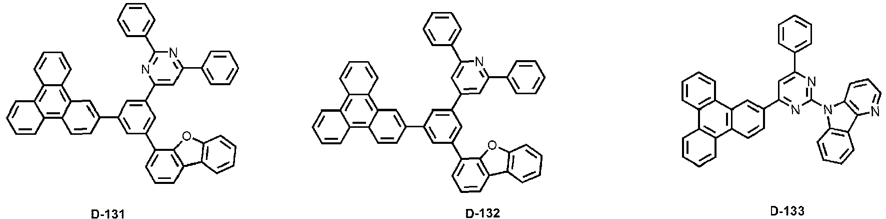

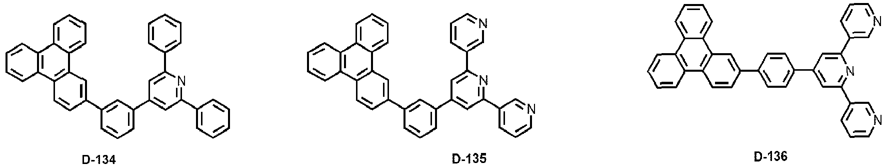

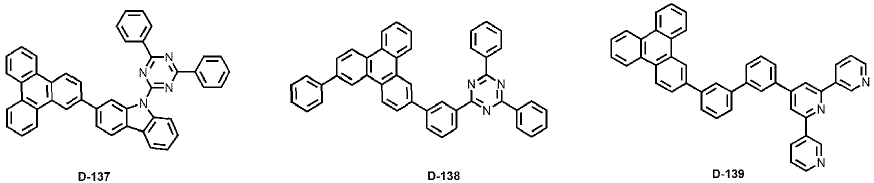

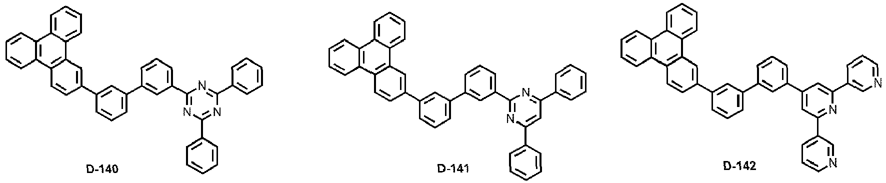

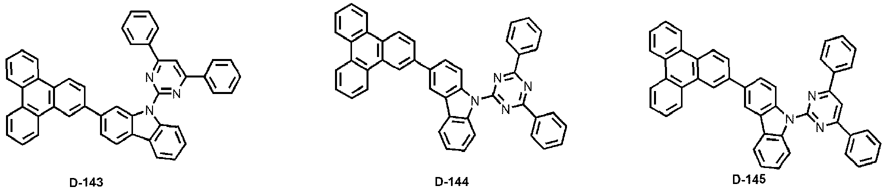

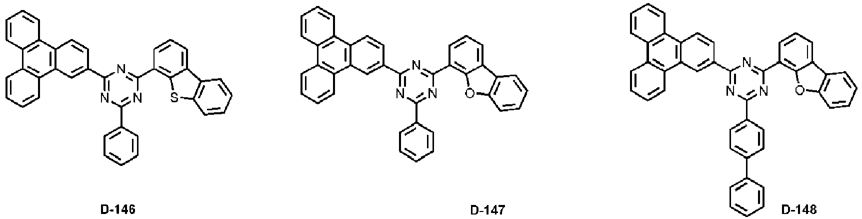

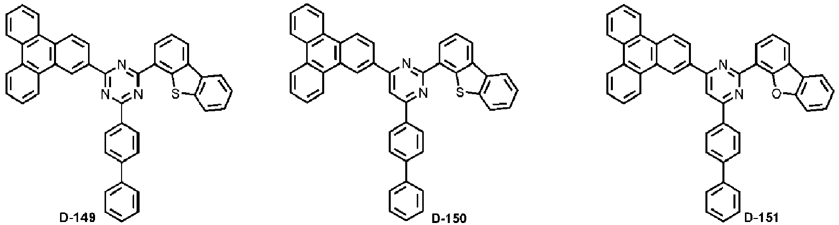

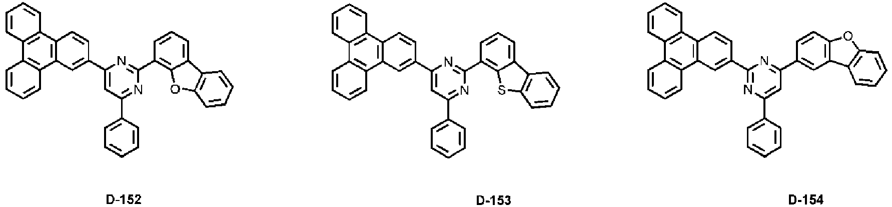

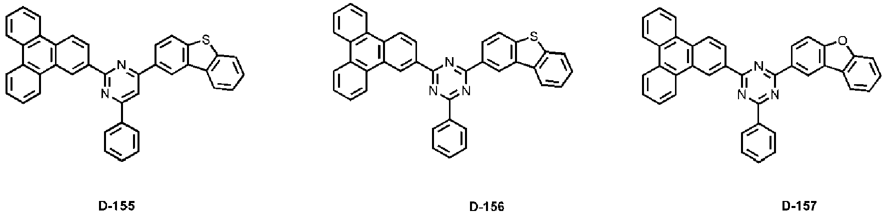

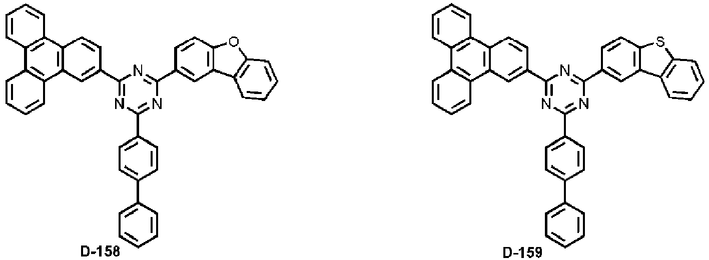

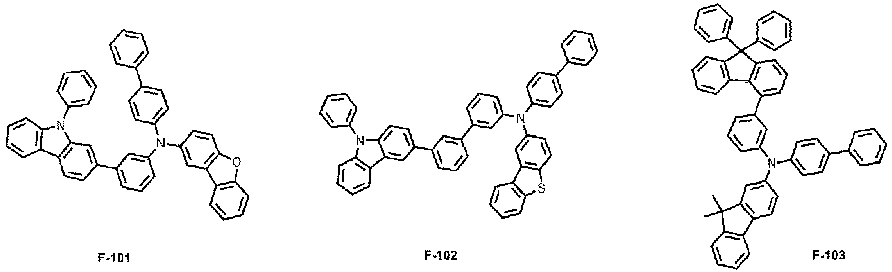

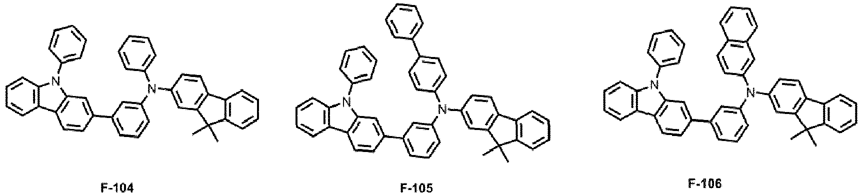

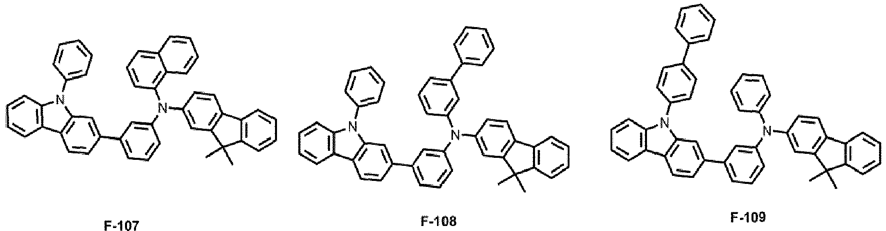

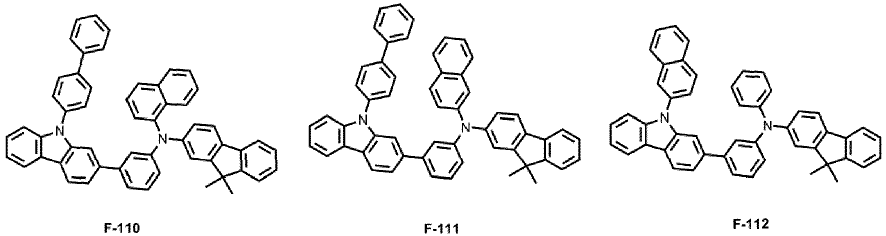

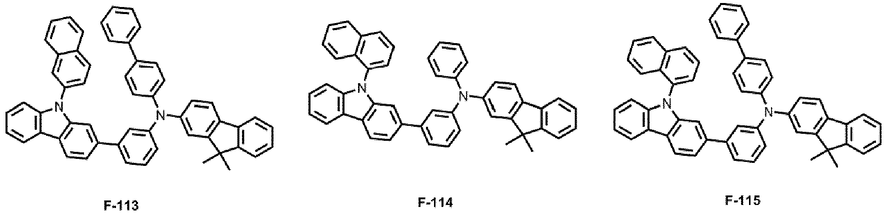

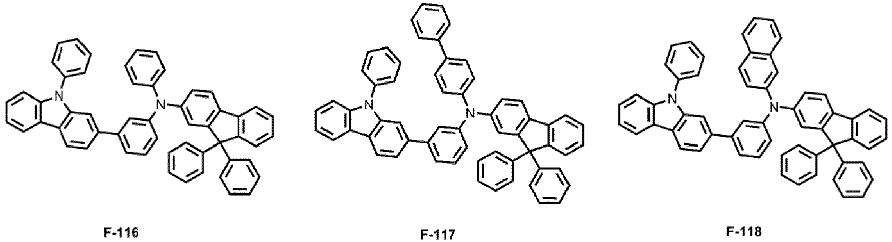

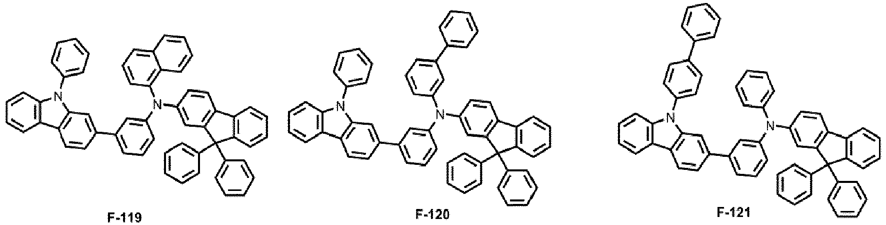

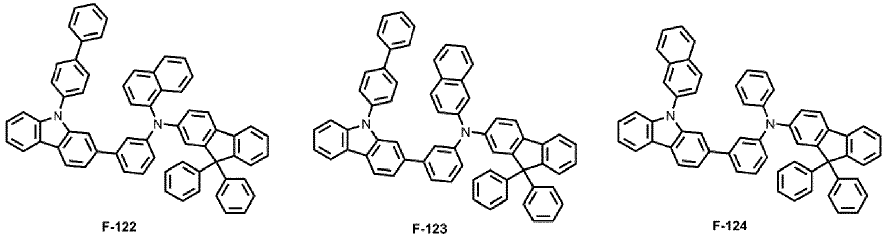

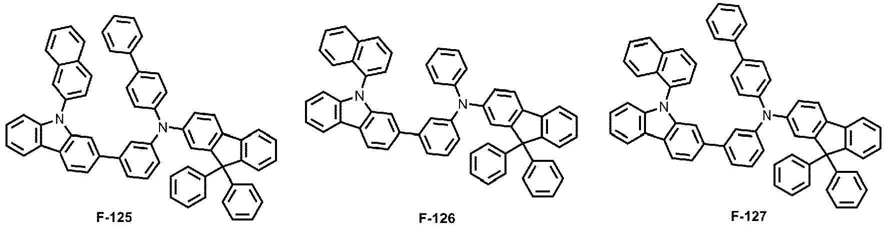

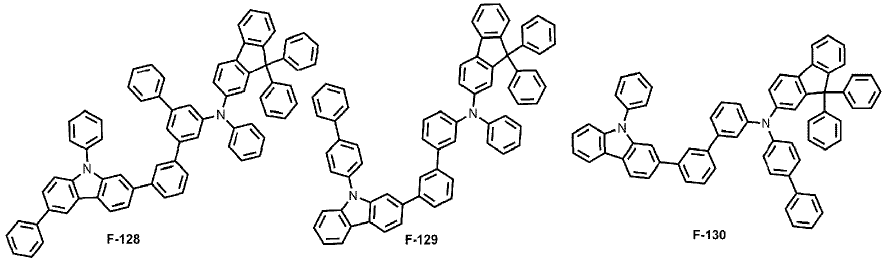

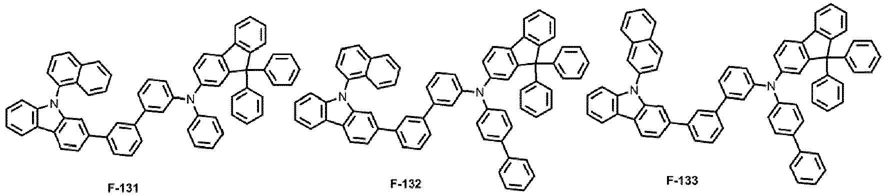

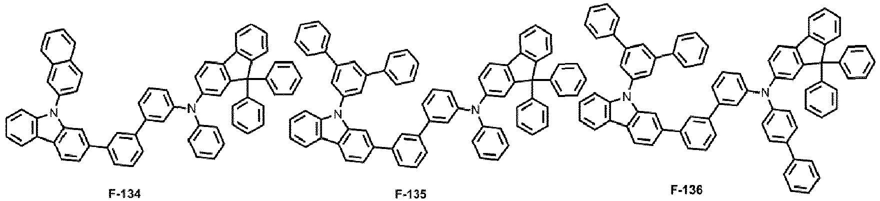

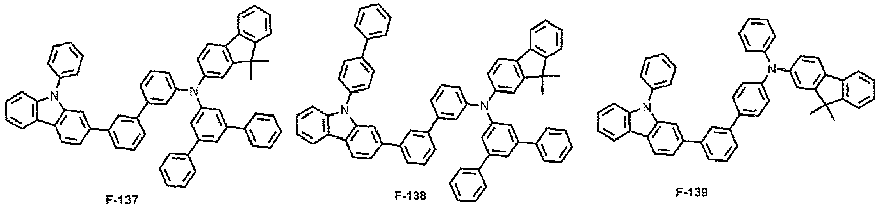

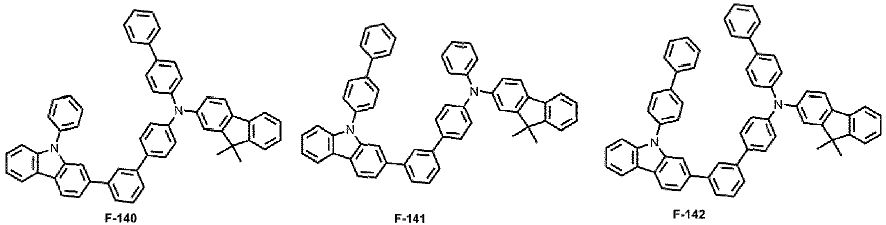

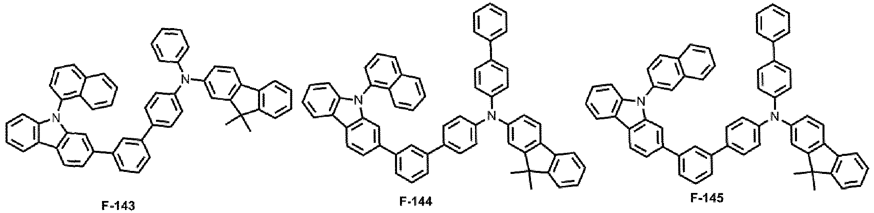

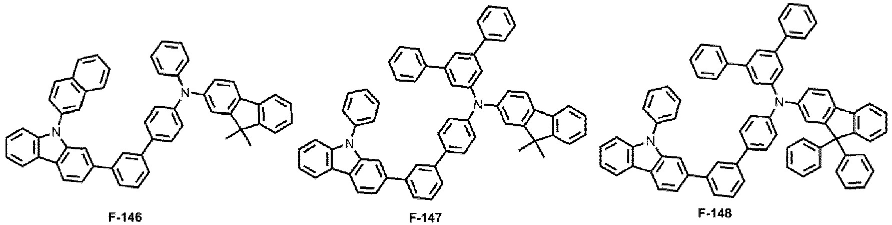

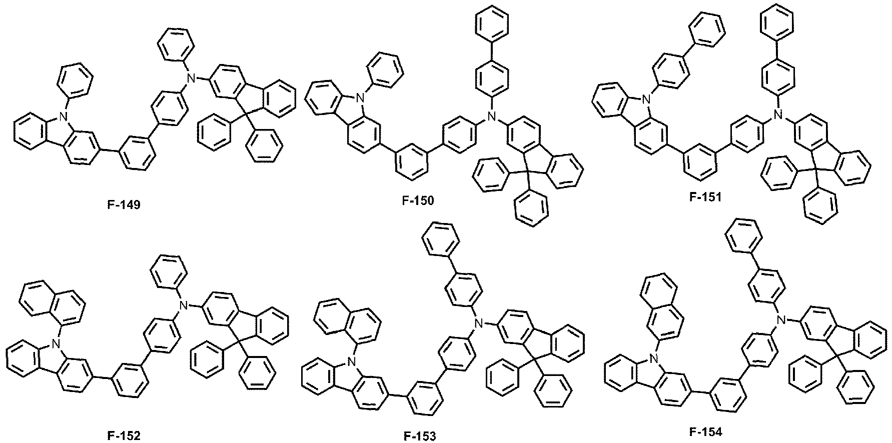

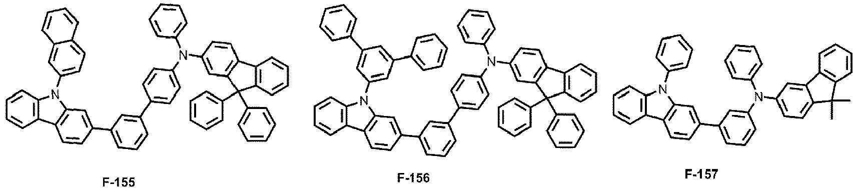

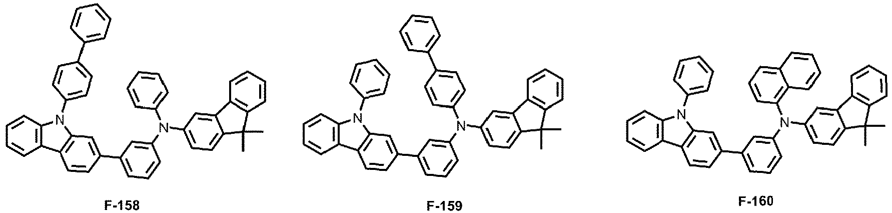

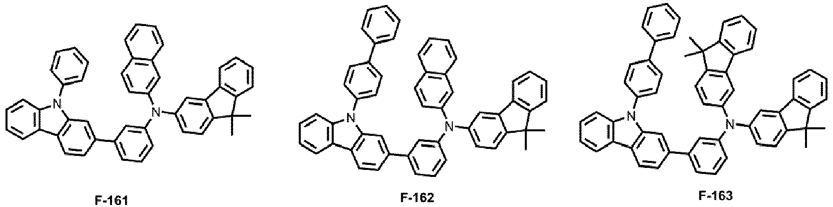

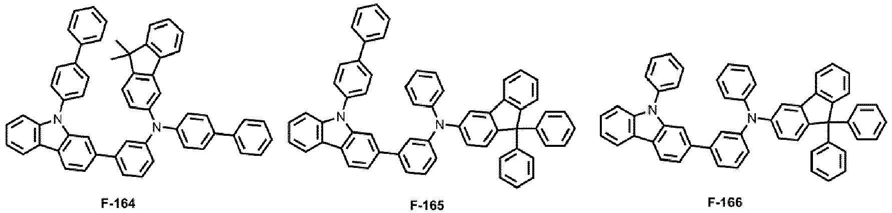

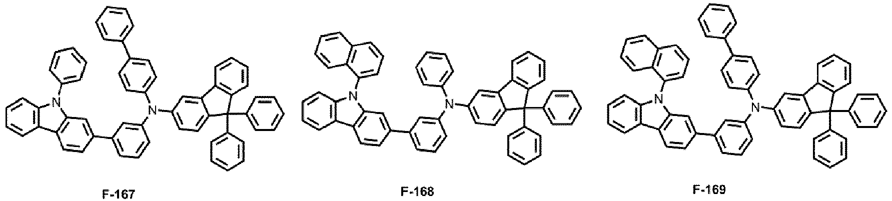

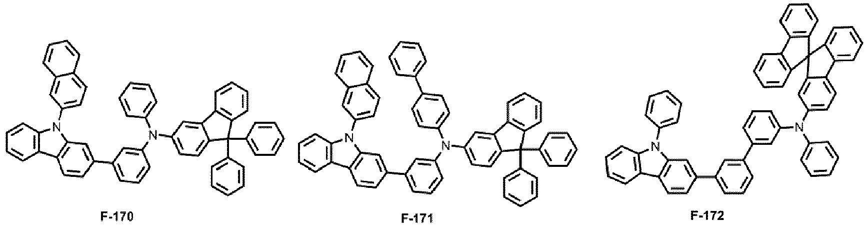

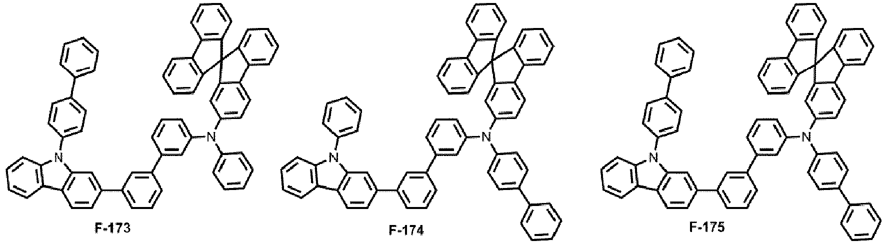

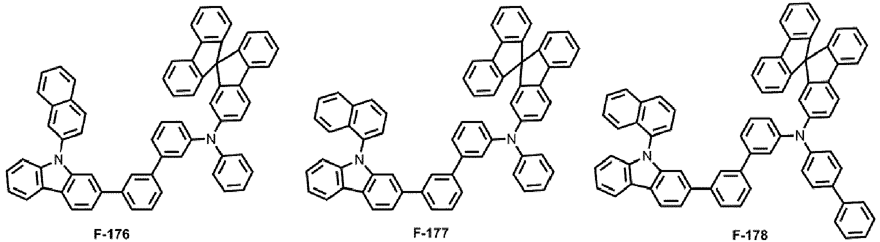

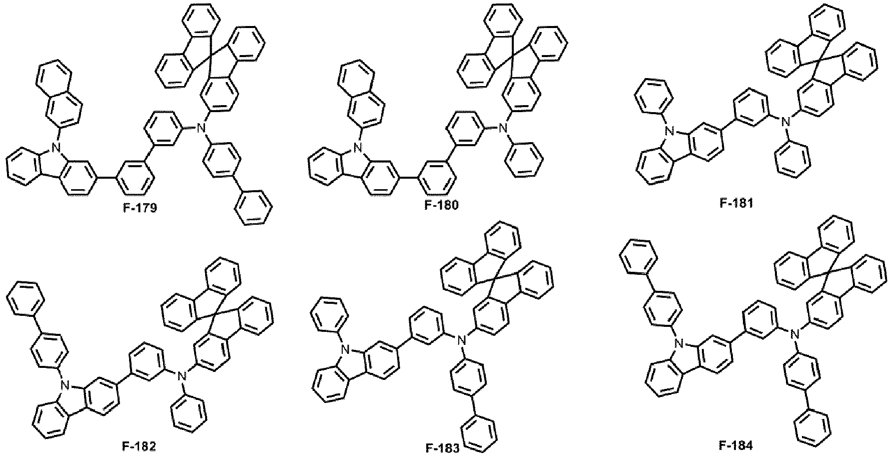

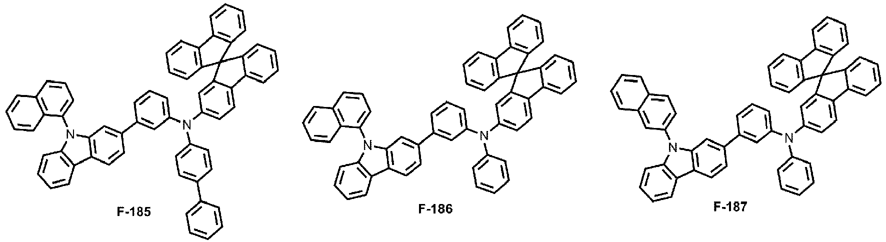

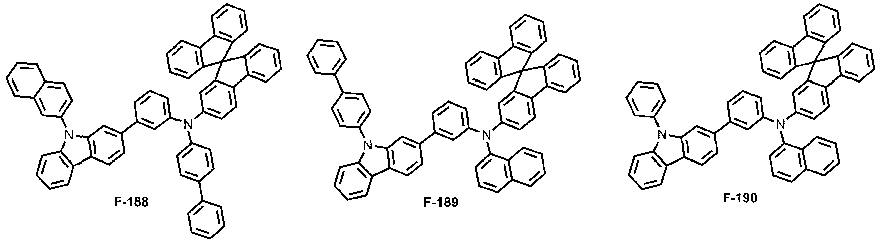

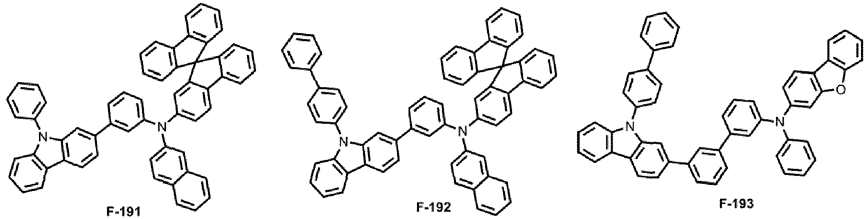

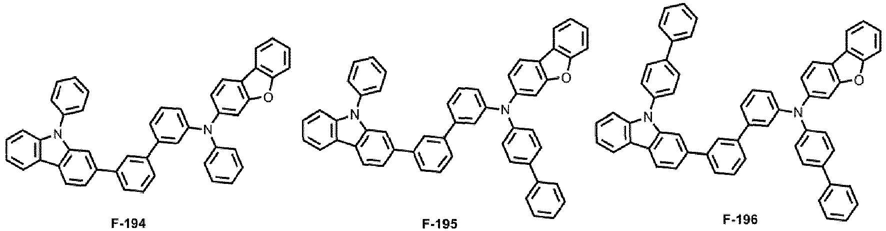

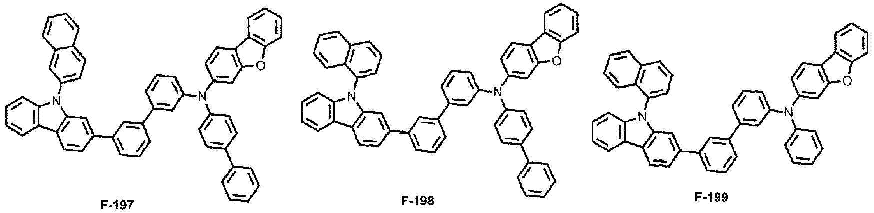

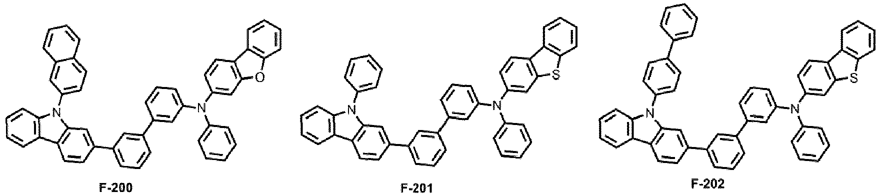

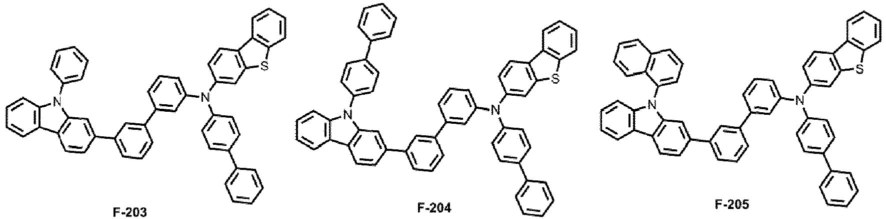

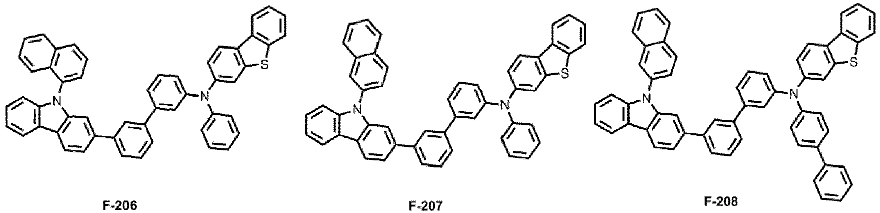

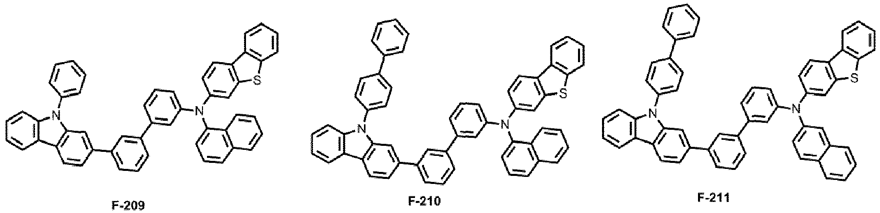

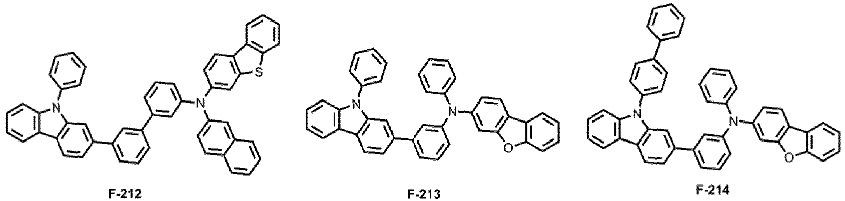

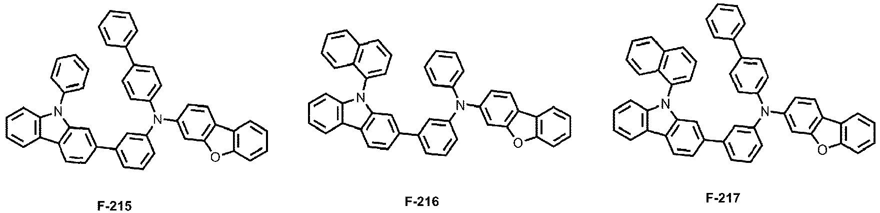

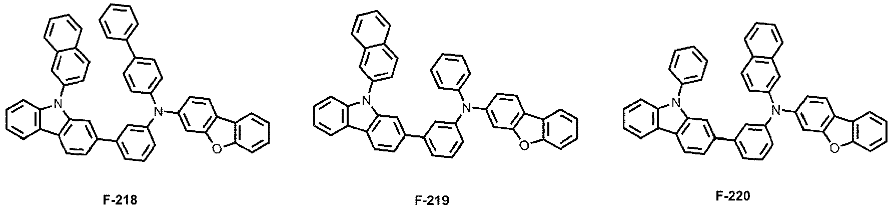

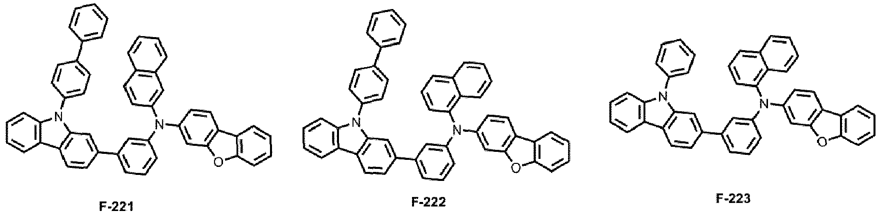

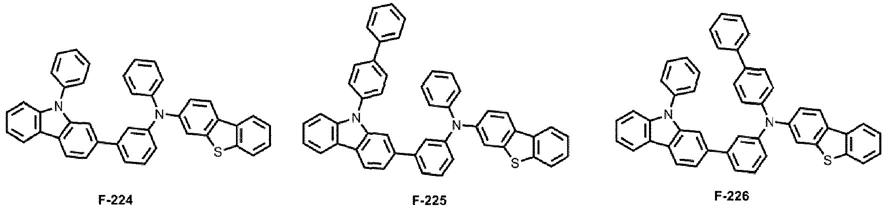

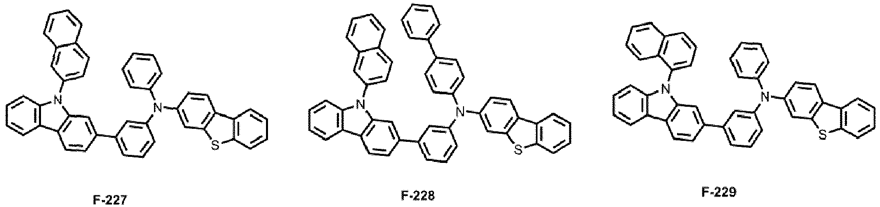

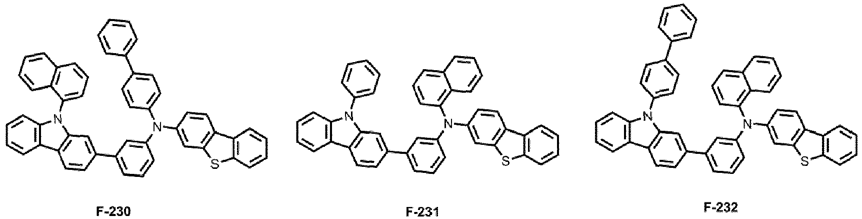

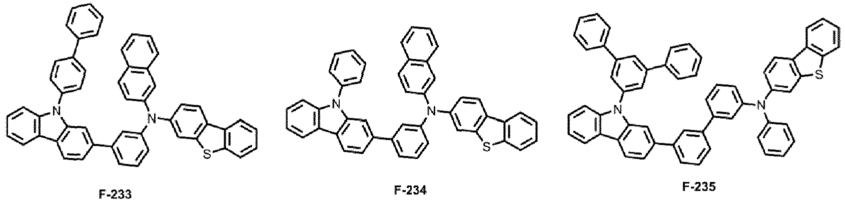

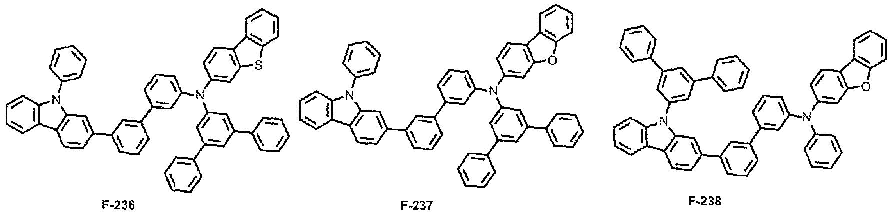

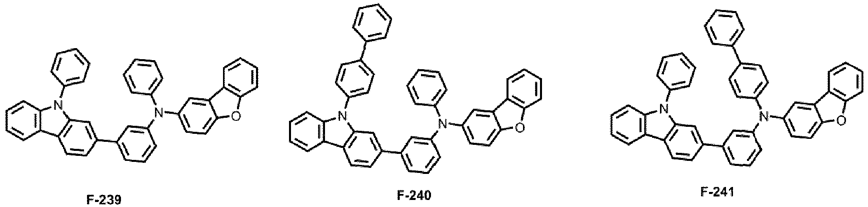

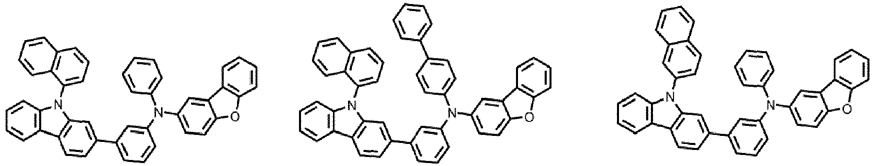

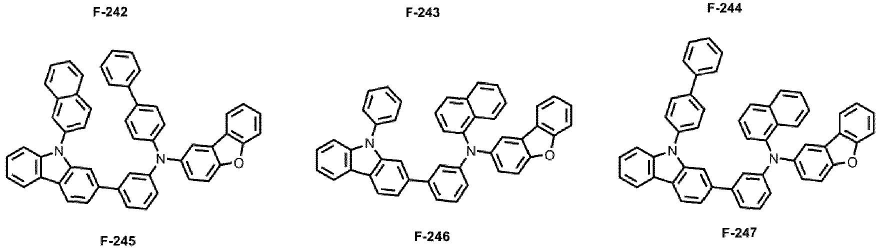

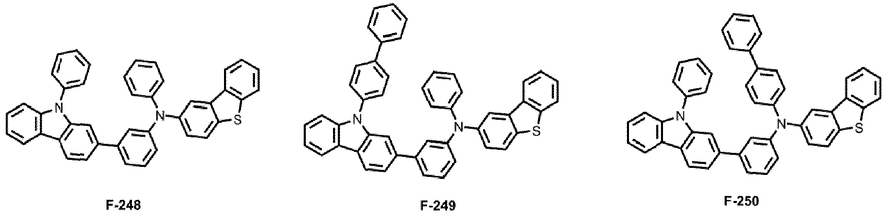

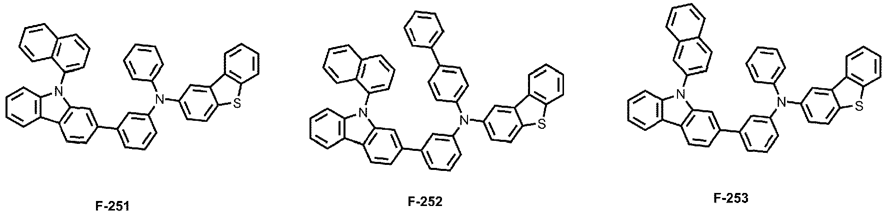

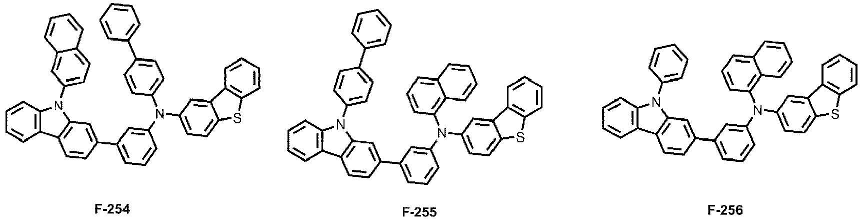

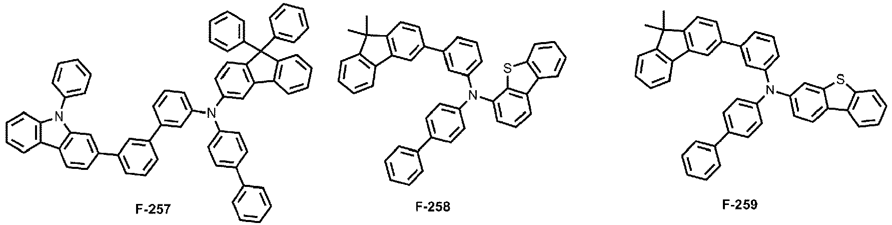

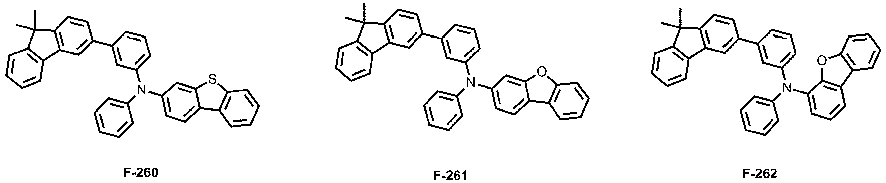

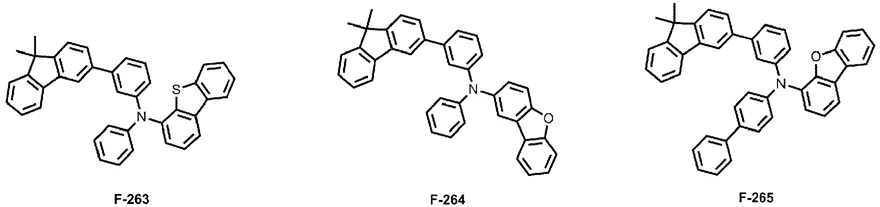

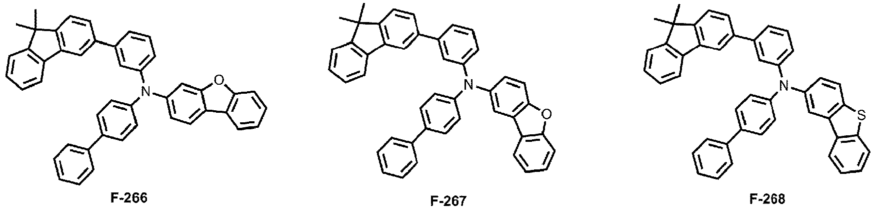

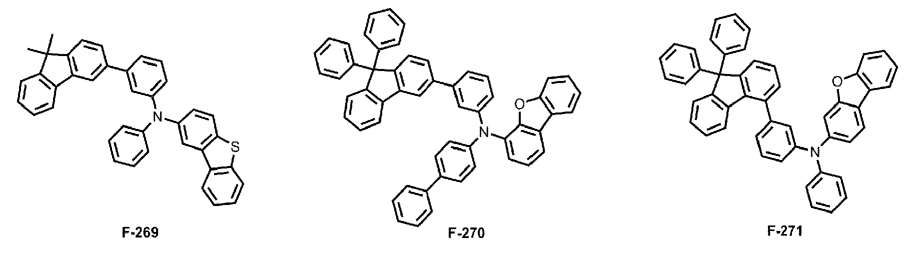

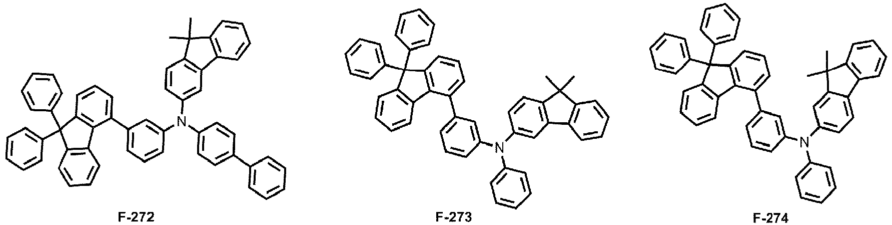

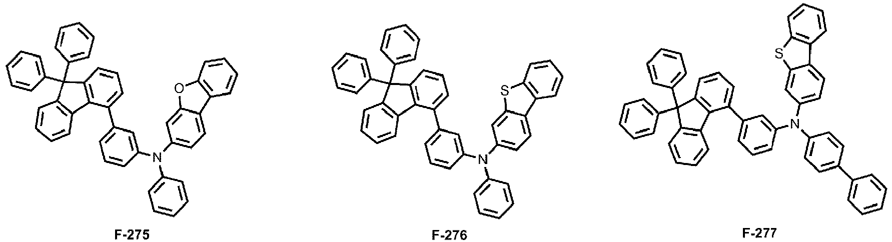

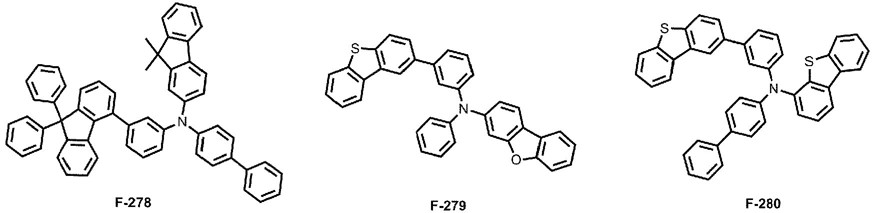

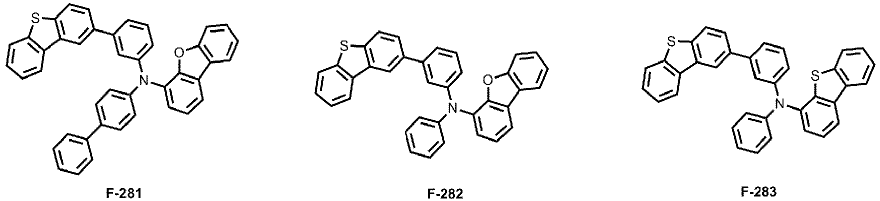

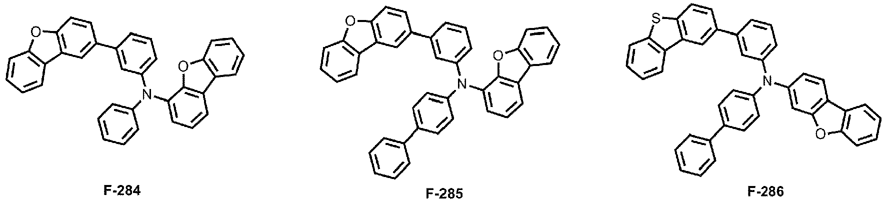

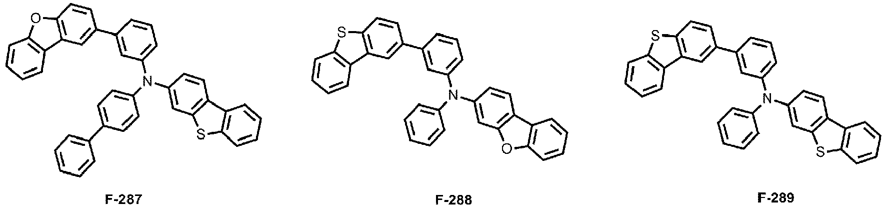

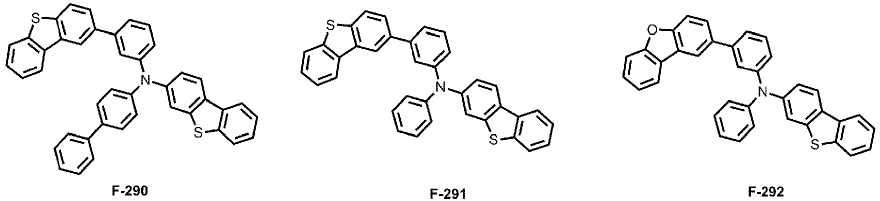

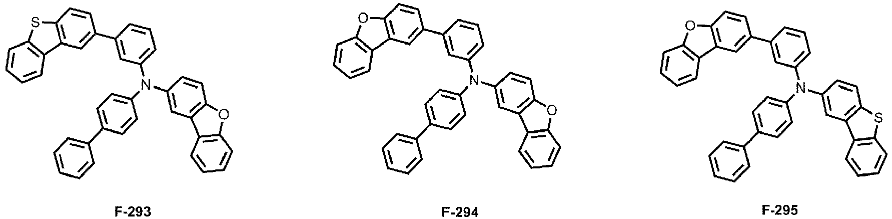

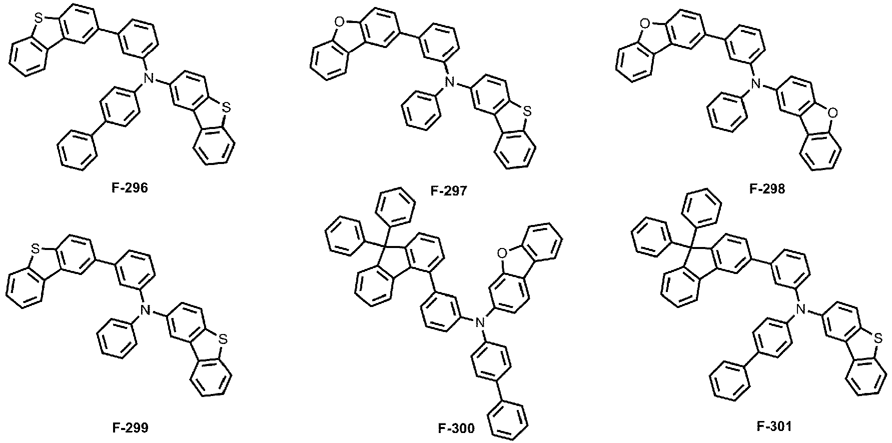

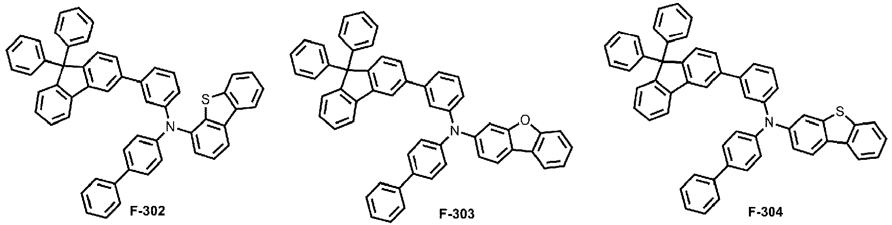

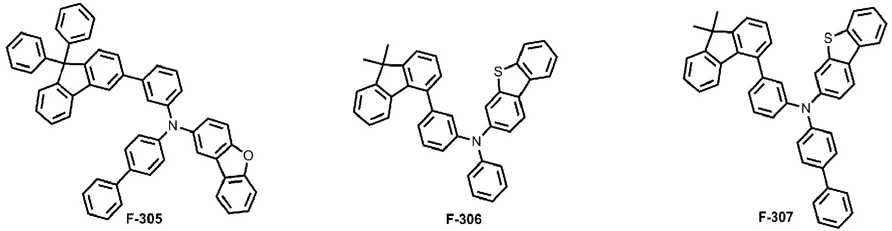

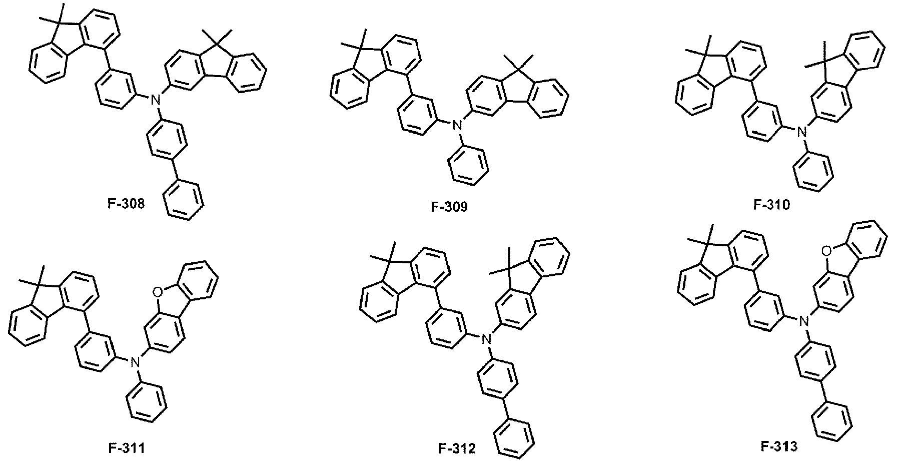

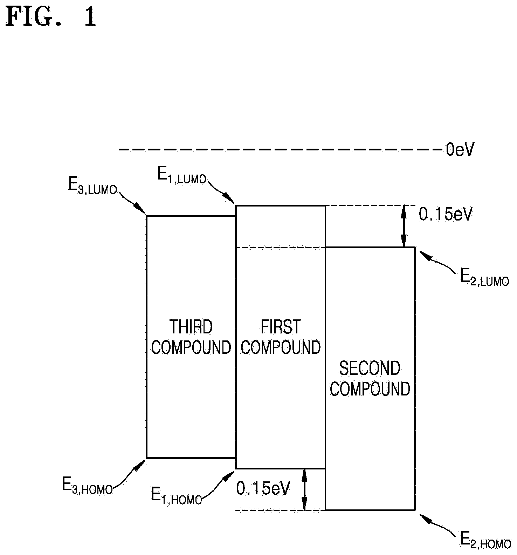

FIG. 1 is a schematic diagram illustrating the relative relationship between HOMO energy levels and LUMO energy levels of the first compound, the second compound, and the third compound that are comprised in an organic light-emitting device according to one or more embodiments.

Since the organic light-emitting device comprises the first compound to the fourth compound that satisfy Equations 1 to 8, the balance of electrons and holes in an emission layer may improve, thus allowing for an effective (or suitable) formation of excitons in the emission layer and preventing (or reducting) the leakage of excitons toward a hole transport region, and consequentially, the formed excitons may effectively contribute to the light emission of the organic light-emitting device. Accordingly, the organic light-emitting device may have high efficiency and long lifespan in conjunction with high power efficiency.

For example, when Equation 7 is satisfied, i.e., when the HOMO energy level of the third compound is less than or equal to -5.6 eV, hole injection from the hole transport region to the emission layer may effectively (or suitably) occur, and thus, accumulation of holes at an interface between the emission layer and the hole transport region may be prevented or reduced. Accordingly, deterioration of the organic light-emitting device may be prevented or reduced and roll-off (e.g., efficiency roll-off) may be reduced, thus increasing the efficiency of the organic light-emitting device.

The substantial balance of electrons and holes and effective energy transfer from a host to a dopant in the emission layer of the organic light-emitting device may substantially improve the efficiency and lifespan of the organic light-emitting device. To this end, the first compound may comprise a hole transporting group, and the second compound may comprise at least one electron transporting group. When the emission layer comprises both the first compound and the second compound, the balance of holes and electrons in the emission layer may improve, and thus, the organic light-emitting device may have both high efficiency and long lifespan.

However, even in the organic light-emitting device that comprises both the first compound and the second compound according to the present embodiments, without a suitable hole transport region, the efficiency of the organic light-emitting device may nevertheless decrease because electrons may leak from the emission layer to a hole transport layer, which may result in an increase in current and voltage.

When the third compound according to the present embodiments is used in the hole transport region, the leakage of electrons from the emission layer to the hole transport region may be reduced. Thus, most excitons formed in the emission layer may contribute to emission, consequentially leading to improving the efficiency of the organic light-emitting device. Moreover, this may reduce the deterioration of organic layer materials caused by leakage of electrons, and may also reduce the amount of current necessary to sustain the same level of luminance. Therefore, the lifespan of the organic light-emitting device may improve.

Furthermore, in the third compound represented by Formula 4, at least one selected from L₄₁ to L₄₃ may be a group represented by Formula 5. In this case, the HOMO energy level of the third compound is -5.6 eV or greater. Accordingly, compared to compounds comprising a para-phenylene group, the third compound (comprising a meta-substituted cyclic group) may have a relatively low HOMO energy level and slow hole mobility. Such HOMO energy level may contribute to balancing electrons and holes in the emission layer and preventing (or reducing) the leakage of excitons toward the hole transport region. Accordingly, the organic light-emitting device may have improved efficiency.

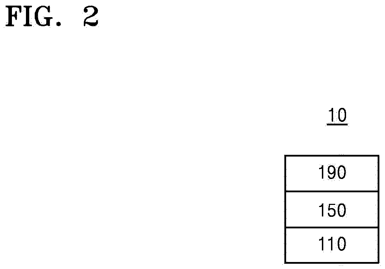

### Description of FIG. 2

FIG. 2 is a schematic diagram of an organic light-emitting device 10 according to an embodiment. The organic light-emitting device 10 comprises a first electrode 110, an organic layer 150, and a second electrode 190.

Hereinafter, the structure of the organic light-emitting device 10 according to an embodiment and a method of manufacturing the organic light-emitting device 10 will be described in connection with FIG. 2.

### First electrode 110

In FIG. 2, a substrate may be additionally disposed under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing or sputtering a material for the first electrode 110 on the substrate. When the first electrode 110 is an anode, the material for the first electrode 110 may be selected from materials with a high work function to facilitate hole injection.

The first electrode 110 may be a reflective electrode, a semi-transmissive electrode, or a transmissive electrode. When the first electrode 110 is a transmissive electrode, a material for the first electrode 110 may be selected from indium tin oxide (ITO), indium zinc oxide (IZO), tin oxide (SnO2), zinc oxide (ZnO), and any combinations thereof, but embodiments are not limited thereto. In one or more embodiments, when the first electrode 110 is a semi-transmissive electrode or a reflective electrode, the material for the first electrode 110 may be selected from magnesium (Mg), silver (Ag), aluminum (Al), aluminum-lithium (Al-Li), calcium (Ca), magnesium-indium (Mg-In), magnesium-silver (Mg-Ag), and any combinations thereof, but is not limited thereto.

The first electrode 110 may have a single-layered structure, or a multi-layered structure comprising two or more layers. For example, the first electrode 110 may have a three-layered structure of ITO/Ag/ITO, but embodiments of the structure of the first electrode 110 are not limited thereto.

### Organic layer 150

The organic layer 150 may be disposed on the first electrode 110. The organic layer 150 comprises an emission layer.

The organic layer 150 further comprises a hole transport region between the first electrode 110 and the emission layer, and may further comprise electron transport region between the emission layer and the second electrode 190.

### Hole transport region in organic layer 150

The hole transport region may have i) a single-layered structure including a single layer including a single material, ii) a single-layered structure including a single layer comprising a plurality of different materials, or iii) a multi-layered structure having a plurality of layers comprising a plurality of different materials.

The hole transport region may comprise at least one layer selected from a hole injection layer, a hole transport layer, an emission auxiliary layer, and an electron blocking layer.

The hole transport region may comprise a first layer comprising the third compound, and the first layer may directly contact the emission layer.

In some embodiments, the first layer may be an emission auxiliary layer.

For example, the hole transport region may have a single-layered structure including a single layer comprising a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer, or hole injection layer/hole transport layer/electron blocking layer, wherein the layers constituting each structure are sequentially stacked on the first electrode 110 in the stated order, but embodiments of the structure of the hole transport region are not limited thereto.

The hole transport region may comprise, in addition to the third compound, at least one selected from m-MTDATA, TDATA, 2-TNATA, NPB (NPD), β-NPB, TPD, a spiro-TPD, a spiro-NPB, methylated NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), (polyaniline)/poly(4-styrenesulfonate) (Pani/PSS), a compound represented by Formula 201, and a compound represented by Formula 202: 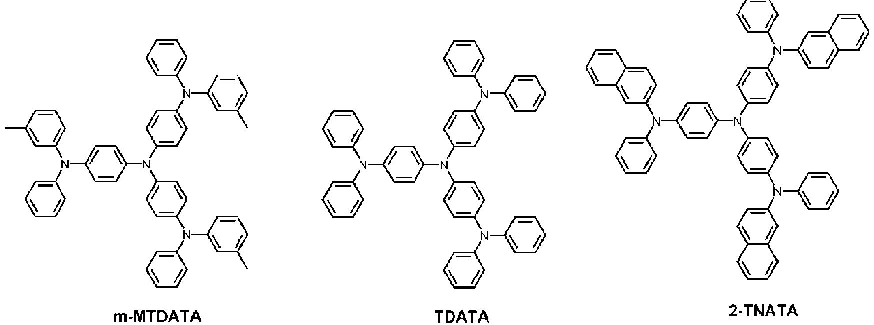 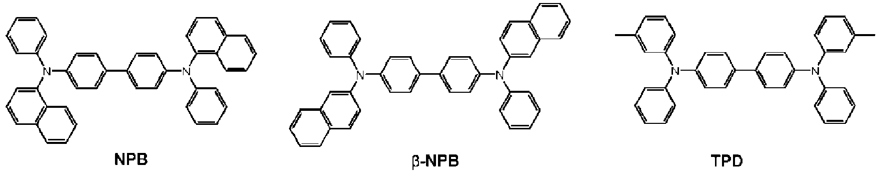 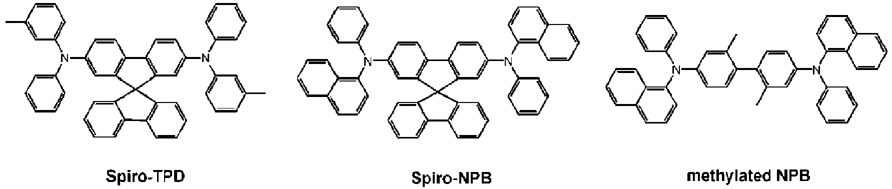 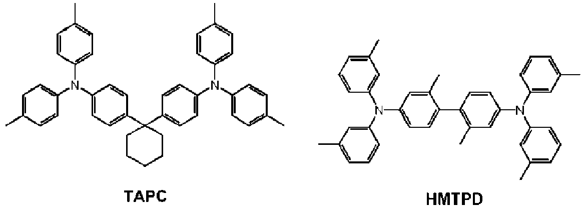 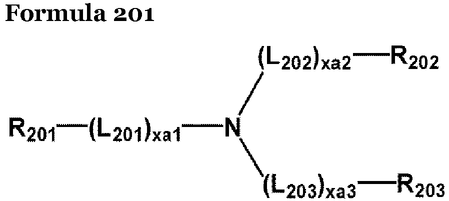 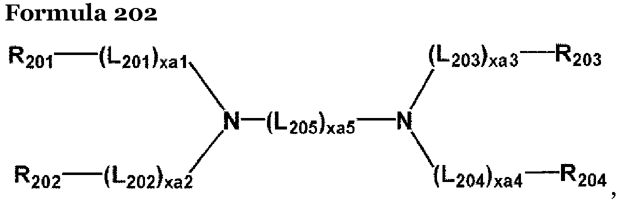 wherein, in Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

In some embodiments, in Formula 202, R₂₀₁ and R₂₀₂ may optionally be bound via a single bond, a dimethyl-methylene group, or a diphenyl-methylene group, and R₂₀₃ and R₂₀₄ may optionally be bound via a single bond, a dimethyl-methylene group, or a diphenyl-methylene group.

In some embodiments, in Formulae 201 and 202, L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

According to an embodiment, xa5 may be 1, 2, 3, or 4.

According to some embodiments, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein description of Q₃₁ to Q₃₃ may be the same as above.

According to some embodiments, at least one selected from R₂₀₁ to R₂₀₃ in Formula 201 may each independently be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

According to some embodiments, in Formula 202, i) R₂₀₁ and R₂₀₂ may be bound via a single bond, and/or ii) R₂₀₃ and R₂₀₄ may be bound via a single bond.

According to some embodiments, at least one selected from R₂₀₁ to R₂₀₄ in Formula 202 may be selected from the group consisting of:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

The compound represented by Formula 201 may be represented by Formula 201A:

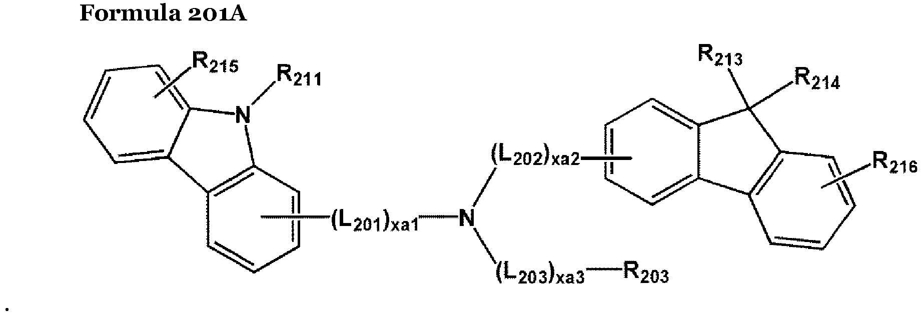

In some embodiments, the compound represented by Formula 201 may be represented by Formula 201A(1), but embodiments are not limited thereto:

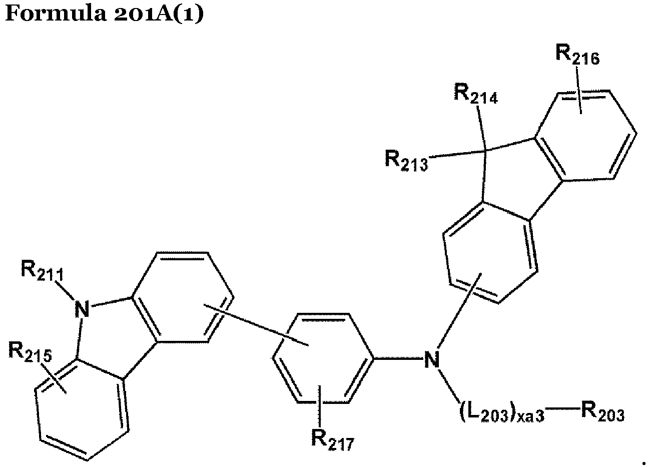

In some embodiments, the compound represented by Formula 201 may be represented by Formula 201A-1, but embodiments are not limited thereto:

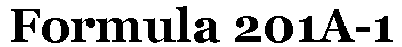

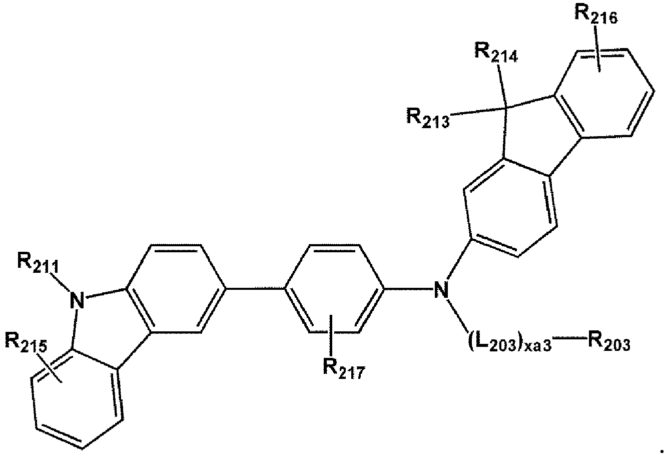

In some embodiments, the compound represented by Formula 202 may be represented by Formula 202A:

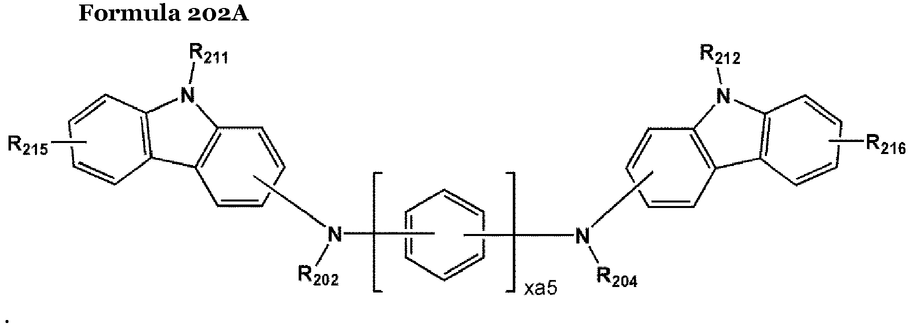

In some embodiments, the compound represented by Formula 202 may be represented by Formula 202A-1:

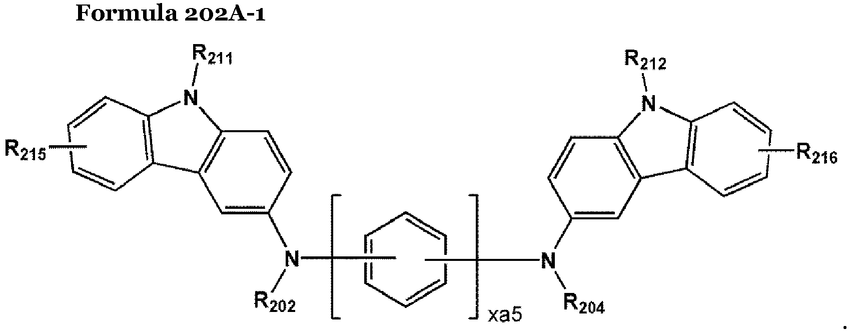

In Formulae 201A, 201A(1), 201A-1, 202A, and 202A-1,
descriptions of L₂₀₁ to L₂₀₃, xa1 to xa3, xa5, and R₂₀₂ to R₂₀₄ may be respectively the same as those provided above,
descriptions of R₂₁₁ and R₂₁₂ may each independently be the same as the description provided above in connection with R₂₀₃, and
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT1 to HT39, but embodiments are not limited thereto:

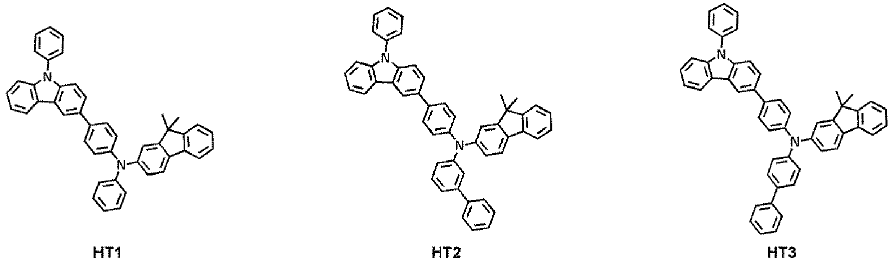

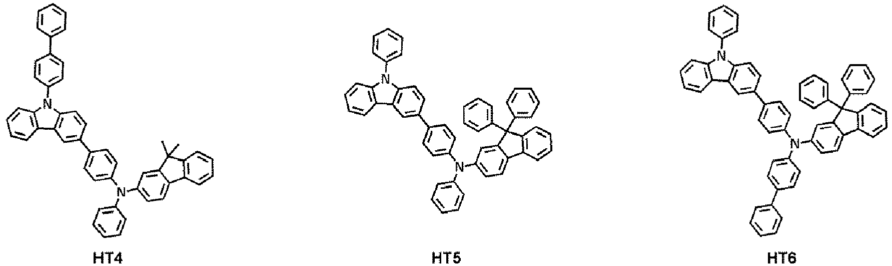

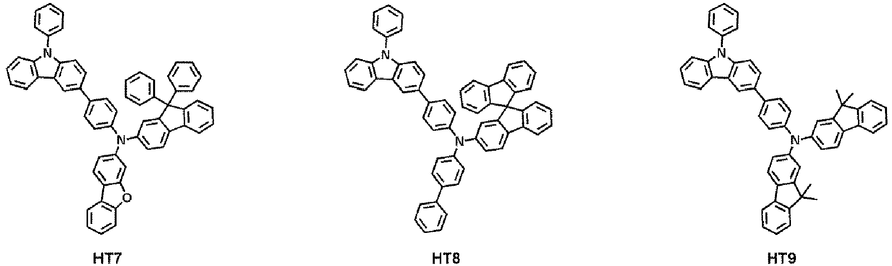

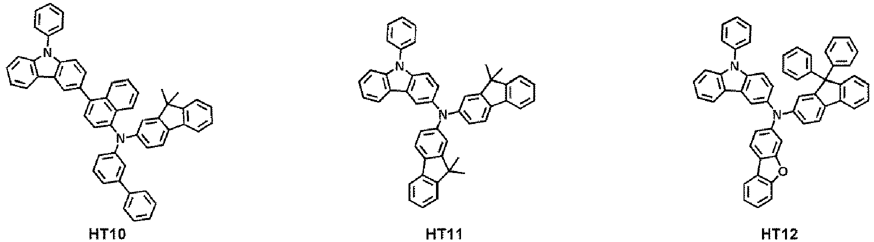

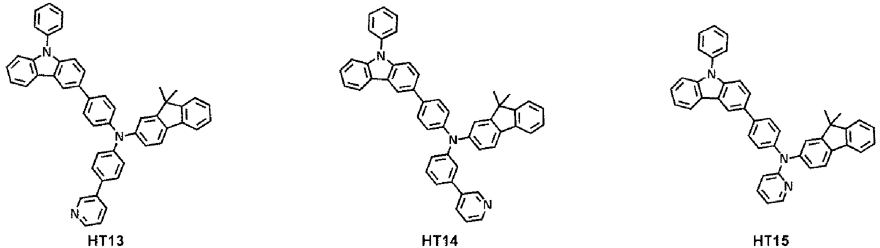

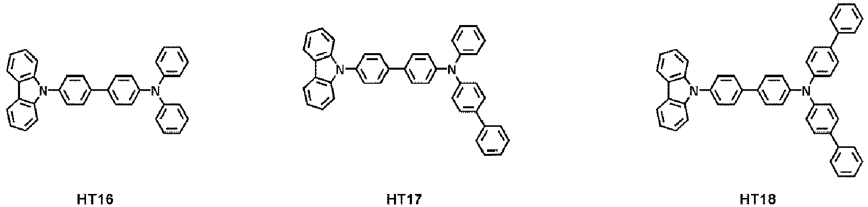

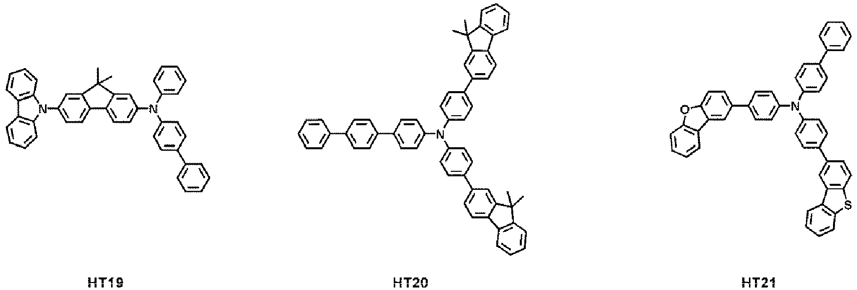

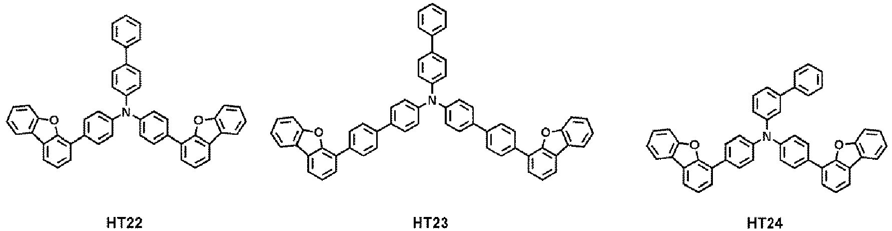

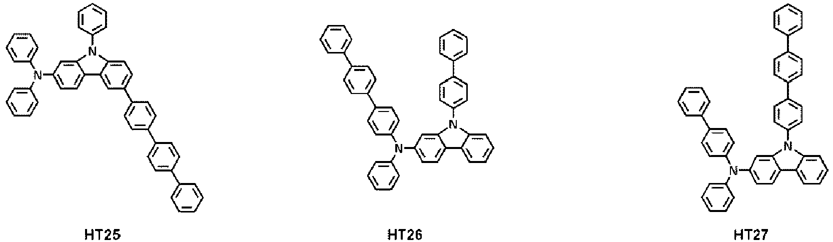

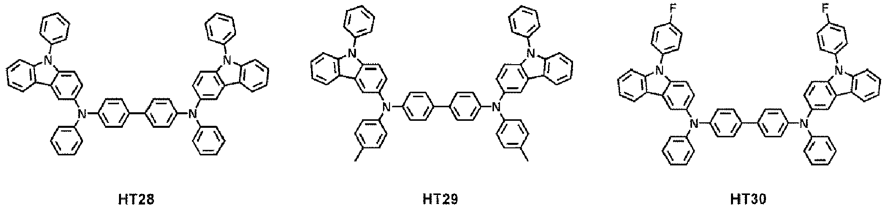

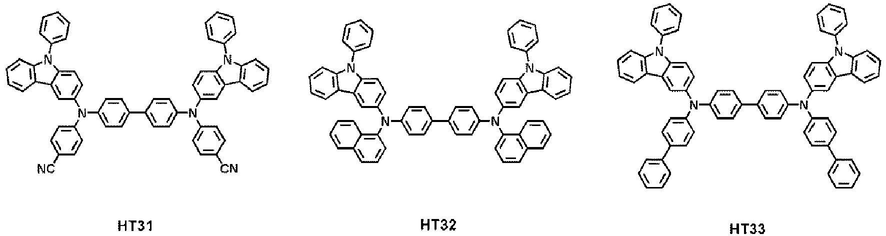

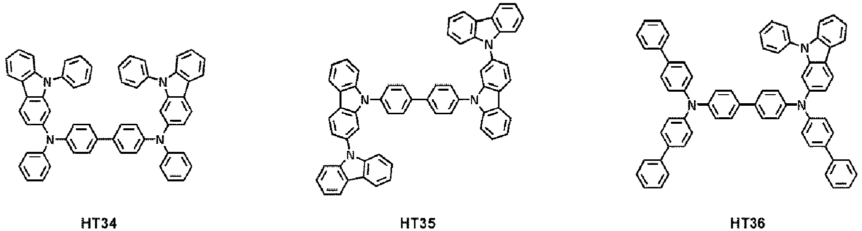

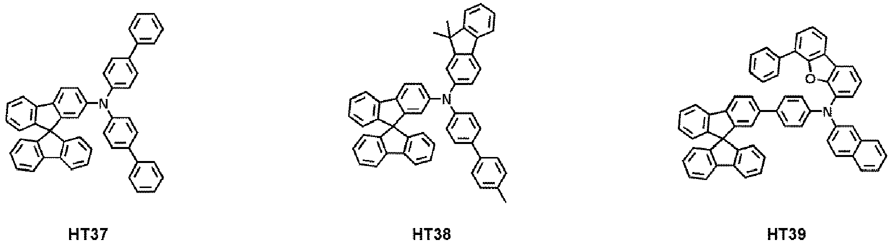

The thickness of the hole transport region may be in a range of about 100 Å to about 10,000 Å, for example, about 100 Å to about 2,000 Å. When the hole transport region comprises at least one selected from a hole injection layer and a hole transport layer, a thickness of the hole injection layer may be in a range of about 50 Å to about 2,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, satisfactory (or suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the flow of electrons from an electron transport region. The emission auxiliary layer and the electron blocking layer may each independently comprise any of the materials described above. In some embodiments, the emission auxiliary layer may comprise the third compound.

The thickness of the emission auxiliary layer may be in a range of about 10 Å to about 2,000 Å, for example, about 50 Å to about 1,000 Å. When the thickness of the emission auxiliary layer is within any of these ranges, excellent (or suitable) hole transport characteristics may be obtained without a substantial increase in driving voltage.

### p-dopant

The hole transport region may further comprise, in addition to the materials described above, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a LUMO level of about -3.5 eV or less.

The p-dopant may comprise at least one selected from a quinone derivative, a metal oxide, and a cyano group-containing compound, but embodiments are not limited thereto.

In some embodiments, the p-dopant may comprise at least one selected from the group consisting of:
a quinone derivative, such as tetracyanoquinodimethane (TCNQ) and/or 2,3,5,6-tetrafluoro-7,7,8,8-tetracyanoquinodimethane (F4-TCNQ);
a metal oxide, such as tungsten oxide and/or molybdenum oxide;
1,4,5,8,9,11-hexaazatriphenylene-hexacarbonitrile (HAT-CN); and
a compound represented by Formula 221, but embodiments are not limited thereto: 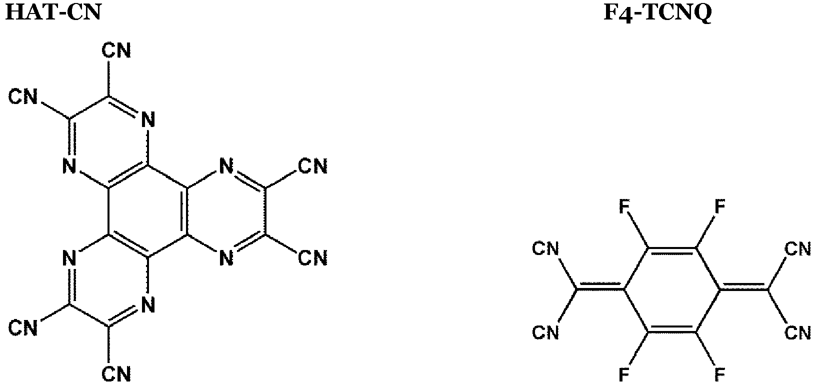 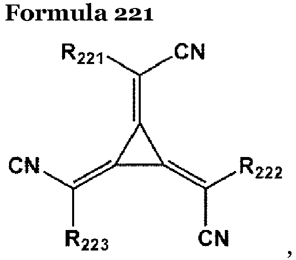 wherein, in Formula 221,
   R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, wherein at least one selected from R₂₂₁ to R₂₂₃ may comprise at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, wherein the two or more layers may contact each other or may be separated from each other. In one or more embodiments, the emission layer may comprise two or more materials selected from a red-light emission material, a green-light emission material, and a blue-light emission material, wherein the two or more materials are mixed together in a single layer to emit white light.

The emission layer may comprise a host and a dopant. The dopant may comprise at least one selected from a phosphorescent dopant and a fluorescent dopant.

The amount of the dopant in the emission layer may be in a range of about 0.01 parts by weight to about 15 parts by weight based on 100 parts by weight of the host, but embodiments are not limited thereto.

The thickness of the emission layer may be in a range of about 100 Å to about 1,000 Å, and in some embodiments, about 200 Å to about 600 Å. When the thickness of the emission layer is within any of these ranges, excellent (or suitable) light-emission characteristics may be obtained without a substantial increase in driving voltage.

### Host in emission layer

The emission layer comprises the first compound and the second compound as a host. The first compound and the second compound may be substantially the same as those described above.

For example, a weight ratio of the first compound to the second compound may be in a range of about 1:99 to about 99:1 or about 20:80 to about 80:20, but embodiments are not limited thereto.

### Phosphorescent dopant included in emission layer in organic layer 150

The phosphorescent dopant may be the fourth compound.

The fourth compound may comprise a metal selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm), but embodiments are not limited thereto.

In some embodiments, the fourth compound may be a compound represented by Formula 401, but embodiments are not limited thereto.

In some embodiments, the phosphorescent dopant may comprise an organometallic complex represented by Formula 401:

**Formula 401** M(L₄₀₁)_{xc1}(L₄₀₂)_{xc2}

wherein L₄₀₁ may be selected from ligands represented by Formula 402 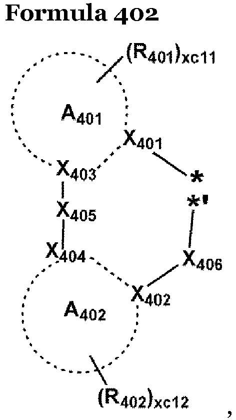 wherein, in Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3; and when xc1 is 2 or greater, a plurality of L₄₀₁(s) may be identical to or different from each other,
L₄₀₂ may be an organic ligand, and xc2 may be an integer selected from 0 to 4; and when xc2 is 2 or greater, a plurality of L₄₀₂(s) may be identical to or different from each other,
X₄₀₁ to X₄₀₄ may each independently be a nitrogen (-N-) or a carbon (-C-),
X₄₀₁ and X₄₀₃ may be bound to each other via a single bond or a double bond, X₄₀₂ and X₄₀₄ may be bound to each other via a single bond or a double bond,
A₄₀₁ and A₄₀₂ may each independently be selected from a C₅-C₆₀ carbocyclic group and a C₁-C₆₀ heterocyclic group,
X₄₀₅ may be selected from a single bond, *-O-*', *-S-*', *-C(=O)-*', *-N(Q₄₁₁)-*', *-C(Q₄₁₁)(Q₄₁₂)-*', *-C(Q₄n)=C(Q₄₁₂)-*', *-C(Q₄₁₁)=*', and *=C(Q₄₁₁)=*', wherein Q₄₁₁ and Q₄₁₂ may be selected from hydrogen, deuterium, a C₁-C₂₀ alkyl group, a C₁-C₂₀ alkoxy group, a phenyl group, a biphenyl group, a terphenyl group, and a naphthyl group,
X₄₀₆ may be a single bond, O, or S,
R₄₀₁ and R₄₀₂ may each independently be selected from hydrogen, deuterium, - F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group and a substituted or unsubstituted monovalent non-aromatic condensed 8- to 60-membered heteropolycyclic group, -Si(Q₄₀₁₎(Q₄₀₂)(Q₄₀₃), -N(Q₄₀₁₎(Q₄₀₂), -B(Q₄₀₁)(Q₄₀₂), - C(=O)(Q₄₀₂), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from 0 to 10, and
* and *' in Formula 402 may each independently indicate a binding site to M in Formula 401.

According to an embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) X₄₀₁ and X₄₀₂ may both be nitrogen.

According to some embodiments, R₄₀₁ and R₄₀₂ in Formula 402 may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁)_{,} -S(=O)₂(Q₄₀₁)_{,} and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments are not limited thereto.

In one or more embodiments, when xc1 in Formula 401 is 2 or greater, two A₄₀₁(s) of the plurality of L₄₀₁(S) may optionally be bound to each other via X₄₀₇ as a linking group, or two A₄₀₂(s) of the plurality of L₄₀₁(S) may optionally be bound to each other via X₄₀₈ as a linking group (see e.g., Compounds PD1 to PD4 and PD7). X₄₀₇ and X₄₀₈ may each independently be selected from a single bond, *-O-*', *-S-*', *-C(=O)-*', *-N(Q₄₁₃)-*' *-C(Q₄₁₃)(Q₄₁₄)-*', and *-C(Q₄₁₃)=C(Q₄₁₄)-*', wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, and/or a naphthyl group, but embodiments are not limited thereto.

L₄₀₂ in Formula 401 may be any suitable monovalent, divalent, or trivalent organic ligand. In some embodiments, L₄₀₂ may be selected from a halogen, a diketone (e.g., acetylacetonate), a carboxylic acid ligand (e.g., picolinate), -C(=O), isonitrile, -CN, and a phosphorus ligand (e.g., phosphine and/or phosphite), but embodiments are not limited thereto.

In some embodiments, the phosphorescent dopant may comprise, for example, at least one selected from Compounds PD1 to PD26, but embodiments are not limited thereto:

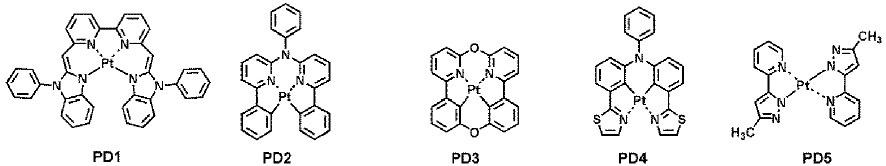

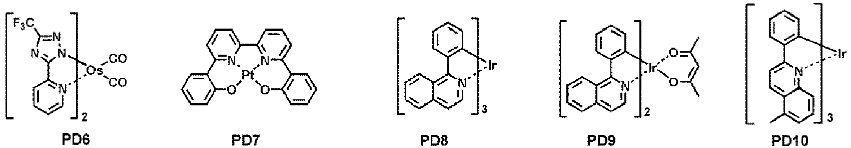

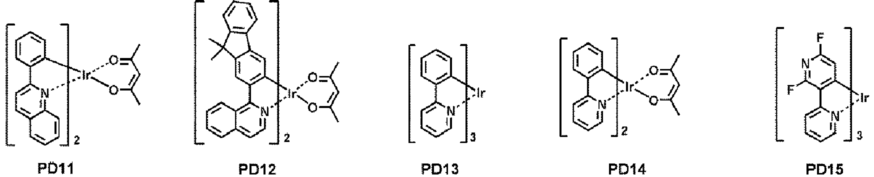

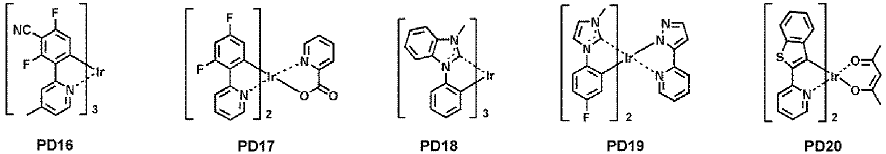

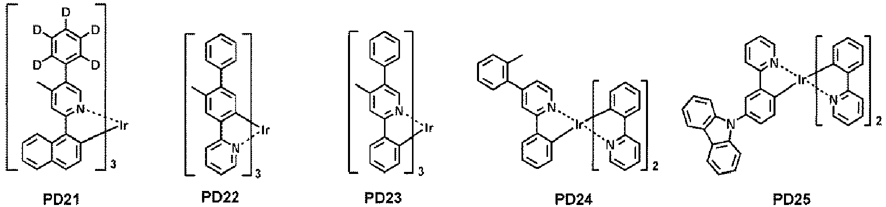

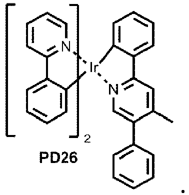

### Electron transport region in organic layer 150

The electron transport region may have i) a single-layered structure including a single layer including a single material, ii) a single-layered structure including a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer, and an electron injection layer, but is not limited thereto.

In some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the layers constituting each structure are sequentially stacked on the emission layer in the stated order. However, embodiments of the structure of the electron transport region are not limited thereto.

The electron transport region (e.g., a buffer layer, a hole blocking layer, an electron control layer, and/or an electron transport layer in the electron transport region) may comprise a metal-free compound containing at least one π electron-depleted nitrogen-containing ring.

The "π electron-depleted nitrogen-containing ring" as used herein may refer to a C₁-C₆₀ heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed (e.g., fused), or iii) a heteropolycyclic group in which at least one 5-membered to 7-membered heteromonocyclic group having at least one *-N=*' moiety, is condensed to at least one C₅-C₆₀ carbocyclic group.

Non-limiting examples of the π electron-depleted nitrogen-containing ring may comprise an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, thiadiazole, an imidazopyridine, an imidazopyrimidine, and an azacarbazole, but are not limited thereto.

In some embodiments, the electron transport region may comprise a compound represented by Formula 601:

**Formula 601** [Ar₆₀₁]ₓₑ₁₁-[(L₆₀₁)ₓₑ₁-R₆₀₁]ₓₑ₂₁,

wherein, in Formula 601,
Ar₆₀₁ may be selected from a substituted or unsubstituted C₅-C₆₀ carbocyclic group and a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₆₀₁)(Q₆₀₂)(Q₆₀₃), -C(=O)(Q₆₀₁), -S(=O)₂(Q₆₀₁), and - P(=O)(Q₆₀₁₎(Q₆₀₂),
wherein Q₆₀₁ to Q₆₀₃ may each independently be a C₁-C₁₀ alkyl group, a C₁-C₁₀ alkoxy group, a phenyl group, a biphenyl group, a terphenyl group, and/or a naphthyl group, and
xe2i may be an integer selected from 1 to 5.

In some embodiments, at least one selected from the xe11 number of Ar₆₀₁(s) and the xe2i number of R₆₀₁(s) may comprise a π electron-depleted nitrogen-containing ring.

In some embodiments, ring Ar₆₀₁ in Formula 601 may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an indenoquinoline group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an indenoquinoline group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)2(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or greater, a plurality of Ar₆₀₁(s) may be bound to respective one another via a single bond.

In one or more embodiments, Ar₆₀₁ in Formula 601 may be an anthracene group.

In some embodiments, the compound represented by Formula 601 may be represented by Formula 601-1: 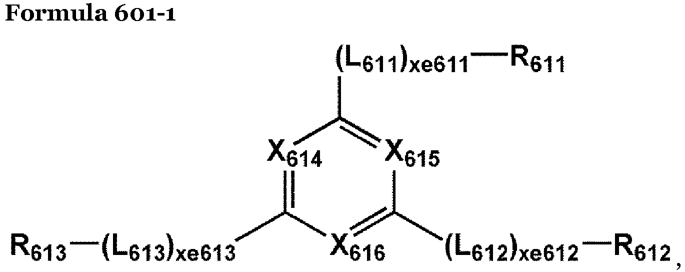 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
descriptions of L₆₁₁ to L₆₁₃ may each independently be the same as the description provided above in connection with L₆₀₁,
descriptions of xe611 to xe613 may each independently be the same as the description provided above in connection with xei,
descriptions of R₆₁₁ to R₆₁₃ may each independently be the same as the description provided above in connection with R₆₀₁,
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one embodiment, L₆₀₁ and L₆₁₁ to L₆₁₃ in Formulae 601 and 601-1 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments are not limited thereto.

In one or more embodiments, xe1 and xe611 to xe613 in Formulae 601 and 601-1 may each independently be selected from 0, 1, and 2.

According to some embodiments, R₆₀₁ and R₆₁₁ to R₆₁₃ in Formulae 601 and 601-1 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may each independently be as those described above.

The electron transport region may comprise at least one compound selected from Compounds ET1 to ET₃₆, but embodiments are not limited thereto:

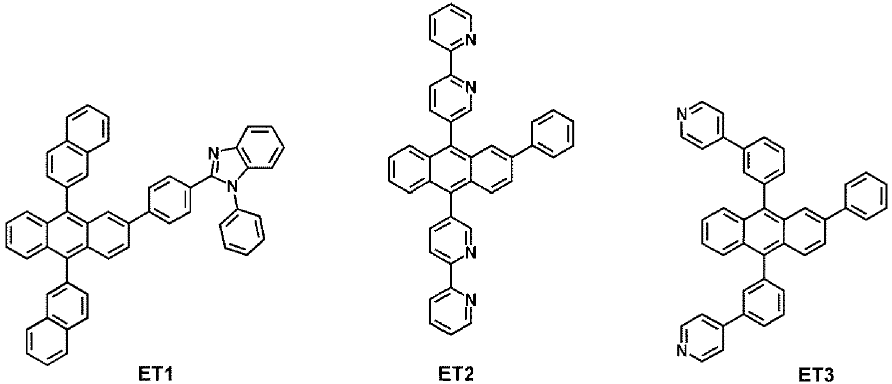

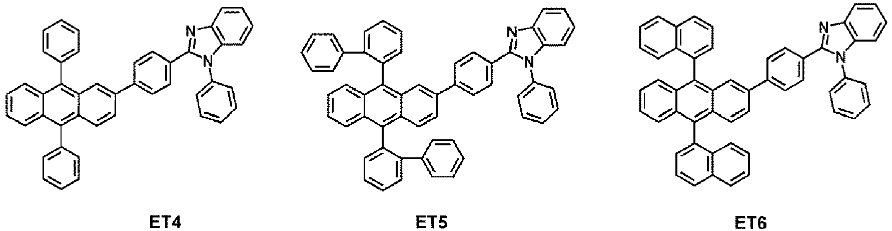

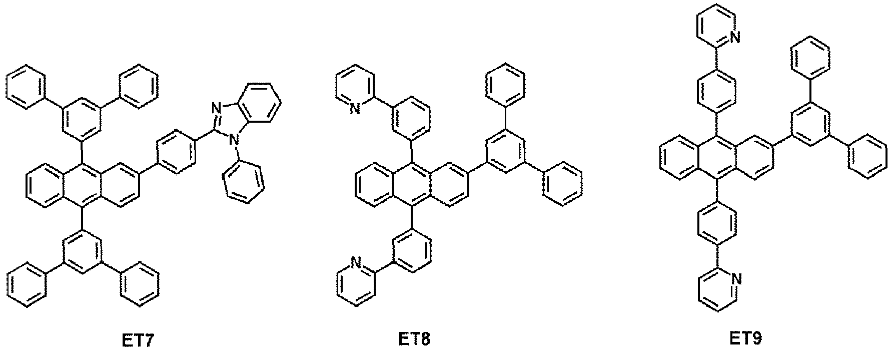

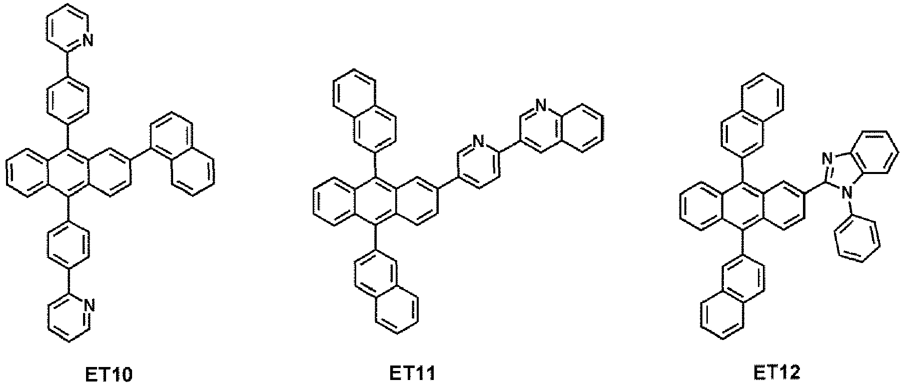

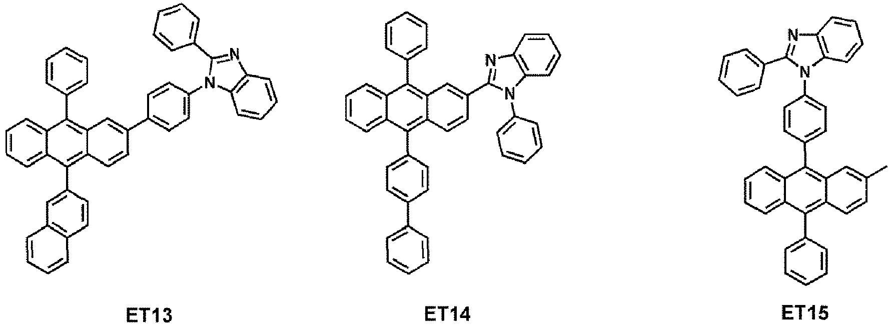

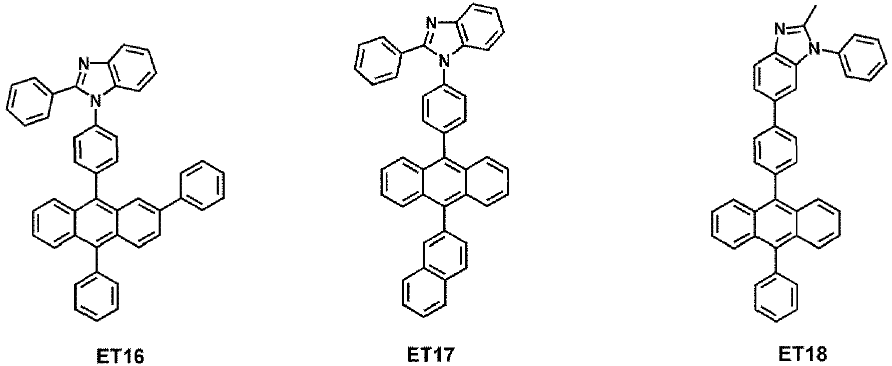

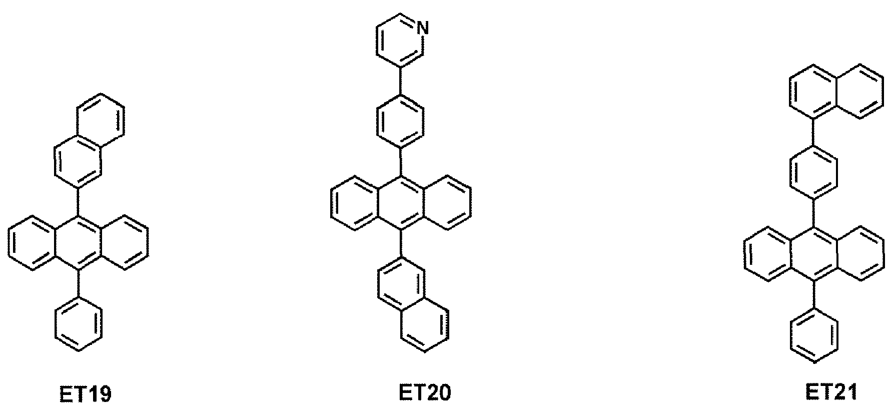

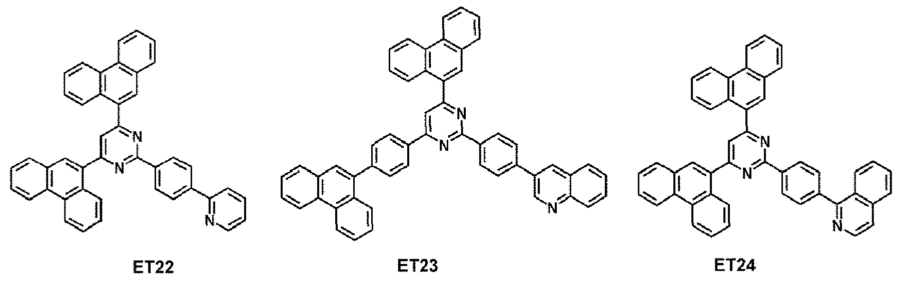

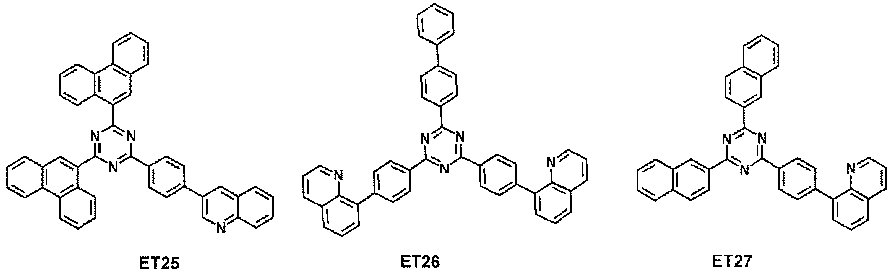

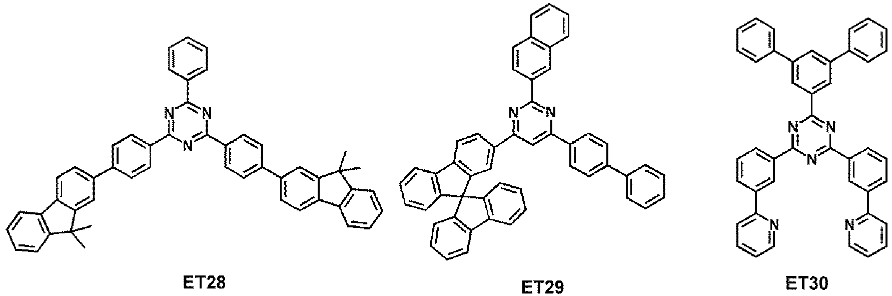

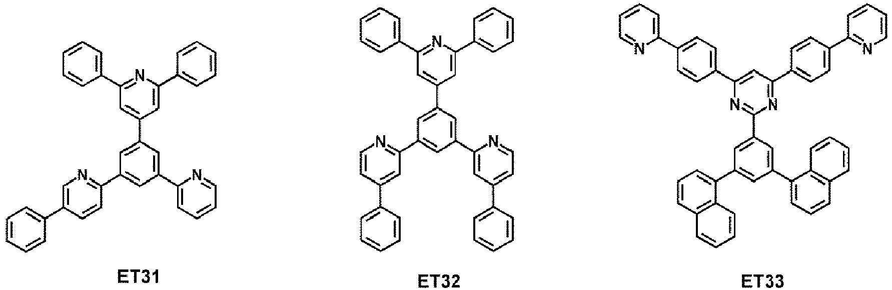

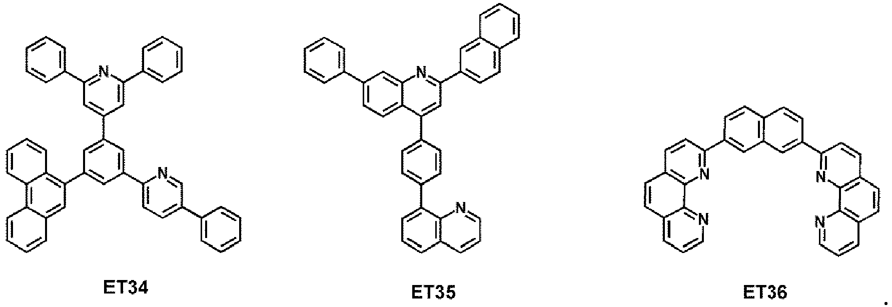

In one or more embodiments, the electron transport region may comprise at least one selected from 2,9-dimethyl-4,7-diphenyl-1,10-phenanthroline (BCP), 4,7-dphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ:

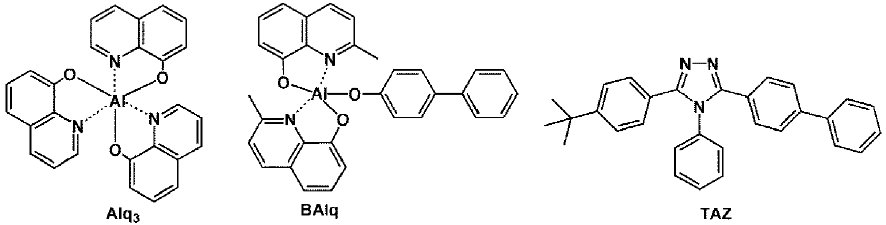

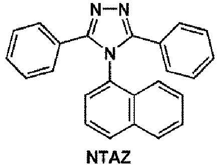

The thicknesses of the buffer layer, the hole blocking layer, and the electron control layer may each independently be in a range of about 20 Å to about 1,000 Å, and in some embodiments, about 30 Å to about 300 Å. When the thicknesses of the buffer layer, the hole blocking layer, and the electron control layer are each within any of these ranges, the electron transport region may have excellent (or suitable) electron blocking characteristics or electron control characteristics without a substantial increase in driving voltage.

The thickness of the electron transport layer may be in a range of about 100 Å to about 1,000 Å, and in some embodiments, about 150 Å to about 500 Å. When the thickness of the electron transport layer is within any of these ranges, the electron transport layer may have satisfactory (or suitable) electron transport characteristics without a substantial increase in driving voltage.

The electron transport region (e.g., the electron transport layer in the electron transport region) may further comprise, in addition to the materials described above, a metal-containing material.

The metal-containing material may comprise at least one selected from an alkali metal complex and an alkaline earth-metal complex. The alkali metal complex may comprise a metal ion selected from an Li ion, a Na ion, a K ion, a Rb ion, and a Cs ion. The alkaline earth-metal complex may comprise a metal ion selected from a Be ion, a Mg ion, a Ca ion, an Sr ion, and a Ba ion. Ligands respectively coordinated with the metal ion of the alkali metal complex and the alkaline earth-metal complex may each independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments are not limited thereto.

In some embodiments, the metal-containing material may comprise a Li complex. The Li complex may comprise, for example, Compound ET-Di (lithium quinolate, LiQ) and/or Compound ET-D2:

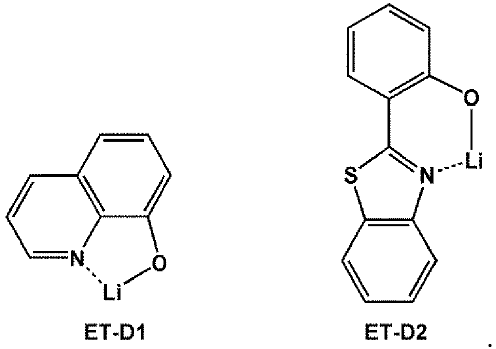

The electron transport region may comprise an electron injection layer that facilitates the injection of electrons from the second electrode 190. The electron injection layer may directly contact the second electrode 190.

The electron injection layer may have i) a single-layered structure including a single layer including a single material, ii) a single-layered structure including a single layer comprising a plurality of different materials, or iii) a multi-layered structure having a plurality of layers comprising a plurality of different materials.

The electron injection layer may comprise an alkali metal, an alkaline earth-metal, a rare-earth metal, an alkali metal compound, an alkaline earth-metal compound, a rare-earth metal compound, an alkali metal complex, an alkaline earth-metal complex, a rare-earth metal complex, or a combination thereof.

The alkali metal may be selected from Li, Na, K, Rb, and Cs. In one embodiment, the alkali metal may be selected from Li, Na, and Cs. In one or more embodiments, the alkali metal may be Li or Cs, but embodiments are not limited thereto.

The alkaline earth-metal may be selected from Mg, Ca, Sr, and Ba.

The rare-earth metal may be selected from Sc, Y, Ce, Tb, Yb, and Gd.

The alkali metal compound, the alkaline earth-metal compound, and the rare-earth metal compound may each independently be selected from oxides and halides (e.g., fluorides, chlorides, bromides, and/or iodines) of the alkali metal, the alkaline earth-metal, and the rare-earth metal, respectively.

For example, the alkali metal compound may be selected from alkali metal oxides (such as Li₂O, Cs₂O, and/or K₂O) and alkali metal halides (such as LiF, NaF, CsF, KF, LiI, NaI, CsI, KI, and/or RbI). In one embodiment, the alkali metal compound may be selected from LiF, Li₂O, NaF, LiI, NaI, CsI, KI, and RbI, but is not limited thereto.

The alkaline earth-metal compound may be selected from alkaline earth-metal compounds (such as MgF2, BaO, SrO, CaO, BaₓSr₁₋ₓO (wherein 0<x<1), and/or BaₓCa₁₋ₓO (wherein 0<x<1)). In one embodiment, the alkaline earth-metal compound may be selected from BaO, SrO, and CaO, but embodiments are not limited thereto.

The rare-earth metal compound may be selected from YbF₃, ScF₃, ScO₃, Y₂O₃, Ce₂O₃, GdF₃, and TbF₃. In one embodiment, the rare-earth metal compound may be selected from YbF₃, ScF₃, TbF₃, YbI₃, ScI₃, and TbI₃, but embodiments are not limited thereto.

The alkali metal complex, the alkaline earth-metal complex, and the rare-earth metal complex may comprise an alkali metal ion, and alkaline earth-metal ion, and a rare-earth metal ion, respectively, as described above, and ligands respectively coordinated with the metal ion of the alkali metal complex, the alkaline earth-metal complex, and the rare-earth metal complex may each independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments are not limited thereto.

The electron injection layer may comprise an alkali metal, an alkaline earth-metal, a rare-earth metal, an alkali metal compound, an alkaline earth-metal compound, a rare-earth metal compound, an alkali metal complex, an alkaline earth-metal complex, a rare-earth metal complex, or a combination thereof, as described above. In one or more embodiments, the electron injection layer may further comprise an organic material. When the electron injection layer further comprises an organic material; an alkali metal, an alkaline earth-metal, a rare-earth metal, an alkali metal compound, an alkaline earth-metal compound, a rare-earth metal compound, an alkali metal complex, an alkaline earth-metal complex, a rare-earth metal complex, or a combination thereof may be homogeneously or non-homogeneously dispersed in a matrix comprising the organic material.

The thickness of the electron injection layer may be in a range of about 1 Å to about 100 Å, and in some embodiments, about 3 Å to about 90 Å. When the thickness of the electron injection layer is within any of these ranges, the electron injection layer may have satisfactory (or suitable) electron injection characteristics without a substantial increase in driving voltage.

### Second electrode 190

The second electrode 190 may be disposed on the organic layer 150. The second electrode 190 may be a cathode, which is an electron injection electrode, and in this regard, the material for the second electrode 190 may be selected from a metal, an alloy, an electrically conductive compound, and a mixture thereof, which may have a relatively low work function.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments are not limited thereto. The second electrode 190 may be a transmissive electrode, a semi-transmissive electrode, or a reflective electrode.

The second electrode 190 may have a single-layered structure, or a multi-layered structure comprising two or more layers.

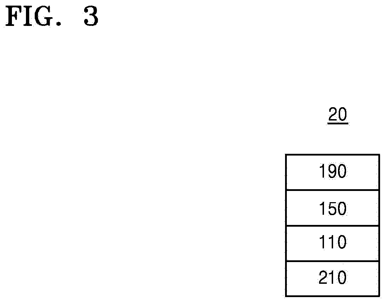

### Description of FIGS. 3 to 5

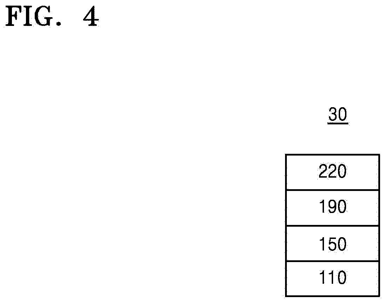

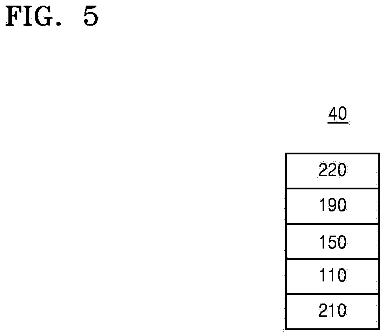

An organic light-emitting device 20 illustrated in FIG. 3 comprises a first capping layer 210, a first electrode 110, an organic layer 150, and a second electrode 190 which are sequentially stacked in this stated order. An organic light-emitting device 30 illustrated in FIG. 4 comprises a first electrode 110, an organic layer 150, a second electrode 190, and a second capping layer 220 which are sequentially stacked in this stated order. An organic light-emitting device 40 illustrated in FIG. 5 comprises a first capping layer 210, a first electrode 110, an organic layer 150, a second electrode 190, and a second capping layer 220 which are sequentially stacked in this stated order.

Regarding FIGS. 3 to 5, the first electrode 110, the organic layer 150, and the second electrode 190 may each independently be the same as those described above in connection with FIG. 2.

In the organic layer 150 of each of the organic light-emitting devices 20 and 40, light emitted from the emission layer may pass through the first electrode 110 (which may be a semi-transmissive electrode or a transmissive electrode), and through the first capping layer 210 toward the outside. In the organic layer 150 of each of the organic light-emitting devices 30 and 40, light emitted from the emission layer may pass through the second electrode 190 (which may be a semi-transmissive electrode or a transmissive electrode), and through the second capping layer 220 toward the outside.

The first capping layer 210 and the second capping layer 220 may increase external luminescent efficiency, based on the principle of constructive interference.

The first capping layer 210 and the second capping layer 220 may each independently be an organic capping layer comprising an organic material, an inorganic capping layer comprising an inorganic material, or a composite capping layer comprising an organic material and an inorganic material.

At least one selected from the first capping layer 210 and the second capping layer 220 may comprise at least one material selected from carbocyclic compounds, heterocyclic compounds, amine-based compounds, porphyrin derivatives, phthalocyanine derivatives, naphthalocyanine derivatives, alkali metal-based complexes, and alkaline earth-metal-based complexes. The carbocyclic compound, the heterocyclic compound, and the amine-based compound may each independently be optionally substituted with a substituent containing at least one element selected from O, N, S, Se, Si, F, Cl, Br, and I. In one embodiment, at least one selected from the first capping layer 210 and the second capping layer 220 may comprise an amine-based compound.

In one embodiment, at least one selected from the first capping layer 210 and the second capping layer 220 may comprise the compound represented by Formula 201 or the compound represented by Formula 202.

In one or more embodiments, at least one selected from the first capping layer 210 and the second capping layer 220 may comprise a compound selected from Compounds HT28 to HT33 and Compounds CP1 to CP5, but embodiments are not limited thereto:

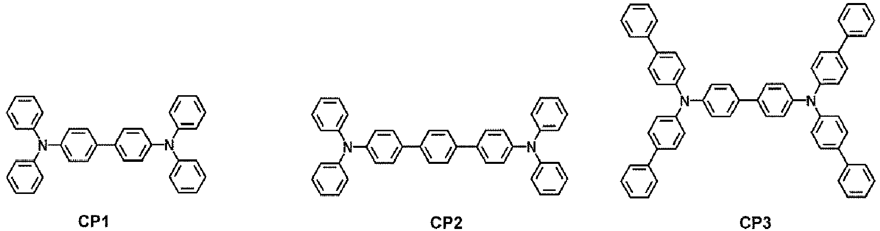

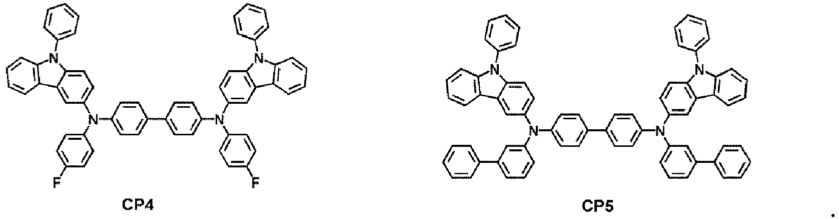

Hereinbefore, an organic light-emitting device according to one or more embodiment has been described in connection with FIGS. 2 to 5. However, embodiments are not limited thereto.

The layers constituting the hole transport region, the emission layer, and the layers constituting the electron transport region may each independently be formed in a respective region using one or more suitable methods such as vacuum deposition, spin coating, casting, Langmuir-Blodgett (LB) deposition, ink-jet printing, laser-printing, and/or laser-induced thermal imaging (LITI).

When the layers constituting the hole transport region, the emission layer, and the layers constituting the electron transport region are each independently formed by vacuum deposition, the vacuum deposition may be performed, for example, at a deposition temperature of about 100°C to about 500°C, at a vacuum degree of about 10⁻⁸ torr to about 10⁻³ torr, and at a deposition rate of about 0.01 Angstroms per second (Å/sec) to about 100 Å/sec, depending on the compound to be comprised in each layer and the structure of each layer to be formed.

When the layers constituting the hole transport region, the emission layer, the and the layers constituting the electron transport region are each independently formed by spin coating, the spin coating may be performed, for example, at a coating rate of about 2,000 revolutions per minute (rpm) to about 5,000 rpm and at a heat treatment temperature of about 80°C to 200°C, depending on the compound to be comprised in each layer and the structure of each layer to be formed.

### Measurement of energy levels

As used herein, the HOMO energy level, the LUMO energy level, and the lowest excited triplet energy level (Ti) of the first compound, the second compound, the third compound, and the fourth compound are typically as measured by the methods described in Table 1.

**Table 1**

| | |
|---|---|
| HOMO energy level evaluation method | A potential (Volts, V) versus current (Amperes, A) graph of a compound is obtained by using cyclic voltammetry (CV) (electrolyte: 0.1 molar (M) Bu₄NClO₄/ solvent: CH₂Cl₂/ electrode: 3-electrode system (working electrode: GC, reference electrode: Ag/AgCl, auxiliary electrode: Pt)). Subsequently, from reduction onset of the graph, a HOMO energy level of the compound is calculated. |
| LUMO energy level evaluation method | A compound is diluted with toluene at a concentration of 1x10⁻⁴ M, and a UV absorption spectrum thereof was measured at room temperature by using a Shimadzu UV-350 spectrometer. Then a LUMO energy level of the compound is calculated by using an optical band gap (Eg) from an edge of the absorption spectrum. |
| T1 energy level evaluation method | A mixture of a compound, diluted with toluene at a concentration of about 1x10⁻⁴ M, is loaded into a quartz cell. Subsequently, the resultant quartz cell is loaded into liquid nitrogen (at T=77 K), a photoluminescence spectrum thereof is measured by using a device for measuring photoluminescence. The obtained spectrum is compared with a photoluminescence spectrum measured at room temperature, and peaks observed only at a low temperature are analyzed to calculate T1 energy levels. |

### General definition of substituents

The term "C₁-C₆₀ alkyl group" as used herein may refer to a linear or branched saturated aliphatic hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. Non-limiting examples thereof may include a methyl group, an ethyl group, a propyl group, an isobutyl group, a sec-butyl group, a tert-butyl group, a pentyl group, an iso-amyl group, and a hexyl group. The term "C₁-C₆₀ alkylene group" as used herein may refer to a divalent group having the same structure as the C₁-C₆₀ alkyl group.

The term "C₂-C₆₀ alkenyl group" as used herein may refer to a hydrocarbon group having at least one carbon-carbon double bond at one or more positions along the hydrocarbon chain of the C₂-C₆₀ alkyl group (e.g., in the middle and/or at the terminus of the C₂-C₆₀ alkyl group). Non-limiting examples thereof may include an ethenyl group, a propenyl group, and a butenyl group. The term "C₂-C₆₀ alkenylene group" as used herein may refer to a divalent group having the same structure as the C₂-C₆₀ alkenyl group.

The term "C₂-C₆₀ alkynyl group" as used herein may refer to a hydrocarbon group having at least one carbon-carbon triple bond at one or more positions along the hydrocarbon chain of the C₂-C₆₀ alkyl group (e.g., in the middle and/or at the terminus of the C₂-C₆₀ alkyl group). Non-limiting examples thereof may include an ethynyl group and a propynyl group. The term "C₂-C₆₀ alkynylene group" as used herein may refer to a divalent group having the same structure as the C₂-C₆₀ alkynyl group.

The term "C₁-C₆₀ alkoxy group" as used herein may refer to a monovalent group represented by -OA₁₀₁ (wherein A₁₀₁ is the C₁-C₆₀ alkyl group). Non-limiting examples thereof may include a methoxy group, an ethoxy group, and an isopropoxy group.

The term "C₃-C₁₀ cycloalkyl group" as used herein may refer to a monovalent saturated hydrocarbon monocyclic group having 3 to 10 carbon atoms. Non-limiting examples thereof may include a cyclopropyl group, a cyclobutyl group, a cyclopentyl group, a cyclohexyl group, and a cycloheptyl group. The term "C₃-C₁₀ cycloalkylene group" as used herein may refer to a divalent group having the same structure as the C₃-C₁₀ cycloalkyl group.

The term "C₁-C₁₀ heterocycloalkyl group" as used herein may refer to a monovalent saturated monocyclic group having at least one heteroatom selected from N, O, Si, P, and S as a ring-forming atom and 1 to 10 carbon atoms. Non-limiting examples thereof may include a 1,2,3,4-oxatriazolidinyl group, a tetrahydrofuranyl group, and a tetrahydrothiophenyl group. The term "C₁-C₁₀ heterocycloalkylene group" as used herein may refer to a divalent group having the same structure as the C₁-C₁₀ heterocycloalkyl group.

The term "C₃-C₁₀ cycloalkenyl group" as used herein may refer to a monovalent monocyclic group that has 3 to 10 carbon atoms and at least one carbon-carbon double bond in its ring, and is not aromatic. Non-limiting examples thereof may include a cyclopentenyl group, a cyclohexenyl group, and a cycloheptenyl group. The term "C₃-C₁₀ cycloalkenylene group" as used herein may refer to a divalent group having the same structure as the C₃-C₁₀ cycloalkenyl group.

The term "C₁-C₁₀ heterocycloalkenyl group" as used herein may refer to a monovalent monocyclic group that has at least one heteroatom (e.g. 1, 2, 3, 4 or 5 hereoatoms) selected from N, O, Si, P, and S as a ring-forming atom, 1 to 10 carbon atoms, e.g. 1, 2, 3, 4 or 5 ring carbon atoms, and at least one carbon-carbon double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein may refer to a divalent group having the same structure as the C₁-C₁₀ heterocycloalkenyl group.

The term "C₆-C₆₀ aryl group" as used herein may refer to a monovalent group that has an aromatic system having 6 to 60 carbon atoms, e.g. 6 to 20 ring carbon atoms, 6 to 14 ring cabon atoms or 6 to 10 ring carbon atoms. The term "C₆-C₆₀ arylene group" as used herein may refer to a divalent group that has an aromatic system having 6 to 60 carbon atoms, e.g. 6 to 20 ring carbon atoms, 6 to 14 ring cabon atoms or 6 to 10 ring carbon atoms. Non-limiting examples of the C₆-C₆₀ aryl group may include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently comprise two or more rings, the respective rings may be fused.

The term "C₁-C₆₀ heteroaryl group" as used herein may refer to a monovalent group having an aromatic system that has at least one heteroatom (e.g. 1, 2, 3, 4 or 5 hereoatoms) selected from N, O, Si, P, and S as a ring-forming atom, in addition to 1 to 60 carbon atoms, e.g. 1 to 19 ring carbon atoms, 1 to 13 ring cabon atoms or 1 to 9 ring carbon atoms. The term "C₁-C₆₀ heteroarylene group" as used herein may refer to a divalent group having an aromatic system that has at least one heteroatom (e.g. 1, 2, 3, 4 or **5** hereoatoms) selected from N, O, Si, P, and S as a ring-forming atom, in addition to 1 to 60 carbon atoms, e.g. 1 to 19 ring carbon atoms, 1 to 13 ring cabon atoms or 1 to 9 ring carbon atoms. Non-limiting examples of the C₁-C₆₀ heteroaryl group may include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently comprise two or more rings, the respective rings may be fused.

The term "C₆-C₆₀ aryloxy group" as used herein may refer to a group represented by -OA₁₀₂ (wherein A₁₀₂ is the C₆-C₆₀ aryl group). The term "C₆-C₆₀ arylthio group" as used herein may refer to a group represented by -SA₁₀₃ (wherein A₁₀₃ is the C₆-C₆₀ aryl group).

The term "monovalent non-aromatic condensed C8-C60 polycyclic group" as used herein may refer to a monovalent group that has two or more rings condensed (e.g., fused) to each other and 8 to 60 ring carbon atoms (e.g., 8 to 20, 8 to 14 or 8 to 10 ring carbon atoms) as the only ring-forming atoms, wherein the entire molecular structure is non-aromatic (e.g., the molecular structure does not have overall aromaticity). Non-limiting examples of the monovalent non-aromatic condensed C8-C60 polycyclic group include a fluorenyl group and a spiro-bifluorenyl group. The term "divalent non-aromatic condensed C8-C60 polycyclic group" as used herein may refer to a divalent group having the same structure as the monovalent non-aromatic condensed C8-C60 polycyclic group.

The term "monovalent non-aromatic condensed 8- to 60-membered heteropolycyclic group" as used herein may refer to a monovalent group having 8- to 60- ring-forming atoms that has two or more rings condensed (e.g., fused) to each other, at least one heteroatom (e.g. 1, 2, 3, 4 or 5 hereoatoms) selected from N, O, Si, P, and S, in addition to carbon atoms (e.g., 1 to 59, 2 to 59, 2 to 19, 2 to 13 or 2 to 9 ring carbon atoms), as ring-forming atoms, wherein the entire molecular structure is non-aromatic (e.g., the molecular structure does not have overall aromaticity). Non-limiting example of the monovalent non-aromatic condensed 8- to 60-membered heteropolycyclic group is a carbazolyl group. The term "divalent non-aromatic condensed 8- to 60-membered heteropolycyclic group" as used herein may refer to a divalent group having the same structure as the monovalent non-aromatic condensed 8- to 60-membered heteropolycyclic group.

The term "C₅-C₆₀ carbocyclic group" as used herein may refer to a monocyclic or polycyclic group having 5 to 60 carbon atoms e.g. 5 to 20 ring carbon atoms, 5 to 14 ring cabon atoms or 5 to 10 ring carbon atoms as the only ring-forming atoms. The C₅-C₆₀ carbocyclic group may be saturated or unsaturated. The C₅-C₆₀ carbocyclic group may be an aromatic carbocyclic group or a non-aromatic carbocyclic group. The term "C₅-C₆₀ carbocyclic group" as used herein may refer to a ring, such as a benzene group, a monovalent group (such as a phenyl group), or a divalent group (such as a phenylene group). In one or more embodiments, depending on the number of substituents connected to the C₅-C₆₀ carbocyclic group, the C₅-C₆₀ carbocyclic group may be a trivalent group or a quadrivalent group.

The term "C₁-C₆₀ heterocyclic group" as used herein may refer to a group having substantially the same structure as a C₅-C₆₀ carbocyclic group, except that as a ring-forming atom, at least one heteroatom (e.g. 1, 2, 3, 4 or 5 hereoatoms) selected from N, O, Si, P, and S may be used in addition to 1 to 60 carbon atoms (e.g. 1 to 20 ring carbon atoms, 1 to 14 ring cabon atoms or 1 to 10 ring carbon atoms).

Certain groups are specified herein as being substituted or unsubstituted. Unless otherwise specified, when a group is substituted it is typically substituted with 1, 2, 3 or 4 substituents. For example, when a group is substituted it may be substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(_{Q32}),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

The term "Ph" as used herein may refer to a phenyl group. The term "Me" as used herein may refer to a methyl group. The term "Et" as used herein may refer to an ethyl group. The term "ter-Bu" or "Bu^{t}" as used herein may refer to a *tert-*butyl group. The term "OMe" as used herein may refer to a methoxy group. "D" as used herein may refer to deuterium.

The term "biphenyl group" as used herein may refer to a phenyl group substituted with a phenyl group. For example, the "biphenyl group" may be a substituted phenyl group having a C₆-C₆₀ aryl group as a substituent.

The term "terphenyl group" as used herein may refer to a phenyl group substituted with a biphenyl group. For example, the "terphenyl group" may be a substituted phenyl group having a C₆-C₆₀ aryl group substituted with a C₆-C₆₀ aryl group as a substituent.

The symbols * and *' used herein, unless defined otherwise, refer to a binding site to a neighboring atom in a corresponding formula.

Hereinafter a compound and an organic light-emitting device according to one or more embodiments will be described in more detail with reference to Synthesis Examples and Examples. The expression "B was used instead of A" used in describing Synthesis Examples may refer to a molar equivalent of A being identical to a molar equivalent of B.

### Examples

### Evaluation Example 1

The HOMO energy level, the LUMO energy level, and the lowest excited triplet energy level (Ti) of the first compound, the second compound, the third compound, and the fourth compound that were used in the manufacture of organic light-emitting devices manufactured in Examples 1 to 9 and Comparative Examples 1 to 3 were measured according to the method described in Table 1 above. The measurement results are shown in Table 2.

**Table 2**

| **Energy level** | **LUMO (eV)** | **HOMO (eV)** | **T1 (eV)** |
|---|---|---|---|
| **B-125** | -2.28 | -5.65 | 2.68 |
| **B-167** | -2.32 | -5.71 | 2.72 |
| **E-165** | -2.25 | -5.72 | 2.76 |
| **C-109** | -2.91 | -6.10 | 2.77 |
| **D-124** | -2.75 | -6.02 | 2.79 |
| **A-161** | -2.82 | -5.91 | 2.71 |
| **F-101** | -2.35 | -5.64 | 2.58 |
| **F-102** | -2.43 | -5.70 | 2.61 |
| **F-103** | -2.41 | -5.72 | 2.62 |
| **F-100** | -2.37 | -5.54 | 2.64 |
| **PD26** | -2.69 | -5.09 | 2.39 |

### Example 1

A glass substrate, on which an anode having a structure of ITO/Ag/ITO (70 Å/ 1,000 Å/ 70 Å) was deposited, was cut to a size of 50 mm x 50 mm x 0.4 mm, sonicated in isopropyl alcohol and water for 10 minutes, respectively, and cleaned by exposure to ultraviolet rays for 10 minutes, and then ozone. The glass substrate was then mounted on a vacuum-deposition device.

Compound HT28 was vacuum-deposited on the ITO glass substrate to form a hole injection layer having a thickness of about 700 Å. Subsequently, Compound NPB was vacuum-deposited on the hole injection layer to form a hole transport layer having a thickness of about 500 Å. Then, Compound F-101 (as a third compound) was vacuum-deposited on the hole transport layer to form a first layer (i.e., emission auxiliary layer) having a thickness of about 350 Å, thereby forming a hole transport region.

Compound B-125 (as a first compound and a host), C-109 (as a second compound and a host), and PD26 (as a fourth compound and a dopant) were co-deposited on the hole transport region at a weight ratio of about 50:50:10 to form an emission layer having a thickness of about 400 Å.

ET1 and LiQ were co-deposited at a weight ratio of about 1:1 on the emission layer to form an electron transport layer having a thickness of about 360 Å. Subsequently, MgAg (at a weight ratio of about 9:1) were vacuum-deposited on the electron transport layer to form a cathode having a thickness of about 120 Å, thereby completing the manufacture of an organic light-emitting device.

### Examples 2 to 9 and Comparative Examples 1 to 3

Organic light-emitting devices were manufactured in the same (or substantially the same) manner as in Example 1, except that compounds listed in Table 3 were respectively used to form the emission layer and the emission auxiliary layer (i.e., the first layer).

### Evaluation Example 2

The driving voltage, current density, efficiency, and lifespan of the organic light-emitting devices of Examples 1 to 9 and Comparative Examples 1 to 3 were evaluated using a Keithley 236 source-measure unit (SMU) and a PR650 luminance meter. The lifespan refers to the time that it took for the initial luminance of the organic light-emitting device to reduce to 97% of the initial luminance. The evaluation results are shown in Table 3.

**Table 3**

| | First compound | Second compound | First compound: Second compound (weight: weight) | Third compound | Driving voltage (V) | Current density (mA/cm²) | Efficiency (cd/A) | Lifespan (hr) |
|---|---|---|---|---|---|---|---|---|
| Example 1 | **B-125** | **C-109** | 5:5 | **F-101** | 4.2 | 10 | 96.4 | 151 |
| Example 2 | **B-167** | **D-124** | 5:5 | **F-101** | 4.5 | 10 | 95.8 | 162 |
| Example 3 | **E-165** | **A-161** | 5:5 | **F-101** | 4.3 | 10 | 97.1 | 157 |
| Example 4 | **B-125** | **C-109** | 5:5 | **F-102** | 4.2 | 10 | 95.7 | 161 |
| Example 5 | **B-167** | **D-124** | 5:5 | **F-102** | 4.4 | 10 | 94.9 | 158 |
| Example 6 | **E-165** | **A-161** | 5:5 | **F-102** | 4.2 | 10 | 95.6 | 149 |
| Example 7 | **B-125** | **C-109** | 5:5 | **F-103** | 4.1 | 10 | 96.3 | 148 |
| Example 8 | **B-167** | **D-124** | 5:5 | **F-103** | 4.4 | 10 | 95.8 | 145 |
| Example 9 | **E-165** | **A-161** | 5:5 | **F-103** | 4.2 | 10 | 95.2 | 153 |
| Comparative Example 1 | **B-125** | **C-109** | 5 : 5 | **F-100** | 4.1 | 10 | 77.4 | 125 |
| Comparative Example 2 | **B-167** | **D-124** | 5 : 5 | **F-100** | 4.4 | 10 | 79.2 | 118 |
| Comparative Example 3 | **E-165** | **A-161** | 5 : 5 | **F-100** | 4.2 | 10 | 78.2 | 111 |

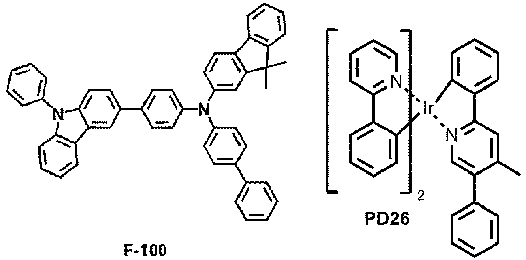

Referring to the results of Table 3, it was found that the organic light-emitting devices of Examples 1 to 9 exhibited excellent efficiency and lifespan, as compared with the organic light-emitting devices of Comparative Examples 1 to 3.

As described above, according to the one or more of the above embodiments, an organic light-emitting device may have high efficiency and long lifespan.

As used herein, the terms "use," "using," and "used" may be considered synonymous with the terms "utilize," "utilizing," and "utilized," respectively.

In addition, the terms "substantially," "about," and similar terms are used as terms of approximation and not as terms of degree, and are intended to account for the inherent deviations in measured or calculated values that would be recognized by those of ordinary skill in the art.

It will be understood that when an element such as a layer, film, region, or substrate is referred to as being "on" another element, it can be directly on the other element or intervening elements may also be present. In contrast, when an element is referred to as being "directly on" or "directly contacting" another element, there are no intervening elements present.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

It should be understood that embodiments described herein should be considered in a descriptive sense only and not for purposes of limitation.

While one or more embodiments of the present disclosure have been described with reference to the figures, it will be understood by those of ordinary skill in the art that various changes in form and details may be made therein without departing from the scope of the present disclosure as defined by the following claims.

## Claims

1. An organic light emitting device (10) comprising:
a first electrode (110);
a second electrode (190) facing the first electrode; and
an organic layer (150) between the first electrode and the second electrode, the organic layer comprising an emission layer, and a hole transport region between the first electrode and the emission layer,
wherein the emission layer comprises a first compound as a host, a second compound as a host, and a fourth compound as a dopant, and the hole transport region comprises a third compound,
the first compound to the fourth compound satisfy Equations 1 to 8: ${E}_{1 , LUMO} \geq {E}_{2 , LUMO} + 0.15 electron volts \left(eV\right)$ ${E}_{1 , HOMO} \geq {E}_{2 , HOMO} + 0.15 eV$ ${E}_{1 , T 1} \geq {E}_{4 , T 1}$ ${E}_{2 , T 1} \geq {E}_{4 , T 1}$ ${E}_{3 , T 1} \geq {E}_{4 , T 1}$ ${E}_{3 , LUMO} \geq {E}_{2 , LUMO} + 0.1 eV$ $- 5.6 eV \geq {E}_{3 , HOMO}$ ${E}_{gap 1} \geq {E}_{gap 3} ,$ wherein, in Equations 1 to 8,
E_{1,LUMO} indicates a lowest unoccupied molecular orbital (LUMO) energy level of the first compound,
E_{2,LUMO} indicates a LUMO energy level of the second compound,
E_{3,LUMO} indicates a LUMO energy level of the third compound,
E_{1,HOMO} indicates a highest occupied molecular orbital (HOMO) energy level of the first compound,
E_{2,HOMO} indicates a HOMO energy level of the second compound,
E_{3,HOMO} indicates a HOMO energy level of the third compound,
E_{1,T1} indicates a lowest excited triplet energy level of the first compound,
E_{2,T1} indicates a lowest excited triplet energy level of the second compound,
E_{3,T1} indicates a lowest excited triplet energy level of the third compound,
E_{4,T1} indicates a lowest excited triplet energy level of the fourth compound,
E_{gap1} indicates a gap between the LUMO energy level of the first compound and the HOMO energy level of the first compound, and
E_{gap3} indicates a gap between the LUMO energy level of the third compound and the HOMO energy level of the third compound;
wherein the HOMO, LUMO and lowest excited triplet energy level (T1) of a compound used in Equations 1 to 8 are determined according to the following processes:
| | |
|---|---|
| HOMO | A potential (Volts, V) versus current (Amperes, A) graph of a compound is obtained by using cyclic voltammetry (CV) (electrolyte: 0.1 molar (M) Bu₄NClO₄/ solvent: CH₂Cl₂/ electrode: 3-electrode system (working electrode: GC, reference electrode: Ag/AgCl, auxiliary electrode: Pt)), and a HOMO energy level of the compound is calculated from reduction onset of the graph |
| LUMO | A compound is diluted with toluene at a concentration of 1x10⁻⁴ M, and a UV absorption spectrum thereof was measured at room temperature by using a Shimadzu UV-350 spectrometer, and a LUMO energy level of the compound is calculated by using an optical band gap (Eg) from an edge of the absorption spectrum |
| T1 | A mixture of a compound, diluted with toluene at a concentration of about 1x10⁻⁴ M, is loaded into a quartz cell, the resultant quartz cell is loaded into liquid nitrogen (at T=77 K), a low-temperature photoluminescence spectrum thereof is measured by using a device for measuring photoluminescence, and T1 is calculated by analysis of peaks observed only at a low temperature when the obtained low-temperature photoluminescence spectrum is compared with a photoluminescence spectrum measured at room temperature |

2. The organic light-emitting device of claim 1, wherein the first compound to the fourth compound satisfy Equations 1a to 6a: ${E}_{1 , LUMO} \geq {E}_{2 , LUMO} + 0.2 eV$ ${E}_{1 , HOMO} \geq {E}_{2 , HOMO} + 0.2 eV$ ${E}_{1 , T 1} \geq {E}_{4 , T 1} + 0.1 eV$ ${E}_{2 , T 1} \geq {E}_{4 , T 1} + 0.1 eV$ ${E}_{3 , T 1} \geq {E}_{4 , T 1} + 0.1 eV$ ${E}_{3 , LUMO} \geq {E}_{2 , LUMO} + 0.2 eV .$

3. The organic light-emitting device of claim 1 or 2, wherein (a) and/or (b) apply:
(a) the hole transport region further comprises a p-dopant having a LUMO level of about -3.5 eV or less, the p-dopant comprising at least one selected from a quinone derivative, a metal oxide, and a cyano group-containing compound
(b) the hole transport region comprises a first layer, the first layer comprises the third compound, and the first layer directly contacts the emission layer;
preferably wherein the hole transport region comprises at least one layer selected from a hole injection layer, a hole transport layer, an emission auxiliary layer, and an electron blocking layer, and the first layer is the emission auxiliary layer.

4. The organic light-emitting device of any one of the preceding claims, wherein
the first compound is represented by one of Formulae 1-1, 2-1, 2-2, and 3-1,
the second compound is represented by one of Formulae 1-2, 2-3, 2-4, and 3-2, and
the third compound is represented by Formula 4: 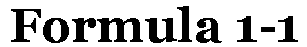 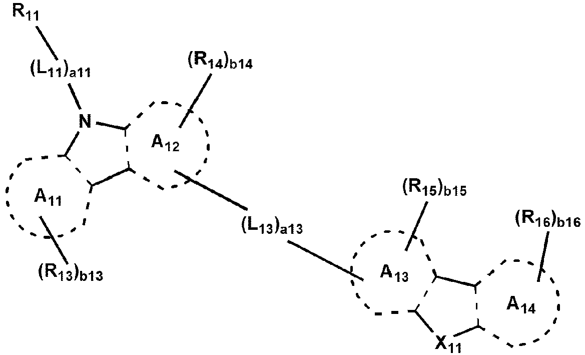 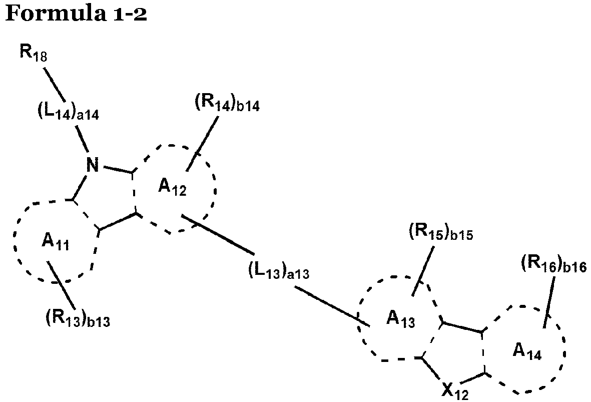 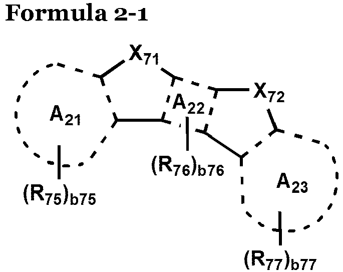 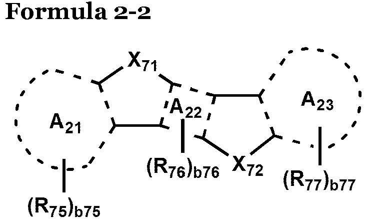 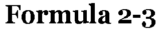 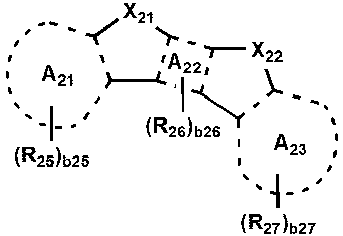 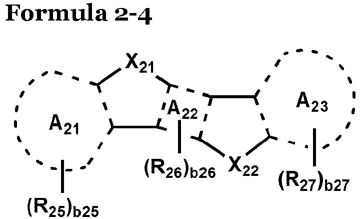 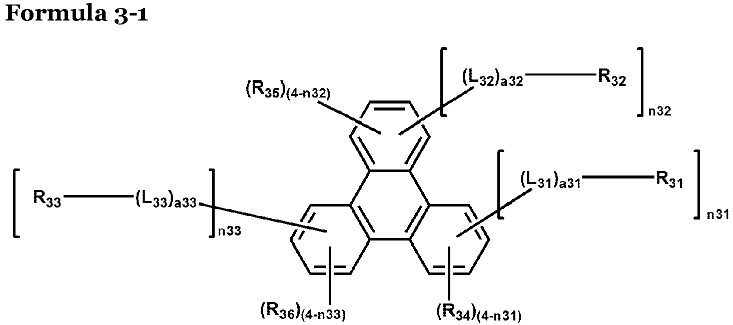 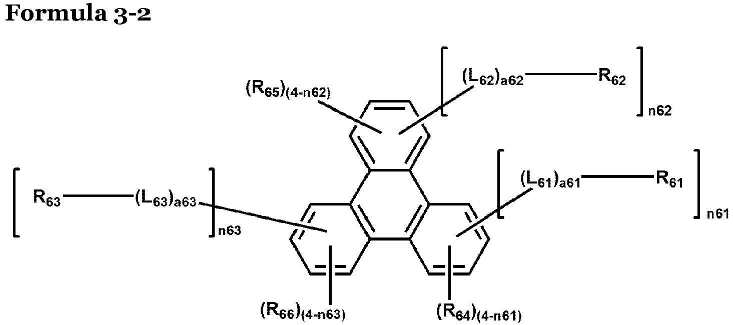 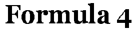 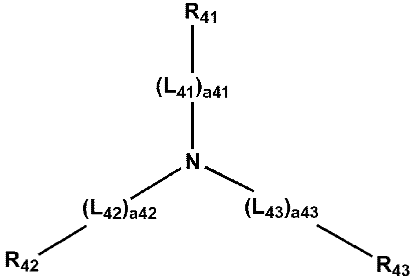 wherein, in Formulae 1-1, 1-2, 2-1 to 2-4, 3-1, 3-2, and 4,
L₁₁ L₁₃, L₁₄, L₃₁ to L₃₃, L₄₁ to L₄₃, and L₆₁ to L₆₃ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group, provided that one or more L₄₁, one or more L₄₂, and/or one or more L₄₃ is a group represented by Formula 5, 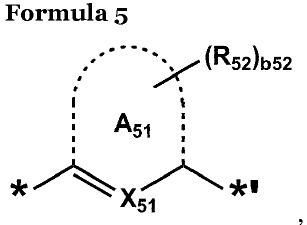
A₁₁ to A₁₄, A₂₁ to A₂₃, and A₅₁ are each independently selected from a C₅-C₂₀ carbocyclic group and a C₁-C₂₀ heterocyclic group,
X₁₁ is selected from O, S, N[(L₁₂)ₐ₁₂-R₁₂], C[(L₁₂)ₐ₁₂-R₁₂](R₁₇), Si[(L₁₂)ₐ₁₂-R₁₂](R₁₇, P[(L₁₂)ₐ₁₂-R₁₂], B[(L₁₂)ₐ₁₂-R₁₂], and P(=O)[(L₁₂)ₐ₁₂-R₁₂],
X₁₂ is selected from O, S, N[(L₁₅)ₐ₁₅-R₁₉]_{,} C[(L₁₅)ₐ₁₅-R₁₉](R₂₀), Si[(L₁₅)ₐ₁₅-R₁₉](R₂₀), P[(L₁₅)ₐ₁₅-R₁₉], B[(L₁₅)ₐ₁₅-R₁₉], and P(=O)[(L₁₅)ₐ₁₅-R₁₉],
X₂₁ is selected from N[(L₂₁)ₐ₂₁-R₂₁], C[(L₂₁)ₐ₂₁-R₂₁](R₂₃), O, and S,
X₂₂ is selected from N[(L₂₂)ₐ₂₂-R₂₂], C[(L₂₂)ₐ₂₂-R₂₂](R₂₄), O, and S,
X₅₁ is selected from N and CR₅₁,
X₇₁ is selected from N[(L₇₁)ₐ₇₁-R₇₁], C[(L₇₁)ₐ₇₁-R₇₁](R₇₃), O, and S,
X₇₂ is selected from N[(L₇₂)ₐ₇₂-R₇₂], C[(L₇₂)ₐ₇₂-R₇₂](R₇₄), O, and S,
L₁₂, L₁₅, L₂₁, L₂₂, L₇₁, and L₇₂ are each independently as defined for L₁₁,
a11 to a15, a21, a22, a31 to a33, a41 to a43, a61 to a63, a71, and a72 are each independently selected from 0, 1, 2, 3, 4, and 5,
wherein when one or more L41 is a group represented by Formula 5, a41 is selected from 1, 2, 3, 4, and 5; when one or more L₄₂ is a group represented by Formula 5, a42 is selected from 1, 2, 3, 4, and 5; and when one or more L₄₃ is a group represented by Formula 5, a43 is selected from 1, 2, 3, 4, and 5,
R₁₁, R₁₃ to R₁₆, R₁₈, R₂₁ to R₂₇, R₃₁ to R₃₆, R₄₁ to R₄₃, R₅₁, R₅₂, R₆₁ to R₆₆, and R₇₁ to R₇₇ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂), wherein at least one selected from R₄₁ to R₄₃ is selected from a substituted or unsubstituted monovalent non-aromatic condensed C8-C60 polycyclic group and a substituted or unsubstituted monovalent non-aromatic condensed 8- to 60-membered heteropolycyclic group,
R₁₂ and R₁₇ are each independently as defined for R₁₁ or are optionally bound to each other to form a C₅-C₂₀ carbocyclic group or a C₁-C₂₀ heterocyclic group,
R₁₉ and R₂₀ are each independently as defined for R₁₁ or are optionally bound to each other to form a C₅-C₂₀ carbocyclic group and a C₁-C₂₀ heterocyclic group,
b13 to b16, b25 to b27, b52, and b75 to b77 are each independently selected from 1, 2, 3, and 4,
n31 to n33 and n61 to n63 are each independently selected from 0, 1, 2, 3, and 4,
* and *' indicate a binding site to an adjacent atom, and
the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed C8-C60 polycyclic group, substituted divalent non-aromatic condensed 8- to 60-membered heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed C8-C60 polycyclic group, and substituted monovalent non-aromatic condensed 8- to 60-membered heteropolycyclic group is substituted with one or more substituents each independently selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

5. The organic light-emitting device of claim 4, wherein A₁₁ to A₁₄, A₂₁ to A₂₃, and A₅₁ are each independently selected from a benzene group, a naphthalene group, a fluorene group, a phenanthrene group, an anthracene group, a triphenylene group, a pyrene group, a chrysene group, a furan group, a thiophene group, a pyrrole group, a pyridine group, a pyrazine group, a pyrimidine group, a pyridazine group, a triazine group, a quinoline group, an isoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a benzofuran group, a benzothiophene group, a dibenzofuran group, a dibenzothiophene group, and a carbazole group.

6. The organic light-emitting device of claim 4 or 5, wherein at least one selected from R₄₁ to R₄₃ is represented by one selected from Formula 4a and 4b: 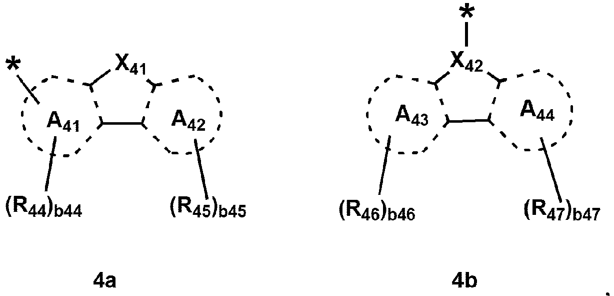 wherein, in Formulae 4a and 4b,
X₄₁ is selected from N(R₄₀₁), B(R₄₀₁), C(R₄₀₁)(R₄₀₂), Si(R₄₀₁)(R₄₀₂), O, and S,
X₄₂ is selected from N, B, C(R₄₀₃), and Si(R₄₀₃),
A₄₁ to A₄₄ are each independently selected from a benzene group, a naphthalene group, a fluorene group, a phenanthrene group, an anthracene group, a triphenylene group, a pyrene group, a chrysene group, a furan group, a thiophene group, a pyrrole group, a pyridine group, a pyrazine group, a pyrimidine group, a pyridazine group, a triazine group, a quinoline group, an isoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a benzofuran group, a benzothiophene group, a dibenzofuran group, a dibenzothiophene group, and a carbazole group,
R₄₄ to R₄₇ are each independently the same as defined for R₄₁ to R₄₃ in claim 4,
b44 to b47 are each independently selected from 1, 2, 3, and 4, and
R₄₀₁ and R₄₀₂ are each independently as defined for R₄₁ to R₄₃ in claim 4 or are
optionally bound to each other to form a C₅-C₂₀ carbocyclic group or a C₁-C₂₀ heterocyclic group.

7. The organic light-emitting device of any one of claims 4 to 6, wherein L₁₁ to L₁₃, L₃₁ to L₃₃, L₇₁, and L₇₂ are each independently selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group, each substituted with at least one selected from deuterium, -F, a cyano group, a methyl group, an ethyl group, an n-propyl group, an iso-propyl group, an n-butyl group, a sec-butyl group, an iso-butyl group, a tert-butyl group, a methoxy group, an ethoxy group, an n-propoxy group, an iso-propoxy group, an n-butoxy group, a sec-butoxy group, an iso-butoxy group, a tert-butoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a thiophenyl group, a furanyl group, a carbazolyl group, a benzofuranyl group, a benzothiophenyl group, a dibenzofuranyl group, a dibenzothiophenyl group, a dibenzosilolyl group, a benzocarbazolyl group, a dibenzocarbazolyl group, -N(Q₃₁)(Q₃₂), -Si(Q₃₁)(Q₃₂)(Q₃₃), and -B(Q₃₁)(Q₃₂), and
L₁₄, L₁₅, L₂₁, L₂₂, and L₆₁ to L₆₃ are each independently selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a pyridinylene group, a pyrazinylene group, a pyrimidinylene group, a pyridazinylene group, a triazinylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a triphenylenylene group, a thiophenylene group, a furanylene group, a pyridinylene group, a pyrazinylene group, a pyrimidinylene group, a pyridazinylene group, a triazinylene group, a carbazolylene group, a benzofuranylene group, a benzothiophenylene group, a dibenzofuranylene group, a dibenzothiophenylene group, a dibenzosilolylene group, a benzocarbazolylene group, and a dibenzocarbazolylene group, each substituted with at least one selected from deuterium, -F, a cyano group, a methyl group, an ethyl group, an n-propyl group, an iso-propyl group, an n-butyl group, a sec-butyl group, an iso-butyl group, a tert-butyl group, a methoxy group, an ethoxy group, an n-propoxy group, an iso-propoxy group, an n-butoxy group, a sec-butoxy group, an iso-butoxy group, a tert-butoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a thiophenyl group, a furanyl group, a pyridinyl group, a pyrazinyl group, a pyrimidinyl group, a pyridazinyl group, a triazinyl group, a carbazolyl group, a benzofuranyl group, a benzothiophenyl group, a dibenzofuranyl group, a dibenzothiophenyl group, a dibenzosilolyl group, a benzocarbazolyl group, a dibenzocarbazolyl group, -N(Q₃₁)(Q₃₂), -Si(Q₃₁)(Q₃₂)(Q₃₃), and -B(Q₃₁)(Q₃₂),
wherein Q₃₁ to Q₃₃ are each independently selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group.

8. The organic light-emitting device of any one of claims 4 to 7, wherein L₄₁ to L₄₃ are each independently selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, dibenzosilolylene group, a benzocarbazolylene group, and a dibenzocarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ are each independently selected from hydrogen, a methyl group, an ethyl group, an n-propyl group, an iso-propyl group, a tert-butyl group, a phenyl group, a biphenyl group, and a terphenyl group,
provided that at least one selected from L₄₁ to L₄₃ is a group represented by Formula 5 as defined in claim 4.

9. The organic light-emitting device of any one of claims 4 to 8, wherein L₄₁ to L₄₃ are each independently selected from groups represented by Formulae 4-1 to 4-31: 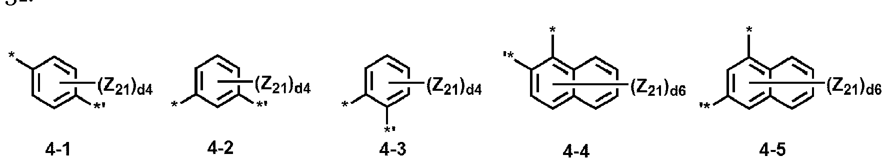 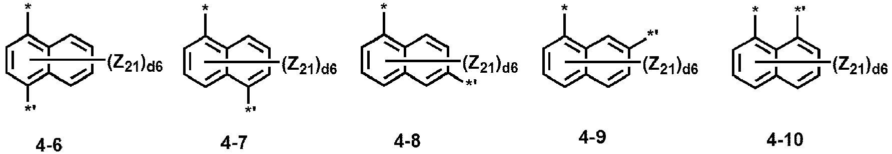 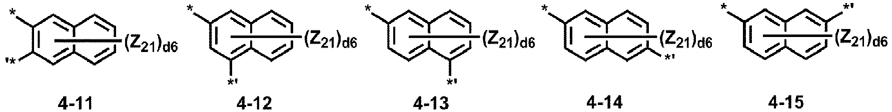 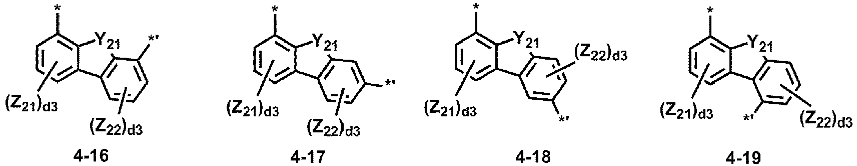 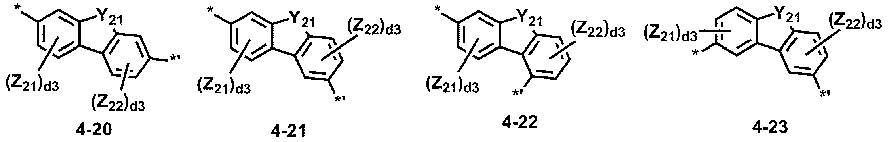 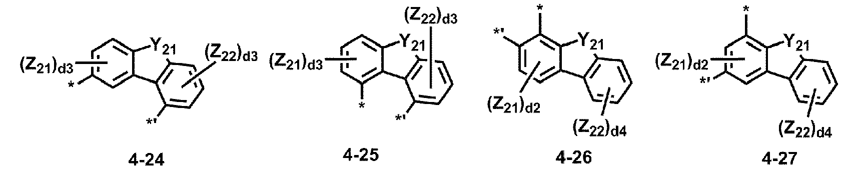 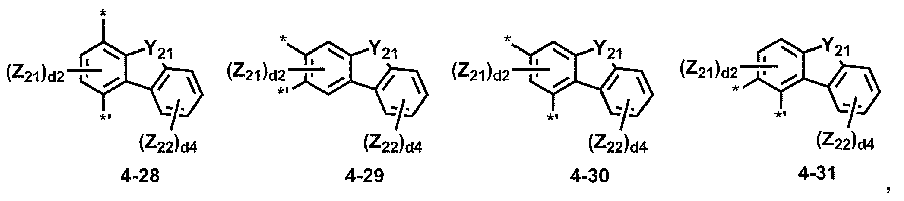 wherein, in Formulae 4-1 to 4-31,
Y₂₁ is selected from O, S, N(R₄₃), C(R₄₃)(R₄₄), and Si(R₄₃)(R₄₄),
Z₂₁ and Z₂₂ are each independently selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₃₁ to Q₃₃ are each independently selected from hydrogen, a methyl group, an ethyl group, an n-propyl group, an iso-propyl group, a tert-butyl group, a phenyl group, a biphenyl group, and a terphenyl group,
d2 is an integer selected from 1 and 2, d3 is an integer selected from 1 to 3, d4 is an integer selected from 1 to 4, d6 is an integer selected from 1 to 6,
R₄₃ is as defined in claim 4 or claim 6 and R₄₄ is as defined in claim 6, and
* and *' each independently indicate a binding site to an adjacent atom;
provided that at least one selected from L₄₁ to L₄₃ is a group represented by Formula 4-2, 4-5, 4-12, 4-27 and 4-30.

10. The organic light-emitting device of any one of claims 4 to 9, wherein Formula 5 is represented by one selected from Formulae 4-2, 4-5, 4-27, and 4-30 as defined in claim 9.

11. The organic light-emitting device of any one of claims 4 to 10, wherein
R₁₁ to R₁₇, R₃₁ to R₃₆, R₅₁, R₅₂, and R₇₁ to R₇₇ are each independently a hole transporting group, and
R₁₈ to R₂₇, R₄₁ to R₄₇, and R₆₁ to R₆₆ are each independently a hole transporting group or an electron transporting group;
wherein the hole transporting group is preferaby selected from a C₁-C₂₀ alkyl group, -Si(Q₁)(Q₂)(Q₃), -N(Q₁)(Q₂), and a group represented by any of Formulae 5-1 to 5-19: 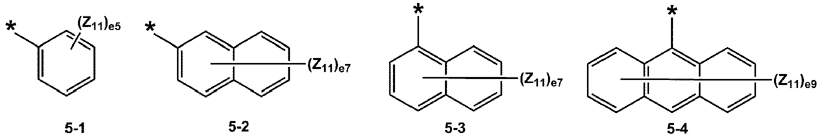 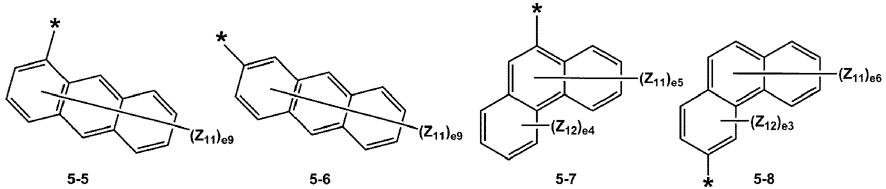 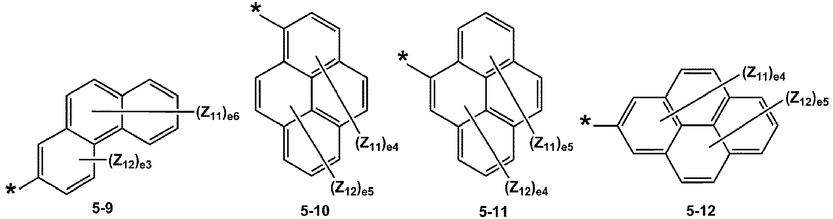 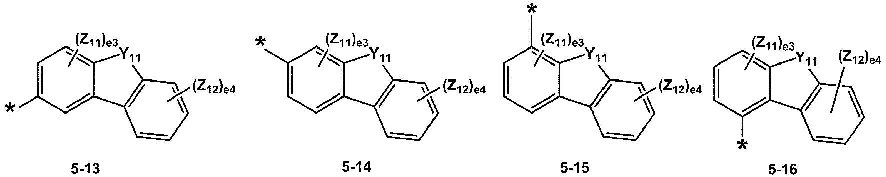 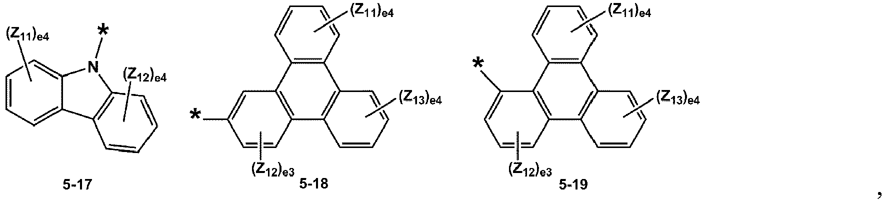 wherein, in Formulae 5-1 to 5-19,
Y₁₁ is selected from O, S, C(Z₁₃)(Z₁₄), N(Z₁₃), and Si(Z₁₃)(Z₁₄),
Z₁₁ to Z₁₄ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a benzofuranyl group, a benzothiophenyl group, a benzosilolyl group, an isobenzothiazolyl group, a dibenzofuranyl group, a dibenzothiophenyl group, a dibenzosilolyl group, a carbazolyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂); and
a phenyl group, a biphenyl group, a terphenyl group, a naphthyl group, a dibenzofuranyl group, a dibenzothiophenyl group, a dibenzosilolyl group, a carbazolyl group, a benzocarbazolyl group, and a dibenzocarbazolyl group, each substituted with at least one selected from a C₁-C₂₀ alkyl group, a C₁-C₂₀ alkoxy group, a phenyl group, a biphenyl group, a terphenyl group, a naphthyl group, a carbazolyl group, a fluorenyl group, -Si(Q₂₁)(Q₂₂)(Q₂₃), and -N(Q₂₁)(Q₂₂),
wherein Q₁ to Q₃, Q₂₁ to Q₂₃, and Q₃₁ to Q₃₃ are each independently selected from a C₁-C₁₀ alkyl group, a C₁-C₁₀ alkoxy group, a phenyl group, a biphenyl group, a terphenyl group, and a naphthyl group,
e₃ is an integer selected from 1 to 3, e4 is an integer selected from 1 to 4, e5 is an integer selected from 1 to 5, e6 is an integer selected from 1 to 6, e7 is an integer selected from 1 to 7, e9 is an integer selected from 1 to 9, and
* indicates a binding site to an adjacent atom;
and wherein the electron transporting group is preferably selected from the group consisting of:
a cyano group, -F, and -CF₃;
a C₆-C₆₀ aryl group substituted with at least one selected from a cyano group, -F, and -CF₃; and
a substituted or unsubstituted C₁-C₆₀ heterocyclic group having at least one *=N-*' moiety as a ring-forming moiety;
more preferably wherein the electron transporting group is selected from -CN, - CF₃, and a group represented by any of Formulae 6-1 to 6-128: 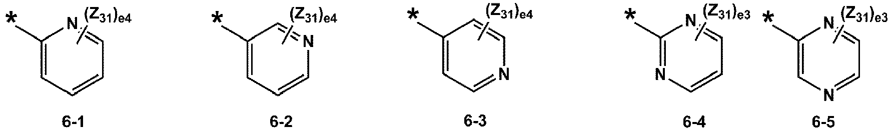 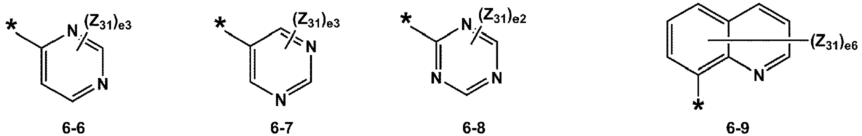 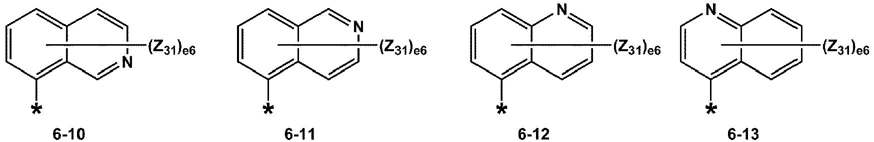 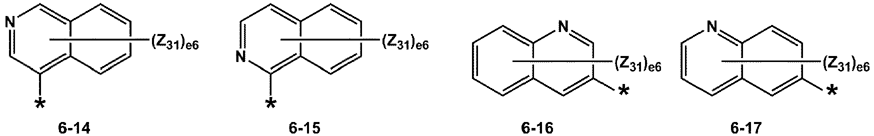 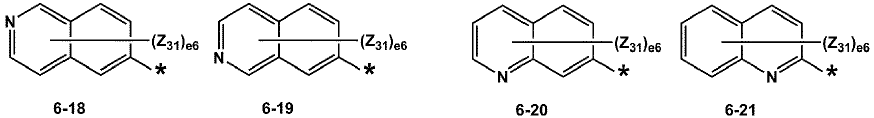 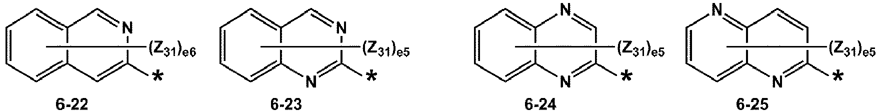 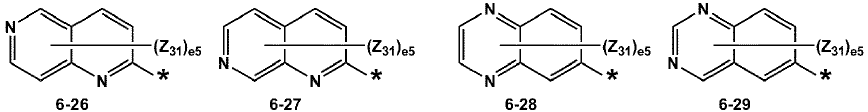 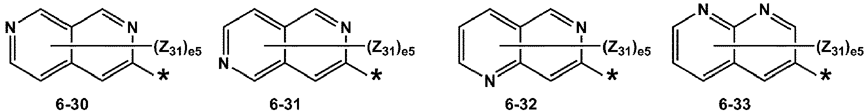 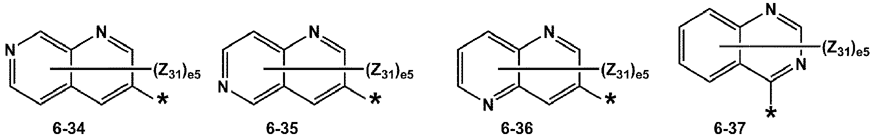 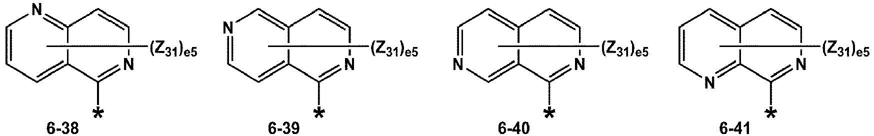 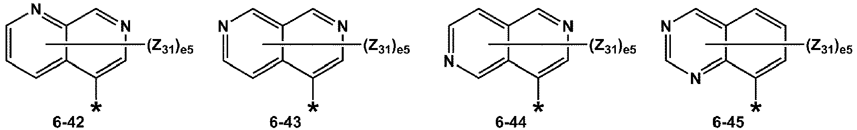 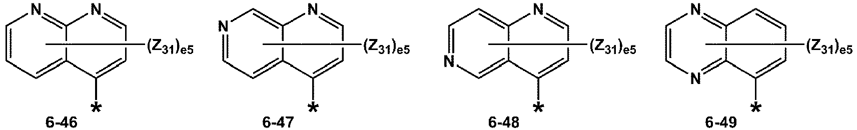 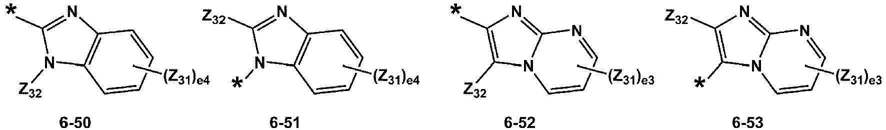 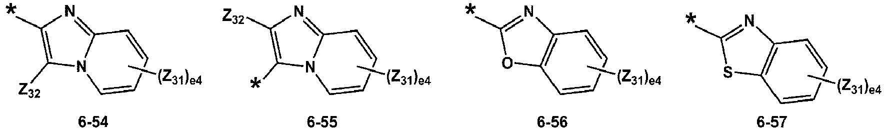 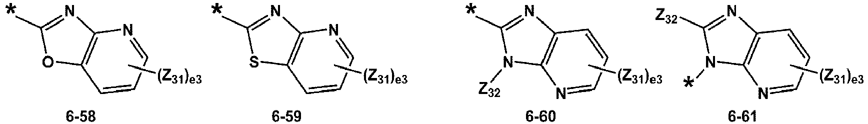 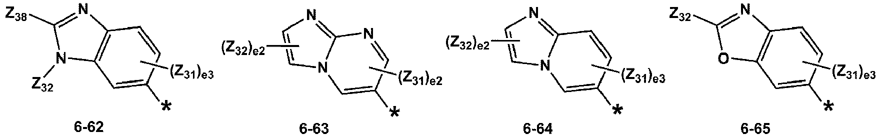 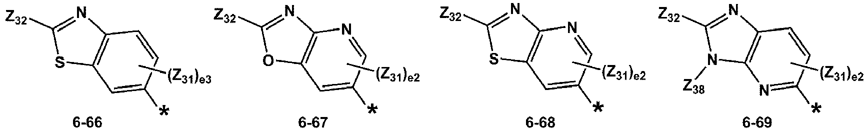 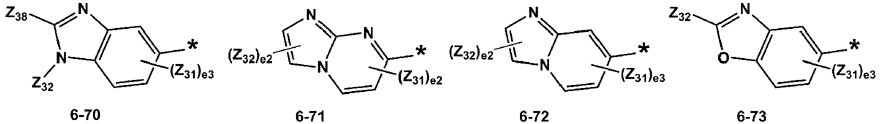 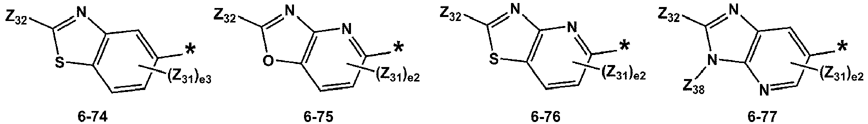 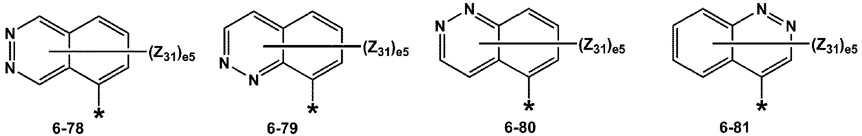 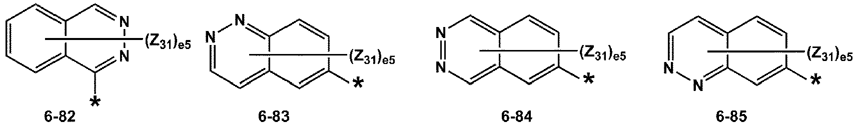 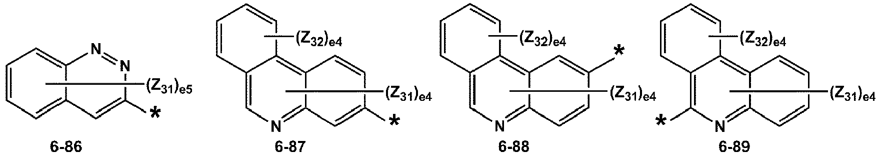 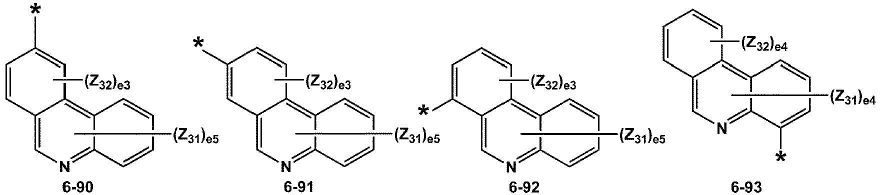 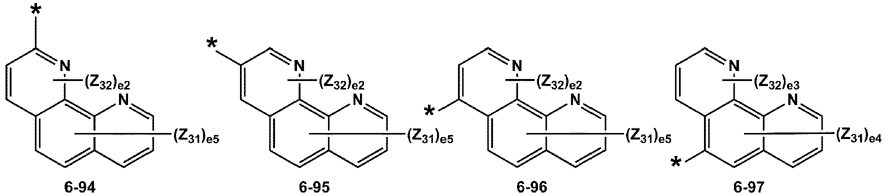 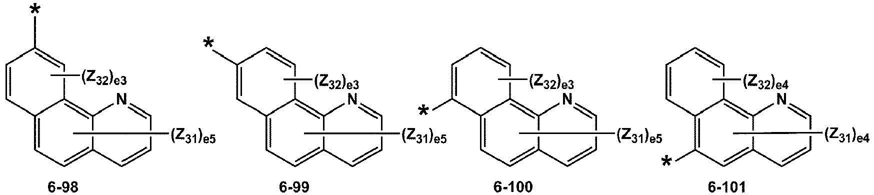 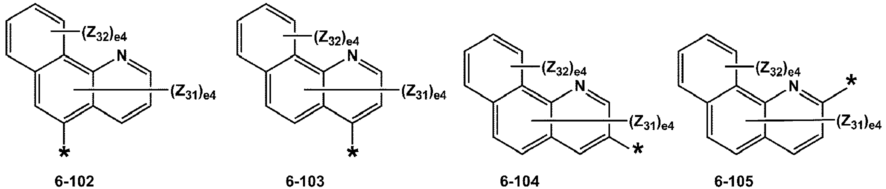 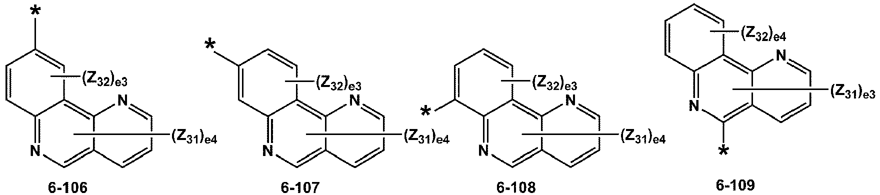 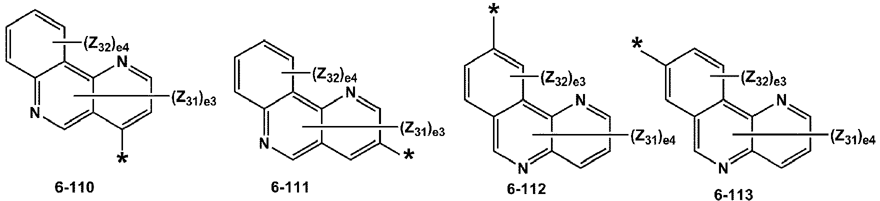 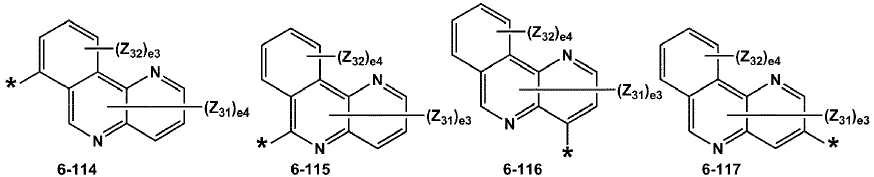 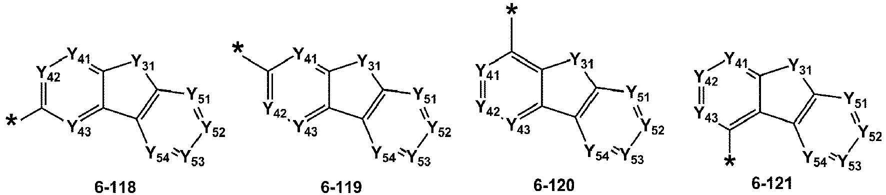 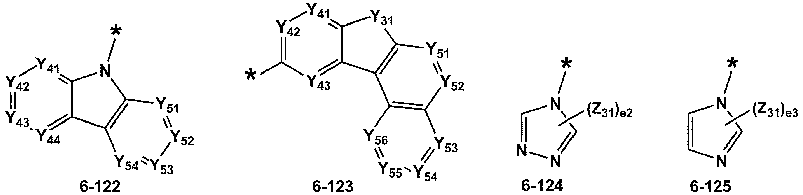 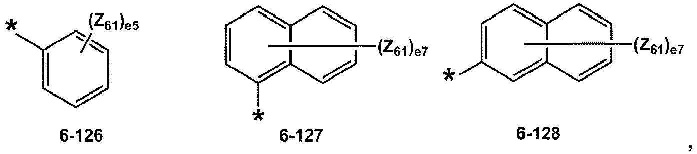 wherein, in Formulae 6-1 to 6-128,
Y₃₁ is selected from O, S, C(Z₃₃)(Z₃₄), N(Z₃₃), and Si(Z₃₃)(Z₃₄),
Y₄₁ is N or C(Z₄₁), Y₄₂ is N or C(Z₄₂), Y₄₃ is N or C(Z₄₃), Y₄₄ is N or C(Z₄₄), Y₅₁ is N or C(Z₅₁), Y₅₂ is N or C(Z₅₂), Y₅₃ is N or C(Z₅₃), Y₅₄ is N or C(Z₅₄), Y₅₅ is N or C(Z₅₅), Y₅₆ is N or C(Z₅₆),
at least one selected from Y₄₁ to Y₄₃ and Y₅₁ to Y₅₄ in Formulae 6-118 to 6-121 is N, at least one selected from Y₄₁ to Y₄₄ and Y₅₁ to Y₅₄ in Formula 6-122 is N, at least one selected from Y₄₁ to Y₄₃ and Y₅₁ to Y₅₆ in Formula 6-123 is N,
Z₃₁ to Z₃₄, Z₃₈, Z₄₁ to Z₄₄, and Z₅₁ to Z₅₆ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂); and
a phenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₂₀ alkyl group, a C₁-C₂₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, a quinazolinyl group, a carbazolyl group, a fluorenyl group, -Si(Q₂₁)(Q₂₂)(Q₂₃), and -N(Q₂₁)(Q₂₂),
Z₆₁ is selected from hydrogen, a cyano group, -F, and -CF₃, and at least one Z₆₁ is selected from a cyano group, -F, and -CF₃,
wherein Q₂₁ to Q₂₃ and Q₃₁ to Q₃₃ are each independently selected from a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group,
e2 is an integer selected from 1 and 2, e3 is an integer selected from 1 to 3, e4 is an integer selected from 1 to 4, e5 is an integer selected from 1 to 5, e6 is an integer selected from 1 to 6, e7 is an integer selected from 1 to 7, and
* indicates a binding site to an adjacent atom.

12. The organic light-emitting device of any one of claims 4 to 11, wherein
the first compound is represented by Formula 1-11, and
the second compound is represented by Formula 1-21: 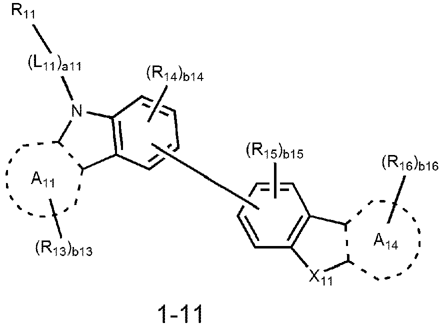 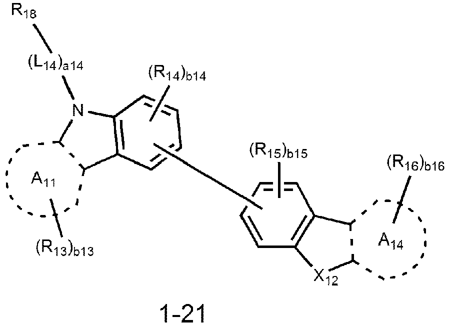 wherein, in Formulae 1-11 and 1-21,
A₁₃, A₁₄, X₁₁, X₁₂, L₁₁, L₁₄, a11, a14, R₁₁, R₁₃ to R₁₆, R₁₈, and b13 to b16 are as defined in any one of claims 4, 5, 7 and 11 in connection with Formulae 1-1 and 1-2.

13. The organic light-emitting device of any one of claims 4 to 11, wherein
the first compound is represented by one of Formulae 2-11 to 2-15 and 2-21 to 2-23, and
the second compound is represented by one of Formulae 2-31 to 2-35 and 2-41 to 2-43: 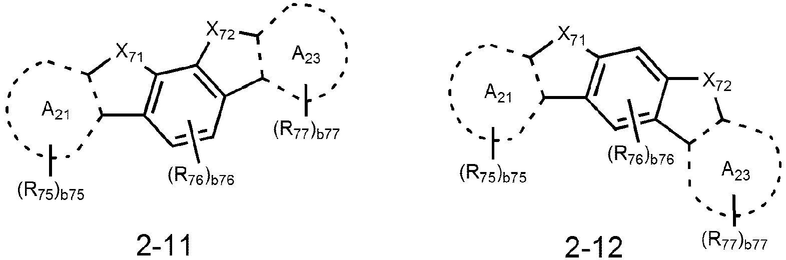 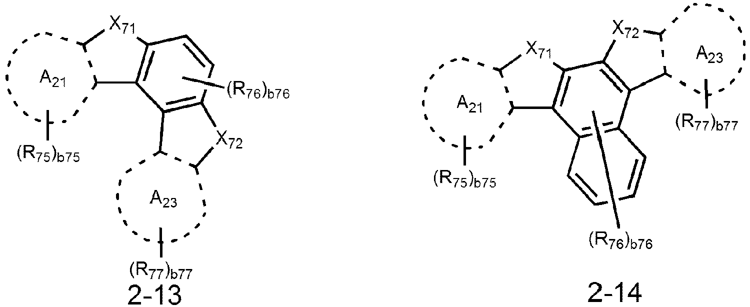 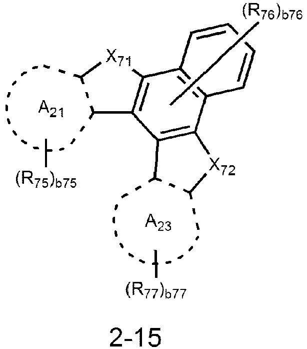 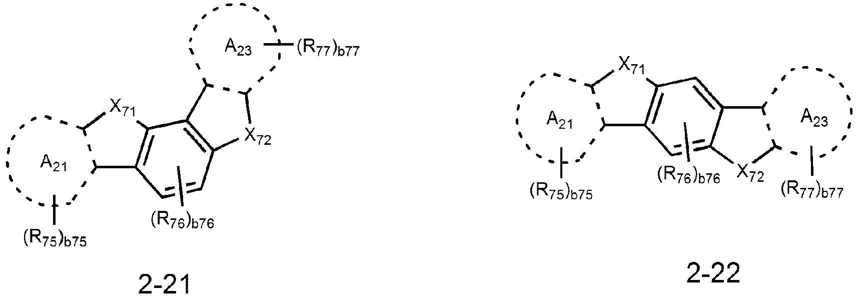 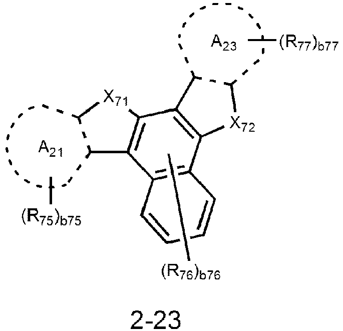 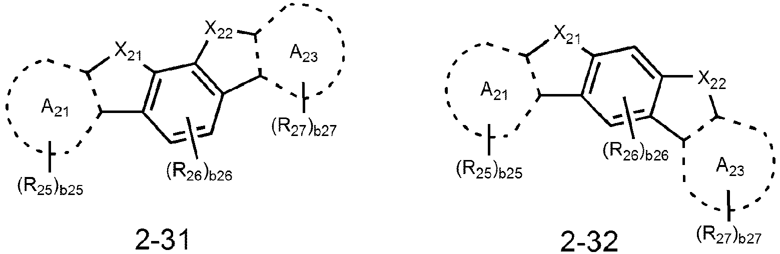 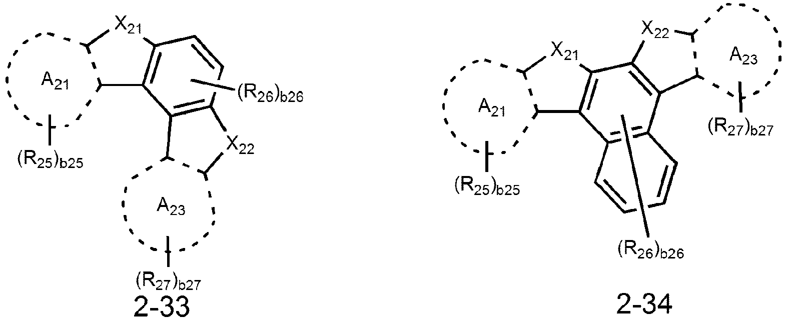 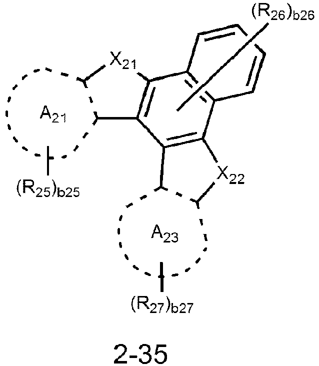 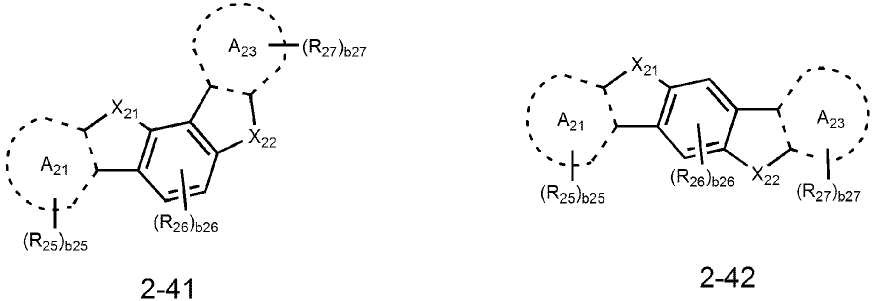 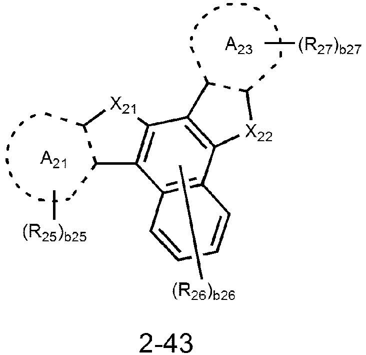 wherein, in Formulae 2-11 to 2-15, 2-21 to 2-23, 2-31 to 2-35, and 2-41 to 2-43, A₂₁, A₂₃, X₂₁, X₂₂, X₇₁, X₇₂, R₂₅ to R₂₇, R₇₅ to R₇₇, b25 to b27, and b75 to b77 are as defined in any one of claims 4, 5, 7 and 11 in connection with Formulae 2-1 to 2-4.

14. The organic light-emitting device of any one of the preceding claims, wherein:
(a) a weight ratio of the first compound to the second compound is in a range of about 1:99 to about 99:1; and/or
(b) the emission layer comprises the fourth compound, and the fourth compound comprises a phosphorescent dopant; and/or
(c) the fourth compound comprises a metal selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm); and/or
(d) a weight ratio of the first compound to the second compound is in a range of about 20:80 to about 80:20.

15. The organic light-emitting device of any one of claims 1, 2, 3 and 14, wherein
the first compound comprises at least one selected from the group consisting of Compound B-125, Compound B-167, and Compound E-165,
the second compound is selected from the group consisting of Compound C-109, Compound D-124, and Compound A-161, and
the third compound is selected from the group consisting of Compounds F101 to F103:

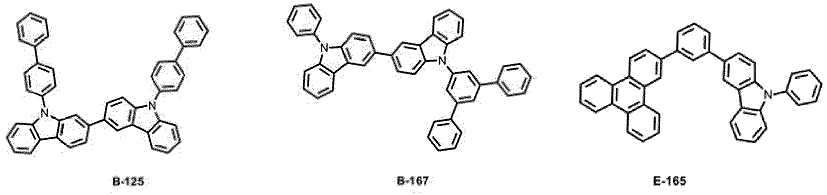

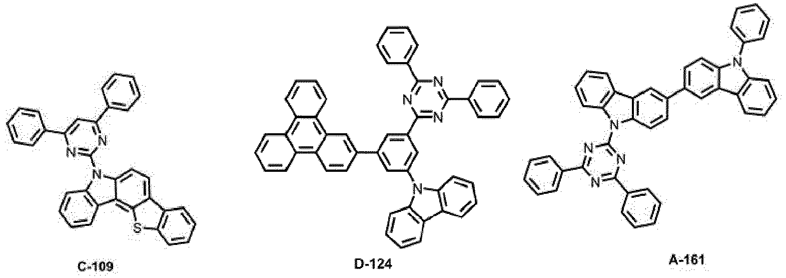

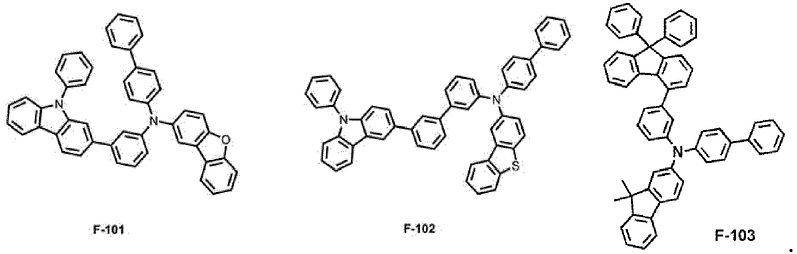

## Patentansprüche

1. Organische lichtemittierende Vorrichtung (10), umfassend:
eine erste Elektrode (110);
eine zweite Elektrode (190), die der ersten Elektrode gegenüberliegt; und
eine organische Schicht (150) zwischen der ersten Elektrode und der zweiten Elektrode, wobei die organische Schicht eine Emissionsschicht und einen Lochtransportbereich zwischen der ersten Elektrode und der Emissionsschicht umfasst,
wobei die Emissionsschicht eine erste Verbindung als Wirt, eine zweite Verbindung als Wirt und eine vierte Verbindung als Dotant umfasst, und der Lochtransportbereich eine dritte Verbindung umfasst,
die erste Verbindung bis die vierte Verbindung erfüllen die Gleichungen 1 bis 8: ${E}_{1 , LUMO} \geq {E}_{2 , LUMO} + 0,15 Elektronenvolt \left(eV\right)$ ${E}_{1 , HOMO} \geq {E}_{2 , HOMO} + 0,15 eV$ ${E}_{1 , T 1} \geq {E}_{4 , T 1}$ ${E}_{2 , T 1} \geq {E}_{4 , T 1}$ ${E}_{3 , T 1} \geq {E}_{4 , T 1}$ ${E}_{3 , LUMO} \geq {E}_{2 , LUMO} + 0,1 eV$ $- 5.6 eV \geq {E}_{3 , HOMO}$ ${E}_{gap 1} \geq {E}_{gap 3} ,$ wobei, in den Gleichungen 1 bis 8,
E_{1, LUMO} ein Energieniveau des niedrigsten unbesetzten Molekülorbitals (LUMO) der ersten Verbindung bezeichnet,
E_{2, LUMO} ein LUMO-Energieniveau der zweiten Verbindung bezeichnet,
E_{3, LUMO} ein LUMO-Energieniveau der dritten Verbindung bezeichnet,
E_{1, HOMO} ein Energieniveau des höchsten besetzten Molekülorbitals (HOMO) der ersten Verbindung bezeichnet,
E_{2, HOMO} ein HOMO-Energieniveau der zweiten Verbindung bezeichnet,
E_{3, HOMO} ein HOMO-Energieniveau der dritten Verbindung bezeichnet,
E_{1, T1} ein niedrigstes angeregtes Triplett-Energieniveau der ersten Verbindung bezeichnet,
E_{2, T1} ein niedrigstes angeregtes Triplett-Energieniveau der zweiten Verbindung bezeichnet,
E_{3, T1} ein niedrigstes angeregtes Triplett-Energieniveau der dritten Verbindung bezeichnet,
E_{4, T1} ein niedrigstes angeregtes Triplett-Energieniveau der vierten Verbindung bezeichnet,
E_{gap1} einen Abstand zwischen dem LUMO-Energieniveau der ersten Verbindung und dem HOMO-Energieniveau der ersten Verbindung bezeichnet, und
E_{gap3} einen Abstand zwischen dem LUMO-Energieniveau der dritten Verbindung und dem HOMO-Energieniveau der dritten Verbindung bezeichnet;
wobei das in den Gleichungen 1 bis 8 verwendete HOMO-Energieniveau, LUMO-Energieniveau und niedrigste angeregte Triplett-Energieniveau (T1) einer Verbindung gemäß den folgenden Verfahren ermittelt werden:
| | |
|---|---|
| HOMO | eine graphische Darstellung des Potenzials (Volt, V) gegen den Strom (Ampere, A) einer Verbindung wird mittels zyklischer Voltammetrie (CV) erhalten (Elektrolyt: 0,1 molares (0,1 M) Bu₄NClO₄/ Lösungsmittel: CH₂Cl₂/ Elektrode: 3-Elektroden-System (Arbeitselektrode: GC, Bezugselektrode: Ag/AgCl, Hilfselektrode: Pt)), und ein HOMO-Energieniveau der Verbindung wird aus dem Beginn des Abfalls der Kurve ermittelt |
| LUMO | eine Verbindung wird mit Toluol in eine Konzentration von 1 · 10⁻⁴ M verdünnt, und ein UV-Absorptionsspektrum davon wurde bei Raumtemperatur durch Verwendung eines Spektrometers UV-350 von Shimadzu gemessen, und ein LUMO-Energieniveau der Verbindung wird durch Verwendung einer optischen Bandlücke (Eg) aus einer Kante des Absorptionsspektrums ermittelt |
| T1 | ein Gemisch einer Verbindung, verdünnt mit Toluol in eine Konzentration von etwa 1 · 10⁻⁴ M, wird in eine Quarzzelle gefüllt, die resultierende Quarzzelle wird in flüssigen Stickstoff (bei T = 77 K) eingebracht, ein Tieftemperatur-Photolumineszenzspektrum davon wird durch Verwendung eines Gerätes zur Messung der Photolumineszenz gemessen, und T1 wird ermittelt durch Auswertung der nur bei einer niedrigen Temperatur beobachteten Peaks, wenn das erhaltene Tieftemperatur-Photolumineszenzspektrum mit einem bei Raumtemperatur gemessenen Photolumineszenzspektrum verglichen wird. |

2. Organische lichtemittierende Vorrichtung nach Anspruch 1, wobei die erste Verbindung bis die vierte Verbindung die Gleichungen 1a bis 6a erfüllen: ${E}_{1 , LUMO} \geq {E}_{2 , LUMO} + 0,2 eV$ ${E}_{1 , HOMO} \geq {E}_{2 , HOMO} + 0,2 eV$ ${E}_{1 , T 1} \geq {E}_{4 , T 1} + 0,1 eV$ ${E}_{2 , T 1} \geq {E}_{4 , T 1} + 0,1 eV$ ${E}_{3 , T 1} \geq {E}_{4 , T 1} + 0,1 eV$ ${E}_{3 , LUMO} \geq {E}_{2 , LUMO} + 0,2 eV .$

3. Organische lichtemittierende Vorrichtung nach Anspruch 1 oder 2, wobei (a) und/oder (b) gelten:
(a) der Lochtransportbereich umfasst weiterhin einen p-Dotanten mit einem LUMO-Niveau von etwa -3,5 eV oder weniger, wobei der p-Dotant mindestens eines, ausgewählt aus einem Chinonderivat, einem Metalloxid und einer Cyanogruppen enthaltenden Verbindung, umfasst,
(b) der Lochtransportbereich umfasst eine erste Schicht, die erste Schicht umfasst die dritte Verbindung, und die erste Schicht ist in direktem Kontakt mit der Emissionsschicht;
vorzugsweise wobei der Lochtransportbereich mindestens eine Schicht, ausgewählt aus einer Lochinjektionsschicht, einer Lochtransportschicht, einer Emissionshilfsschicht und einer Elektronenblockierschicht, umfasst, und die erste Schicht die Emissionshilfsschicht ist.

4. Organische lichtemittierende Vorrichtung nach einem der vorangehenden Ansprüche, wobei
die erste Verbindung durch eine der Formeln 1-1, 2-1, 2-2 und 3-1 dargestellt wird,
die zweite Verbindung durch eine der Formeln 1-2, 2-3, 2-4 und 3-2 dargestellt wird, und
die dritte Verbindung durch Formel 4 dargestellt wird: 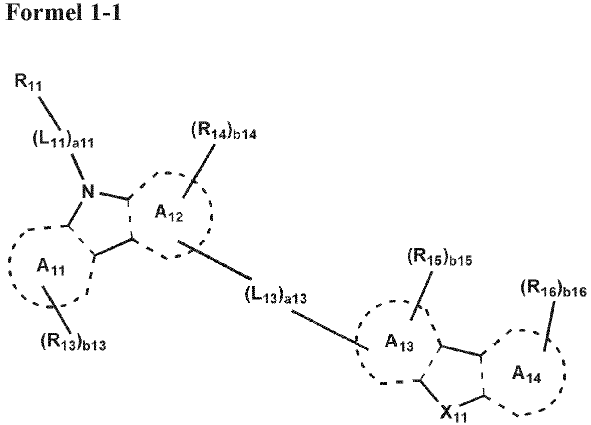 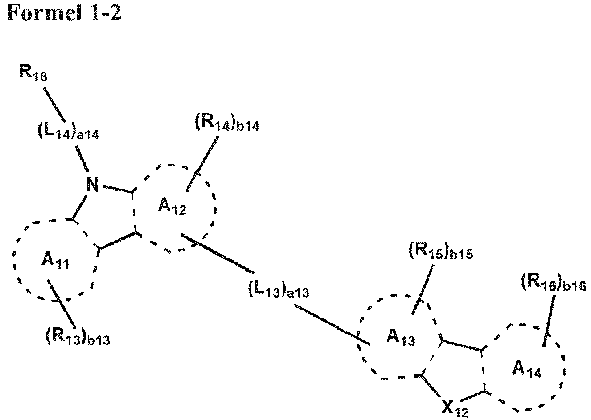 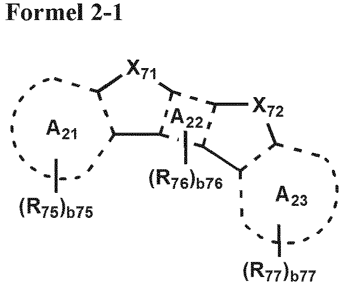 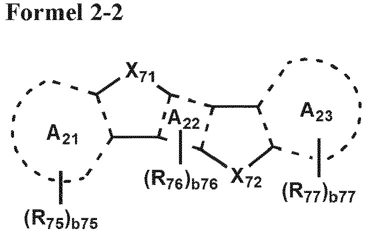 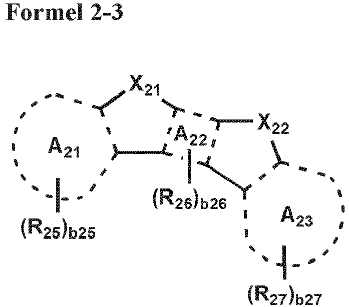 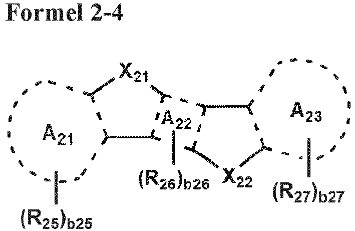 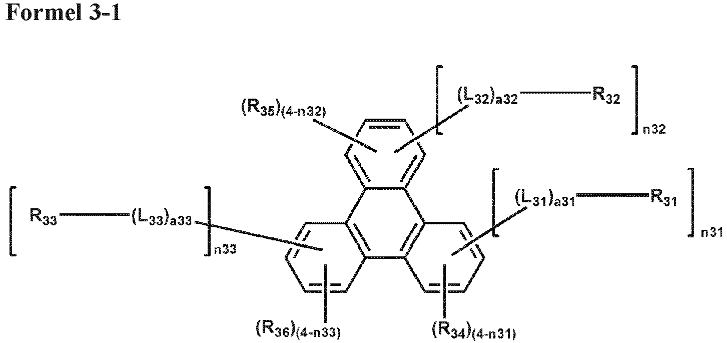 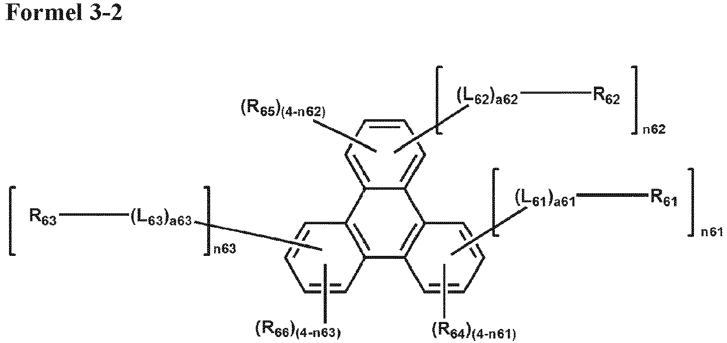 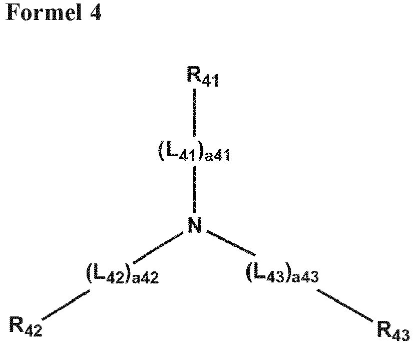 wobei, in den Formeln 1-1, 1-2, 2-1 bis 2-4, 3-1, 3-2 und 4,
L₁₁, L₁₃, L₁₄, L₃₁ bis L₃₃, L₄₁ bis L₄₃ und L₆₁ bis L₆₃ jeweils unabhängig voneinander ausgewählt sind aus einem substituierten oder unsubstituierten C₃-C₁₀-Cycloalkylenrest, einem substituierten oder unsubstituierten C₁-C₁₀-Heterocycloalkylenrest, einem substituierten oder unsubstituierten C₃-C₁₀-Cycloalkenylenrest, einem substituierten oder unsubstituierten C₁-C₁₀-Heterocycloalkenylenrest, einem substituierten oder unsubstituierten C₆-C₆₀-Arylenrest, einem substituierten oder unsubstituierten C₁-C₆₀-Heteroarylenrest, einem substituierten oder unsubstituierten zweiwertigen, nichtaromatischen, kondensierten polycyclischen C8-C60-Rest und einem substituierten oder unsubstituierten zweiwertigen, nichtaromatischen, kondensierten heteropolycyclischen 8- bis 60-gliedrigen Rest, mit der Maßgabe, dass ein oder mehrere L₄₁, ein oder mehrere L₄₂ und/oder ein oder mehrere L₄₃ eine durch Formel 5 dargestellte Gruppe sind, 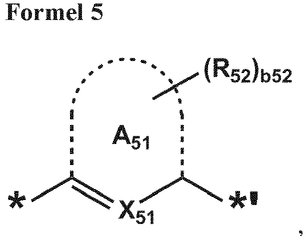
A₁₁ bis A₁₄, A₂₁ bis A₂₃ und A₅₁ jeweils unabhängig voneinander aus einem carbocyclischen C₅-C₂₀-Rest und einem heterocyclischen C₁-C₂₀-Rest ausgewählt sind,
X₁₁ aus O, S, N[(L₁₂)ₐ₁₂-R₁₂], C[(L₁₂)ₐ₁₂-R₁₂](R₁₇), Si[(L₁₂)ₐ₁₂-R₁₂](R₁₇), P[(L₁₂)ₐ₁₂-R₁₂], B[(L₁₂)ₐ₁₂-R₁₂] und P(=O)[(L₁₂)ₐ₁₂-R₁₂] ausgewählt ist,
X₁₂ aus O, S, N[(L₁₅)ₐ₁₅-R₁₉], C[(L₁₅)ₐ₁₅-R₁₉](R₂₀), Si[(L₁₅)ₐ₁₅-R₁₉](R₂₀), P[(L₁₅)ₐ₁₅-R₁₉], B[(L₁₅)ₐ₁₅-R₁₉] und P(=O)[(L₁₅)ₐ₁₅-R₁₉] ausgewählt ist,
X₂₁ aus N[(L₂₁)ₐ₂₁-R₂₁], C(L₂₁)ₐ₂₁-R₂₁](R₂₃), O und S ausgewählt ist,
X₂₂ aus N[(L₂₂)ₐ₂₂-R₂₂], C(L₂₂)ₐ₂₂-R₂₂](R₂₄), O und S ausgewählt ist,
X₅₁ aus N und CR₅₁ ausgewählt ist,
X₇₁ aus N[(L₇₁)ₐ₇₁-R₇₁], C(L₇₁)ₐ₇₁-R₇₁](R₇₃), O und S ausgewählt ist,
X₇₂ aus N[(L₇₂)ₐ₇₂-R₇₂], C(L₇₂)ₐ₇₂-R₇₂](R₇₄), O und S ausgewählt ist,
L₁₂, L₁₅, L₂₁, L₂₂, L₇₁ und L₇₂ jeweils unabhängig voneinander wie bei L₁₁ definiert sind,
a11 bis a15, a21, a22, a31 bis a33, a41 bis a43, a61 bis a63, a71 und a72 jeweils unabhängig voneinander aus 0, 1, 2, 3, 4 und 5 ausgewählt sind,
wobei, wenn ein oder mehrere L₄₁ eine durch Formel 5 dargestellte Gruppe sind, a41 aus 1, 2, 3, 4 und 5 ausgewählt ist; wenn ein oder mehrere L₄₂ eine durch Formel 5 dargestellte Gruppe sind, a42 aus 1, 2, 3, 4 und 5 ausgewählt ist; und wenn ein oder mehrere L₄₃ eine durch Formel 5 dargestellte Gruppe sind, a43 aus 1, 2, 3, 4 und 5 ausgewählt ist,
R₁₁, R₁₃ bis R₁₆, R₁₈, R₂₁ bis R₂₇, R₃₁ bis R₃₆, R₄₁ bis R₄₃, R₅₁, R₅₂, R₆₁ bis R₆₆ und R₇₁ bis R₇₇ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem substituierten oder unsubstituierten C₁-C₆₀-Alkylrest, einem substituierten oder unsubstituierten C₂-C₆₀-Alkenylrest, einem substituierten oder unsubstituierten C₂-C₆₀-Alkinylrest, einem substituierten oder unsubstituierten C₁-C₆₀-Alkoxyrest, einem substituierten oder unsubstituierten C₃-C₁₀-Cycloalkylrest, einem substituierten oder unsubstituierten C₁-C₁₀-Heterocycloalkylrest, einem substituierten oder unsubstituierten C₃-C₁₀-Cycloalkenylrest, einem substituierten oder unsubstituierten C₁-C₁₀-Heterocycloalkenylrest, einem substituierten oder unsubstituierten C₆-C₆₀-Arylrest, einem substituierten oder unsubstituierten C₆-C₆₀-Aryloxyrest, einem substituierten oder unsubstituierten C₆-C₆₀-Arylthiorest, einem substituierten oder unsubstituierten C₁-C₆₀-Heteoarylrest, einem substituierten oder unsubstituierten einwertigen, nichtaromatischen, kondensierten polycyclischen C8-C60-Rest, einem substituierten oder unsubstituierten einwertigen, nichtaromatischen, kondensierten heteropolycyclischen 8- bis 60-gliedrigen Rest, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂), wobei mindestens eines, ausgewählt aus R₄₁ bis R₄₃, aus einem substituierten oder unsubstituierten einwertigen, nichtaromatischen, kondensierten polycyclischen C8-C60-Rest und einem substituierten oder unsubstituierten einwertigen, nichtaromatischen, kondensierten heteropolycyclischen 8- bis 60-gliedrigen Rest ausgewählt ist,
R₁₂ und R₁₇ jeweils unabhängig voneinander wie bei R₁₁ definiert sind oder gegebenenfalls miteinander verbunden sind, um einen carbocyclischen C₅-C₂₀-Rest oder einen heterocyclischen C₁-C₂₀-Rest zu bilden,
R₁₉ und R₂₀ jeweils unabhängig voneinander wie bei R₁₁ definiert sind oder gegebenenfalls miteinander verbunden sind, um einen carbocyclischen C₅-C₂₀-Rest und einen heterocyclischen C₁-C₂₀-Rest zu bilden,
b13 bis b16, b25 bis b27, b52 und b75 bis b77 jeweils unabhängig voneinander aus 1, 2, 3 und 4 ausgewählt sind,
n31 bis n33 und n61 bis n63 jeweils unabhängig voneinander aus 0, 1, 2, 3 und 4 ausgewählt sind,
* und *' eine Bindungsstelle zu einem benachbarten Atom kennzeichnen, und
der substituierte C₃-C₁₀-Cycloalkylenrest, substituierte C₁-C₁₀-Heterocycloalkylenrest, substituierte C₃-C₁₀-Cycloalkenylenrest, substituierte C₁-C₁₀-Heterocycloalkenylenrest, substituierte C₆-C₆₀-Arylenrest, substituierte C₁-C₆₀-Heteroarylenrest, substituierte zweiwertige, nichtaromatische, kondensierte polycyclische C8-C60-Rest, substituierte zweiwertige, nichtaromatische, kondensierte heteropolycyclische 8- bis 60-gliedrige Rest, substituierte C₁-C₆₀-Alkylrest, substituierte C₂-C₆₀-Alkenylrest, substituierte C₂-C₆₀-Alkinylrest, substituierte C₁-C₆₀-Alkoxyrest, substituierte C₃-C₁₀-Cycloalkylrest, substituierte C₁-C₁₀-Heterocycloalkylrest, substituierte C₃-C₁₀-Cycloalkenylrest, substituierte C₁-C₁₀-Heterocycloalkenylrest, substituierte C₆-C₆₀-Arylrest, substituierte C₆-C₆₀-Aryloxyrest, substituierte C₆-C₆₀-Arylthiorest, substituierte C₁-C₆₀-Heteoarylrest, substituierte einwertige, nichtaromatische, kondensierte polycyclische C8-C60-Rest und substituierte einwertige, nichtaromatische, kondensierte heteropolycyclische 8- bis 60-gliedrige Rest substituiert ist mit einem oder mehreren Substituenten, jeweils unabhängig voneinander ausgewählt aus der Gruppe bestehend aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₆₀-Alkylrest, einem C₂-C₆₀-Alkenylrest, einem C₂-C₆₀-Alkinylrest und einem C₁-C₆₀-Alkoxyrest;
einem C₁-C₆₀-Alkylrest, einem C₂-C₆₀-Alkenylrest, einem C₂-C₆₀-Alkinylrest und einem C₁-C₆₀-Alkoxyrest, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteoarylrest, einem einwertigen, nichtaromatischen, kondensierten polycyclischen C8-C60-Rest, einem einwertigen, nichtaromatischen, kondensierten heteropolycyclischen 8- bis 60-gliedrigen Rest, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteoarylrest, einem einwertigen, nichtaromatischen, kondensierten polycyclischen C8-C60-Rest, einem einwertigen, nichtaromatischen, kondensierten heteropolycyclischen 8- bis 60-gliedrigen Rest, einer Biphenylgruppe und einer Terphenylgruppe;
einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteoarylrest, einem einwertigen, nichtaromatischen, kondensierten polycyclischen C8-C60-Rest, einem einwertigen, nichtaromatischen, kondensierten heteropolycyclischen 8- bis 60-gliedrigen Rest, einer Biphenylgruppe und einer Terphenylgruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₆₀-Alkylrest, einem C₂-C₆₀-Alkenylrest, einem C₂-C₆₀-Alkinylrest, einem C₁-C₆₀-Alkoxyrest, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem C₆-C₆₀-Aryloxyrest, einem C₆-C₆₀-Arylthiorest, einem C₁-C₆₀-Heteoarylrest, einem einwertigen, nichtaromatischen, kondensierten polycyclischen C8-C60-Rest, einem einwertigen, nichtaromatischen, kondensierten heteropolycyclischen 8- bis 60-gliedrigen Rest, einer Biphenylgruppe, einer Terphenylgruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₆₀-Alkylrest, einem C₂-C₆₀-Alkenylrest, einem C₂-C₆₀-Alkinylrest, einem C₁-C₆₀-Alkoxyrest, einem C₃-C₁₀-Cycloalkylrest, einem C₁-C₁₀-Heterocycloalkylrest, einem C₃-C₁₀-Cycloalkenylrest, einem C₁-C₁₀-Heterocycloalkenylrest, einem C₆-C₆₀-Arylrest, einem mit einem C₆-C₆₀-Arylrest substituierten C₆-C₆₀-Arylrest, einem C₁-C₆₀-Heteoarylrest, einem einwertigen, nichtaromatischen, kondensierten polycyclischen C8-C60-Rest, einem einwertigen, nichtaromatischen, kondensierten heteropolycyclischen 8- bis 60-gliedrigen Rest, einer Biphenylgruppe und einer Terphenylgruppe.

5. Organische lichtemittierende Vorrichtung nach Anspruch 4, wobei A₁₁ bis A₁₄, A₂₁ bis A₂₃ und A₅₁ jeweils unabhängig voneinander ausgewählt sind aus einer Benzolgruppe, einer Naphthalingruppe, einer Fluorengruppe, einer Phenanthrengruppe, einer Anthracengruppe, einer Triphenylengruppe, einer Pyrengruppe, einer Chrysengruppe, einer Furangruppe, einer Thiophengruppe, einer Pyrrolgruppe, einer Pyridingruppe, einer Pyrazingruppe, einer Pyrimidingruppe, einer Pyridazingruppe, einer Triazingruppe, einer Chinolingruppe, einer Isochinolingruppe, einer 2,6-Naphthyridingruppe, einer 1,8-Naphthyridingruppe, einer 1,5-Naphthyridingruppe, einer 1,6-Naphthyridingruppe, einer 1,7-Naphthyridingruppe, einer 2,7-Naphthyridingruppe, einer Chinoxalingruppe, einer Chinazolingruppe, einer Benzofurangruppe, einer Benzothiophengruppe, einer Dibenzofurangruppe, einer Dibenzothiophengruppe und einer Carbazolgruppe.

6. Organische lichtemittierende Vorrichtung nach Anspruch 4 oder 5, wobei mindestens eines, ausgewählt aus R₄₁ bis R₄₃, durch eine, ausgewählt aus Formel 4a und 4b, dargestellt wird: 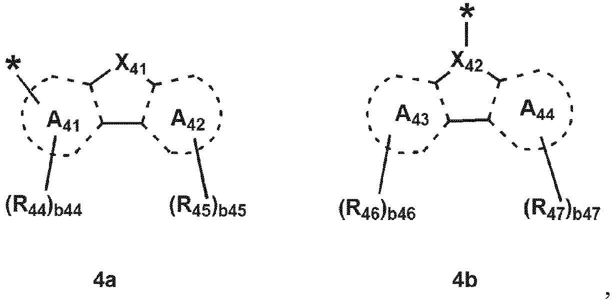 wobei, in den Formeln 4a und 4b,
X₄₁ aus N(R₄₀₁), B(R₄₀₁), C(R₄₀₁)(R₄₀₂), Si(R₄₀₁)(R₄₀₂), O und S ausgewählt ist,
X₄₂ aus N, B, C(R₄₀₃) und Si(R₄₀₃) ausgewählt ist,
A₄₁ bis A₄₄ jeweils unabhängig voneinander ausgewählt sind aus einer Benzolgruppe, einer Naphthalingruppe, einer Fluorengruppe, einer Phenanthrengruppe, einer Anthracengruppe, einer Triphenylengruppe, einer Pyrengruppe, einer Chrysengruppe, einer Furangruppe, einer Thiophengruppe, einer Pyrrolgruppe, einer Pyridingruppe, einer Pyrazingruppe, einer Pyrimidingruppe, einer Pyridazingruppe, einer Triazingruppe, einer Chinolingruppe, einer Isochinolingruppe, einer 2,6-Naphthyridingruppe, einer 1,8-Naphthyridingruppe, einer 1,5-Naphthyridingruppe, einer 1,6-Naphthyridingruppe, einer 1,7-Naphthyridingruppe, einer 2,7-Naphthyridingruppe, einer Chinoxalingruppe, einer Chinazolingruppe, einer Benzofurangruppe, einer Benzothiophengruppe, einer Dibenzofurangruppe, einer Dibenzothiophengruppe und einer Carbazolgruppe,
R₄₄ bis R₄₇ jeweils unabhängig voneinander das Gleiche sind wie bei R₄₁ bis R₄₃ in Anspruch 4 definiert,
b44 bis b47 jeweils unabhängig voneinander aus 1, 2, 3 und 4 ausgewählt sind, und
R₄₀₁ und R₄₀₂ jeweils unabhängig voneinander wie bei R₄₁ bis R₄₃ in Anspruch 4 definiert sind oder gegebenenfalls miteinander verbunden sind, um einen carbocyclischen C₅-C₂₀-Rest oder einen heterocyclischen C₁-C₂₀-Rest zu bilden.

7. Organische lichtemittierende Vorrichtung nach einem der Ansprüche 4 bis 6, wobei L₁₁ bis L₁₃, L₃₁ bis L₃₃, L₇₁ und L₇₂ jeweils unabhängig voneinander ausgewählt sind aus der Gruppe bestehend aus:
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Triphenylenylengruppe, einer Thiophenylengruppe, einer Furanylengruppe, einer Carbazolylengruppe, einer Benzofuranylengruppe, einer Benzothiophenylengruppe, einer Dibenzofuranylengruppe, einer Dibenzothiophenylengruppe, einer Dibenzosilolylengruppe, einer Benzocarbazolylengruppe und einer Dibenzocarbazolylengruppe; und
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Triphenylenylengruppe, einer Thiophenylengruppe, einer Furanylengruppe, einer Carbazolylengruppe, einer Benzofuranylengruppe, einer Benzothiophenylengruppe, einer Dibenzofuranylengruppe, einer Dibenzothiophenylengruppe, einer Dibenzosilolylengruppe, einer Benzocarbazolylengruppe und einer Dibenzocarbazolylengruppe, jeweils substituiert mit mindestens einem, ausgewählt aus Deuterium, -F, einer Cyanogruppe, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Methoxygruppe, einer Ethoxygruppe, einer n-Propoxygruppe, einer Isopropoxygruppe, einer n-Butoxygruppe, einer sec-Butoxygruppe, einer Isobutoxygruppe, einer tert-Butoxygruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Triphenylenylgruppe, einer Thiophenylgruppe, einer Furanylgruppe, einer Carbazolylgruppe, einer Benzofuranylgruppe, einer Benzothiophenylgruppe, einer Dibenzofuranylgruppe, einer Dibenzothiophenylgruppe, einer Dibenzosilolylgruppe, einer Benzocarbazolylgruppe, einer Dibenzocarbazolylgruppe, -N(Q₃₁)(Q₃₂), -Si(Q₃₁)(Q₃₂)(Q₃₃) und -B(Q₃₁)(Q₃₂), und
L₁₄, L₁₅, L₂₁, L₂₂ und L₆₁ bis L₆₃ jeweils unabhängig voneinander ausgewählt sind aus der Gruppe bestehend aus:
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Triphenylenylengruppe, einer Thiophenylengruppe, einer Furanylengruppe, einer Pyridinylengruppe, einer Pyrazinylengruppe, einer Pyrimidinylengruppe, einer Pyridazinylengruppe, einer Triazinylengruppe, einer Carbazolylengruppe, einer Benzofuranylengruppe, einer Benzothiophenylengruppe, einer Dibenzofuranylengruppe, einer Dibenzothiophenylengruppe, einer Dibenzosilolylengruppe, einer Benzocarbazolylengruppe und einer Dibenzocarbazolylengruppe; und
einer Phenylengruppe, einer Naphthylengruppe, einer Fluorenylengruppe, einer Spirobifluorenylengruppe, einer Benzofluorenylengruppe, einer Dibenzofluorenylengruppe, einer Phenanthrenylengruppe, einer Anthracenylengruppe, einer Triphenylenylengruppe, einer Thiophenylengruppe, einer Furanylengruppe, einer Pyridinylengruppe, einer Pyrazinylengruppe, einer Pyrimidinylengruppe, einer Pyridazinylengruppe, einer Triazinylengruppe, einer Carbazolylengruppe, einer Benzofuranylengruppe, einer Benzothiophenylengruppe, einer Dibenzofuranylengruppe, einer Dibenzothiophenylengruppe, einer Dibenzosilolylengruppe, einer Benzocarbazolylengruppe und einer Dibenzocarbazolylengruppe, jeweils substituiert mit mindestens einem, ausgewählt aus Deuterium, -F, einer Cyanogruppe, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Methoxygruppe, einer Ethoxygruppe, einer n-Propoxygruppe, einer Isopropoxygruppe, einer n-Butoxygruppe, einer sec-Butoxygruppe, einer Isobutoxygruppe, einer tert-Butoxygruppe, einer Phenylgruppe, einer Biphenylgruppe, einer Terphenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Triphenylenylgruppe, einer Thiophenylgruppe, einer Furanylgruppe, einer Pyridinylgruppe, einer Pyrazinylgruppe, einer Pyrimidinylgruppe, einer Pyridazinylgruppe, einer Triazinylgruppe, einer Carbazolylgruppe, einer Benzofuranylgruppe, einer Benzothiophenylgruppe, einer Dibenzofuranylgruppe, einer Dibenzothiophenylgruppe, einer Dibenzosilolylgruppe, einer Benzocarbazolylgruppe, einer Dibenzocarbazolylgruppe, -N(Q₃₁)(Q₃₂), -Si(Q₃₁)(Q₃₂)(Q₃₃) und -B(Q₃₁)(Q₃₂),
wobei Q₃₁ bis Q₃₃ jeweils unabhängig voneinander ausgewählt sind aus einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Phenylgruppe, einer Biphenylgruppe, einer Terphenylgruppe und einer Naphthylgruppe.

8. Organische lichtemittierende Vorrichtung nach einem der Ansprüche 4 bis 7, wobei L₄₁ bis L₄₃ jeweils unabhängig voneinander ausgewählt sind aus der Gruppe bestehend aus:
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Benzocarbazolylengruppe und einer Dibenzocarbazolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Benzocarbazolylengruppe und einer Dibenzocarbazolylengruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe. einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₃₁ bis Q₃₃ jeweils unabhängig voneinander ausgewählt sind aus Wasserstoff, einer Methylgruppe, einer Ethylgruppe, einer n-Propylgruppe, einer Isopropylgruppe, einer tert-Butylgruppe, einer Phenylgruppe, einer Biphenylgruppe und einer Terphenylgruppe,
mit der Maßgabe, dass mindestens eines, ausgewählt aus L₄₁ bis L₄₃, eine Gruppe, dargestellt durch Formel 5 wie in Anspruch 4 definiert, ist.

9. Organische lichtemittierende Vorrichtung nach einem der Ansprüche 4 bis 8, wobei L₄₁ bis L₄₃ jeweils unabhängig voneinander ausgewählt sind aus Gruppen, dargestellt durch die Formeln 4-1 bis 4-31: 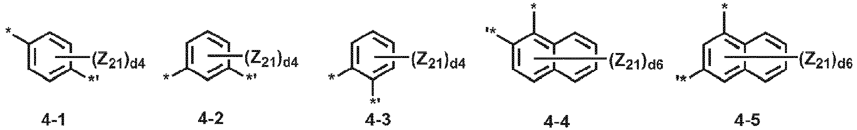 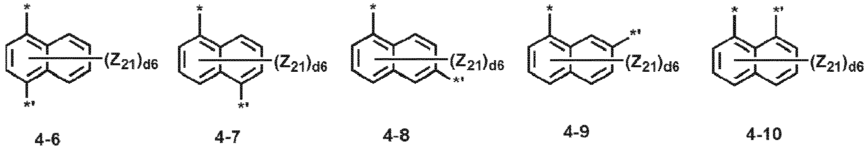 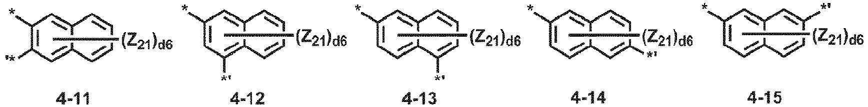 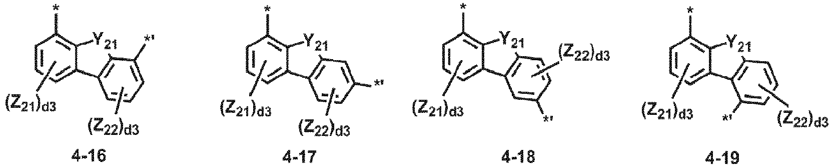 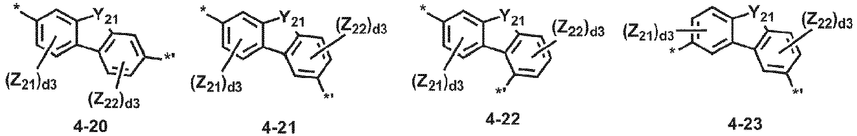 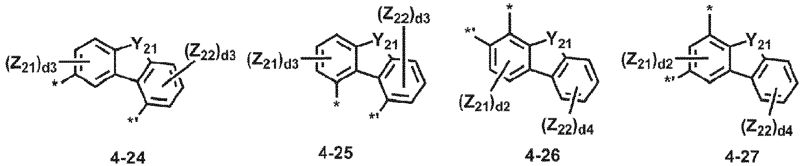 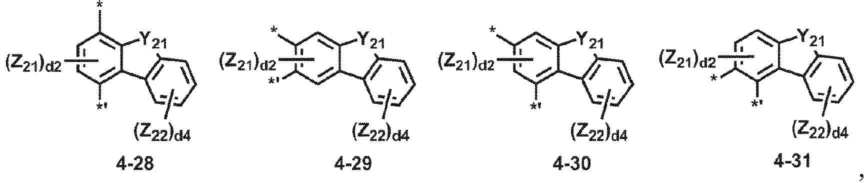 wobei, in den Formeln 4-1 bis 4-31,
Y₂₁ aus O, S, N(R₄₃), C(R₄₃)(R₄₄) und Si(R₄₃)(R₄₄) ausgewählt ist,
Z₂₁ und Z₂₂ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einer Phenylgruppe, einer Naphthylgruppe, einer Fluorenylgruppe, einer Spirobifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe, einer Triazinylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₃₁ bis Q₃₃ jeweils unabhängig voneinander ausgewählt sind aus Wasserstoff, einer Methylgruppe, einer Ethylgruppe, einer n-Propylgruppe, einer Isopropylgruppe, einer tert-Butylgruppe, einer Phenylgruppe, einer Biphenylgruppe und einer Terphenylgruppe,
d2 eine aus 1 und 2 ausgewählte ganze Zahl ist, d3 eine aus 1 bis 3 ausgewählte ganze Zahl ist 1, ist, d4 eine aus 1 bis 4 ausgewählte ganze Zahl ist, d6 eine aus 1 bis 6 ausgewählte ganze Zahl ist,
R₄₃ wie in Anspruch 4 oder Anspruch 6 definiert ist und R₄₄ wie in Anspruch 6 definiert ist, und
* und *' jeweils unabhängig voneinander eine Bindungsstelle zu einem benachbarten Atom kennzeichnen;
mit der Maßgabe, dass mindestens eines, ausgewählt aus L₄₁ bis L₄₃, eine durch Formel 4-2, 4-5, 4-12, 4-27 und 4-30 dargestellte Gruppe ist.

10. Organische lichtemittierende Vorrichtung nach einem der Ansprüche 4 bis 9, wobei Formel 5 durch eine, ausgewählt aus den Formeln 4-2, 4-5, 4-27 und 4-30 wie in Anspruch 9 definiert, dargestellt wird.

11. Organische lichtemittierende Vorrichtung nach einem der Ansprüche 4 bis 10, wobei
R₁₁ bis R₁₇, R₃₁ bis R₃₆, R₅₁, R₅₂ und R₇₁ bis R₇₇ jeweils unabhängig voneinander eine Lochtransportgruppe sind, und
R₁₈ bis R₂₇, R₄₁ bis R₄₇ und R₆₁ bis R₆₆ jeweils unabhängig voneinander eine Lochtransportgruppe oder eine Elektronentransportgruppe sind;
wobei die Lochtransportgruppe vorzugsweise ausgewählt ist aus einem C₁-C₂₀-Alkylrest, -Si(Q₁)(Q₂)(Q₃), -N(Q₁)(Q₂) und einer Gruppe, dargestellt durch eine der Formeln 5-1 bis 5-19: 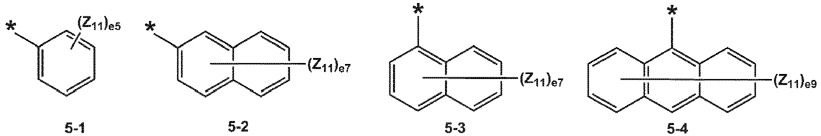 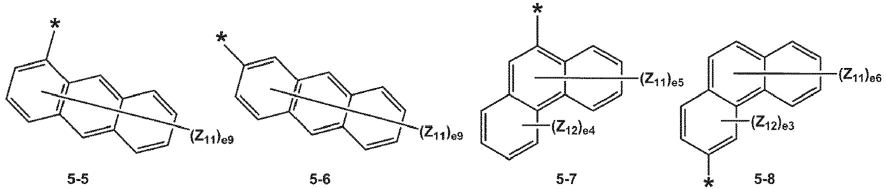 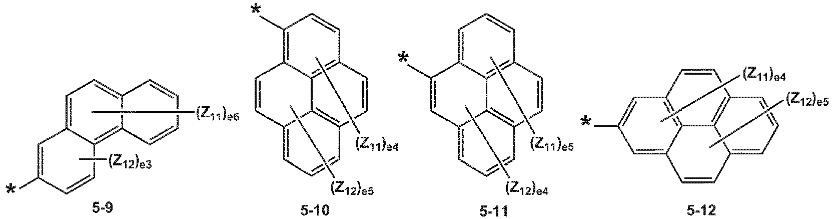 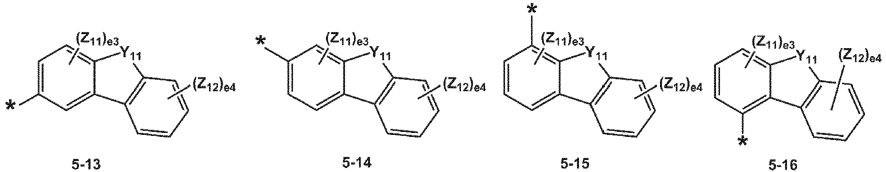 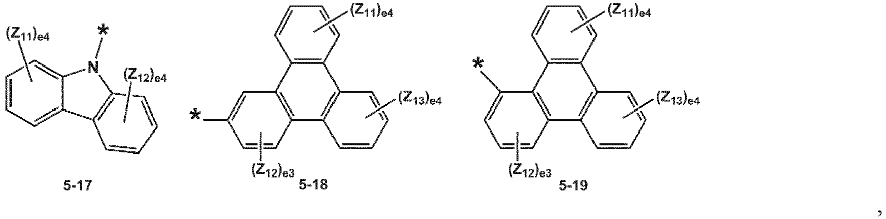 wobei, in den Formeln 5-1 bis 5-19,
Y₁₁ aus O, S, C(Z₁₃)(Z₁₄), N(Z₁₃) und Si(Z₁₃)(Z₁₄) ausgewählt ist,
Z₁₁ bis Z₁₄ jeweils unabhängig voneinander ausgewählt sind aus der Gruppe bestehend aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe. einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Benzofuranylgruppe, einer Benzothiophenylgruppe, einer Benzosilolylgruppe, einer Isobenzothiazolylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂); und
einer Phenylgruppe, einer Biphenylgruppe, einer Terphenylgruppe, einer Naphthylgruppe, einer Dibenzofuranylgruppe, einer Dibenzothiophenylgruppe, einer Dibenzosilolylgruppe, einer Carbazolylgruppe, einer Benzocarbazolylgruppe und einer Dibenzocarbazolylgruppe, jeweils substituiert mit mindestens einem, ausgewählt aus einem C₁-C₂₀-Alkylrest, einem C₁-C₂₀-Alkoxyrest, einer Phenylgruppe, einer Biphenylgruppe, einer Terphenylgruppe, einer Naphthylgruppe, einer Carbazolylgruppe, einer Fluorenylgruppe, -Si(Q₂₁)(Q₂₂)(Q₂₃) und -N(Q₂₁)(Q₂₂),
wobei Q₁ bis Q₃, Q₂₁ bis Q₂₃ und Q₃₁ bis Q₃₃ jeweils unabhängig voneinander aus einem C₁-C₁₀-Alkylrest, einem C₁-C₁₀-Alkoxyrest, einer Phenylgruppe, einer Biphenylgruppe, einer Terphenylgruppe und einer Naphthylgruppe ausgewählt sind,
e3 eine aus 1 bis 3 ausgewählte ganze Zahl ist, e4 eine aus 1 bis 4 ausgewählte ganze Zahl ist, e5 eine aus 1 bis 5 ausgewählte ganze Zahl ist, e6 eine aus 1 bis 6 ausgewählte ganze Zahl ist, e7 eine aus 1 bis 7 ausgewählte ganze Zahl ist, e9 eine aus 1 bis 9 ausgewählte ganze Zahl ist, und
* eine Bindungsstelle zu einem benachbarten Atom kennzeichnet;
und wobei die Elektronentransportgruppe vorzugsweise ausgewählt ist aus der Gruppe bestehend aus:
einer Cyanogruppe, -F und -CF₃;
einem C₆-C₆₀-Arylrest, substituiert mit mindestens einem, ausgewählt aus einer Cyanogruppe, -F und -CF₃; und
einem substituierten oder unsubstituierten heterocyclischen C₁-C₆₀-Rest mit mindestens einer Einheit *=N-*' als ringbildende Einheit;
stärker bevorzugt wobei die Elektronentransportgruppe ausgewählt ist aus -CN, -CF₃ und einer Gruppe, dargestellt durch eine der Formeln 6-1 bis 6-128: 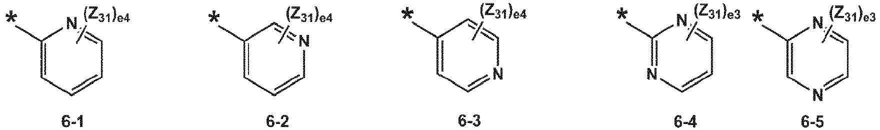 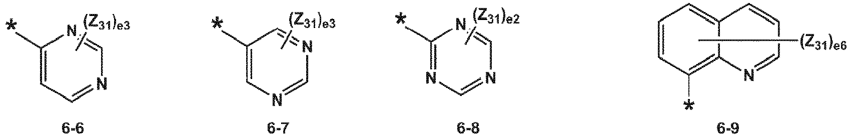 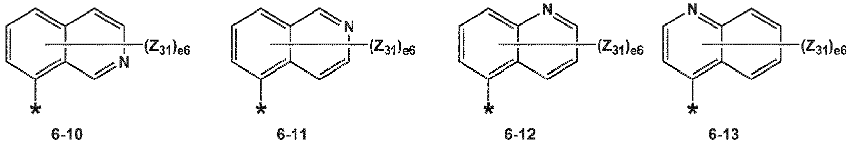 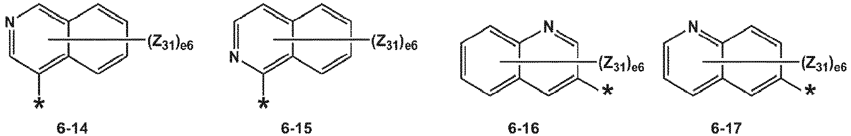 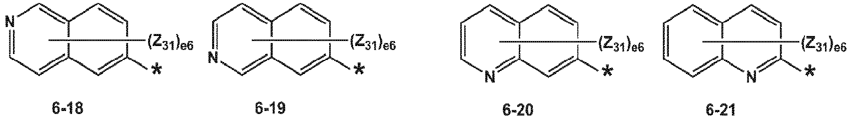 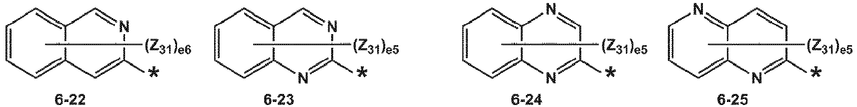 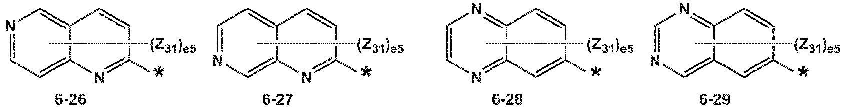 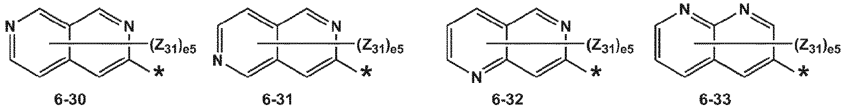 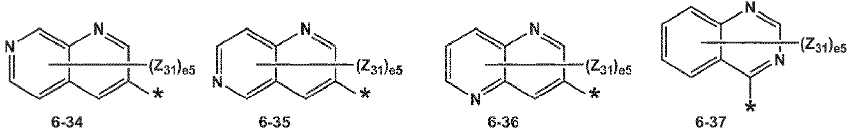 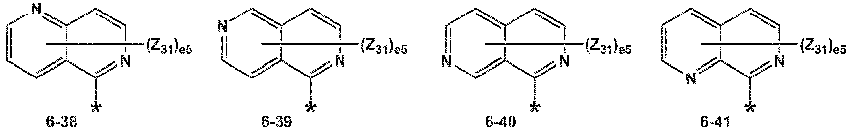 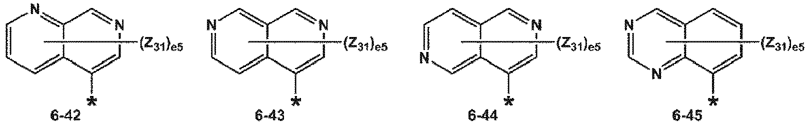 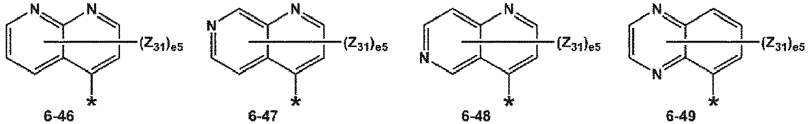 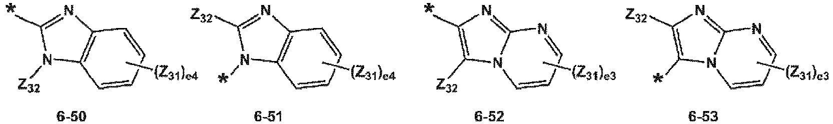 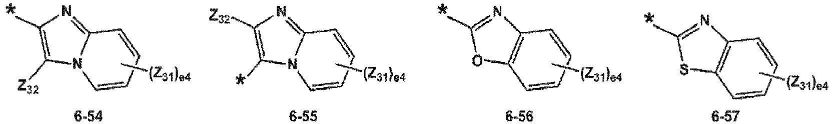 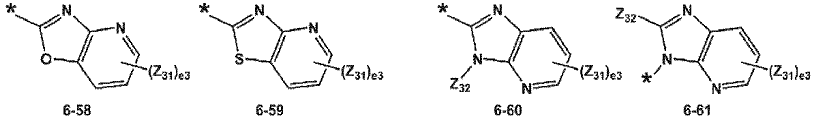 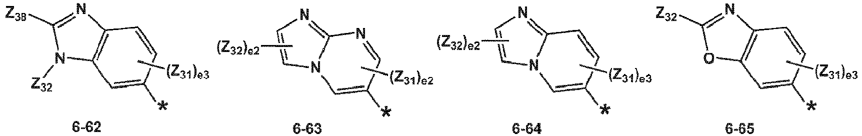 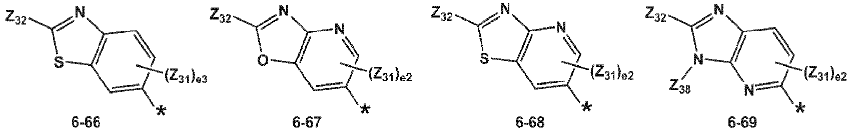 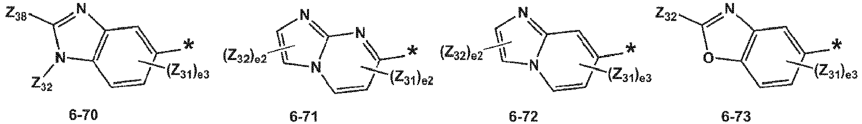 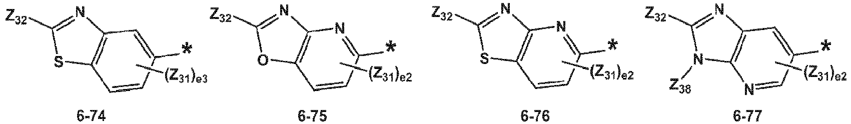 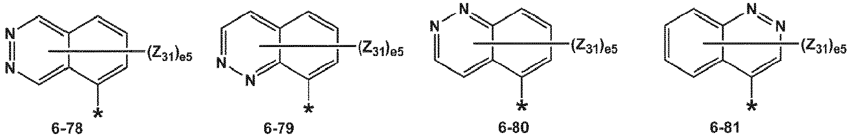 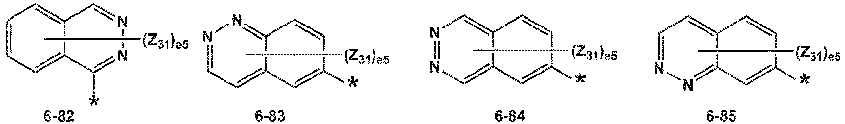 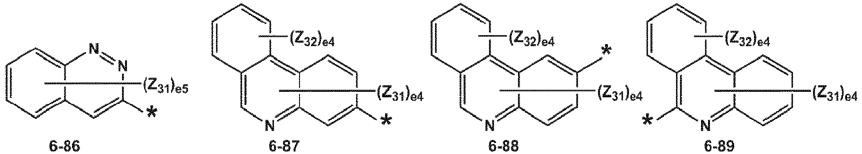 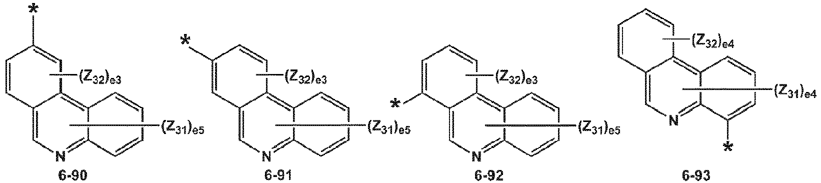 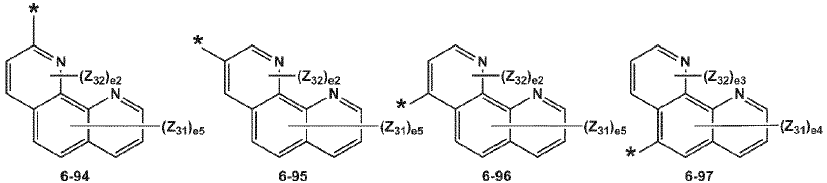 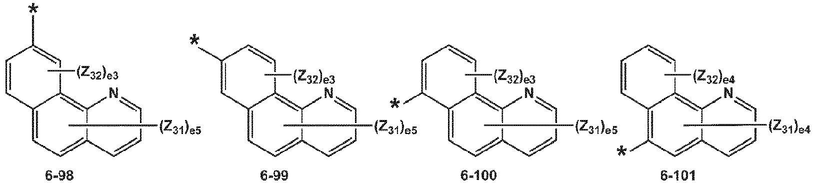 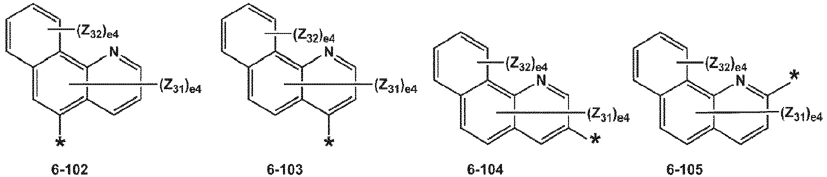 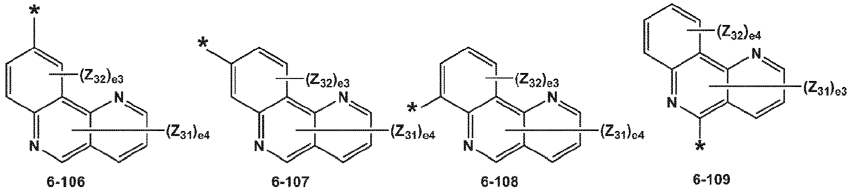 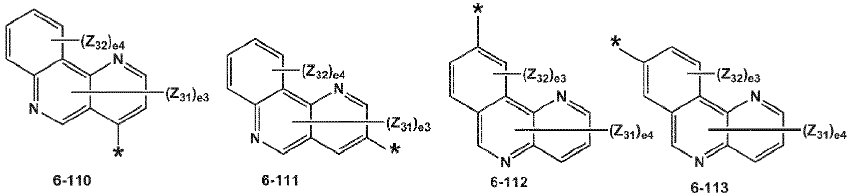 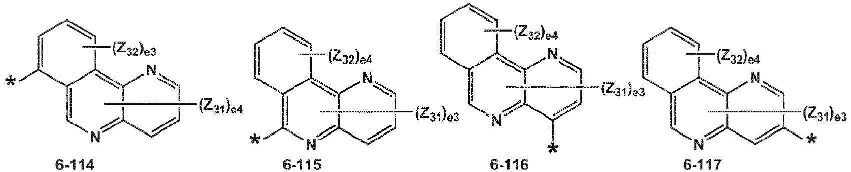 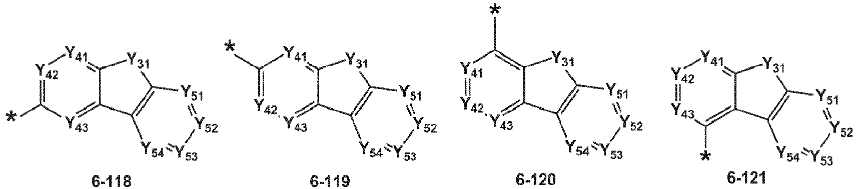 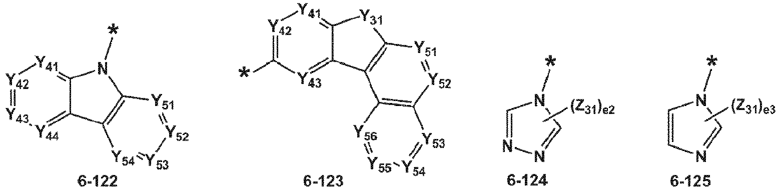 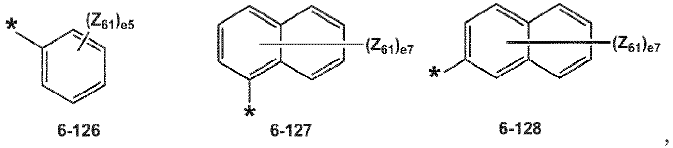 wobei, in den Formeln 6-1 bis 6-128,
Y₃₁ aus O, S, C(Z₃₃)(Z₃₄), N(Z₃₃) und Si(Z₃₃)(Z₃₄) ausgewählt ist,
Y₄₁ N oder C(Z₄₁) ist, Y₄₂ N oder C(Z₄₂) ist, Y₄₃ N oder C(Z₄₃) ist, Y₄₄ N oder C(Z₄₄) ist, Y₅₁ N oder C(Z₅₁) ist, Y₅₂ N oder C(Z₅₂) ist, Y₅₃ N oder C(Z₅₃) ist, Y₅₄ N oder C(Z₅₄) ist, Y₅₅ N oder C(Z₅₅) ist, Y₅₆ N oder C(Z₅₆) ist,
mindestens eines, ausgewählt aus Y₄₁ bis Y₄₃ und Y₅₁ bis Y₅₄ in den Formeln 6-118 bis 6-121, N ist, mindestens eines, ausgewählt aus Y₄₁ bis Y₄₄ und Y₅₁ bis Y₅₄ in Formel 6-122, N ist, mindestens eines, ausgewählt aus Y₄₁ bis Y₄₃ und Y₅₁ bis Y₅₆ in Formel 6-123, N ist,
Z₃₁ bis Z₃₄, Z₃₈, Z₄₁ bis Z₄₄ und Z₅₁ bis Z₅₆ jeweils unabhängig voneinander ausgewählt sind aus der Gruppe bestehend aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einem C₁-C₂₀-Alkylrest, einem C₁-C₂₀-Alkoxyrest, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe. einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂); und
einer Phenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einem, ausgewählt aus einem C₁-C₂₀-Alkylrest, einem C₁-C₂₀-Alkoxyrest, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe, einer Chinazolinylgruppe, einer Carbazolylgruppe, einer Fluorenylgruppe, -Si(Q₂₁)(Q₂₂)(Q₂₃) und -N(Q₂₁)(Q₂₂),
Z₆₁ aus Wasserstoff, einer Cyanogruppe, -F und -CF₃ ausgewählt ist, und mindestens ein Z₆₁ aus einer Cyanogruppe, -F und -CF₃ ausgewählt ist,
wobei Q₂₁ bis Q₂₃ und Q₃₁ bis Q₃₃ jeweils unabhängig voneinander ausgewählt sind aus einem C₁-C₁₀-Alkylrest, einem C₁-C₁₀-Alkoxyrest, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe,
e2 eine aus 1 und 2 ausgewählte ganze Zahl ist, ist, e3 eine aus 1 bis 3 ausgewählte ganze Zahl ist, e4 eine aus 1 bis 4 ausgewählte ganze Zahl ist, ist, e5 eine aus 1 bis 5 ausgewählte ganze Zahl ist, e6 eine aus 1 bis 6 ausgewählte ganze Zahl ist, ist, e7 eine aus 1 bis 7 ausgewählte ganze Zahl ist, und
* eine Bindungsstelle zu einem benachbarten Atom kennzeichnet.

12. Organische lichtemittierende Vorrichtung nach einem der Ansprüche 4 bis 11, wobei
die erste Verbindung durch Formel 1-11 dargestellt wird, und
die zweite Verbindung durch Formel 1-21 dargestellt wird: 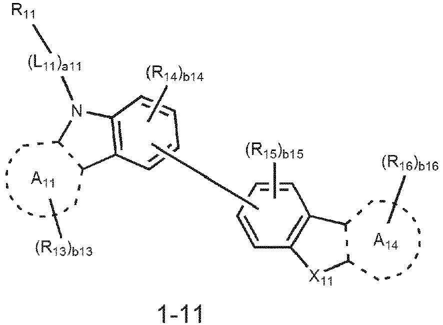 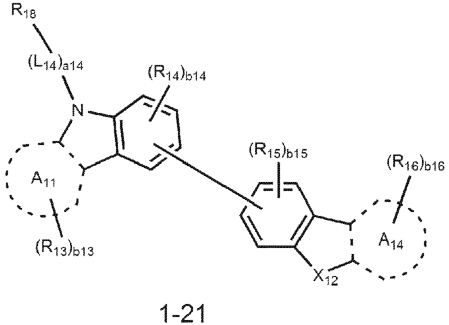 wobei, in den Formeln 1-11 und 1-21,
A₁₁, A₁₄, X₁₁, X₁₂, L₁₁, L₁₄, a11, a14, R₁₁, R₁₃ bis R₁₆, R₁₈ und b13 bis b16 wie in einem der Ansprüche 4, 5, 7 und 11 in Verbindung mit den Formeln 1-1 und 1-2 definiert sind.

13. Organische lichtemittierende Vorrichtung nach einem der Ansprüche 4 bis 11, wobei
die erste Verbindung durch eine der Formeln 2-11 bis 2-15 und 2-21 bis 2-23 dargestellt wird, und
die zweite Verbindung durch eine der Formeln 2-31 bis 2-35 und 2-41 bis 2-43 dargestellt wird: 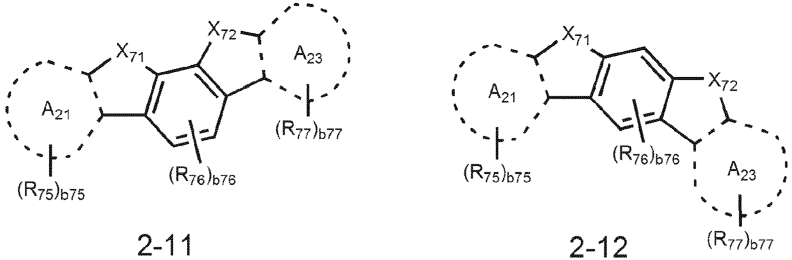 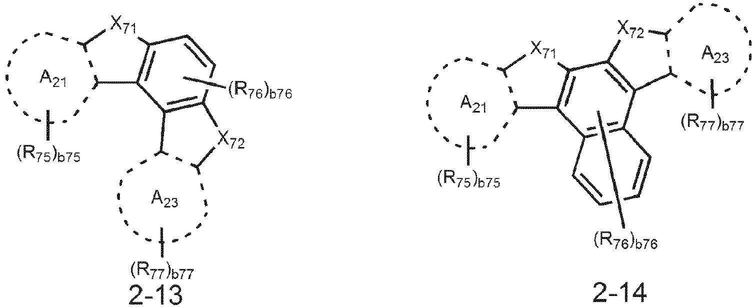 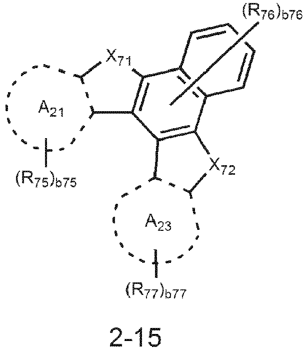 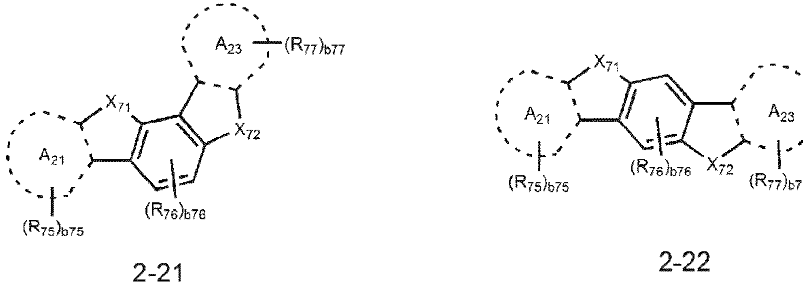 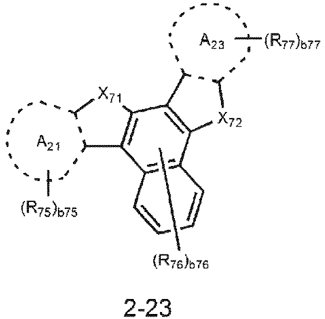 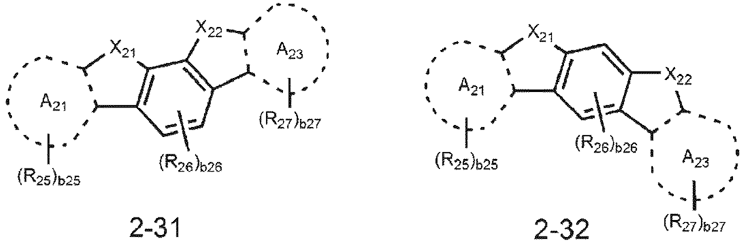 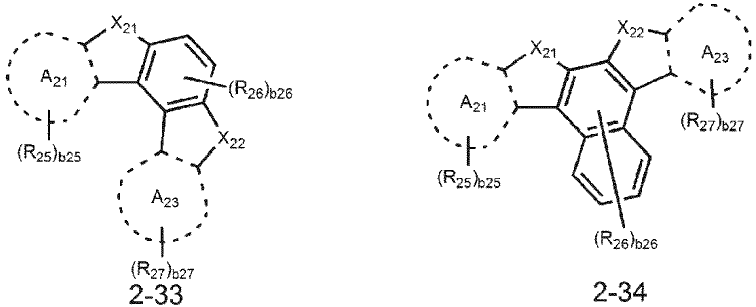 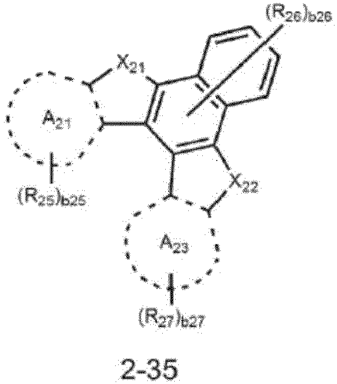 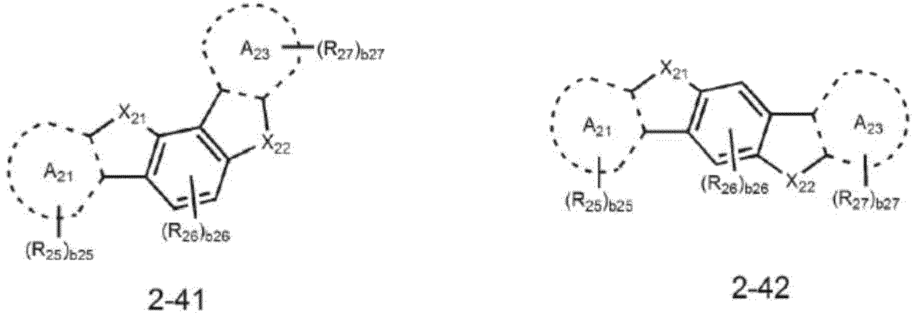 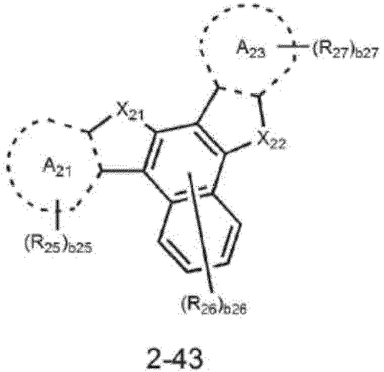 wobei, in den Formeln 2-11 bis 2-15, 2-21 bis 2-23, 2-31 bis 2-35 und 2-41 bis 2-43,
A₂₁, A₂₃, X₂₁, X₂₂, X₇₁, X₇₂, R₂₅ bis R₂₇, R₇₅ bis R₇₇, b25 bis b27 und b75 bis b77 wie in einem der Ansprüche 4, 5, 7 und 11 in Verbindung mit den Formeln 2-1 bis 2-4 definiert sind.

14. Organische lichtemittierende Vorrichtung nach einem der vorangehenden Ansprüche, wobei:
(a) ein Gewichtsverhältnis der ersten Verbindung zu der zweiten Verbindung in einem Bereich von etwa 1:99 bis etwa 99:1 liegt; und/oder
(b) die Emissionsschicht die vierte Verbindung umfasst, und die vierte Verbindung einen phosphoreszierenden Dotanten umfasst; und/oder
(c) die vierte Verbindung ein Metall, ausgewählt aus Iridium (Ir), Platin (Pt), Palladium (Pd), Osmium (Os), Titan (Ti), Zirconium (Zr), Hafnium (Hf), Europium (Eu), Terbium (Tb), Rhodium (Rh) und Thulium (Tm), umfasst; und/oder
(d) ein Gewichtsverhältnis der ersten Verbindung zu der zweiten Verbindung in einem Bereich von etwa 20:80 bis etwa 80:20 liegt.

15. Organische lichtemittierende Vorrichtung nach einem der Ansprüche 1, 2, 3 und 14, wobei
die erste Verbindung mindestens eine, ausgewählt aus der Gruppe bestehend aus Verbindung B-125, Verbindung B-167 und Verbindung E-165, umfasst,
die zweite Verbindung ausgewählt ist aus der Gruppe bestehend aus Verbindung C-109, Verbindung D-124 und Verbindung A-161, und
die dritte Verbindung ausgewählt ist aus der Gruppe bestehend aus den Verbindungen F101 bis F103:

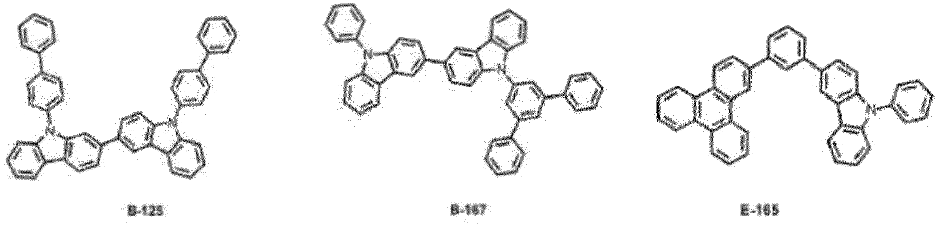

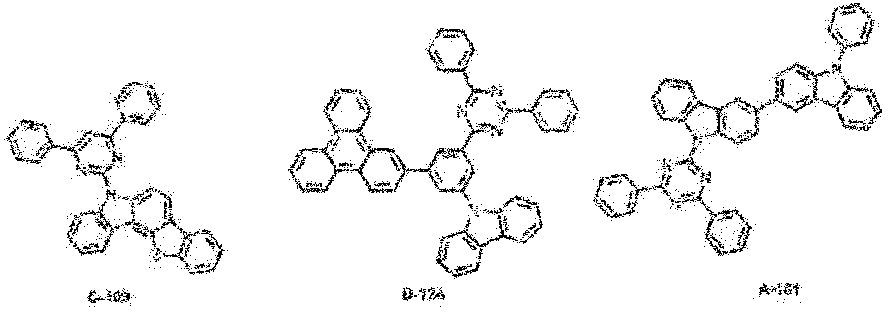

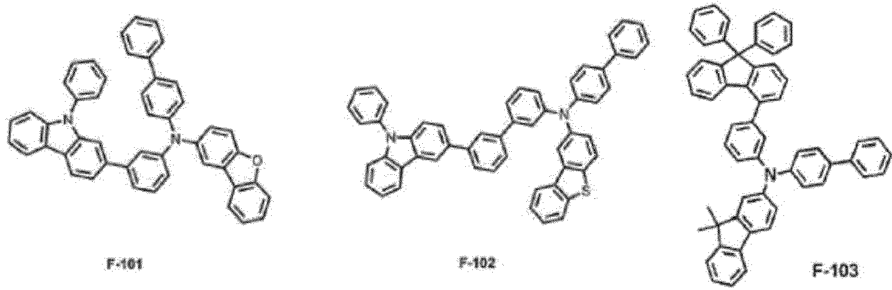

## Revendications

1. Dispositif électroluminescent organique (10) comprenant :
une première électrode (110) ;
une seconde électrode (190) faisant face à la première électrode ; et
une couche organique (150) entre la première électrode et la seconde électrode, la couche organique comprenant une couche d'émission, et une région de transport de trous entre la première électrode et la couche d'émission,
dans lequel la couche d'émission comprend un premier composé en tant qu'hôte, un deuxième composé en tant qu'hôte, et un quatrième composé en tant que dopant, et la région de transport de trous comprend un troisième composé,
le premier composé au quatrième composé satisfont aux équations 1 à 8 : ${E}_{1 , LUMO} \geq {E}_{2 , LUMO} + 0,15 électron-volt \left(eV\right)$ ${E}_{1 , HOMO} \geq {E}_{2 , HOMO} + 0,15 eV$ ${E}_{1 , T 1} \geq {E}_{4 , T 1}$ ${E}_{2 , T 1} \geq {E}_{4 , T 1}$ ${E}_{3 , T 1} \geq {E}_{4 , T 1}$ ${E}_{3 , LUMO} \geq {E}_{2 , LUMO} + 0,1 eV$ $- 5.6 eV \geq {E}_{3 , HOMO}$ ${E}_{écart 1} \geq {E}_{écart 3}$ où, dans les équations 1 à 8,
E_{1,LUMO} indique un niveau d'énergie de l'orbitale moléculaire inoccupée la plus basse (LUMO) du premier composé,
E_{2,LUMO} indique un niveau d'énergie LUMO du deuxième composé,
E_{3,LUMO} indique un niveau d'énergie LUMO du troisième composé,
E_{1,HOMO} indique un niveau d'énergie de l'orbitale moléculaire occupée la plus élevée (HOMO) du premier composé,
E_{2,HOMO} indique un niveau d'énergie HOMO du deuxième composé,
E_{3,HOMO} indique un niveau d'énergie HOMO du troisième composé,
E_{1,T1} indique un niveau d'énergie du triplet excité le plus bas du premier composé,
E_{2,T1} indique le niveau d'énergie du triplet excité le plus bas du deuxième composé,
E_{3,T1} indique le niveau d'énergie du triplet excité le plus bas du troisième composé,
E_{4,T1} indique le niveau d'énergie du triplet excité le plus bas du quatrième composé,
E_{écart1} indique un écart entre le niveau d'énergie LUMO du premier composé et le niveau d'énergie HOMO du premier composé, et
E_{écart3} indique un écart entre le niveau d'énergie LUMO du troisième composé et le niveau d'énergie HOMO du troisième composé ;
où HOMO, LUMO et le niveau d'énergie du triplet excité le plus bas (T₁) d'un composé utilisé dans les équations 1 à 8 sont déterminés selon les processus suivants :
| | |
|---|---|
| HOMO | Un graphique de potentiel (Volts, V) en fonction du courant (Ampères, A) d'un composé est obtenu par voltampérométrie cyclique (VC) (électrolyte : Bu₄NClO₄ 0,1 molaire (M)/ solvant : CH₂Cl₂/ électrode : système à 3 électrodes (électrode de travail : GC, électrode de référence : Ag/AgCl, électrode auxiliaire : Pt)) et un niveau d'énergie HOMO du composé est calculé à partir du début de |
| | la réduction du graphe |
| LUMO | Un composé est dilué avec du toluène à une concentration de 1x10⁻⁴ M, et un spectre d'absorption d'UV de celui-ci a été mesuré à température ambiante en utilisant un spectromètre Shimadzu UV-350, et un niveau d'énergie LUMO du composé est calculé en utilisant une bande interdite optique (Eg) à partir d'un bord du spectre d'absorption |
| T₁ | Un mélange d'un composé, dilué avec du toluène à une concentration d'environ 1x10⁻⁴ M, est chargé dans une cellule de quartz, la cellule de quartz résultante est chargée dans de l'azote liquide (à T = 77 K), un spectre de photoluminescence à basse température de celle-ci est mesuré en utilisant un dispositif de mesure de photoluminescence, et T₁ est calculé par analyse des pics observés uniquement à basse température lorsque le spectre de photoluminescence à basse température est comparé au spectre de photoluminescence mesuré à température ambiante |

2. Dispositif électroluminescent organique selon la revendication 1, dans lequel le premier composé au quatrième composé satisfont aux équations la à 6a : ${E}_{1 , LUMO} \geq {E}_{2 , LUMO} + 0,2 eV$ ${E}_{1 , HOMO} \geq {E}_{2 , HOMO} + 0,2 eV$ ${E}_{1 , T 1} \geq {E}_{4 , T 1} + 0,1 eV$ ${E}_{2 , T 1} \geq {E}_{4 , T 1} + 0,1 eV$ ${E}_{3 , T 1} \geq {E}_{4 , T 1} + 0,1 eV$ ${E}_{3 , LUMO} \geq {E}_{2 , LUMO} + 0,2 eV .$

3. Dispositif électroluminescent organique selon la revendication 1 ou 2, dans lequel (a) et/ou (b) s'applique :
(a) la région de transport de trous comprend en outre un dopant p ayant un niveau LUMO d'environ -3,5 eV ou moins, le dopant p comprenant au moins un élément choisi parmi un dérivé de quinone, un oxyde métallique et un composé contenant un groupe cyano
(b) la région de transport de trous comprend une première couche, la première couche comprend le troisième composé, et la première couche est en contact direct avec la couche d'émission ;
plus préférablement dans lequel la région de transport de trous comprend au moins une couche choisie parmi une couche d'injection de trous, une couche de transport de trous, une couche auxiliaire d'émission, et une couche de blocage d'électrons, et la première couche est la couche auxiliaire d'émission.

4. Dispositif électroluminescent organique selon l'une quelconque des revendications précédentes, dans lequel
le premier composé est représenté par l'une des formules 1-1, 2-1, 2-2 et 3-1,
le deuxième composé est représenté par l'une des formules 1-2, 2-3, 2-4 et 3-2, et
le troisième composé est représenté par la formule 4 : 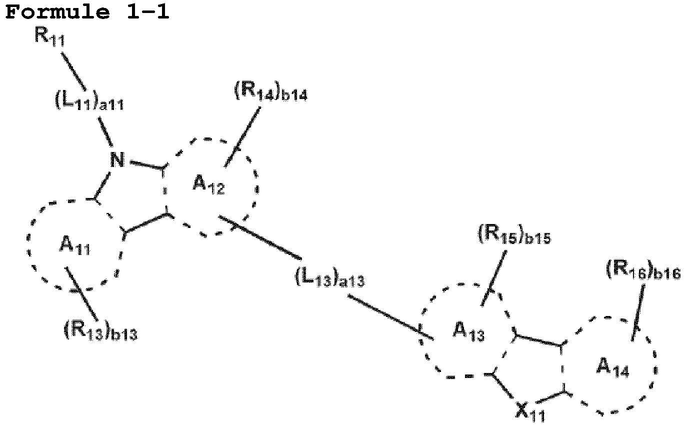 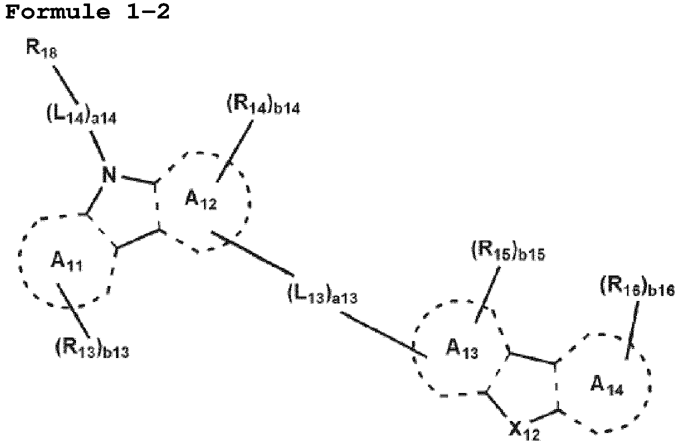 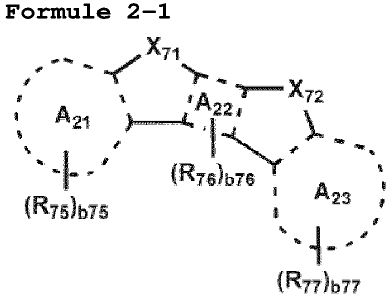 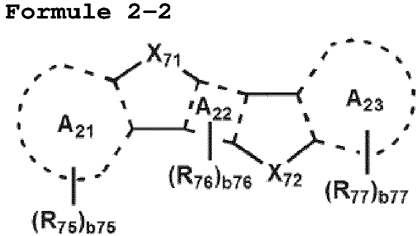 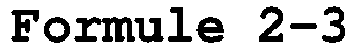 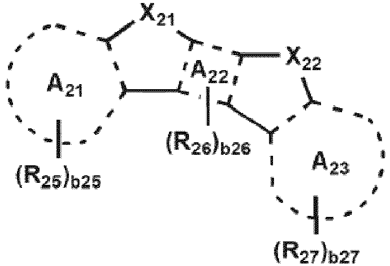 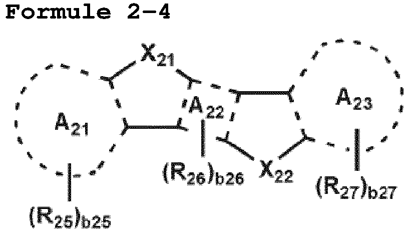 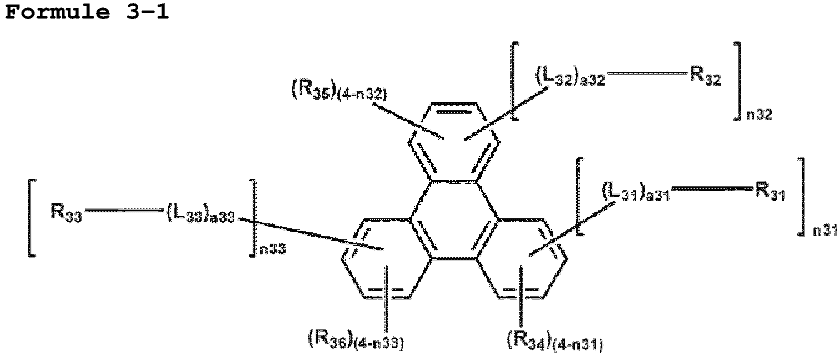 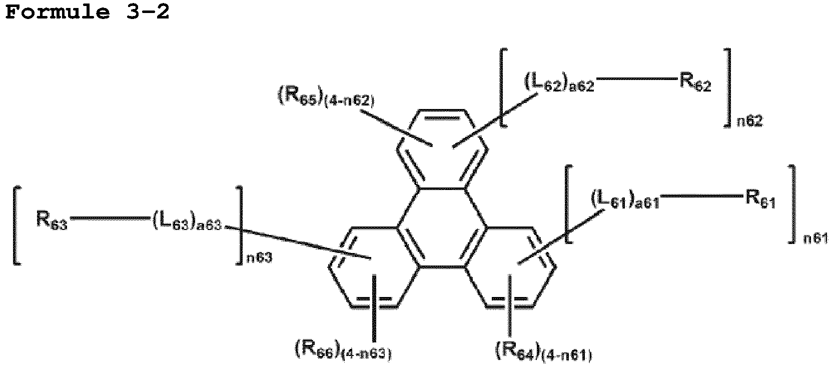 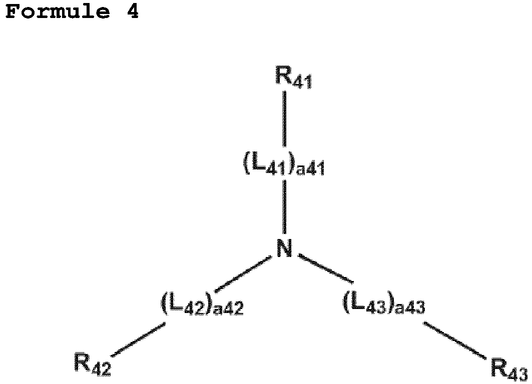 où, dans les formules 1-1, 1-2, 2-1 à 2-4, 3-1, 3-2 et 4,
L₁₁, L₁₃, L₁₄, L₃₁ à L₃₃, L₄₁ à L₄₃ et L₆₁ à L₆₃ sont chacun indépendamment choisis parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique en C₈ à C₆₀ condensé non aromatique divalent substitué ou non substitué et un groupe hétéropolycyclique à 8 à 60 chaînons condensé non aromatique divalent substitué ou non substitué, à condition qu'un ou plusieurs L₄₁, un ou plusieurs L₄₂ et/ou un ou plusieurs L₄₃ soient un groupe représenté par la formule 5, 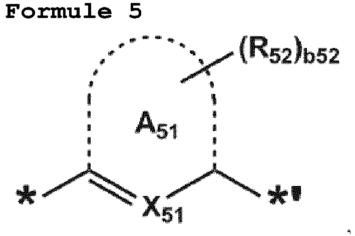
A₁₁ à A₁₄, A₂₁ à A₂₃ et A₅₁ sont chacun indépendamment choisis parmi un groupe carbocyclique en C₅ à C₂₀ et un groupe hétérocyclique en C₁ à C₂₀,
X₁₁ est choisi parmi O, S, N[(L₁₂)ₐ₁₂-R₁₂], C[(L₁₂)ₐ₁₂-R₁₂](R₁₇), Si[(L₁₂)ₐ₁₂-R₁₂](R₁₇), P[(L₁₂)ₐ₁₂-R₁₂], B[(L₁₂)ₐ₁₂-R₁₂] et P(=O)[(L₁₂)ₐ₁₂-R₁₂],
X₁₂ est choisi parmi O, S, N[(L₁₅)ₐ₁₅-R₁₉], C[(L₁₅)ₐ₁₅-R₁₉](R₂₀), Si[(L₁₅)ₐ₁₅-R₁₉](R₂₀), P[(L₁₅)ₐ₁₅-R₁₉], B[(L₁₅)ₐ₁₅-R₁₉] et P(=O)[(L₁₅)ₐ₁₅-R₁₉],
X₂₁ est choisi parmi N[(L₂₁)ₐ₂₁-R₂₁], C[(L₂₁)ₐ₂₁-R₂₁](R₂₃), O et S,
X₂₂ est choisi parmi N[(L₂₂)ₐ₂₂-R₂₂], C[(L₂₂)ₐ₂₂-R₂₂](R₂₄), O et S,
X₅₁ est choisi parmi N et CR₅₁,
X₇₁ est choisi parmi N[(L₇₁)ₐ₇₁-R₇₁], C[(L₇₁)ₐ₇₁-R₇₁](R₇₃), O et S,
X₇₂ est choisi parmi N[(L₇₂)ₐ₇₂-R₇₂], C[(L₇₂)ₐ₇₂-R₇₂](R₇₄), O et S,
L₁₂, L₁₅, L₂₁, L₂₂, L₇₁ et L₇₂ sont chacun indépendamment tels que définis pour L₁₁,
a11 à al5, a21, a22, a31 à a33, a41 à a43, a61 à a63, a71 et a72 sont chacun indépendamment choisis parmi 0, 1, 2, 3, 4 et 5,
où, lorsqu'un ou plusieurs L₄₁ sont un groupe représenté par la formule 5, a41 est choisi parmi 1, 2, 3, 4 et 5 ; lorsqu'un ou plusieurs L₄₂ sont un groupe représenté par la formule 5, a42 est choisi parmi 1, 2, 3, 4 et 5 ; et lorsqu'un ou plusieurs L₄₃ sont un groupe représenté par la formule 5, a43 est choisi parmi 1, 2, 3, 4 et 5,
R₁₁, R₁₃ à R₁₆, R₁₈, R₂₁ à R₂₇, R₃₁ à R₃₆, R₄₁ à R₄₃, R₅₁, R₅₂, R₆₁ à R₆₆ et R₇₁ à R₇₇ sont chacun indépendamment choisis parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, un groupe hétéropolycyclique à 8 à 60 chaînons condensé non aromatique monovalent substitué ou non substitué, -Si(Q₁)(Q₂)(Q₃), -N(Q₁)(Q₂), -B(Q₁)(Q₂), -C(=O)(Q₁), -S(=O)₂(Q₁) et -P(=O)(Q₁)(Q₂), où au moins l'un choisi parmi R₄₁ à R₄₃ est choisi parmi un groupe polycyclique en C₈ à C₆₀ condensé non aromatique monovalent substitué ou non substitué et un groupe hétéropolycyclique à 8 à 60 chaînons condensé non aromatique monovalent substitué ou non substitué,
R₁₂ et R₁₇ sont chacun indépendamment tels que définis pour R₁₁ ou sont éventuellement liés l'un à l'autre pour former un groupe carbocyclique en C₅ à C₂₀ ou un groupe hétérocyclique en C₁ à C₂₀,
R₁₉ et R₂₀ sont chacun indépendamment tels que définis pour R₁₁ ou sont éventuellement liés l'un à l'autre pour former un groupe carbocyclique en C₅ à C₂₀ et un groupe hétérocyclique en C₁ à C₂₀,
b13 à b16, b25 à b27, b52 et b75 à b77 sont chacun indépendamment choisis parmi 1, 2, 3 et 4,
n31 à n33 et n61 à n63 sont chacun indépendamment choisis parmi 0, 1, 2, 3 et 4,
* et *' indiquent un site de liaison à un atome adjacent, et
le groupe cycloalkylène en C₃ à C₁₀ substitué, le groupe hétérocycloalkylène en C₁ à C₁₀ substitué, le groupe cycloalcénylène en C₃ à C₁₀ substitué, le groupe hétérocycloalcénylène en C₁ à C₁₀ substitué, le groupe arylène en C₆ à C₆₀ substitué, le groupe hétéroarylène en C₁ à C₆₀ substitué, le groupe polycyclique en C₈ à C₆₀ condensé non aromatique divalent substitué, le groupe hétéropolycyclique à 8 à 60 chaînons condensé non aromatique divalent substitué, le groupe alkyle en C₁ à C₆₀ substitué, le groupe alcényle en C₂ à C₆₀ substitué, le groupe alcynyle en C₂ à C₆₀ substitué, le groupe alkoxy en C₁ à C₆₀ substitué, le groupe cycloalkyle en C₃ à C₁₀ substitué, le groupe hétérocycloalkyle en C₁ à C₁₀ substitué, le groupe cycloalcényle en C₃ à C₁₀ substitué, le groupe hétérocycloalcényle en C₁ à C₁₀ substitué, le groupe aryle en C₆ à C₆₀ substitué, le groupe aryloxy en C₆ à C₆₀ substitué, le groupe arylthio en C₆ à C₆₀ substitué, le groupe hétéroaryle en C₁ à C₆₀ substitué, le groupe polycyclique en C₈ à C₆₀ condensé non aromatique monovalent substitué et le groupe hétéropolycyclique à 8 à 60 chaînons condensé non aromatique monovalent substitué sont substitués par un ou plusieurs substituants chacun indépendamment choisis dans le groupe constitué par :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀ et un groupe alkoxy en C₁ à C₆₀ ;
un groupe alkyle en C₁ à C₆₀, un groupe alcényle en C₂ à C₆₀, un groupe alcynyle en C₂ à C₆₀ et un groupe alkoxy en C₁ à C₆₀, chacun substitué par au moins un élément choisi parmi le deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) et -P(=O)(Q₁₁)(Q₁₂) ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle et un groupe terphényle ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle et un groupe terphényle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle, un groupe terphényle, -Si(Q₂₁)(Q₂₂)(Q₂₃), -N(Q₂₁)(Q₂₂), -B(Q₂₁)(Q₂₂), -C(=O)(Q₂₁), -S (=O)₂(Q₂₁)et -P (=O)(Q₂₁)(Q₂₂); et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁)et -P (=O)(Q₃₁)(Q₃₂),
où Q₁ à Q₃, Q₁₁ à Q₁₃, Q₂₁ à Q₂₃ et Q₃₁ à Q₃₃ sont chacun indépendamment choisis parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryle en C₆ à C₆₀ substitué par un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle et un groupe terphényle.

5. Dispositif électroluminescent organique selon la revendication 4, dans lequel A₁₁ à A₁₄, A₂₁ à A₂₃ et A₅₁ sont chacun indépendamment choisis parmi un groupe benzène, un groupe naphtalène, un groupe fluorène, un groupe phénanthrène, un groupe anthracène, un groupe triphénylène, un groupe pyrène, un groupe chrysène, un groupe furane, un groupe thiophène, un groupe pyrrole, un groupe pyridine, un groupe pyrazine, un groupe pyrimidine, un groupe pyridazine, un groupe triazine, un groupe quinoléine, un groupe isoquinoléine, un groupe 2,6-naphtyridine, un groupe 1,8-naphtyridine, un groupe 1,5-naphtyridine, un groupe 1,6-naphtyridine, un groupe 1,7-naphtyridine, un groupe 2,7-naphtyridine, un groupe quinoxaline, un groupe quinazoline, un groupe benzofurane, un groupe benzothiophène, un groupe dibenzofurane, un groupe dibenzothiophène et un groupe carbazole.

6. Dispositif électroluminescent organique selon la revendication 4 ou 5, dans lequel au moins l'un choisi parmi R₄₁ à R₄₃ est représenté par une formule choisie parmi les formules 4a et 4b : 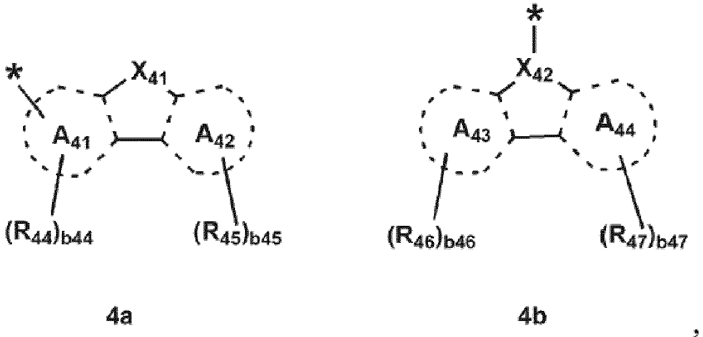 où, dans les formules 4a et 4b,
X₄₁ est choisi parmi N(R₄₀₁), B(R₄₀₁), C(R₄₀₁)(R₄₀₂), Si(R₄₀₁)(R₄₀₂), O et S,
X₄₂ est choisi parmi N, B, C(R₄₀₃) et Si(R₄₀₃),
A₄₁ à A₄₄ sont chacun indépendamment choisis parmi un groupe benzène, un groupe naphtalène, un groupe fluorène, un groupe phénanthrène, un groupe anthracène, un groupe triphénylène, un groupe pyrène, un groupe chrysène, un groupe furane, un groupe thiophène, un groupe pyrrole, un groupe pyridine, un groupe pyrazine, un groupe pyrimidine, un groupe pyridazine, un groupe triazine, un groupe quinoléine, un groupe isoquinoléine, un groupe 2,6-naphtyridine, un groupe 1,8-naphtyridine, un groupe 1,5-naphtyridine, un groupe 1,6-naphtyridine, un groupe 1,7-naphtyridine, un groupe 2,7-naphtyridine, un groupe quinoxaline, un groupe quinazoline, un groupe benzofurane, un groupe benzothiophène, un groupe dibenzofurane, un groupe dibenzothiophène et un groupe carbazole,
R₄₄ à R₄₇ sont chacun indépendamment les mêmes que définis pour R₄₁ à R₄₃ dans la revendication 4,
b44 à b47 sont chacun indépendamment choisis parmi 1, 2, 3 et 4, et
R₄₀₁ et R₄₀₂ sont chacun indépendamment tels que définis pour R₄₁ à R₄₃ dans la revendication 4 ou sont éventuellement liés l'un à l'autre pour former un groupe carbocyclique en C₅ à C₂₀ ou un groupe hétérocyclique en C₁ à C₂₀.

7. Dispositif électroluminescent organique selon l'une quelconque des revendications 4 à 6, dans lequel L₁₁ à L₁₃, L₃₁ à L₃₃, L₇₁ et L₇₂ sont chacun indépendamment choisis dans le groupe constitué par :
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe triphénylénylène, un groupe thiophénylène, un groupe furanylène, un groupe carbazolylène un groupe benzofuranylène, un groupe benzothiophénylène, un groupe dibenzofuranylène, un groupe dibenzothiophénylène, un groupe dibenzosilolylène, un groupe benzocarbazolylène et un groupe dibenzocarbazolylène ; et
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe triphénylénylène, un groupe thiophénylène, un groupe furanylène, un groupe carbazolylène un groupe benzofuranylène, un groupe benzothiophénylène, un groupe dibenzofuranylène, un groupe dibenzothiophénylène, un groupe dibenzosilolylène, un groupe benzocarbazolylène et un groupe dibenzocarbazolylène, chacun substitué par au moins un élément choisi parmi le deutérium, -F, un groupe cyano, un groupe méthyle, un groupe éthyle, un groupe n-propyle, un groupe iso-propyle, un groupe n-butyle, un groupe sec.-butyle, un groupe iso-butyle, un groupe tert-butyle, un groupe méthoxy, un groupe éthoxy, un groupe n-propoxy, un groupe iso-propoxy, un groupe n-butoxy, un groupe sec.-butoxy, un groupe iso-butoxy, un groupe tert-butoxy, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe triphénylényle, un groupe thiophényle, un groupe furanyle, un groupe carbazolyle, un groupe benzofuranyle, un groupe benzothiophényle, un groupe dibenzofuranyle, un groupe dibenzothiophényle, un groupe dibenzosilolyle, un groupe benzocarbazolyle, un groupe dibenzocarbazolyle, -N(Q₃₁)(Q₃₂), -Si(Q₃₁)(Q₃₂)(Q₃₃) et -B(Q₃₁)(Q₃₂), et
L₁₄, L₁₅, L₂₁, L₂₂ et L₆₁ à L₆₃ sont chacun indépendamment choisis dans le groupe constitué par :
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe triphénylénylène, un groupe thiophénylène, un groupe furanylène, un groupe pyridinylène, un groupe pyrazinylène, un groupe pyrimidinylène, un groupe pyridazinylène, un groupe triazinylène, un groupe carbazolylène, un groupe benzofuranylène, un groupe benzothiophénylène, un groupe dibenzofuranylène, un groupe dibenzothiophénylène, un groupe dibenzosilolylène, un groupe benzocarbazolylène et un groupe dibenzocarbazolylène ; et
un groupe phénylène, un groupe naphtylène, un groupe fluorénylène, un groupe spiro-bifluorénylène, un groupe benzofluorénylène, un groupe dibenzofluorénylène, un groupe phénanthrénylène, un groupe anthracénylène, un groupe triphénylénylène, un groupe thiophénylène, un groupe furanylène, un groupe pyridinylène, un groupe pyrazinylène, un groupe pyrimidinylène, un groupe pyridazinylène, un groupe triazinylène, un groupe carbazolylène, un groupe benzofuranylène, un groupe benzothiophénylène, un groupe dibenzofuranylène, un groupe dibenzothiophénylène, un groupe dibenzosilolylène, un groupe benzocarbazolylène et un groupe dibenzocarbazolylène, chacun substitué par au moins l'un choisi parmi le deutérium, -F, un groupe cyano, un groupe méthyle, un groupe éthyle, un groupe n-propyle, un groupe iso-propyle, un groupe n-butyle, un groupe sec.-butyle, un groupe iso-butyle, un groupe tert-butyle, un groupe méthoxy, un groupe éthoxy, un groupe n-propoxy, un groupe iso-propoxy, un groupe n-butoxy, un groupe sec.-butoxy, un groupe iso-butoxy, un groupe tert-butoxy, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe triphénylényle, un groupe thiophényle, un groupe furanyle, un groupe pyridinyle, un groupe pyrazinyle, un groupe pyrimidinyle, un groupe pyridazinyle, un groupe triazinyle, un groupe carbazolyle, un groupe benzofuranyle, un groupe benzothiophényle, un groupe dibenzofuranyle, un groupe dibenzothiophényle, un groupe dibenzosilolyle, un groupe benzocarbazolyle, un groupe dibenzocarbazolyle, -N(Q₃₁)(Q₃₂), -Si(Q₃₁)(Q₃₂)(Q₃₃) et -B(Q₃₁)(Q₃₂),
où Q₃₁ à Q₃₃ sont chacun indépendamment choisis parmi un groupe méthyle, un groupe éthyle, un groupe n-propyle, un groupe iso-propyle, un groupe n-butyle, un groupe sec.-butyle, un groupe iso-butyle, un groupe tert-butyle, un groupe phényle, un groupe biphényle, un groupe terphényle et un groupe naphtyle.

8. Dispositif électroluminescent organique selon l'une quelconque des revendications 4 à 7, dans lequel L₄₁ à L₄₃ sont chacun indépendamment choisis dans le groupe constitué par :
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-bifluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinoléinylène, un groupe isoquinoléinylène, un groupe benzoquinoléinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe benzocarbazolylène et un groupe dibenzocarbazolylène ; et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-bifluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinoléinylène, un groupe isoquinoléinylène, un groupe benzoquinoléinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe benzocarbazolylène et un groupe dibenzocarbazolylène, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂),
où Q₃₁ à Q₃₃ sont chacun indépendamment choisis parmi l'hydrogène, un groupe méthyle, un groupe éthyle, un groupe n-propyle, un groupe iso-propyle, un groupe tert-butyle, un groupe phényle, un groupe biphényle et un groupe terphényle,
à condition qu'au moins l'un choisi parmi L₄₁ à L₄₃ soit un groupe représenté par la formule 5 telle que définie dans la revendication 4.

9. Dispositif électroluminescent organique selon l'une quelconque des revendications 4 à 8, dans lequel L₄₁ à L₄₃ sont chacun indépendamment choisis parmi les groupes représentés par les formules 4-1 à 4-31 : 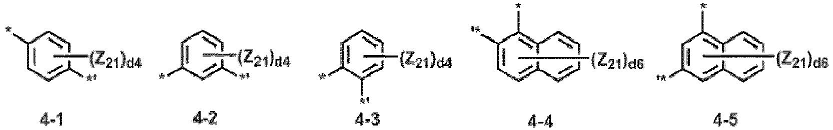 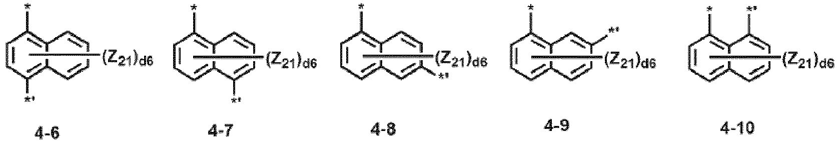 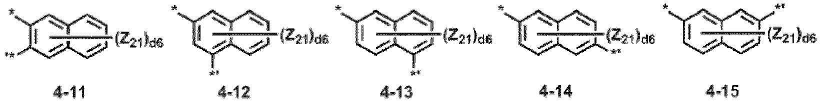 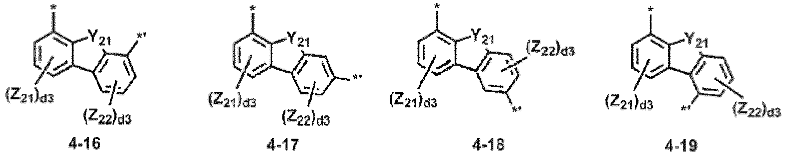 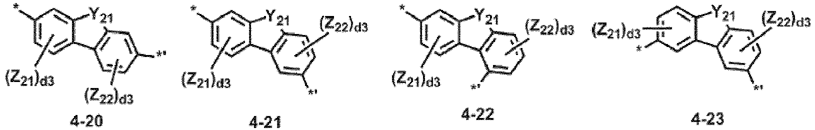 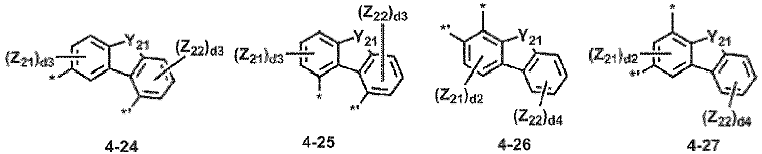 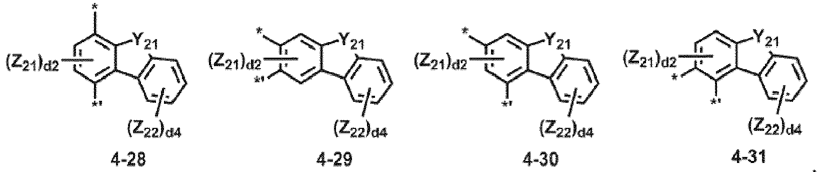 où, dans les formules 4-1 à 4-31,
Y₂₁ est choisi parmi O, S, N(R₄₃), C(R₄₃)(R₄₄) et Si(R₄₃)(R₄₄),
Z₂₁ et Z₂₂ sont chacun indépendamment choisis parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinoléinyle, un groupe isoquinoléinyle, un groupe quinoxalinyle, un groupe quinazolinyle, un groupe carbazolyle, un groupe triazinyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂),
où Q₃₁ à Q₃₃ sont chacun indépendamment choisis parmi l'hydrogène, un groupe méthyle, un groupe éthyle, un groupe n-propyle, un groupe iso-propyle, un groupe tert-butyle, un groupe phényle, un groupe biphényle et un groupe terphényle,
d2 est un nombre entier choisi parmi 1 et 2, d3 est un nombre entier choisi parmi 1 à 3, d4 est un nombre entier choisi parmi 1 à 4, d6 est un nombre entier choisi parmi 1 à 6,
R₄₃ est tel que défini dans la revendication 4 ou la revendication 6 et R₄₄ est tel que défini dans la revendication 6, et
* et *' indiquent chacun indépendamment un site de liaison à un atome adjacent ;
à condition qu'au moins l'un choisi parmi L₄₁ à L₄₃ soit un groupe représenté par les formules 4-2, 4-5, 4-12, 4-27 et 4-30.

10. Dispositif électroluminescent organique selon l'une quelconque des revendications 4 à 9, dans lequel la formule 5 est représentée par l'une choisie parmi les formules 4-2, 4-5, 4-27 et 4-30 telles que définies dans la revendication 9.

11. Dispositif électroluminescent organique selon l'une quelconque des revendications 4 à 10, dans lequel
R₁₁ à R₁₇, R₃₁ à R₃₆, R₅₁, R₅₂ et R₇₁ à R₇₇ sont chacun indépendamment un groupe de transport de trous, et
R₁₈ à R₂₇, R₄₁ à R₄₇ et R₆₁ à R₆₆ sont chacun indépendamment un groupe de transport de trous ou un groupe de transport d'électrons ;
dans lequel le groupe de transport de trous est de préférence choisi parmi un groupe alkyle en C₁ à C₂₀, -Si(Q₁)(Q₂)(Q₃), -N(Q₁)(Q₂), et un groupe représenté par l'une quelconque des formules 5-1 à 5-19 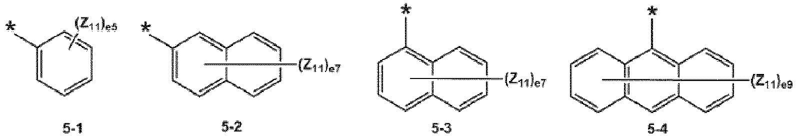 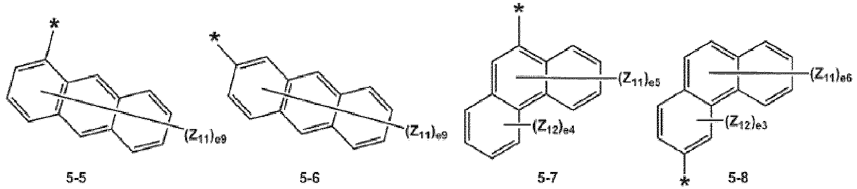 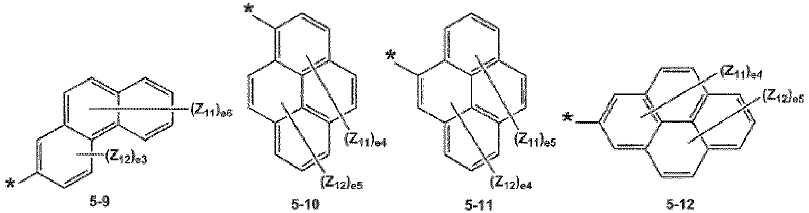 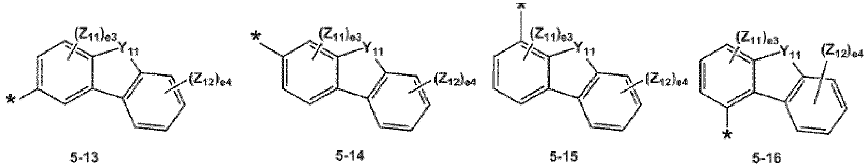 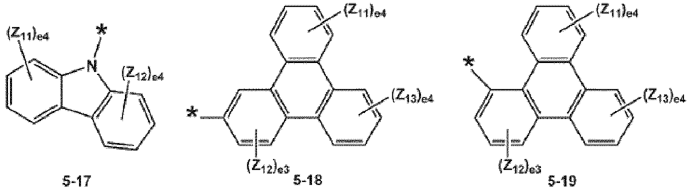 où, dans les formules 5-1 à 5-19,
Y₁₁ est choisi parmi O, S, C(Z₁₃)(Z₁₄), N(Z₁₃) et Si(Z₁₃)(Z₁₄),
Z₁₁ à Z₁₄ sont chacun indépendamment choisis dans le groupe constitué par :
l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe benzofuranyle, un groupe benzothiophényle, un groupe benzosilolyle, un groupe isobenzothiazolyle, un groupe dibenzofuranyle, un groupe dibenzothiophényle, un groupe dibenzosilolyle, un groupe carbazolyle, un groupe benzocarbazolyle, un groupe dibenzocarbazolyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂) ; et
un groupe phényle, un groupe biphényle, un groupe terphényle, un groupe naphtyle, un groupe dibenzofuranyle, un groupe dibenzothiophényle, un groupe dibenzosilolyle, un groupe carbazolyle, un groupe benzocarbazolyle et un groupe dibenzocarbazolyle, chacun substitué par au moins l'un choisi parmi un groupe alkyle en C₁ à C₂₀, un groupe alkoxy en C₁ à C₂₀, un groupe phényle, un groupe biphényle, un groupe terphényle, un groupe naphtyle, un groupe carbazolyle, un groupe fluorényle, -Si(Q₂₁)(Q₂₂)(Q₂₃) et -N(Q₂₁)(Q₂₂),
où Q₁ à Q₃, Q₂₁ à Q₂₃ et Q₃₁ à Q₃₃ sont chacun indépendamment choisis parmi un groupe alkyle en C₁ à C₁₀, un groupe alkoxy en C₁ à C₁₀, un groupe phényle, un groupe biphényle, un groupe terphényle et un groupe naphtyle,
e3 est un nombre entier choisi parmi 1 à 3, e4 est un nombre entier choisi parmi 1 à 4, e5 est un nombre entier choisi parmi 1 à 5, e6 est un nombre entier choisi parmi 1 à 6, e7 est un nombre entier choisi parmi 1 à 7, e9 est un nombre entier choisi parmi 1 à 9, et
* indique un site de liaison à un atome adjacent ;
et dans lequel le groupe de transport d'électrons est de préférence choisi dans le groupe constitué par :
un groupe cyano, -F et -CF₃ ;
un groupe aryle en C₆ à C₆₀ substitué par au moins l'un choisi parmi un groupe cyano, -F et -CF₃ ; et
un groupe hétérocyclique C₁ à C₆₀ substitué ou non substitué ayant au moins un groupement *=N-*' en tant que groupement formant un cycle ;
plus préférablement dans lequel le groupe de transport d'électrons est choisi parmi -CN, -CF₃ et un groupe représenté par l'une quelconque des formules 6-1 à 6-128 : 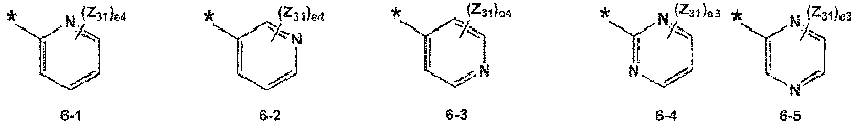 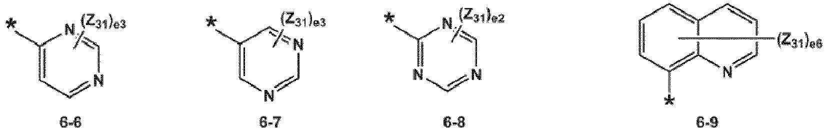 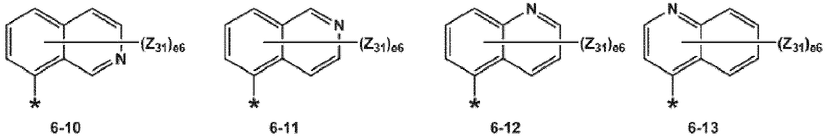 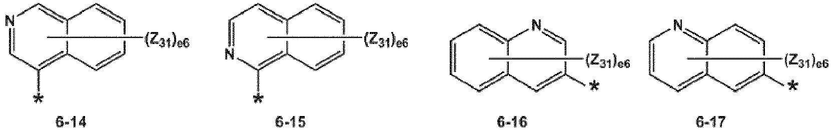 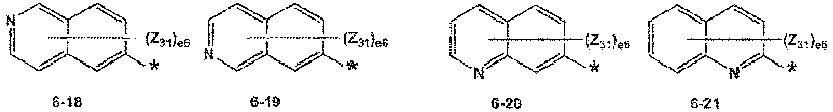 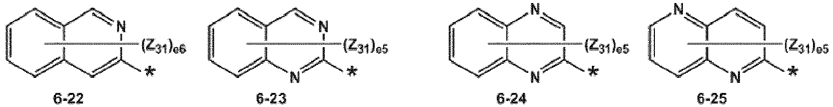 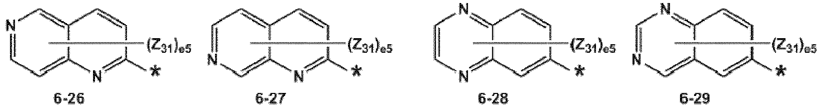 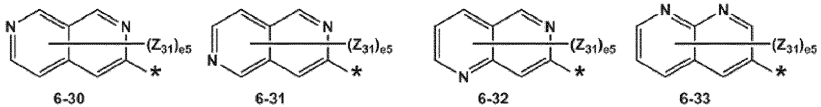 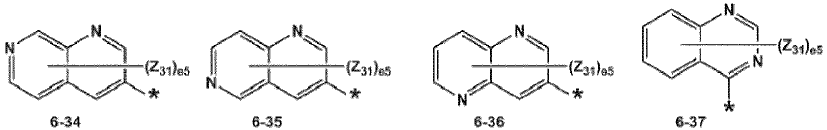 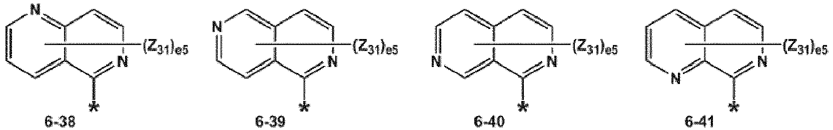 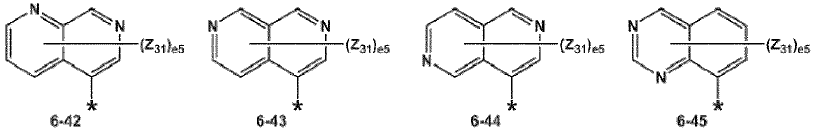 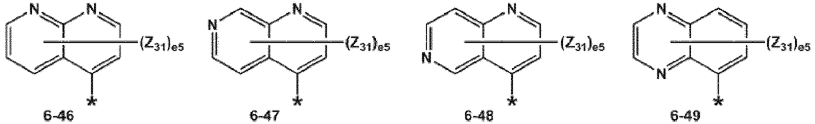 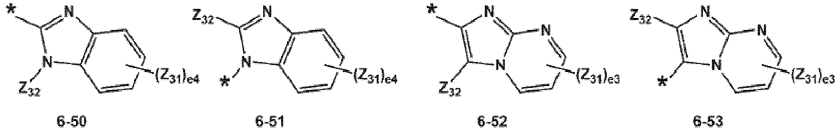 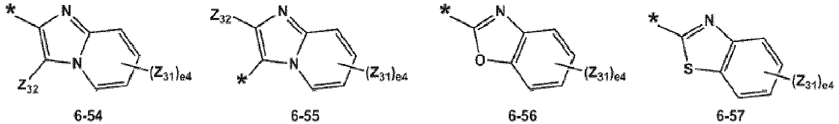 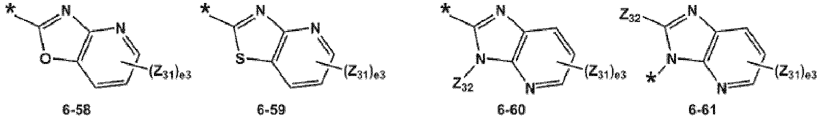 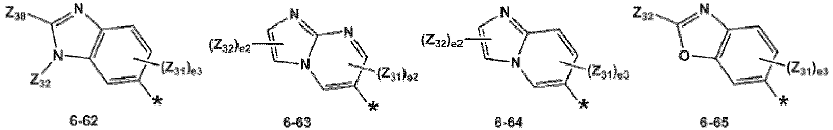 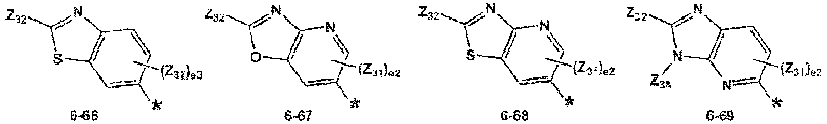 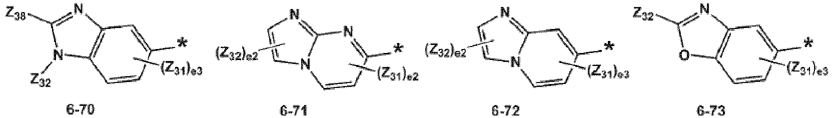 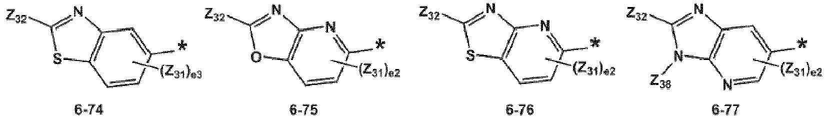 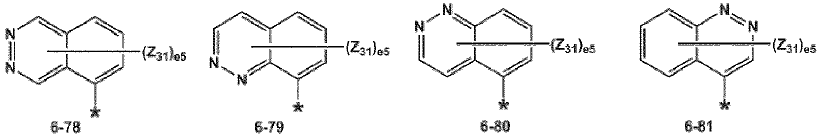 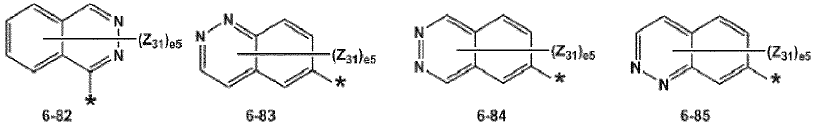 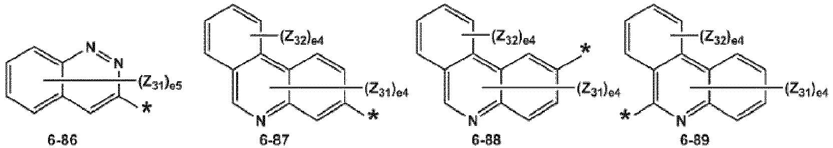 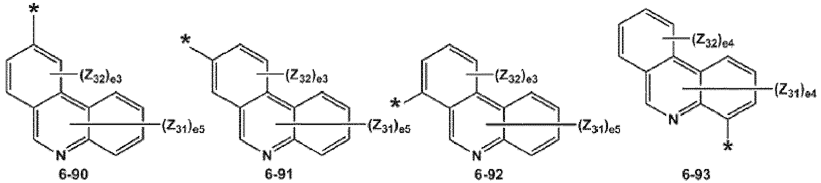 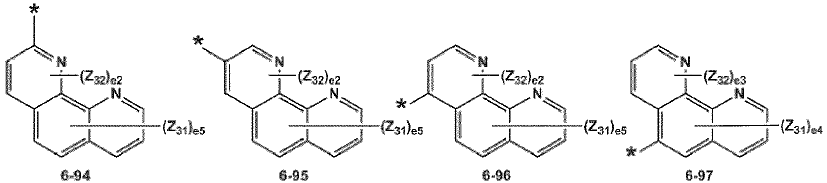 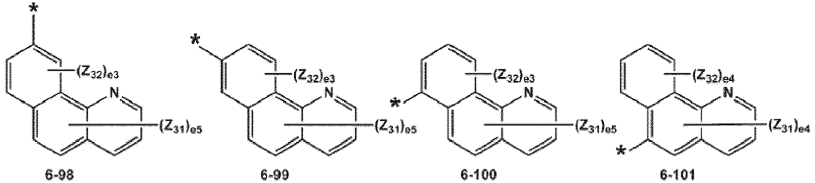 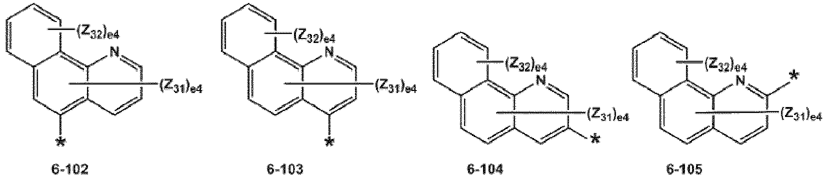 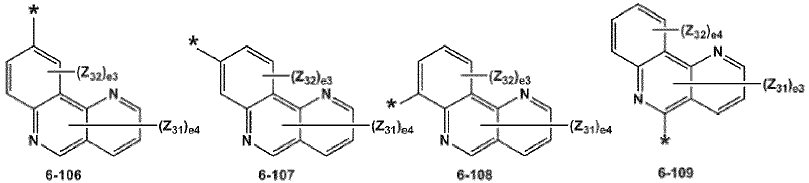 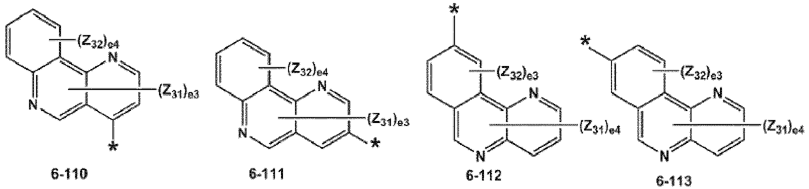 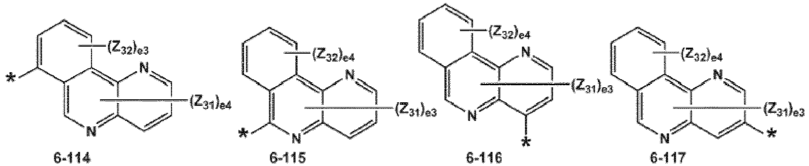 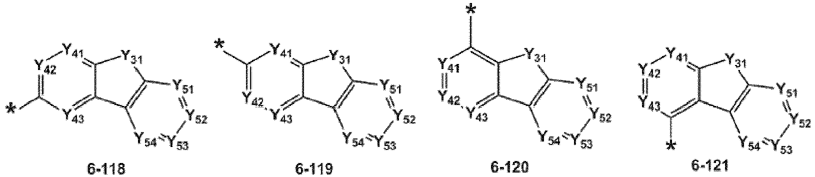 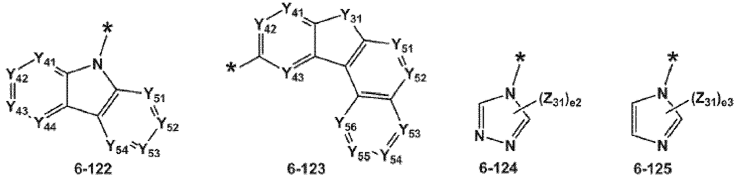 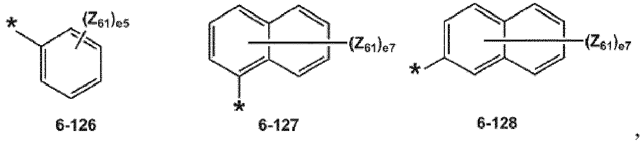 où, dans les formules 6-1 à 6-128,
Y₃₁ est choisi parmi O, S, C(Z₃₃)(Z₃₄), N(Z₃₃) et Si(Z₃₃)(Z₃₄),
Y₄₁ est N ou C(Z₄₁), Y₄₂ est N ou C(Z₄₂), Y₄₃ est N ou C(Z₄₃), Y₄₄ est N ou C(Z₄₄), Y₅₁ est N ou C(Z₅₁), Y₅₂ est N ou C(Z₅₂), Y₅₃ est N ou C(Z₅₃), Y₅₄ est N ou C(Z₅₄), Y₅₅ est N ou C(Z₅₅), Y₅₆ est N ou C(Z₅₆),
au moins l'un choisi parmi Y₄₁ à Y₄₃ et Y₅₁ à Y₅₄ dans les formules 6-118 à 6-121 est N, au moins l'un choisi parmi Y₄₁ à Y₄₄ et Y₅₁ à Y₅₄ dans la formule 6-122 est N, au moins l'un choisi parmi Y₄₁ à Y₄₃ et Y₅₁ à Y₅₆ dans la formule 6-123 est N,
Z₃₁ à Z₃₄, Z₃₈, Z₄₁ à Z₄₄ et Z₅₁ à Z₅₆ sont chacun indépendamment choisis dans le groupe constitué par :
l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alkoxy en C₁ à C₂₀, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinoléinyle, un groupe isoquinoléinyle, un groupe benzoquinoléinyle, un groupe phtalazinyle, un groupe naphthyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂) ; et
un groupe phényle, un groupe naphtyle, un groupe pyridinyle, un groupe pyrimidinyle, un groupe pyrazinyle, un groupe quinoléinyle, un groupe isoquinolinyle, un groupe quinoxalinyle et un groupe quinazolinyle, chacun substitué par au moins l'un choisi parmi un groupe alkyle en C₁ à C₂₀, un groupe alkoxy en C₁ à C₂₀, un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle, un groupe quinazolinyle, un groupe carbazolyle, un groupe fluorényle, -Si(Q₂₁)(Q₂₂)(Q₂₃) et -N(Q₂₁)(Q₂₂),
Z₆₁ est choisi parmi l'hydrogène, un groupe cyano, -F et -CF₃, et au moins un Z₆₁ est choisi parmi un groupe cyano, -F et -CF₃,
où Q₂₁ à Q₂₃ et Q₃₁ à Q₃₃ sont chacun indépendamment choisis parmi un groupe alkyle en C₁ à C₁₀, un groupe alkoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinoléinyle, un groupe isoquinoléinyle, un groupe quinoxalinyle et un groupe quinazolinyle,
e2 est un nombre entier choisi parmi 1 et 2, e3 est un nombre entier choisi parmi 1 à 3, e4 est un nombre entier choisi parmi 1 à 4, e5 est un nombre entier choisi parmi 1 à 5, e6 est un nombre entier choisi parmi 1 à 6, e7 est un nombre entier choisi parmi 1 à 7, et
* indique un site de liaison à un atome adjacent.

12. Dispositif électroluminescent organique selon l'une quelconque des revendications 4 à 11, dans lequel
le premier composé est représenté par la formule 1-11, et
le deuxième composé est représenté par la formule 1-21 : 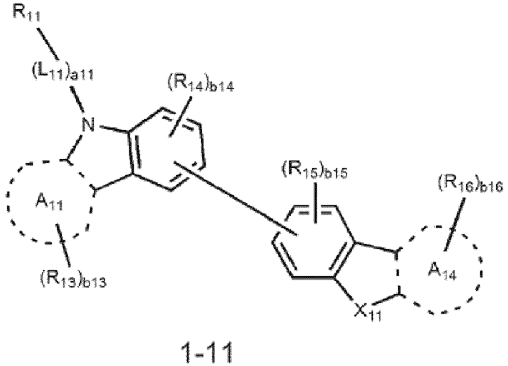 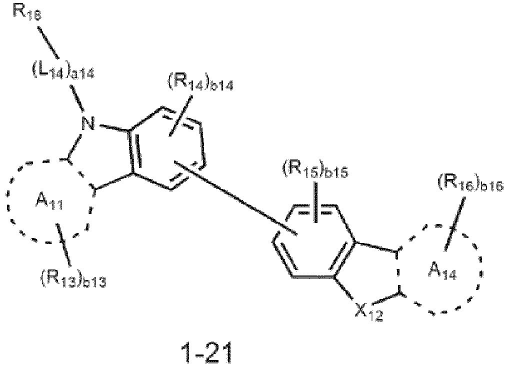 où, dans les formules 1-11 et 1-21,
A₁₁, A₁₄, X₁₁, X₁₂, L₁₁, L₁₄, a11, a14, R₁₁, R₁₃ à R₁₆, R₁₈ et b13 à bl6 sont tels que définis dans l'une quelconque des revendications 4, 5, 7 et 11 en relation avec les formules 1-1 et 1-2.

13. Dispositif électroluminescent organique selon l'une quelconque des revendications 4 à 11, dans lequel
le premier composé est représenté par l'une des formules 2-11 à 2-15 et 2-21 à 2-23, et
le deuxième composé est représenté par l'une des formules 2-31 à 2-35 et 2-41 à 2-43 : 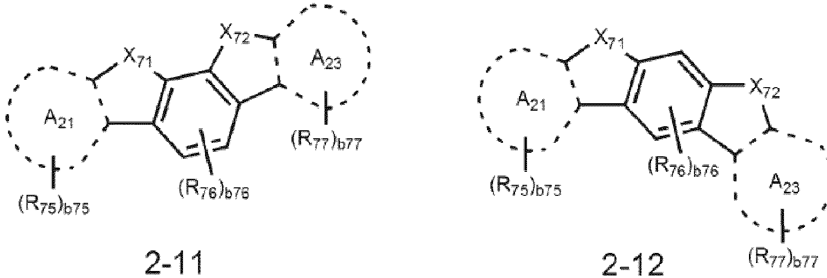 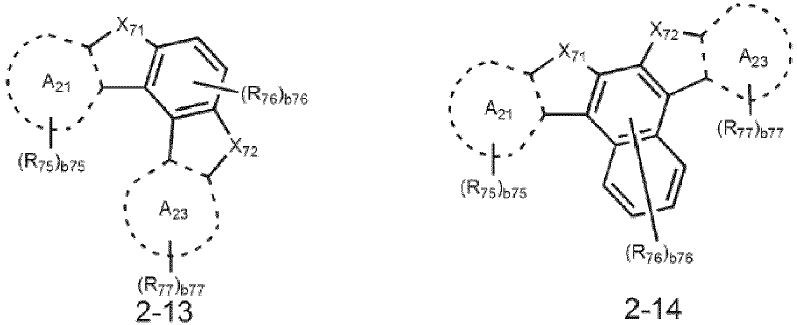 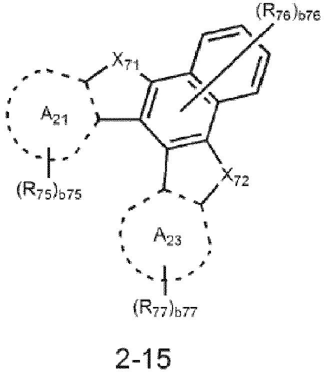 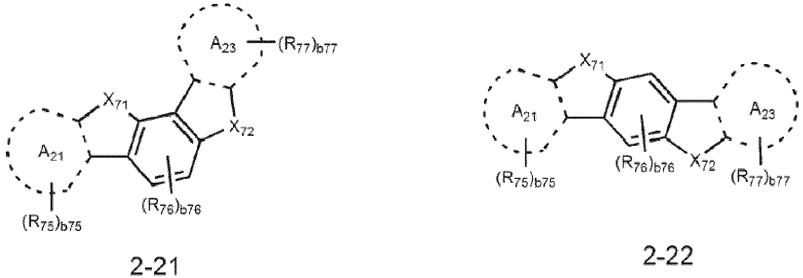 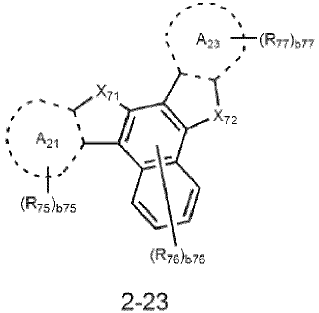 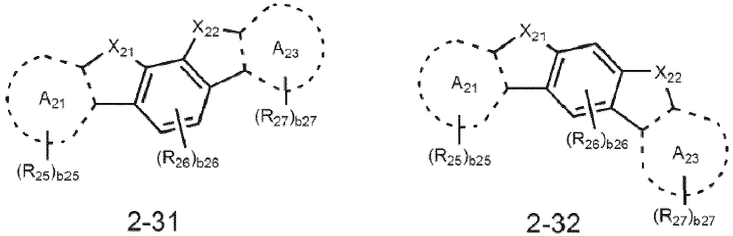 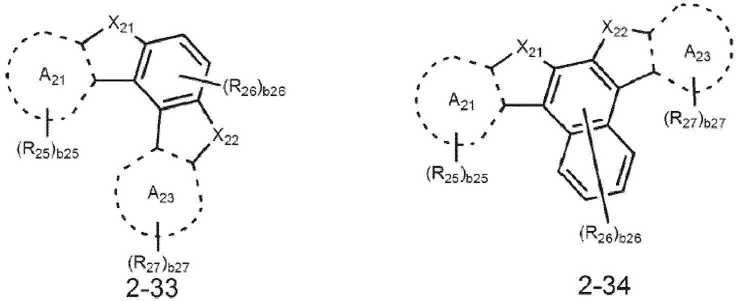 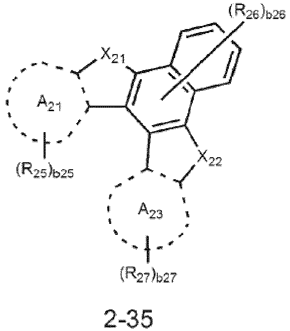 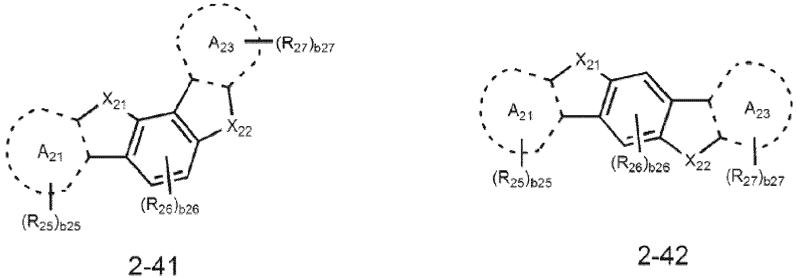 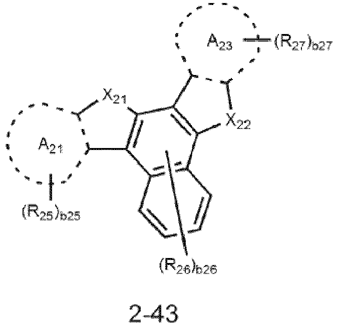 où, dans les formules 2-11 à 2-15, 2-21 à 2-23, 2-31 à 2-35 et 2-41 à 2-43, A₂₁, A₂₃, X₂₁, X₂₂, X₇₁, X₇₂, R₂₅ à R₂₇, R₇₅ à R₇₇, b25 à b27 et b75 à b77 sont tels que définis dans l'une quelconque des revendications 4, 5, 7 et 11 en relation avec les formules 2-1 à 2-4.

14. Dispositif électroluminescent organique selon l'une quelconque des revendications précédentes, dans lequel :
(a) un rapport pondéral du premier composé au deuxième composé est compris dans une plage d'environ 1:99 à environ 99:1 ; et/ou
(b) la couche d'émission comprend le quatrième composé, et le quatrième composé comprend un dopant phosphorescent ; et/ou
(c) le quatrième composé comprend un métal choisi parmi l'iridium (Ir), le platine (Pt), le palladium (Pd), l'osmium (Os), le titane (Ti), le zirconium (Zr), le hafnium (Hf), l'europium (Eu), le terbium (Tb), le rhodium (Rh) et le thulium (Tm) ; et/ou
(d) un rapport pondéral du premier composé au deuxième composé est compris dans une plage d'environ 20:80 à environ 80:20.

15. Dispositif électroluminescent organique selon l'une quelconque des revendications 1, 2, 3 et 14, dans lequel
le premier composé comprend au moins l'un choisi dans le groupe constitué par le composé B-125, le composé B-167 et le composé E-165,
le deuxième composé est choisi dans le groupe constitué par le composé C-109, le composé D-124 et le composé A-161, et
le troisième composé est choisi dans le groupe constitué par les composés F101 à F103 :
